# EUROPEAN PATENT APPLICATION

(11) **EP 3 432 381 A1**
(43) Date of publication of application: **23.01.2019**
(21) Application number: 18184374.9
(22) Date of filing: 19.07.2018
(51) Int. Cl.: H01L 51/54, C09K 11/06

(54) **ORGANOMETALLIC COMPOUND AND ORGANIC LIGHT-EMITTING DEVICE INCLUDING THE SAME**

(30) Priority: 20.07.2017 KR 20170092254; 18.07.2018 KR 20180083252
(71) Applicant: Samsung Electronics Co., Ltd., Gyeonggi-do 16677 (KR); Samsung SDI Co., Ltd., Gyeonggi-do (KR)
(72) Inventor: JUNG, Yongsik, 16678 Gyeonggi-do, (KR); KWON, Eunsuk, 16678 Gyeonggi-do, (KR); MIN, Minsik, 16678 Gyeonggi-do, (KR); BAE, Hyejin, 16678 Gyeonggi-do, (KR); RAI, Virendra Kumar, 16678 Gyeonggi-do, (KR); SON, Jhunmo, 16678 Gyeonggi-do, (KR); LEE, Hasup, 16678 Gyeonggi-do, (KR); KIM, Jongsoo, 16678 Gyeonggi-do, (KR); KIM, Joonghyuk, 16678 Gyeonggi-do, (KR)
(74) Representative: Elkington & Fife LLP

(57) **Abstract**

An organometallic compound represented by one of Formulae 1 to 4: 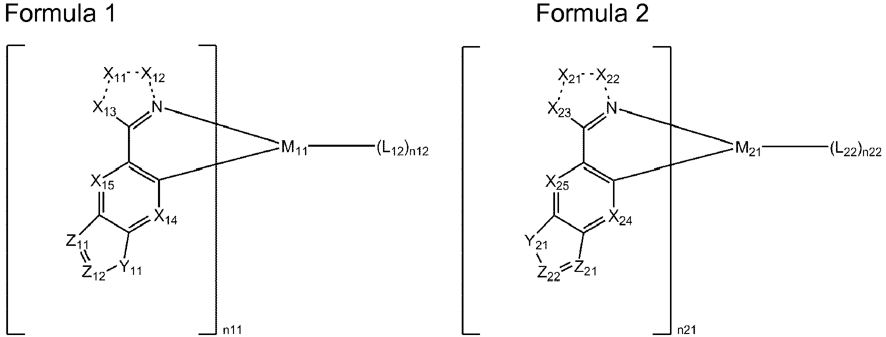 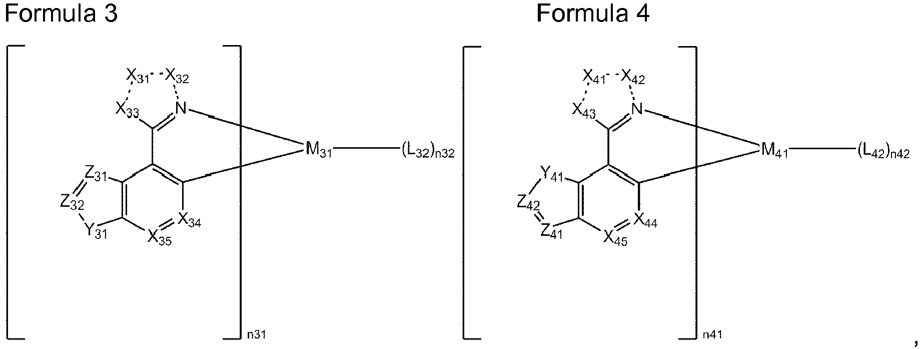 wherein, in Formulae 1 to 4, groups and variables are the same as described in the specification.

## Description

### FIELD OF THE INVENTION

One or more embodiments relate to an organometallic compound and an organic light-emitting device including the same.

### BACKGROUND OF THE INVENTION

Organic light-emitting devices (OLEDs) are self-emission devices that produce full-color images, and that also have wide viewing angles, high contrast ratios, short response times, and excellent characteristics in terms of brightness, driving voltage, and response speed, compared to devices in the art.

A typical organic light-emitting device includes an anode, a cathode, and an organic layer disposed between the anode and the cathode, wherein the organic layer includes an emission layer. A hole transport region may be disposed between the anode and the emission layer, and an electron transport region may be disposed between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transit from an excited state to a ground state, thereby generating light.

Various types of organic light emitting devices are known. However, there still remains a need in OLEDs having low driving voltage, high efficiency, high brightness, and long lifespan.

### SUMMARY OF THE INVENTION

Aspects of the present disclosure provide a new organometallic compound and an organic light-emitting device including the same.

Additional aspects will be set forth in part in the description which follows and, in part, will be apparent from the description, or may be learned by practice of the presented embodiments.

An aspect of the present disclosure provides an organometallic compound represented by one of Formulae 1 to 4:

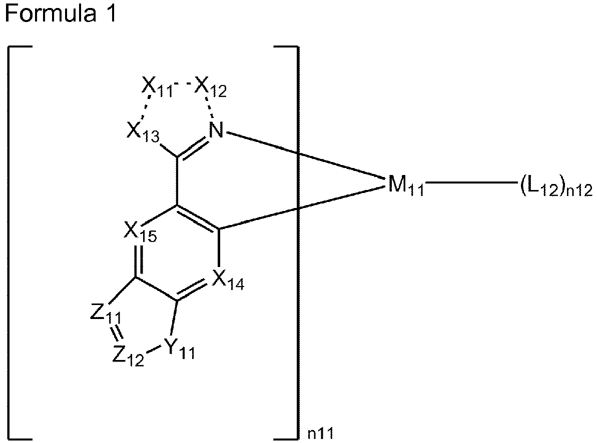

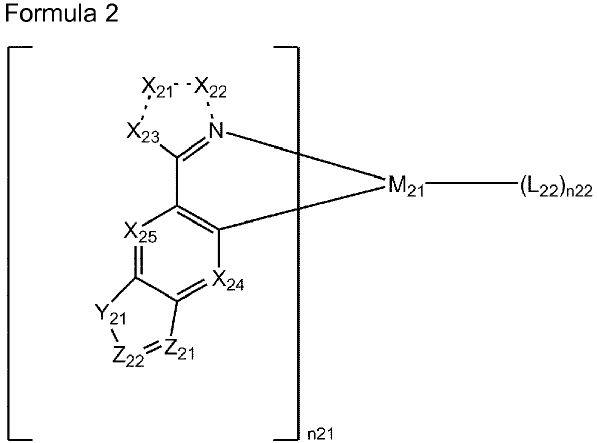

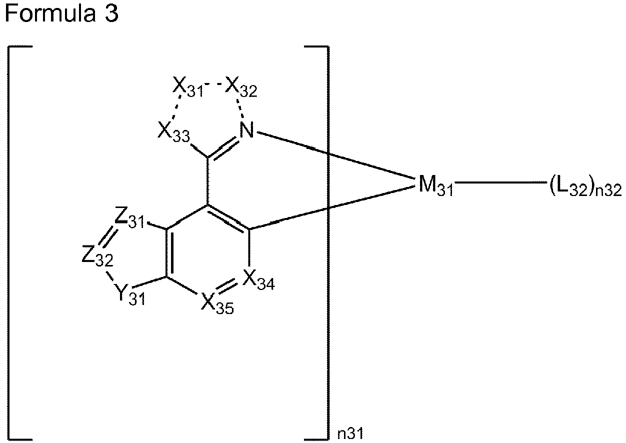

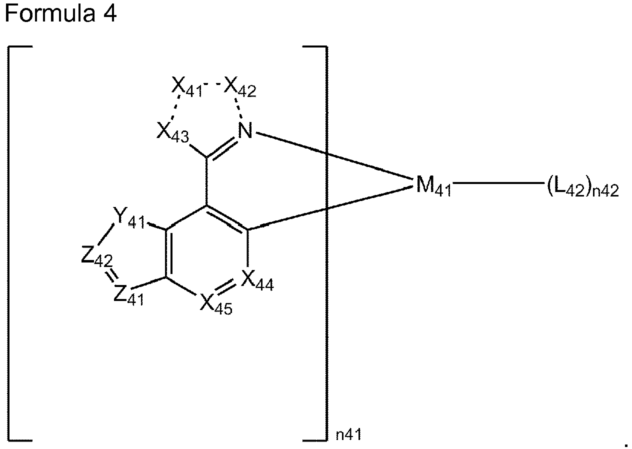

In Formulae 1 to 4,
M₁₁, M₂₁, M₃₁, and M₄₁ may each independently be selected from first-row transition metals, second-row transition metals, and third-row transition metals,
X₁₁ to X₁₃ may each independently be selected from N, N(R₁₂), O, S, C(R₁₃), and C(R₁₂)(R₁₃), and two neighboring constituents R₁₂, neighboring R₁₂ and R₁₃, and/or two neighboring constituents R₁₃ may optionally be linked to form a substituted or unsubstituted C₅-C₃₀ carbocyclic group or a substituted or unsubstituted C₁-C₃₀ heterocyclic group,
X₂₁ to X₂₃ may each independently be selected from N, N(R₂₂), O, S, C(R₂₃), and C(R₂₂)(R₂₃), and two neighboring constituents R₂₂, neighboring R₂₂ and R₂₃, and/or two neighboring constituents R₂₃ may optionally be linked to form a substituted or unsubstituted C₅-C₃₀ carbocyclic group or a substituted or unsubstituted C₁-C₃₀ heterocyclic group,
X₃₁ to X₃₃ may each independently be selected from N, N(R₃₂), O, S, C(R₃₃), and C(R₃₂)(R₃₃), and two neighboring constituents R₃₂, neighboring R₃₂ and R₃₃, and/or two neighboring constituents R₃₃ may optionally be linked to form a substituted or unsubstituted C₅-C₃₀ carbocyclic group or a substituted or unsubstituted C₁-C₃₀ heterocyclic group,
X₄₁ to X₄₃ may each independently be selected from N, N(R₄₂), O, S, C(R₄₃), and C(R₄₂)(R₄₃), and two neighboring constituents R₄₂, neighboring R₄₂ and R₄₃, and/or two neighboring constituents R₄₃ may optionally be linked to form a substituted or unsubstituted C₅-C₃₀ carbocyclic group or a substituted or unsubstituted C₁-C₃₀ heterocyclic group,
a bond between X₁₁ and X₁₃, a bond between X₁₁ and X₁₂, a bond between X₁₂ and N, a bond between X₂₁ and X₂₃, a bond between X₂₁ and X₂₂, a bond between X₂₂ and N, a bond between X₃₁ and X₃₃, a bond between X₃₁ and X₃₂, a bond between X₃₂ and N, a bond between X₄₁ and X₄₃, a bond between X₄₁ and X₄₂, and a bond between X₄₂ and N may each independently be a single bond or a double bond,
   X₁₄ and X₁₅ may each independently be N or C(R₁₄),
   X₂₄ and X₂₅ may each independently be N or C(R₂₄),
   X₃₄ and X₃₅ may each independently be N or C(R₃₄),
   X₄₄ and X₄₅ may each independently be N or C(R₄₄),
   Y₁₁ may be selected from N(R₁₅), O, and S,
   Y₂₁ may be selected from N(R₂₅), O, and S,
   Y₃₁ may be selected from N(R₃₅), O, and S,
   Y₄₁ may be selected from N(R₄₅), O, and S,
Z₁₁ and Z₁₂ may each independently be N or C(R₁₁), provided at least one of Z₁₁ and Z₁₂ is N,
Z₂₁ and Z₂₂ may each independently be N or C(R₂₁), provided at least one of Z₂₁ and Z₂₂ is N,
Z₃₁ and Z₃₂ may each independently be N or C(R₃₁), provided at least one of Z₃₁ and Z₃₂ is N,
Z₄₁ and Z₄₂ may each independently be N or C(R₄₁), provided at least one of Z₄₁ and Z₄₂ is N,
R₁₁ to R₁₅, R₂₁ to R₂₅, R₃₁ to R₃₅, and R₄₁ to R₄₅ may each independently be selected from hydrogen, deuterium, -F, -CI, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₇-C₆₀ arylalkyl group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted C₂-C₆₀ heteroarylalkyl group, a substituted or unsubstituted monovalent non-aromatic condensed polycyclic group, a substituted or unsubstituted monovalent non-aromatic condensed heteropolycyclic group, -N(Q₁)(Q₂),-Si(Q₃)(Q₄)(Q₅), -B(Q₆)(Q₇), and -P(=O)(Q₈)(Q₉),
two, three, or four neighboring constituents selected from R₁₁ to R₁₅, two, three, or four neighboring constituents selected from R₂₁ to R₂₅, two, three, or four neighboring constituents selected from R₃₁ to R₃₅, and/or two, three, or four neighboring constituents selected from R₄₁ to R₄₅ may optionally be linked to form a four-coordinate, six-coordinate, or eight-coordinate ligand,
n11, n21, n31, and n41 may each independently be selected from 1, 2, 3, and 4,
n12, n22, n32, and n42 may each independently be selected from 0, 1, 2, 3, and 4,
L₁₂, L₂₂, L₃₂, and L₄₂ may each independently be selected from a one-coordinate ligand, a two-coordinate ligand, and a three-coordinate ligand, and
Q₁ to Q₉ may each independently be selected from hydrogen, deuterium, -F, -CI, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₁-C₆₀ alkyl group substituted with at least one selected from deuterium, a C₁-C₆₀ alkyl group, and a C₆-C₆₀ aryl group, a C₂-C₆₀ alkenyl group, a C₂-C₆₀ alkynyl group, a C₁-C₆₀ alkoxy group, a C₃-C₁₉ cycloalkyl group, a C₁-C₁₀ heterocycloalkyl group, a C₃-C₁₉ cycloalkenyl group, a C₁-C₁₀ heterocycloalkenyl group, a C₆-C₆₀ aryl group, a C₆-C₆₀ aryl group substituted with at least one selected from deuterium, a C₁-C₆₀ alkyl group, and a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, and a monovalent non-aromatic condensed heteropolycyclic group.

Another aspect of the present disclosure provides an organic light-emitting device including:
a first electrode;
a second electrode; and
an organic layer disposed between the first electrode and the second electrode,
wherein the organic layer includes an emission layer and the organometallic compound.

The organometallic compound in the emission layer may act as a dopant.

### BRIEF DESCRIPTION OF THE DRAWINGS

These and/or other aspects will become apparent and more readily appreciated from the following description of the embodiments, taken in conjunction with the accompanying drawings in which:
FIG. 1 is a schematic cross-sectional view of an organic light-emitting device according to an embodiment;
FIG. 2 is a graph of current (amperes, A) versus voltage (volts, V) showing data obtained by measuring Compound 8 by using cyclic voltammetry (CV); and
FIG. 3 is a graph of normalized intensity (arbitrary units, a. u.) versus wavelength (nanometers, nm) showing a photoluminescence (PL) spectrum of Compound 8.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

It will be understood that when an element is referred to as being "on" another element, it can be directly in contact with the other element or intervening elements may be present therebetween. In contrast, when an element is referred to as being "directly on" another element, there are no intervening elements present.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

The terminology used herein is for the purpose of describing particular embodiments only and is not intended to be limiting. As used herein, the singular forms "a," "an," and "the" are intended to include the plural forms as well, unless the context clearly indicates otherwise.

The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

An organometallic compound according to an embodiment is represented by one of Formulae 1 to 4:

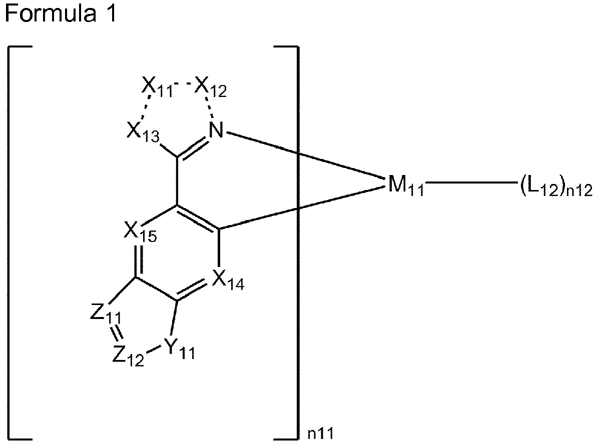

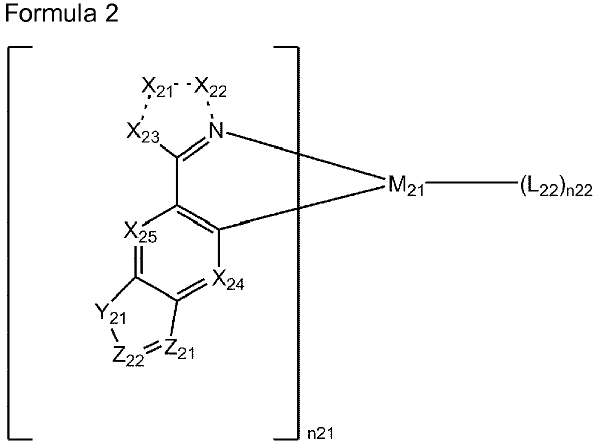

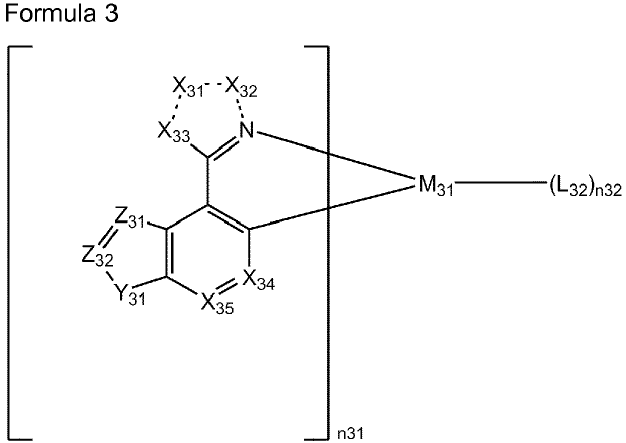

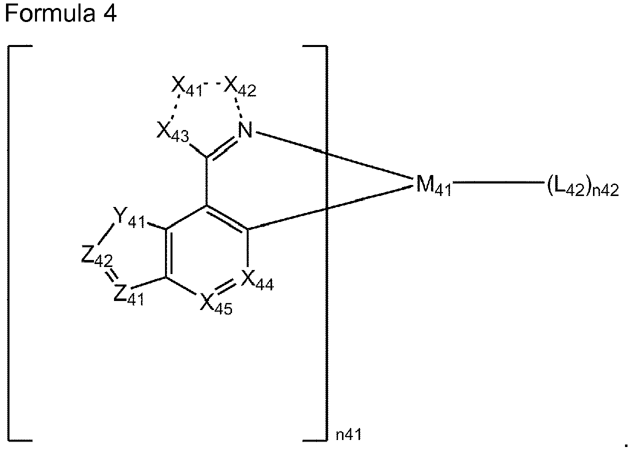

M₁₁, M₂₁, M₃₁, and M₄₁ in Formulae 1 to 4 may each independently be selected from first-row transition metals, second-row transition metals, and third-row transition metals.

For example, M₁₁, M₂₁, M₃₁, and M₄₁ in Formulae 1 to 4 may each independently be selected from platinum (Pt), palladium (Pd), copper (Cu), silver (Ag), gold (Au), rhodium (Rh), iridium (Ir), ruthenium (Ru), osmium (Os), titanium (Ti), zirconium (Zr), hafnium (Hf), europium (Eu), terbium (Tb), and thulium (Tm), but embodiments of the present disclosure are not limited thereto.

In an embodiment, M₁₁, M₂₁, M₃₁, and M₄₁ in Formulae 1 to 4 may each independently be selected from Pt, Pd, Cu, Ag, Au, Rh, Ir, Ru, and Os, but embodiments of the present disclosure are not limited thereto.

In an embodiment, M₁₁, M₂₁, M₃₁, and M₄₁ in Formulae 1 to 4 may each independently be selected from Rh, Ir, Ru, and Os, but embodiments of the present disclosure are not limited thereto.

In an embodiment, M₁₁, M₂₁, M₃₁, and M₄₁ in Formulae 1 to 4 may each be Ir, but embodiments of the present disclosure are not limited thereto.

In Formulae 1 to 4, X₁₁ to X₁₃ may each independently be selected from N, N(R₁₂), O, S, C(R₁₃), and C(R₁₂)(R₁₃), and two neighboring constituents R₁₂, two neighboring R₁₂ and R₁₃, and/or two neighboring constituents R₁₃ may optionally be linked to form a substituted or unsubstituted C₅-C₃₀ carbocyclic group or a substituted or unsubstituted C₁-C₃₀ heterocyclic group,
X₂₁ to X₂₃ may each independently be selected from N, N(R₂₂), O, S, C(R₂₃), and C(R₂₂)(R₂₃), and two neighboring constituents R₂₂, two neighboring R₂₂ and R₂₃, and/or two neighboring constituents R₂₃ may optionally be linked to form a substituted or unsubstituted C₅-C₃₀ carbocyclic group or a substituted or unsubstituted C₁-C₃₀ heterocyclic group,
X₃₁ to X₃₃ may each independently be selected from N, N(R₃₂), O, S, C(R₃₃), and C(R₃₂)(R₃₃), two neighboring constituents R₃₂, two neighboring R₃₂ and R₃₃, and/or two neighboring constituents R₃₃ may optionally be linked to form a substituted or unsubstituted C₅-C₃₀ carbocyclic group or a substituted or unsubstituted C₁-C₃₀ heterocyclic group, and
X₄₁ to X₄₃ may each independently be selected from N, N(R₄₂), O, S, C(R₄₃), and C(R₄₂)(R₄₃), and two neighboring constituents R₄₂, two neighboring R₄₂ and R₄₃, and/or two neighboring constituents R₄₃ may optionally be linked to form a substituted or unsubstituted C₅-C₃₀ carbocyclic group or a substituted or unsubstituted C₁-C₃₀ heterocyclic group.

For example, in Formulae 1 to 4, X₁₁ may be C(R₁₃), X₁₂ may be N or C(R₁₃), and X₁₃ may be N(R₁₂),
X₂₁ may be C(R₂₃), X₂₂ may be N or C(R₂₃), and X₂₃ may be N(R₂₂),
X₃₁ may be C(R₃₃), X₃₂ may be N or C(R₃₃), and X₃₃ may be N(R₃₂), and
X₄₁ may be C(R₄₃), X₄₂ may be N or C(R₄₃), and X₄₃ may be N(R₄₂), but embodiments of the present disclosure are not limited thereto.

In an embodiment, in Formulae 1 to 4, X₁₂ may be C(R₁₃), X₁₁ may be N or C(R₁₃), and X₁₃ may be N(R₁₂),
X₂₂ may be C(R₂₃), X₂₁ may be N or C(R₂₃), and X₂₃ may be N(R₂₂),
X₃₂ may be C(R₃₃), X₃₁ may be N or C(R₃₃), and X₃₃ may be N(R₃₂), and
X₄₂ may be C(R₄₃), X₄₁ may be N or C(R₄₃), and X₄₃ may be N(R₄₂), but embodiments of the present disclosure are not limited thereto.

In an embodiment, in Formulae 1 to 4, X₁₁ may be N, X₁₂ may be N or C(R₁₃), and X₁₃ may be N(R₁₂),
X₂₁ may be N, X₂₂ may be N or C(R₂₃), and X₂₃ may be N(R₂₂),
X₃₁ may be N, X₃₂ may be N or C(R₃₃), and X₃₃ may be N(R₃₂), and
X₄₁ may be N, X₄₂ may be N or C(R₄₃), and X₄₃ may be N(R₄₂), but embodiments of the present disclosure are not limited thereto.

In an embodiment, in Formulae 1 to 4, X₁₂ may be N, X₁₁ may be N or C(R₁₃), and X₁₃ may be N(R₁₂),
X₂₂ may be N, X₂₁ may be N or C(R₂₃), and X₂₃ may be N(R₂₂),
X₃₂ may be N, X₃₁ may be N or C(R₃₃), and X₃₃ may be N(R₃₂), and
X₄₂ may be N, X₄₁ may be N or C(R₄₃), and X₄₃ may be N(R₄₂), but embodiments of the present disclosure are not limited thereto.

In an embodiment, in Formulae 1 to 4, X₁₃ may be O or S, and X₁₁ and X₁₂ may each independently be N or C(R₁₃),
X₂₃ may be O or S, and X₂₁ and X₂₂ may each independently be N or C(R₂₃),
X₃₃ may be O or S, and X₃₁ and X₃₂ may each independently be N and C(R₃₃),
X₄₃ may be O or S, and X₄₁ and X₄₂ may each independently be N and C(R₄₃), but embodiments of the present disclosure are not limited thereto.

In Formulae 1 to 4, a bond between X₁₁ and X₁₃, a bond between X₁₁ and X₁₂, a bond between X₁₂ and N, a bond between X₂₁ and X₂₃, a bond between X₂₁ and X₂₂, a bond between X₂₂ and N, a bond between X₃₁ and X₃₃, a bond between X₃₁ and X₃₂, a bond between X₃₂ and N, a bond between X₄₁ and X₄₃, a bond between X₄₁ and X₄₂, and a bond between X₄₂ and N may each independently be a single bond or a double bond.

For example, in Formulae 1 to 4, a bond between X₁₁ and X₁₂, a bond between X₂₁ and X₂₂, a bond between X₃₁ and X₃₂, and a bond between X₄₁ and X₄₂ may each be a double bond, and a bond between X₁₁ and X₁₃, a bond between X₁₂ and N, a bond between X₂₁ and X₂₃, a bond between X₂₂ and N, a bond between X₃₁ and X₃₃, a bond between X₃₂ and N, a bond between X₄₁ and X₄₃, a bond between X₄₂ and N may each be a single bond, but embodiments of the present disclosure are not limited thereto.

In Formulae 1 to 4, X₁₄ and X₁₅ may each independently be N or C(R₁₄),
X₂₄ and X₂₅ may each independently be N or C(R₂₄),
X₃₄ and X₃₅ may each independently be N or C(R₃₄), and
X₄₄ and X₄₅ may each independently be N or C(R₄₄).

For example, in Formulae 1 to 4, X₁₄ and X₁₅ may each be C(R₁₄),
X₂₄ and X₂₅ may each be C(R₂₄),
X₃₄ and X₃₅ may each be C(R₃₄), and
X₄₄ and X₄₅ may each be C(R₄₄), but embodiments of the present disclosure are not limited thereto.

In Formulae 1 to 4, Y₁₁ may be selected from N(R₁₅), O, and S,
Y₂₁ may be selected from N(R₂₅), O, and S,
Y₃₁ may be selected from N(R₃₅), O, and S, and
Y₄₁ may be selected from N(R₄₅), O, and S.

For example, in Formulae 1 to 4, Y₁₁ may be O or S,
Y₂₁ may be O or S,
Y₃₁ may be O or S, and
Y₄₁ may be O or S, but embodiments of the present disclosure are not limited thereto.

In Formulae 1 to 4, Z₁₁ and Z₁₂ may each independently be N or C(R₁₁), provided that at least one of Z₁₁ and Z₁₂ is N, Z₂₁ and Z₂₂ may each independently be N or C(R₂₁), provided that at least one of Z₂₁ and Z₂₂ is N, Z₃₁ and Z₃₂ may each independently be N or C(R₃₁), provided that at least one of Z₃₁ and Z₃₂ is N, and Z₄₁ and Z₄₂ may each independently be N or C(R₄₁), provided that at least one of Z₄₁ and Z₄₂ is N.

For example, in Formulae 1 to 4, Z₁₁ may be N, Z₂₁ may be N, Z₃₁ may be N, and Z₄₁ may be N, but embodiments of the present disclosure are not limited thereto.

R₁₁ to R₁₅, R₂₁ to R₂₅, R₃₁ to R₃₅, and R₄₁ to R₄₅ in Formulae 1 to 4 may each independently be selected from hydrogen, deuterium, -F, -CI, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₉ cycloalkyl group, a substituted or unsubstituted C₁-C₁₀ heterocycloalkyl group, a substituted or unsubstituted C₃-C₁₉ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₇-C₆₀ arylalkyl group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted C₂-C₆₀ heteroarylalkyl group, a substituted or unsubstituted monovalent non-aromatic condensed polycyclic group, a substituted or unsubstituted monovalent non-aromatic condensed heteropolycyclic group,-N(Q₁)(Q₂), -Si(Q₃)(Q₄)(Q₅), -B(Q₆)(Q₇), and -P(=O)(Q₈)(Q₉), and
Q₁ to Q₉ may each independently be selected from hydrogen, deuterium, -F, -CI, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₁-C₆₀ alkyl group substituted with at least one selected from deuterium, a C₁-C₆₀ alkyl group, and a C₆-C₆₀ aryl group, a C₂-C₆₀ alkenyl group, a C₂-C₆₀ alkynyl group, a C₁-C₆₀ alkoxy group, a C₃-C₁₉ cycloalkyl group, a C₁-C₁₀ heterocycloalkyl group, a C₃-C₁₉ cycloalkenyl group, a C₁-C₁₀ heterocycloalkenyl group, a C₆-C₆₀ aryl group, a C₆-C₆₀ aryl group substituted with at least one selected from deuterium, a C₁-C₆₀ alkyl group, and a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, and a monovalent non-aromatic condensed heteropolycyclic group.

For example, R₁₁ to R₁₅, R₂₁ to R₂₅, R₃₁ to R₃₅, and R₄₁ to R₄₅ in Formulae 1 to 4 may each independently be selected from:
hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -CI, -Br, -I, -CD₃, -CD₂H, -CDH₂, -CF₃,-CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclopentyl group substituted with deuterium, a cyclohexyl group, a cyclohexyl group substituted with deuterium, a cycloheptyl group, a cycloheptyl group substituted with deuterium, a cyclooctyl group, a cyclooctyl group substituted with deuterium, a bicyclo[2.2.1]heptanyl group, an adamantanyl group, a norbornanyl group, a norbornenyl group, a cyclopentenyl group, a cyclohexenyl group, a cycloheptenyl group, a phenyl group, a naphthyl group, a pyridinyl group, and a pyrimidinyl group;
a cyclopentyl group, a cyclohexyl group, a cycloheptyl group, a cyclooctyl group, a bicyclo[2.2.1]heptanyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group;
a cyclopentyl group, a cyclohexyl group, a cycloheptyl group, a cyclooctyl group, a bicyclo[2.2.1]heptanyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group, each substituted with at least one selected from deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclopentyl group substituted with deuterium, a cyclohexyl group, a cyclohexyl group substituted with deuterium, a cycloheptyl group, a cycloheptyl group substituted with deuterium, a cyclooctyl group, a cyclooctyl group substituted with deuterium, a bicyclo[2.2.1]heptanyl group, an adamantanyl group, a norbornanyl group, a norbornenyl group, a cyclopentenyl group, a cyclohexenyl group, a cycloheptenyl group, a phenyl group, a C₁-C₂₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group, and -Si(Q₃₃)(Q₃₄)(Q₃₅); and
-N(Q₁)(Q₂), -Si(Q₃)(Q₄)(Q₅), -B(Q₆)(Q₇), and -P(=O)(Q₈)(Q₉), and
Q₁ to Q₉ and Q₃₃ to Q₃₅ may each independently be selected from:
   -CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CH₃, -CD₂CD₂H, and -CD₂CDH₂;
   an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
   an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from deuterium, a C₁-C₁₀ alkyl group, and a phenyl group,
but embodiments of the present disclosure are not limited thereto.

In an embodiment, R₁₁ to R₁₅, R₂₁ to R₂₅, R₃₁ to R₃₅, and R₄₁ to R₄₅ in Formulae 1 to 4 may each independently be selected from:
hydrogen, deuterium, -F, a cyano group, a nitro group, -SF₅, a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, a bicyclo[2.2.1]heptanyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a fluorenyl group, a carbazolyl group, a dibenzofuranyl group, a dibenzothiophenyl group, and a dibenzosilolyl group;
a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, a bicyclo[2.2.1]heptanyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a fluorenyl group, a carbazolyl group, a dibenzofuranyl group, a dibenzothiophenyl group, and a dibenzosilolyl group, each substituted with at least one selected from deuterium, -F, -CD₃, -CD₂H,-CDH₂, -CF₃, -CF₂H, -CFH₂, a cyano group, a nitro group, a C₁-C₁₀ alkyl group, a C₁-C₁₀ alkoxy group, a cyclopentyl group, a cyclopentyl group substituted with deuterium, a cyclohexyl group, a cyclohexyl group substituted with deuterium, a cycloheptyl group, a cycloheptyl group substituted with deuterium, a cyclooctyl group, a cyclooctyl group substituted with deuterium, a bicyclo[2.2.1]heptanyl group, an adamantanyl group, a norbornanyl group, a norbornenyl group, a cyclopentenyl group, a cyclohexenyl group, a cycloheptenyl group, a phenyl group, a C₁-C₂₀ alkylphenyl group, a naphthyl group, a pyridinyl group, a pyrimidinyl group, a fluorenyl group, a carbazolyl group, a dibenzofuranyl group, a dibenzothiophenyl group, a dibenzosilolyl group, and -Si(Q₃₃)(Q₃₄)(Q₃₅); and
-N(Q₁)(Q₂), -Si(Q₃)(Q₄)(Q₅), -B(Q₆)(Q₇), and -P(=O)(Q₈)(Q₉), and
Q₁ to Q₉ and Q₃₃ to Q₃₅ may each independently be selected from:
   -CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, and-CD₂CDH₂;
   an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
   an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from deuterium, a C₁-C₁₀ alkyl group, and a phenyl group,
but embodiments of the present disclosure are not limited thereto.

In an embodiment, R₁₁ to R₁₅, R₂₁ to R₂₅, R₃₁ to R₃₅, and R₄₁ to R₄₅ in Formulae 1 to 4 may each independently be selected from hydrogen, deuterium, -F, a cyano group, a nitro group, -SF₅, -CH₃, -CD₃, -CD₂H, -CDH₂, -CF₃, -CF₂H, -CFH₂, groups represented by Formulae 9-1 to 9-21, groups represented by Formulae 10-1 to 10-256, -N(Q₁)(Q₂), -Si(Q₃)(Q₄)(Q₅), -B(Q₆)(Q₇), and -P(=O)(Q₈)(Q₉), but embodiments of the present disclosure are not limited thereto: 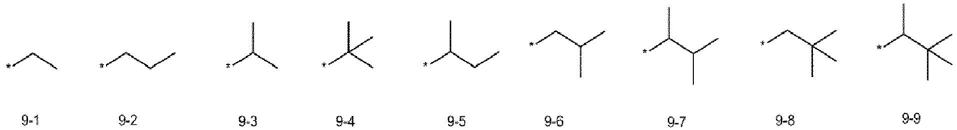 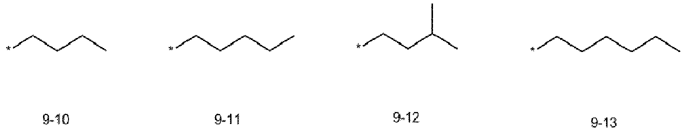 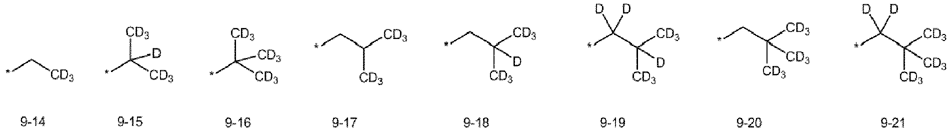 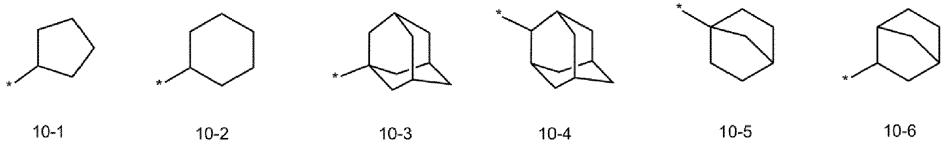 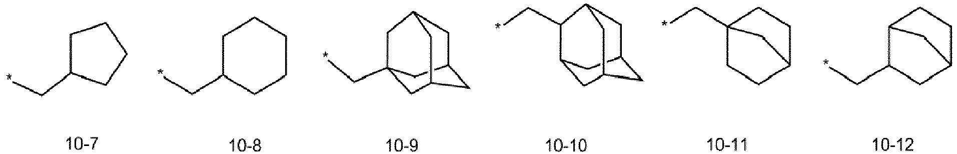 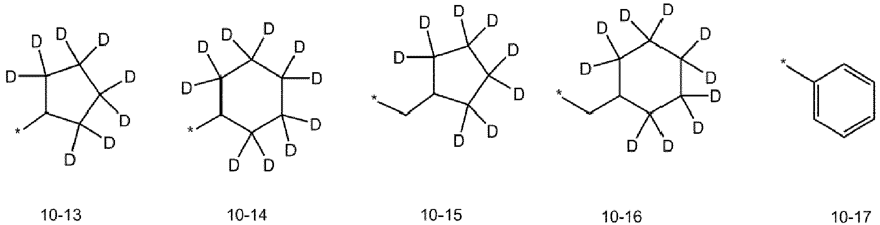 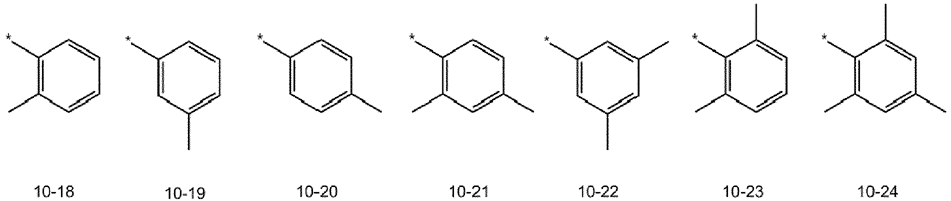 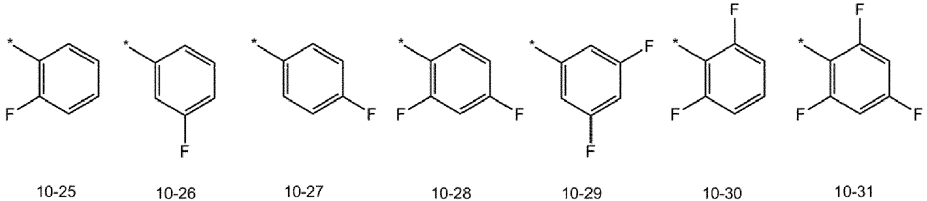 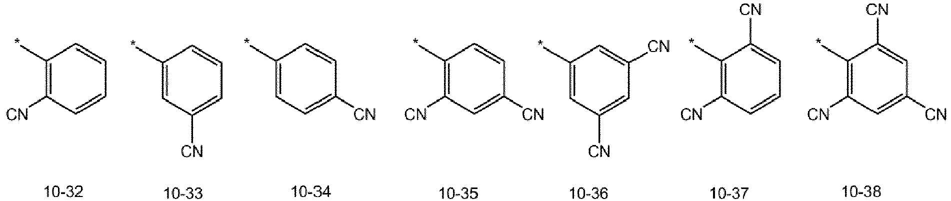 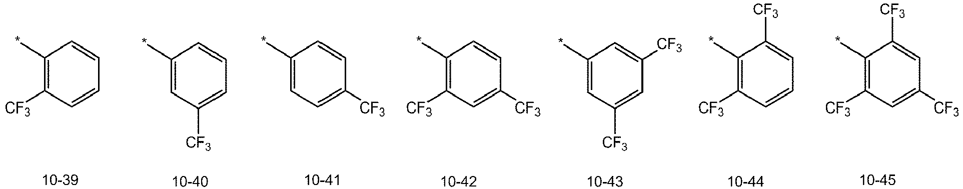 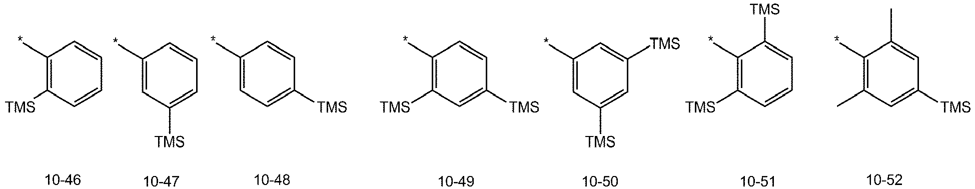 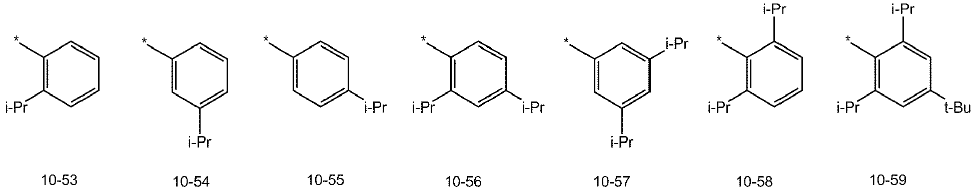 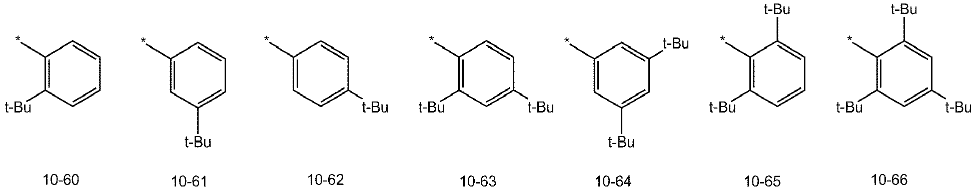 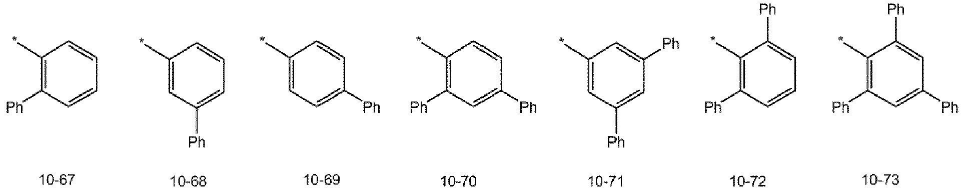 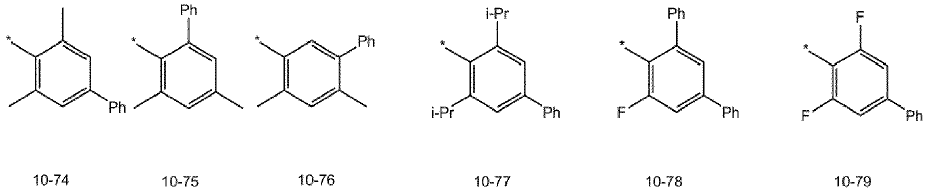 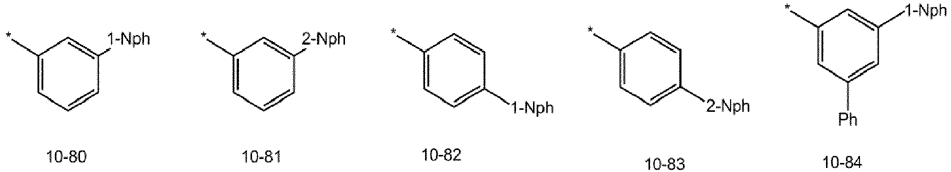 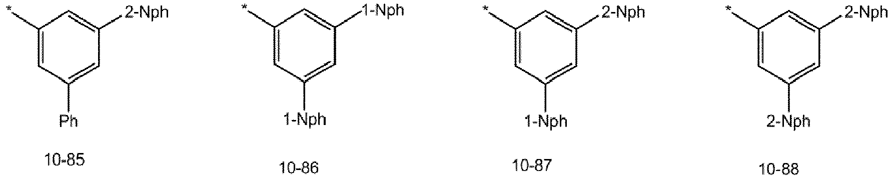 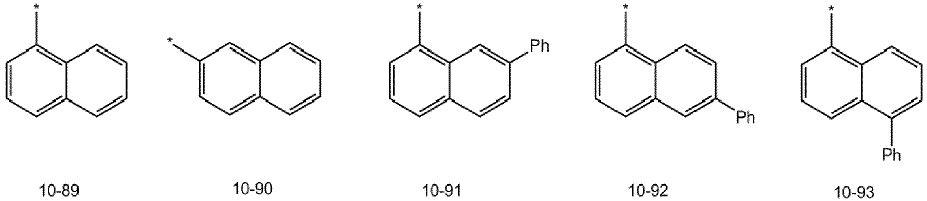 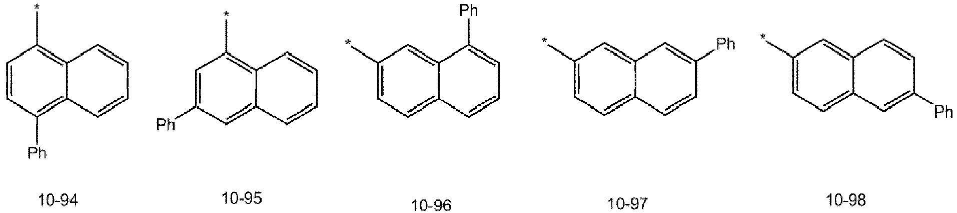 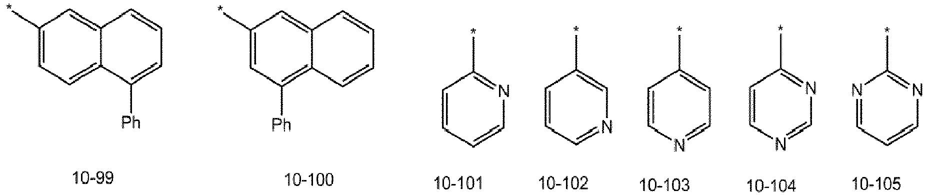 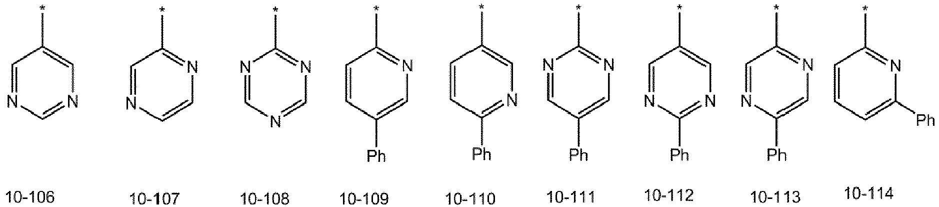 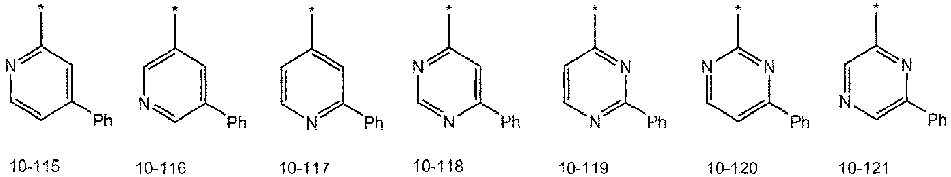 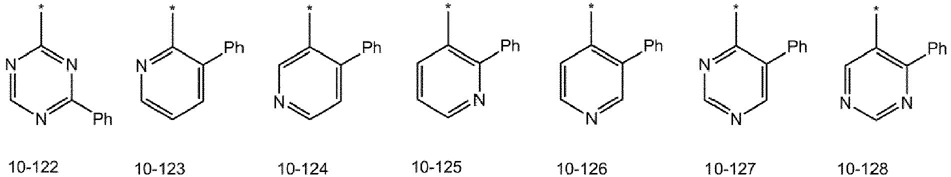 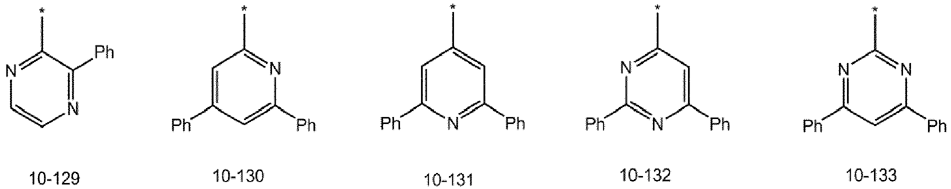 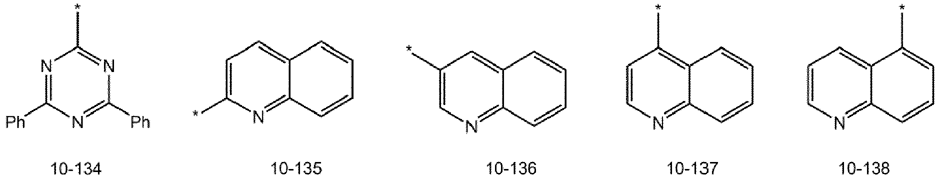 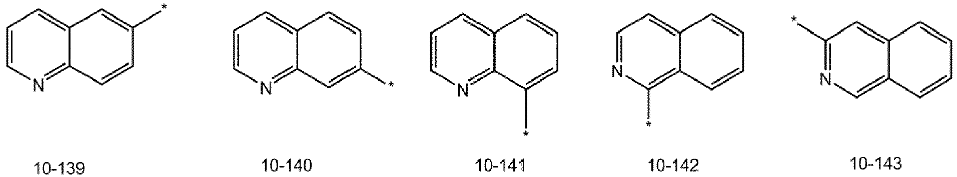 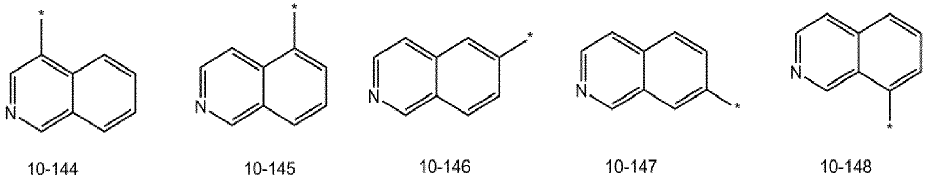 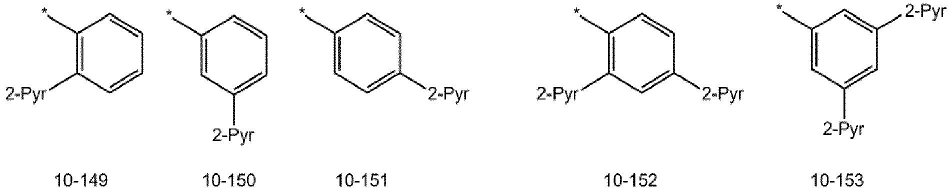 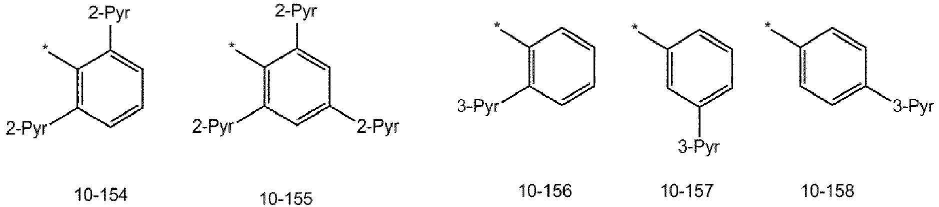 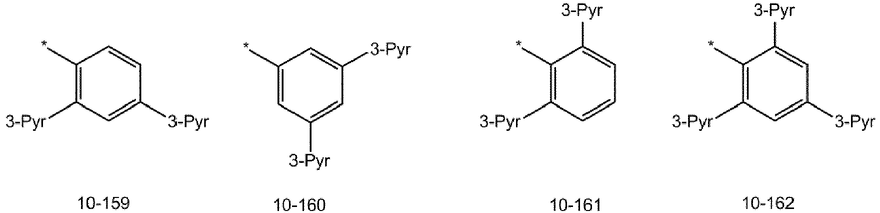 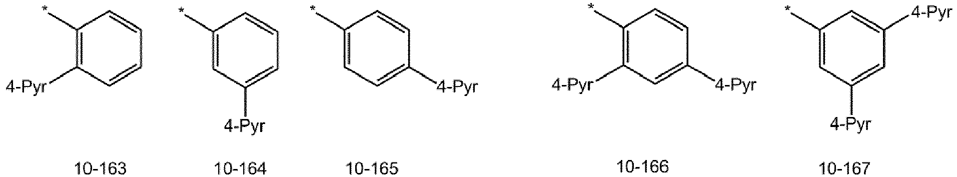 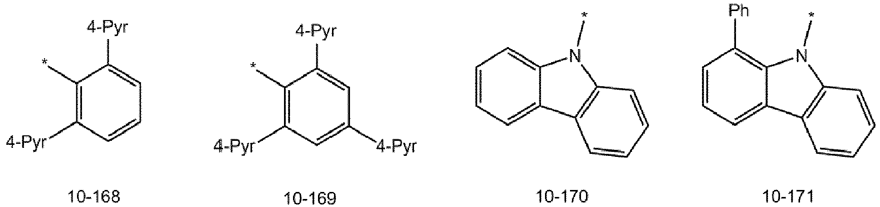 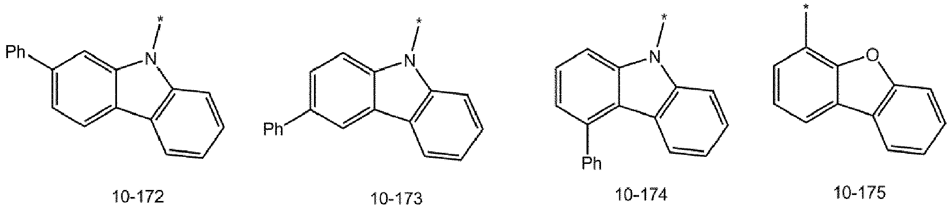 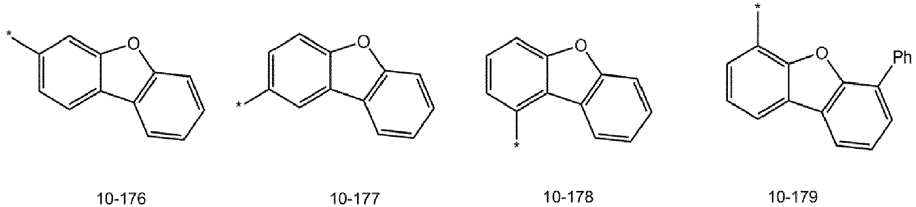 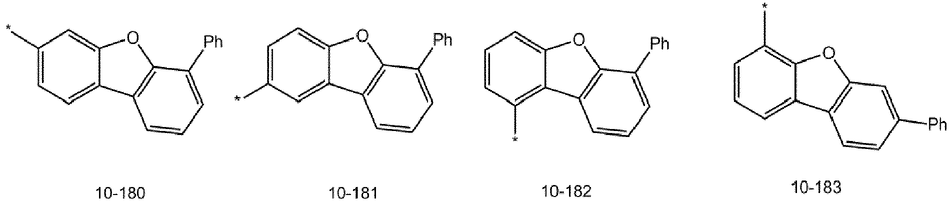 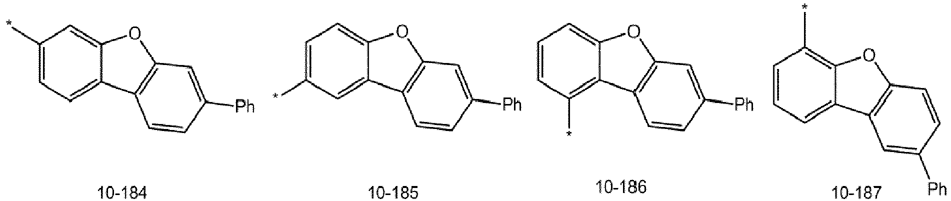 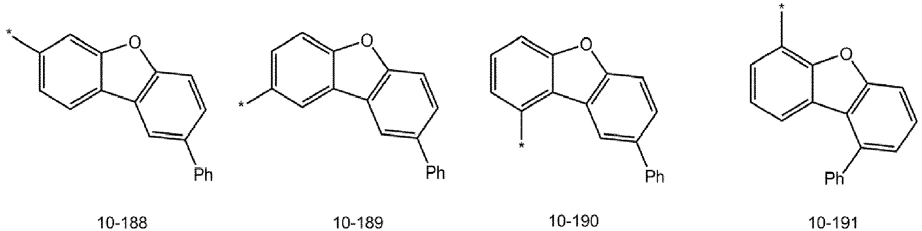 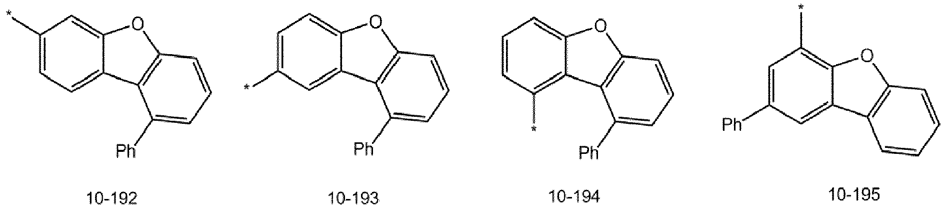 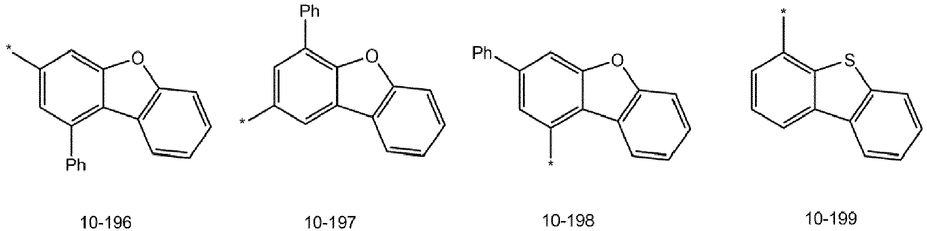 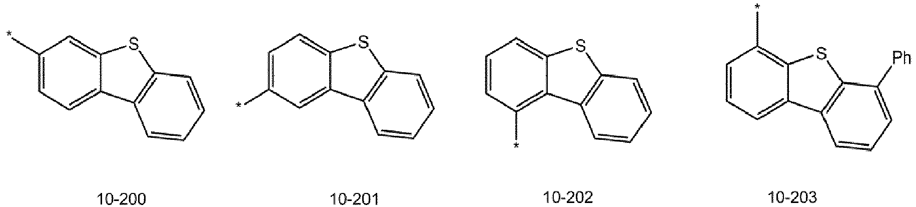 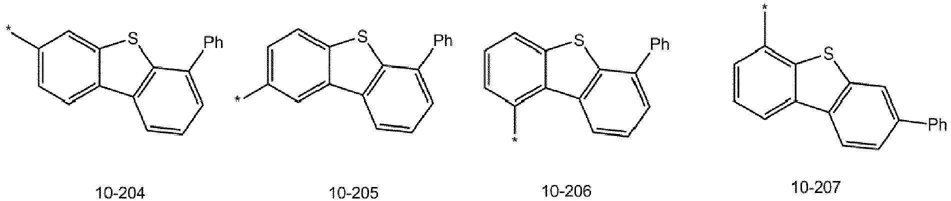 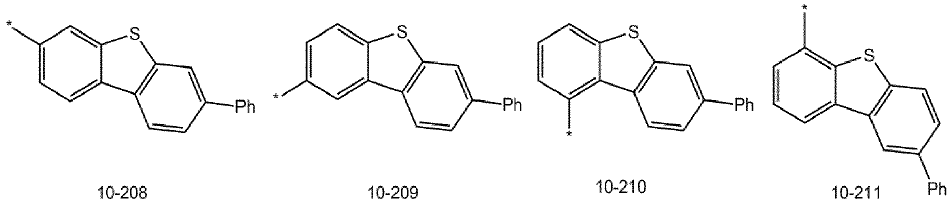 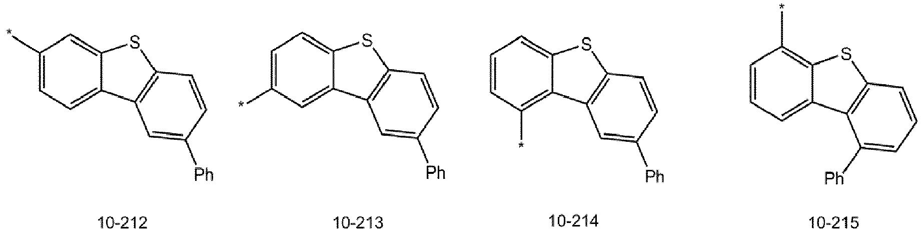 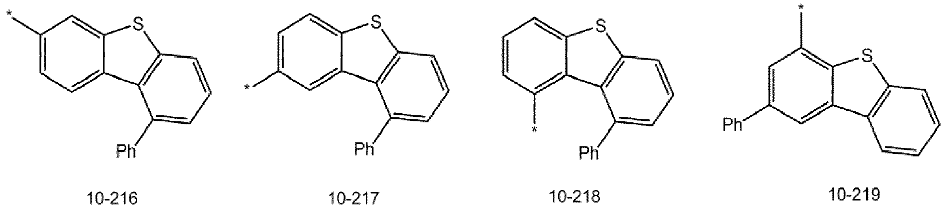 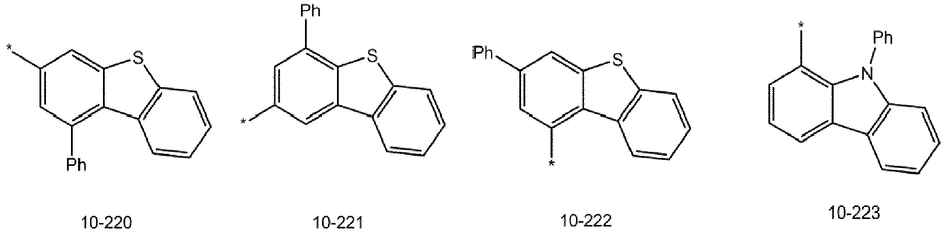 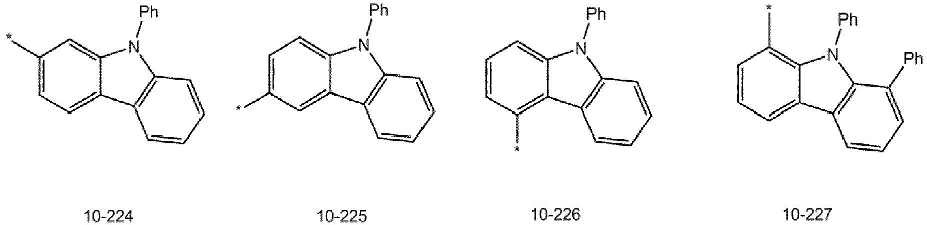 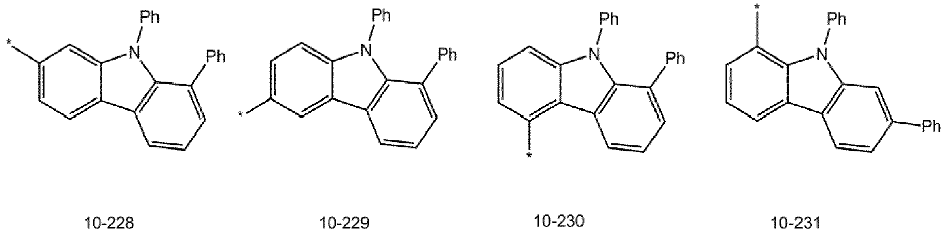 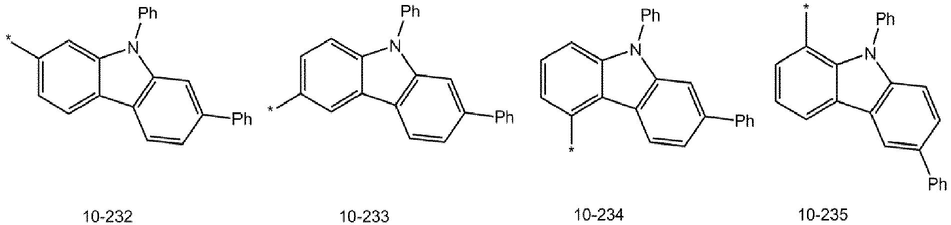 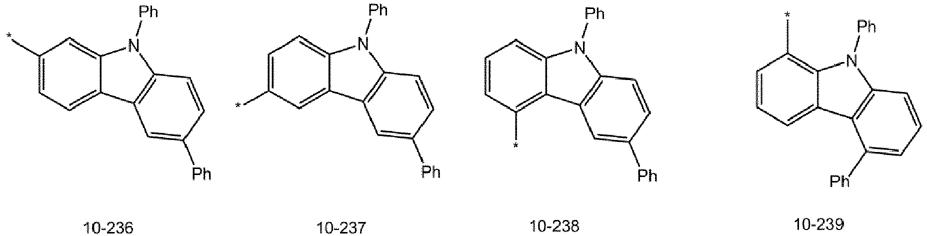 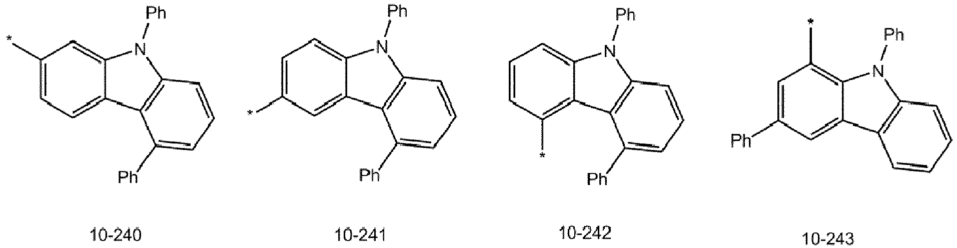 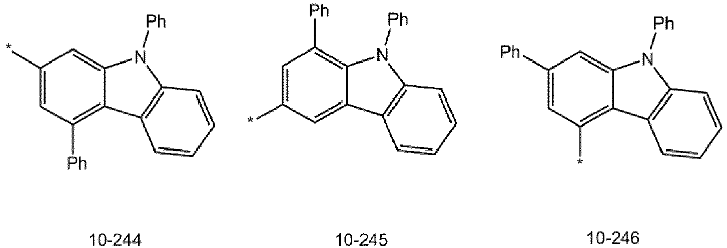 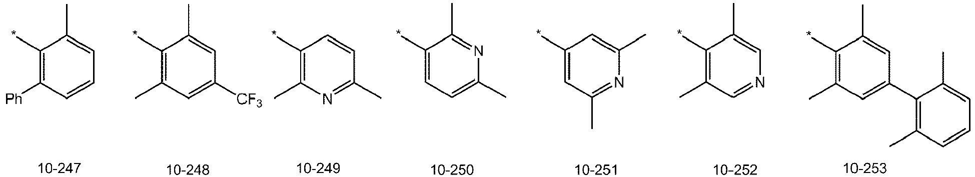 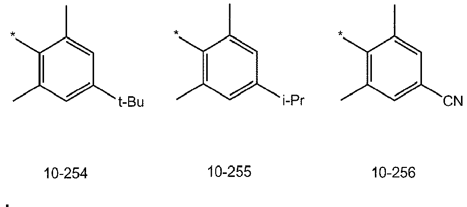 Q₁ to Q₉ may each independently be selected from:
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CH₃, -CD₂CD₂H, and -CD₂CDH₂;
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from deuterium, a C₁-C₁₀ alkyl group, and a phenyl group.

In Formulae 9-1 to 9-21 and 10-1 to 10-256,
* indicates a binding site to a neighboring atom,
i-Pr indicates an iso-propyl group, and t-Bu indicates a t-butyl group,
Ph indicates a phenyl group,
1-Nph indicates a 1-naphthyl group, 2-Nph indicates a 2-naphthyl group,
2-Pyr indicates a 2-pyridyl group, 3-Pyr indicates a 3-pyridyl group, and 4-Pyr indicates a 4-pyridyl group, and
TMS indicates a trimethylsilyl group.

In an embodiment, R₁₁ to R₁₅, R₂₁ to R₂₅, R₃₁ to R₃₅, and R₄₁ to R₄₅ in Formulae 1 to 4 may each independently be selected from hydrogen, deuterium, -F, a cyano group, a nitro group, -SF₅, -CH₃, -CF₃, groups represented by Formulae 9-1 to 9-13, groups represented by Formulae 10-17 to 10-79, and groups represented by Formulae 10-247 to 10-256, but embodiments of the present disclosure are not limited thereto:

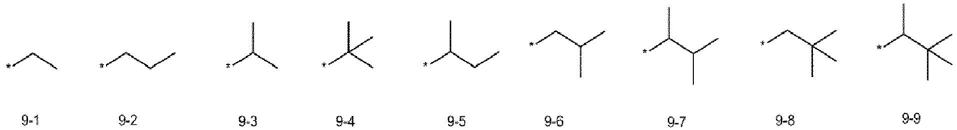

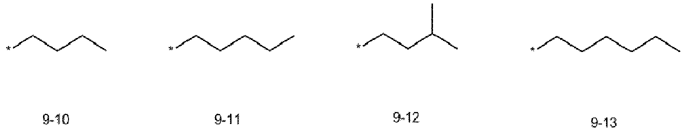

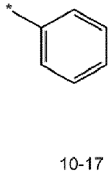

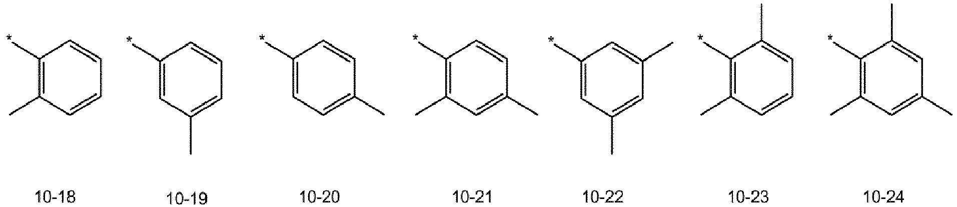

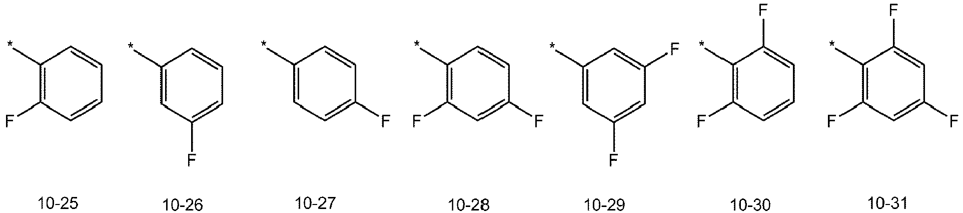

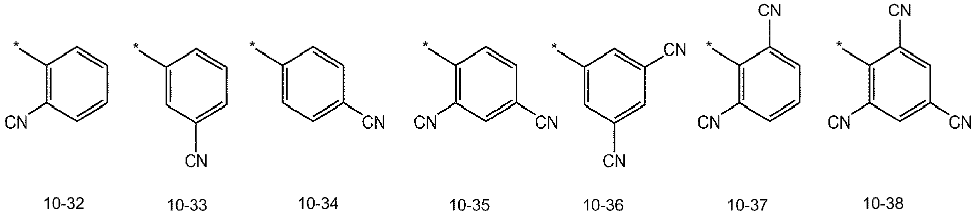

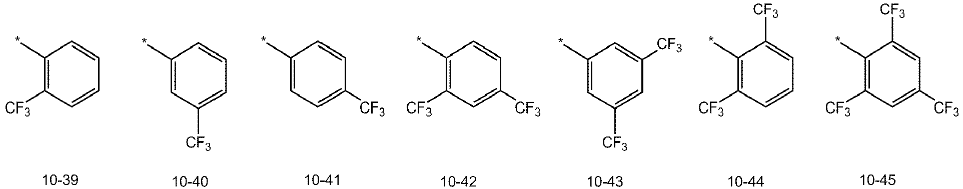

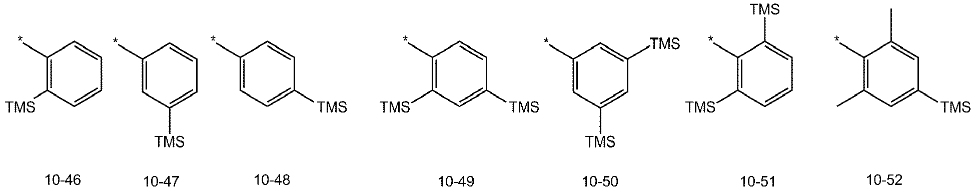

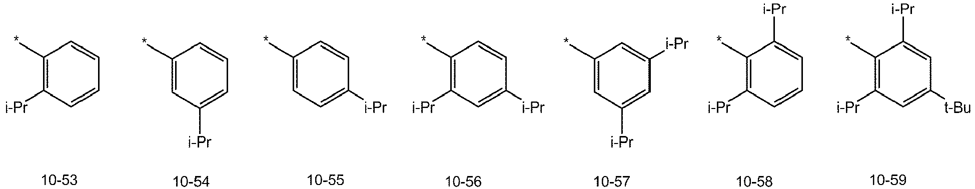

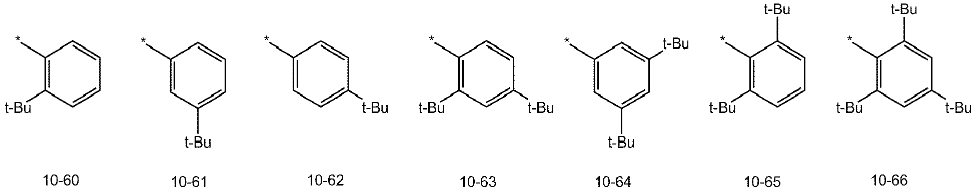

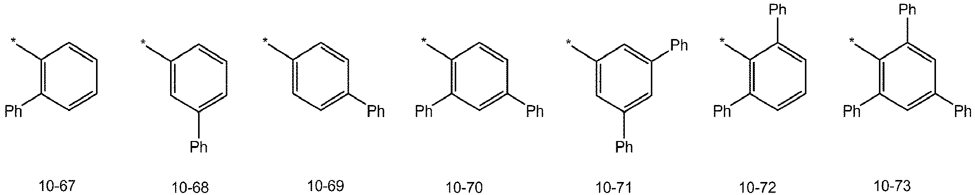

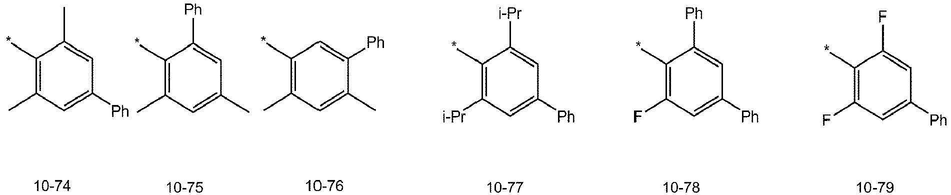

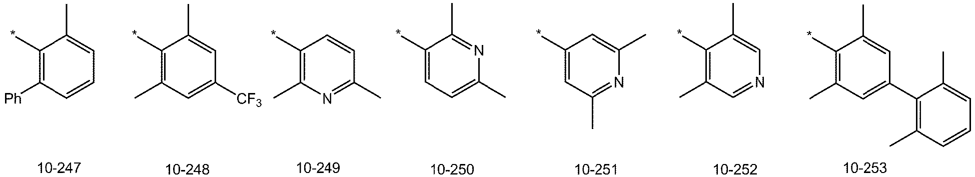

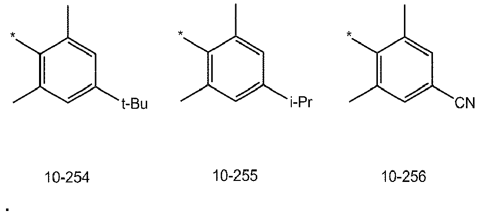

In the groups represented by Formulae 9-1 to 9-13, the groups represented by Formulae 10-17 to 10-79, and the groups represented by Formulae 10-247 to 10-256,
* indicates a binding site to a neighboring atom,
i-Pr indicates an iso-propyl group, and t-Bu indicates a t-butyl group,
Ph indicates a phenyl group, and
TMS indicates a trimethylsilyl group.

In an embodiment, in Formulae 1 to 4, X₁₃ may be N(R₁₂), X₂₃ may be N(R₂₂), X₃₃ may be N(R₃₂), and X₄₃ may be N(R₄₂),
R₁₂, R₂₂, R₃₂, and R₄₂ may each independently be selected from a phenyl group, a naphthyl group, a pyridinyl group, a pyrimidinyl group, a fluorenyl group, a carbazolyl group, a dibenzofuranyl group, a dibenzothiophenyl group, and a dibenzosilolyl group, each substituted with at least one selected from deuterium, -F, -CD₃, -CD₂H, -CDH₂, -CF₃, -CF₂H,-CFH₂, a cyano group, nitro group, a C₁-C₁₀ alkyl group, a C₁-C₁₀ alkoxy group, a cyclopentyl group, a cyclopentyl group substituted with deuterium, a cyclohexyl group, a cyclohexyl group substituted with deuterium, a cycloheptyl group, a cycloheptyl group substituted with deuterium, a cyclooctyl group, a cyclooctyl group substituted with deuterium, a bicyclo[2.2.1]heptanyl group, an adamantanyl group, a norbonanyl group, a norbornenyl group, a cyclopentenyl group, a cyclohexenyl group, a cycloheptenyl group, a phenyl group, a C₁-C₂₀ alkylphenyl group, a naphthyl group, a pyridinyl group, a pyrimidinyl group, a fluorenyl group, a carbazolyl group, a dibenzofuranyl group, a dibenzothiophenyl group, dibenzosilolyl group, and -Si(Q₃₃)(Q₃₄)(Q₃₅),
Q₃₃ to Q₃₅ may each independently be selected from:
   -CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CH₃, -CD₂CD₂H, and -CD₂CDH₂;
   an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
   an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group and a naphthyl group, each substituted with at least one selected from deuterium, a C₁-C₁₀ alkyl group, and a phenyl group, but embodiments of the present disclosure are not limited thereto.

In Formulae 1 to 4, two, three, or four neighboring constituents selected from R₁₁ to R₁₅, two, three, or four neighboring constituents selected from R₂₁ to R₂₅, two, three, or four neighboring constituents selected from R₃₁ to R₃₅, and/or two, three, or four neighboring constituents selected from R₄₁ to R₄₅ may optionally be linked to form a four-coordinate, six-coordinate, or eight-coordinate ligand.

For example, in Formulae 1 to 4, two neighboring constituents R₁₃, two neighboring constituents R₂₃, two neighboring constituents R₃₃, and/or two neighboring constituents R₄₃ may optionally be linked to form a four-coordinate ligand, but embodiments of the present disclosure are not limited thereto.

In an embodiment, in Formulae 1 to 4, neighboring R₁₁ and R₁₃, neighboring R₂₁ and R₂₃, neighboring R₃₁ and R₃₃, and/or neighboring R₄₁ and R₄₃ may optionally be linked to form a four-coordinate ligand, but embodiments of the present disclosure are not limited thereto.

In an embodiment, in Formulae 1 to 4, neighboring R₁₄ and R₁₃, neighboring R₂₄ and R₂₃, neighboring R₃₄ and R₃₃, and/or neighboring R₄₄ and R₄₃ may optionally be linked to form a four-coordinate ligand, but embodiments of the present disclosure are not limited thereto.

In an embodiment, in Formulae 1 to 4, neighboring R₁₅ and R₁₃, neighboring R₂₅ and R₂₃, neighboring R₃₅ and R₃₃, and/or neighboring R₄₅ and R₄₃ may optionally be linked to form a four-coordinate ligand, but embodiments of the present disclosure are not limited thereto.

For example, in Formulae 1 to 4, three neighboring constituents R₁₃, three neighboring constituents R₂₃, three neighboring constituents R₃₃, and/or three neighboring constituents R₄₃ may optionally be linked to form a six-coordinate ligand, but embodiments of the present disclosure are not limited thereto.

In an embodiment, two, three, or four neighboring constituents selected from R₁₁ to R₁₅, two, three, or four neighboring constituents selected from R₂₁ to R₂₅, two, three, or four neighboring constituents selected from R₃₁ to R₃₅, and/or two, three, or four neighboring constituents selected from R₄₁ to R₄₅ may be linked via L₁₃ to form a four-coordinate ligand, L₁₃ may be selected from *-O-*', *-S-*', *-[C(R₁₉)(R₂₀)]ₖ₁₁-*', *-[Si(R₁₉)(R₂₀)]ₖ₁₁-*', and a substituted or unsubstituted benzene group, R₁₉ and R₂₀ are each independently the same as described in connection with R₁₁, and k11 may be selected from 1, 2, and 3, but embodiments of the present disclosure are not limited thereto.

In an embodiment, two, three, or four neighboring constituents selected from R₁₁ to R₁₅, two, three, or four neighboring constituents selected from R₂₁ to R₂₅, two, three, or four neighboring constituents selected from R₃₁ to R₃₅, and/or two, three, or four neighboring constituents selected from R₄₁ to R₄₅ may be linked via L₁₄ to form a six-coordinate ligand, L₁₄ may be selected from 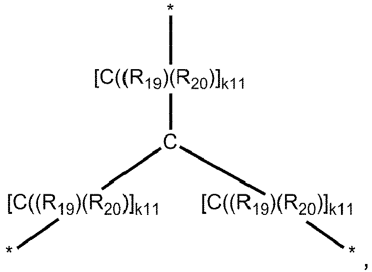 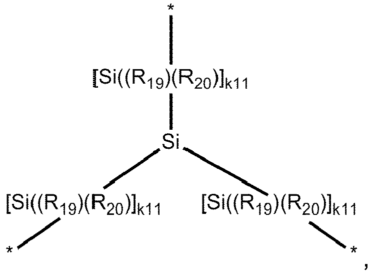 and a substituted or unsubstituted benzene group, R₁₉ and R₂₀ are each independently the same as described in connection with R₁₁, and k11 may be selected from 1, 2, and 3, but embodiments of the present disclosure are not limited thereto.

n11 in Formula 1 indicates the number of ligands represented by 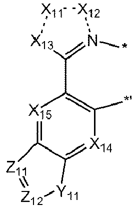 (wherein * and *' indicate a binding site to M₁₁ in Formula 1), and n11 may be selected from 1, 2, 3, and 4. When n11 is two or more, the ligands represented by 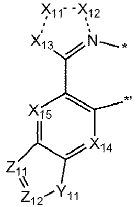 in Formula 1 may be identical to or different from each other.

n21 in Formula 2 indicates the number of ligands represented by 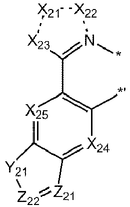 (wherein * and *' each indicate a binding site to M₂₁ in Formula 2), and n21 may be selected from 1, 2, 3, and 4. When n21 is two or more, the ligands represented by 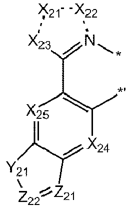 in Formula 2 may be identical to or different from each other.

n31 in Formula 3 indicates the number of ligands represented by 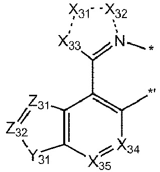 (wherein * and *' each indicate a binding site to M₃₁ in Formula 3), and n31 may be 1, 2, 3, and 4. When n31 is two or more, the ligands represented by 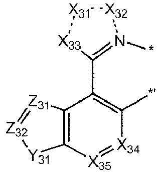 in Formula 3 may be identical to or different from each other.

n41 in Formula 4 indicates the number of ligands represented by 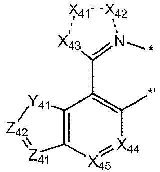 (wherein * and *' each indicate a binding site to M₄₁ in Formula 4), and n41 may be selected from 1, 2, 3, and 4. When n41 is two or more, the ligands represented by 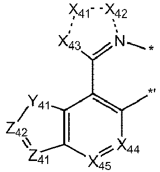 in Formula 4 may be identical to or different from each other.

For example, n11, n21, n31, and n41 in Formulae 1 to 4 may each independently be selected from 1, 2, and 3, but embodiments of the present disclosure are not limited thereto.

n12 in Formula 1 indicates the number of constituents L₁₂, and n12 may be selected from 0, 1, 2, 3, and 4. When n12 is two or more, two or more constituents L₁₂ in Formula 1 may be identical to or different from each other.

n22 in Formula 2 indicates the number of constituents L₂₂, and n22 may be selected from 0, 1, 2, 3, and 4. When n22 is two or more, two or more constituents L₂₂ in Formula 2 may be identical to or different from each other.

n32 in Formula 3 indicates the number of constituents L₃₂, and n32 may be selected from 0, 1, 2, 3, and 4. When n32 is two or more, two or more constituents L₃₂ in Formula 3 may be identical to or different from each other.

n42 in Formula 4 indicates the number of constituents L₄₂, and n42 may be selected from 0, 1, 2, 3, and 4. When n42 is two or more, two or more constituents L₄₂ in Formula 4 may be identical to or different from each other.

For example, n12, n22, n32, and n42 in Formulae 1 to 4 may each independently be selected from 0, 1, and 2, but embodiments of the present disclosure are not limited thereto.

In an embodiment, M₁₁, M₂₁, M₃₁, and M₄₁ in Formulae 1 to 4 may each be Ir,
n11, n21, n31, and n41 may each independently be 2 or 3, and
n12, n22, n32, and n42 may each independently be selected from 0, 1, and 2, but embodiments of the present disclosure are not limited thereto.

L₁₂, L₂₂, L₃₂, and L₄₂ in Formulae 1 to 4 may each independently be selected from a one-coordinate ligand, a two-coordinate ligand, and a three-coordinate ligand.

For example, L₁₂, L₂₂, L₃₂, and L₄₂ in Formulae 1 to 4 may each independently be selected from one-coordinate ligands, for example, I⁻, Br⁻, Cl⁻, sulfide, nitrate, azide, hydroxide, cyanate, isocyanate, thiocyanate, water, acetonitrile, pyridine, ammonia, carbon monoxide, P(Ph)₃, P(Ph)₂CH₃, PPh(CH₃)₂, and P(CH₃)₃, but embodiments of the present disclosure are not limited thereto.

In an embodiment, L₁₂, L₂₂, L₃₂, and L₄₂ in Formulae 1 to 4 may each independently be selected from two-coordinate ligands, for example, oxalate, acetylacetonate, picolinic acid, 1,2-bis(diphenylphosphino)ethane, 1,1-bis(diphenylphosphino)methane, glycinate, and ethylenediamine, but embodiments of the present disclosure are not limited thereto.

In an embodiment, L₁₂, L₂₂, L₃₂, and L₄₂ in Formulae 1 to 4 may each be a ligand represented by one of Formulae 7-1 to 7-11, but embodiments of the present disclosure are not limited thereto:

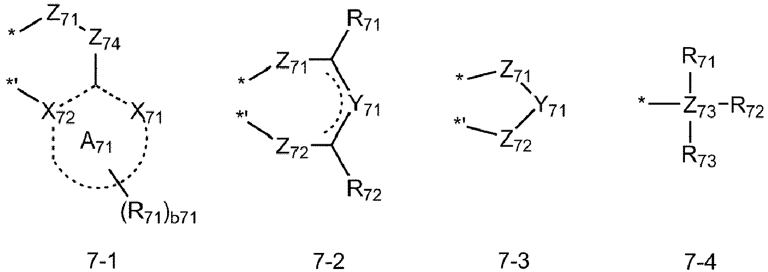

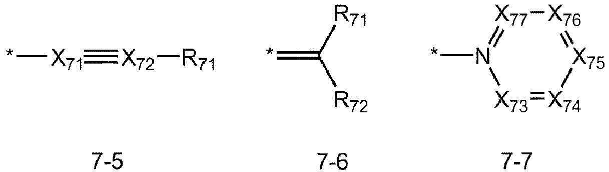

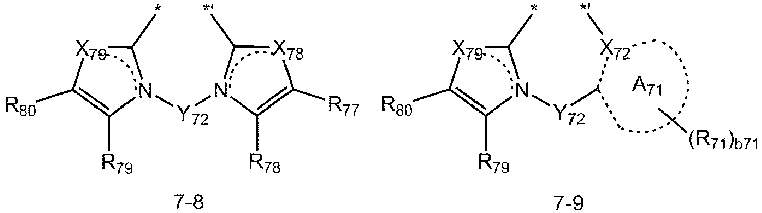

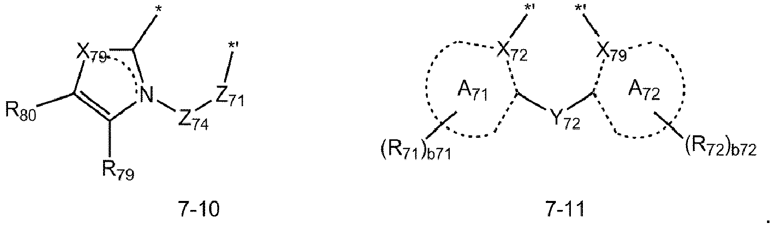

In Formulae 7-1 to 7-11,
A₇₁ and A₇₂ may each independently be a C₅-C₂₀ carbocyclic group or a C₁-C₂₀ heterocyclic group,
X₇₁ and X₇₂ may each independently be C or N,
X₇₃ may be N or C(Q₇₃), X₇₄ may be N or C(Q₇₄), X₇₅ may be N or C(Q₇₅), X₇₆ may be N or C(Q₇₆), and X₇₇ may be N or C(Q₇₇),
X₇₈ may be O, S, or N(Q₇₈), and X₇₉ may be O, S, or N(Q₇₉),
Y₇₁ and Y₇₂ may each independently be selected from a single bond, a double bond, a substituted or unsubstituted C₁-C₅ alkylene group, a substituted or unsubstituted C₂-C₅ alkenylene group, and a substituted or unsubstituted C₆-C₁₀ arylene group,
Z₇₁ and Z₇₂ may each independently be selected from N, O, N(R₇₄), P(R₇₅)(R₇₆), and As(R₇₅)(R₇₆),
Z₇₃ may be P or As,
Z₇₄ may be CO or CH₂,
R₇₁ to R₈₀ and Q₇₃ to Q₇₉ may each independently be selected from hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₉ cycloalkyl group, a substituted or unsubstituted C₁-C₁₀ heterocycloalkyl group, a substituted or unsubstituted C₃-C₁₉ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₇-C₆₀ arylalkyl group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted C₂-C₆₀ heteroarylalkyl group, a substituted or unsubstituted monovalent non-aromatic condensed polycyclic group, and a substituted or unsubstituted monovalent non-aromatic condensed heteropolycyclic group, wherein R₇₁ and R₇₂ may optionally be linked to form a ring, R₇₇ and R₇₈ may optionally be linked to form a ring, and R₇₈ and R₇₉ may optionally be linked to form a ring, and R₇₉ and R₈₀ may optionally be linked to form a ring,
b71 and b72 may each independently be selected from 1, 2, and 3, and
* and *' each indicate a binding site to a neighboring atom.

For example, A₇₁ and A₇₂ in Formula 7-1 may each independently be selected from a benzene group, a naphthalene group, an imidazole group, a benzimidazole group, a pyridine group, a pyrimidine group, a triazine group, a quinoline group, and an isoquinoline group, but embodiments of the present disclosure are not limited thereto.

For example, X₇₂ and X₇₉ in Formula 7-1 may each be N, but embodiments of the present disclosure are not limited thereto.

For example, in Formula 7-7, X₇₃ may be C(Q₇₃), X₇₄ may be C(Q₇₄), X₇₅ may be C(Q₇₅), X₇₆ may be C(Q₇₆), and X₇₇ may be C(Q₇₇), but embodiments of the present disclosure are not limited thereto.

For example, in Formula 7-8, X₇₈ may be N(Q₇₈) and X₇₉ may be N(Q₇₉), but embodiments of the present disclosure are not limited thereto.

For example, Y₇₁ and Y₇₂ in Formula 7-2, 7-3 and 7-8 may each independently be a substituted or unsubstituted methylene group or a substituted or unsubstituted phenylene group, but embodiments of the present disclosure are not limited thereto.

For example, Z₇₁ and Z₇₂ in Formulae 7-1 and 7-2 may each be O, but embodiments of the present disclosure are not limited thereto.

For example, Z₇₃ in Formula 7-4 may be P, but embodiments of the present disclosure are not limited thereto.

For example, R₇₁ to R₈₀ and Q₇₃ to Q₇₉ in Formulae 7-1 to 7-8 may each independently be selected from:
hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a phenyl group, a naphthyl group, a pyridinyl group, and a pyrimidinyl group;
a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, and an imidazopyridinyl group; and
a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, and an imidazopyridinyl group, each substituted with at least one selected from deuterium, -F, -CI, -Br, -I, -CD₃,-CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, and an imidazopyridinyl group,
but embodiments of the present disclosure are not limited thereto.

In an embodiment, L₁₂, L₂₂, L₃₂, and L₄₂ in Formulae 1 to 4 may each be a ligand represented by one of Formulae 5-1 to 5-116 and 8-1 to 8-23, but embodiments of the present disclosure are not limited thereto:

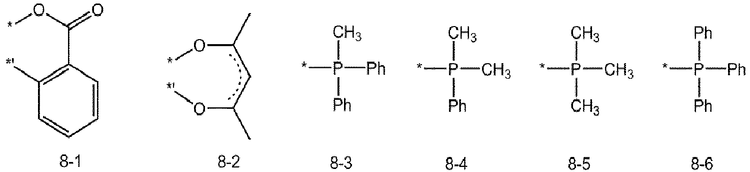

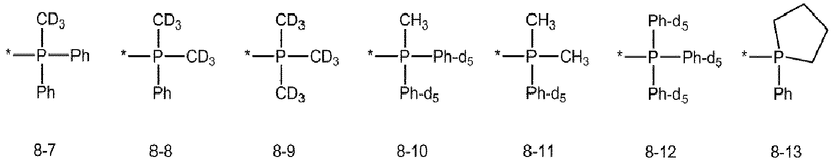

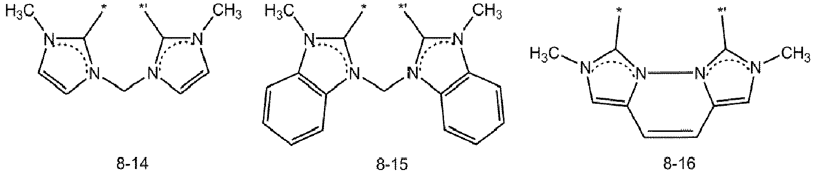

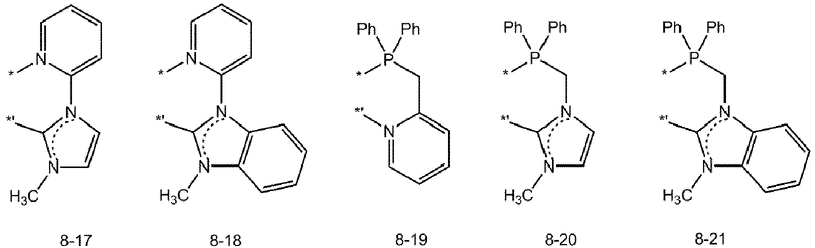

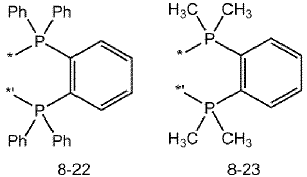

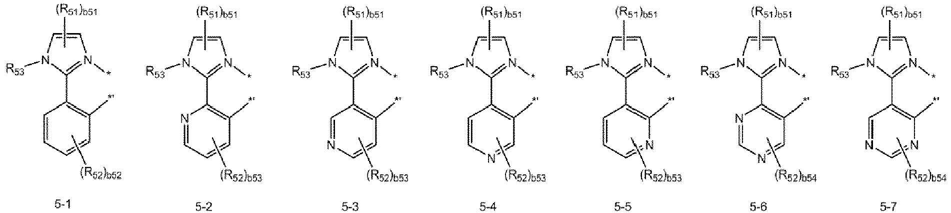

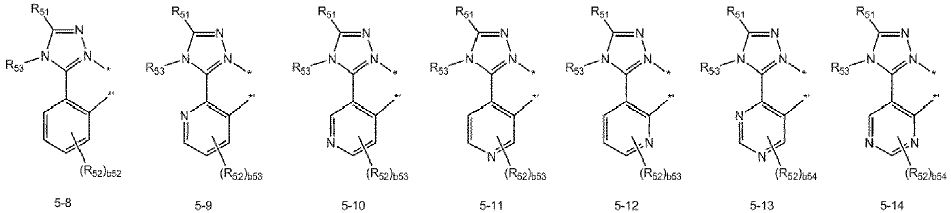

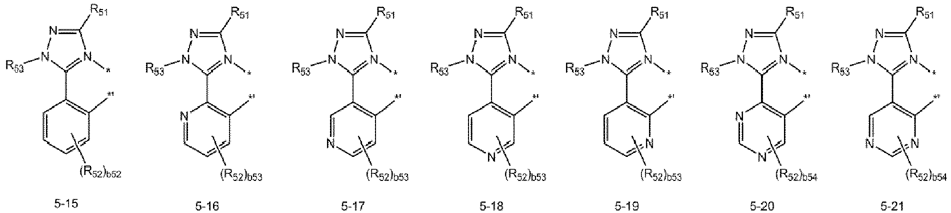

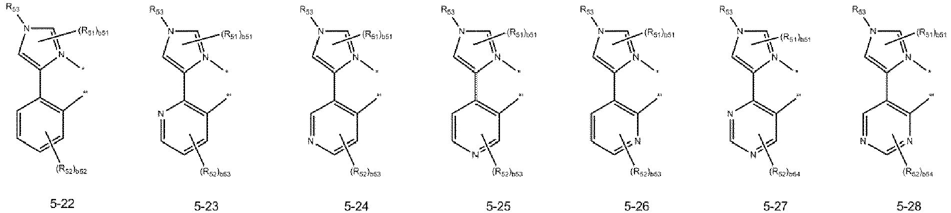

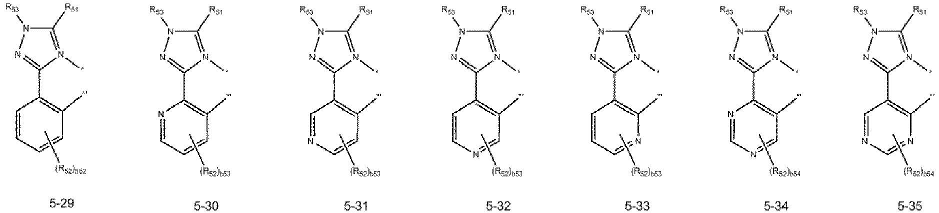

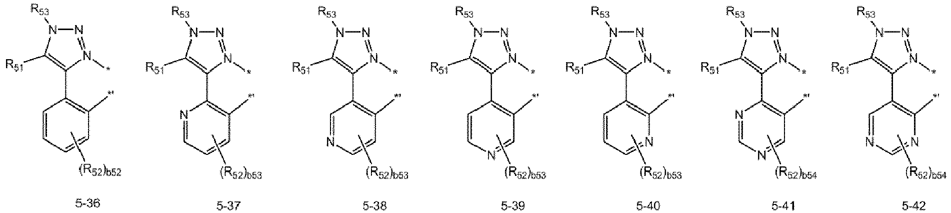

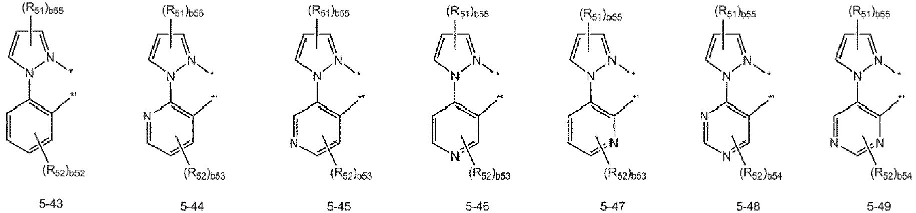

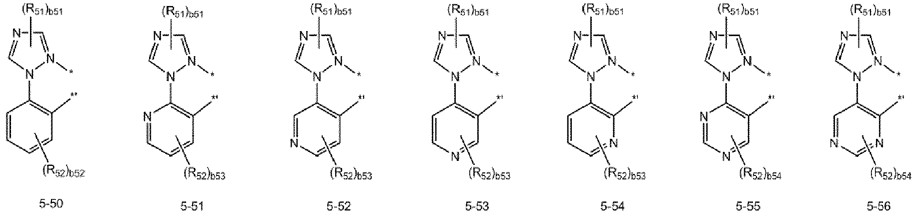

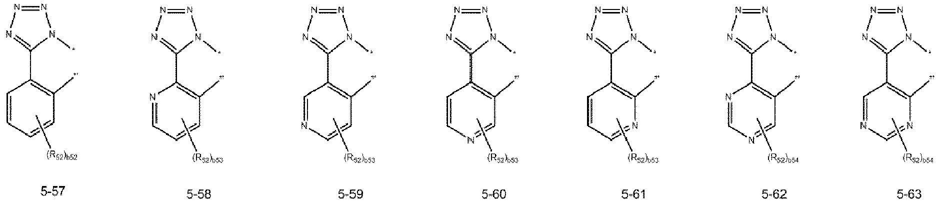

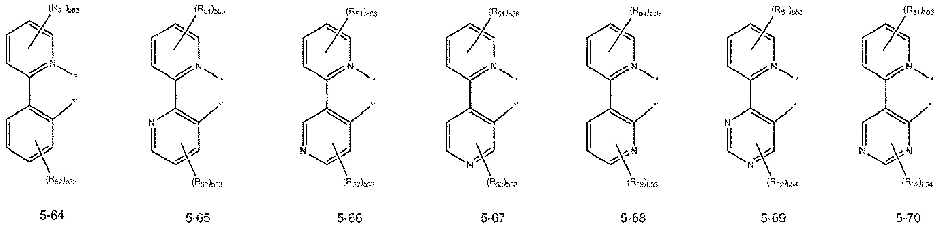

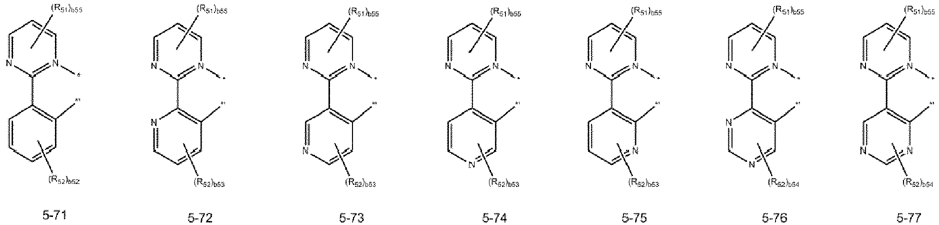

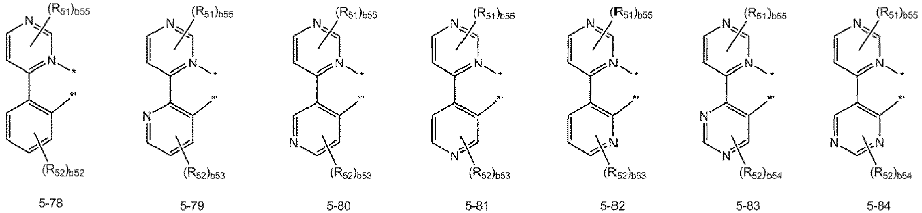

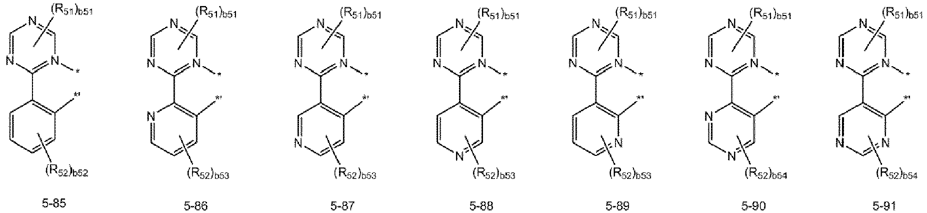

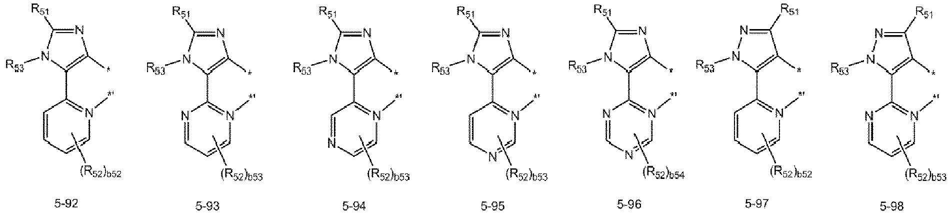

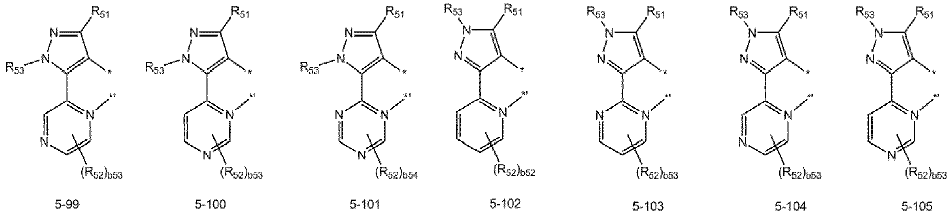

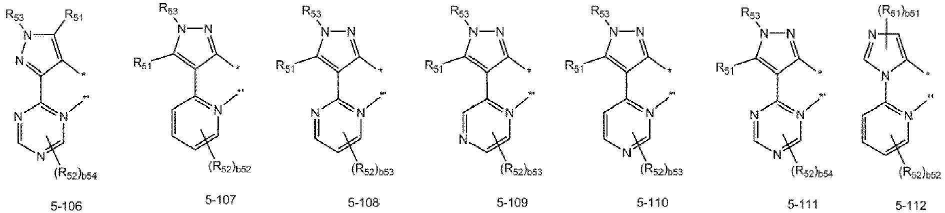

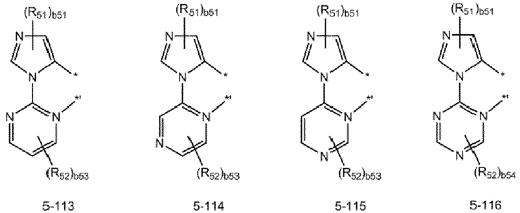

In Formulae 5-1 to 5-116 and 8-1 to 8-23,
R₅₁ to R₅₃ may each independently be selected from:
   hydrogen, -F, a cyano group, a nitro group, a methyl group, an ethyl group, a propyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decanyl group, an iso-decanyl group, a sec-decanyl group, a tert-decanyl group, a methoxy group, an ethoxy group, a propoxy group, a butoxy group, a pentoxy group, a phenyl group, a naphthyl group, a pyridinyl group, a pyrimidinyl group, a triazinyl group, a dibenzofuranyl group, and a dibenzothiophenyl group; and
   a methyl group, an ethyl group, a propyl group, an n-butyl group, an iso-butyl group, a sec-butyl group, a tert-butyl group, an n-pentyl group, an iso-pentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decanyl group, an iso-decanyl group, a sec-decanyl group, a tert-decanyl group, a methoxy group, an ethoxy group, a propoxy group, a butoxy group, a pentoxy group, a phenyl group, a naphthyl group, a pyridinyl group, a pyrimidinyl group, a triazinyl group, a dibenzofuranyl group, and a dibenzothiophenyl group, each substituted with at least one selected from -F, a cyano group, and a nitro group,
b51 and b54 may each independently be 1 or 2,
b53 and b55 may each independently be selected from 1, 2, and 3,
b52 may be selected from 1, 2, 3, and 4,
Ph indicates a phenyl group,
Ph-d5 is a phenyl group in which all hydrogen atoms are substituted with deuterium, and
* and *' each indicate a binding site to a neighboring atom.

The organometallic compound represented by one of Formulae 1 to 4 may be represented by one of Formulae 1-1 to 1-72, 2-1 to 2-72, 3-1 to 3-72, and 4-1 to 4-72, but embodiments of the present disclosure are not limited thereto:

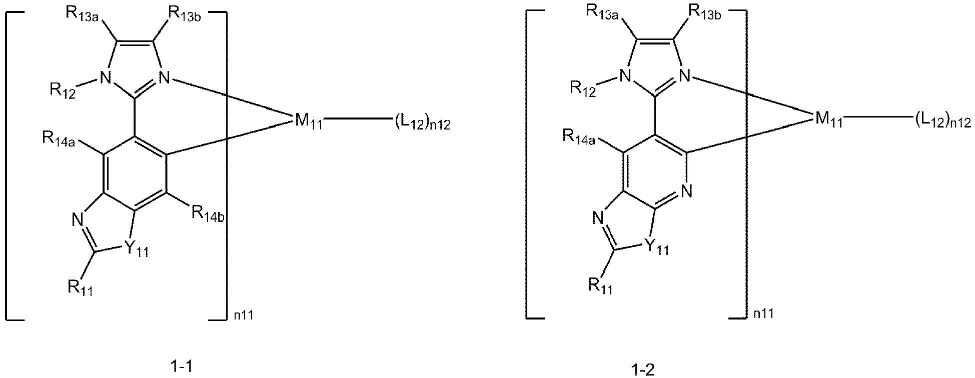

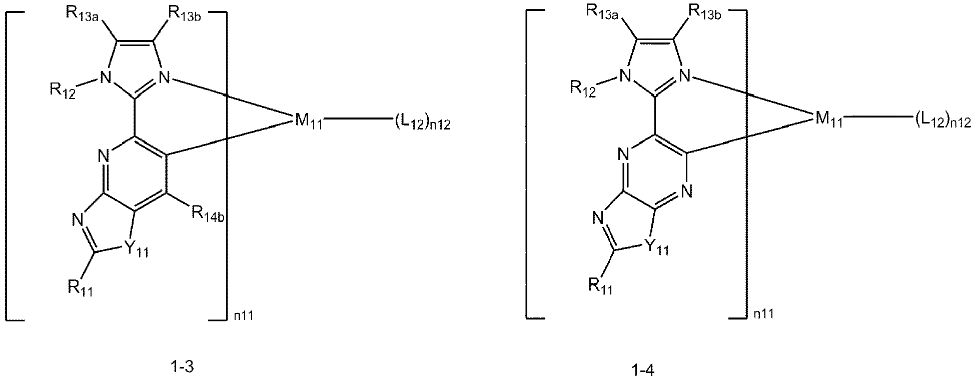

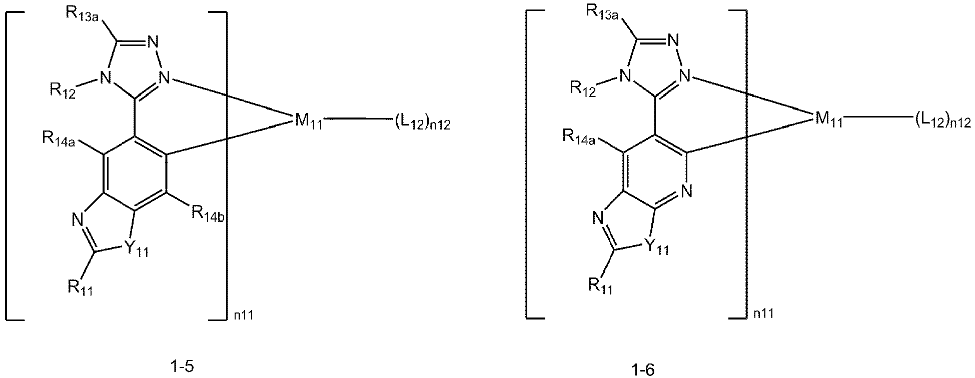

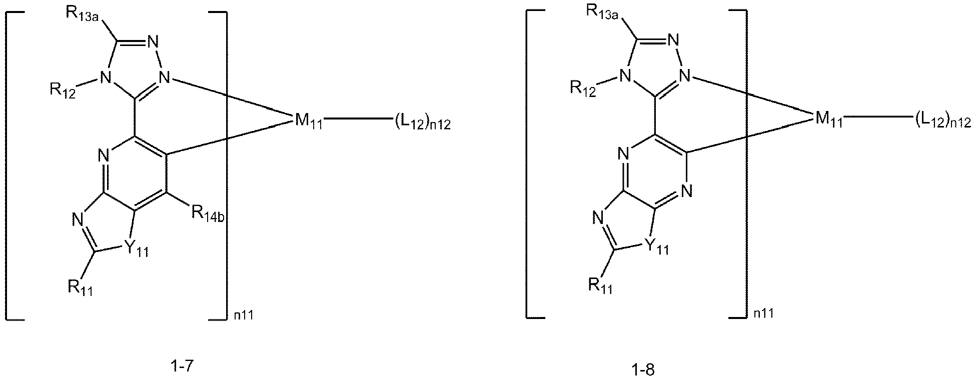

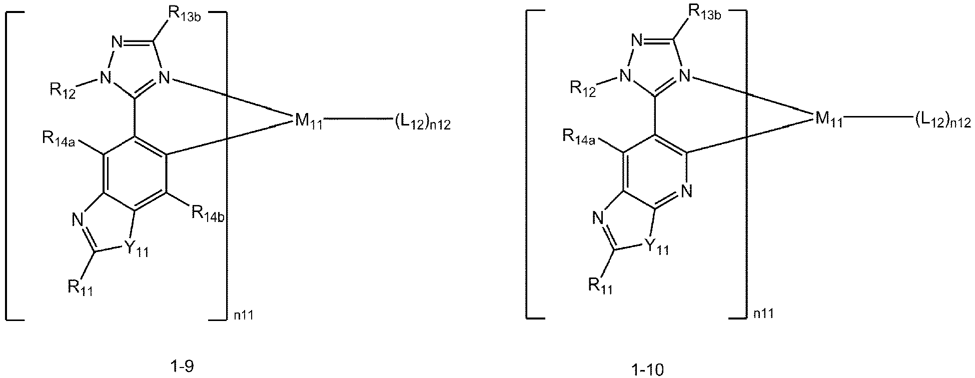

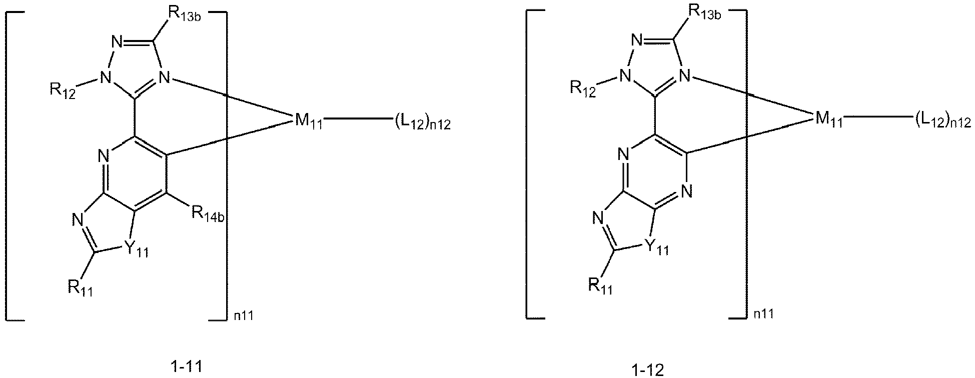

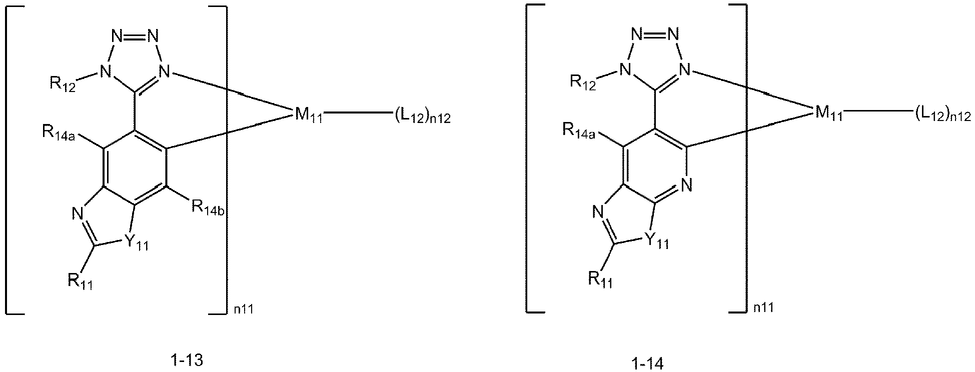

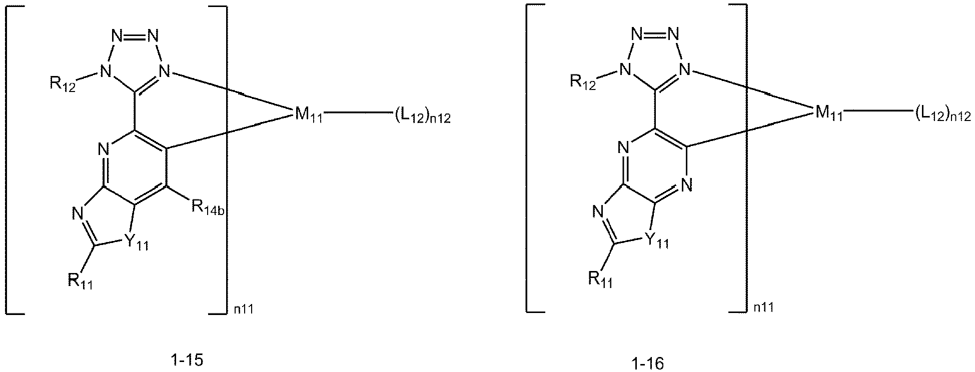

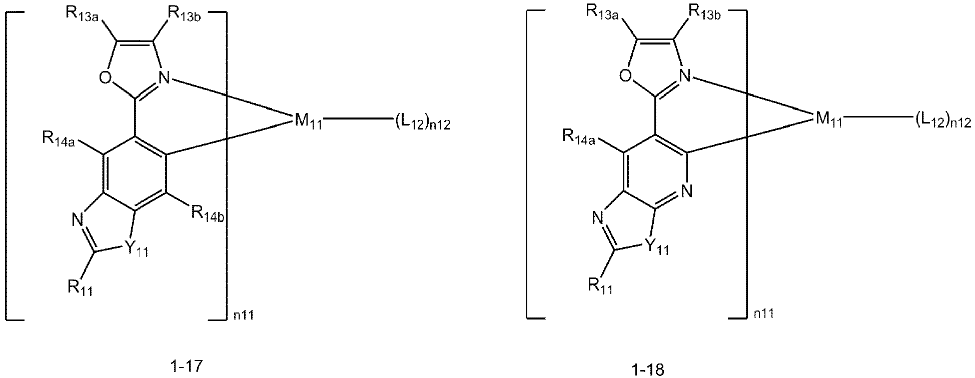

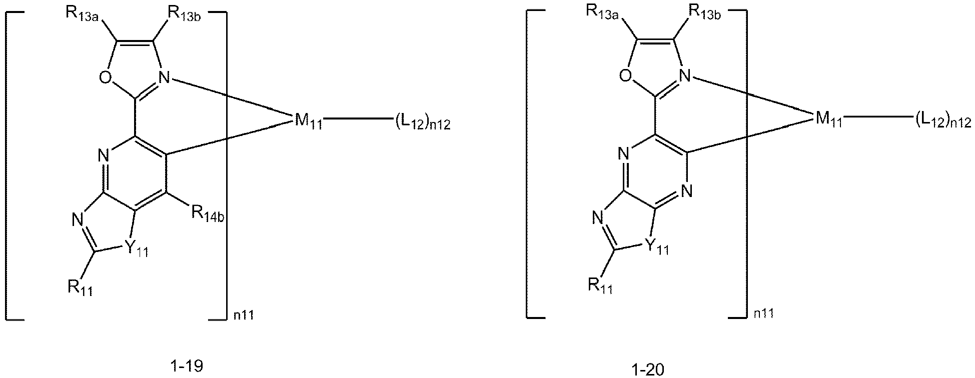

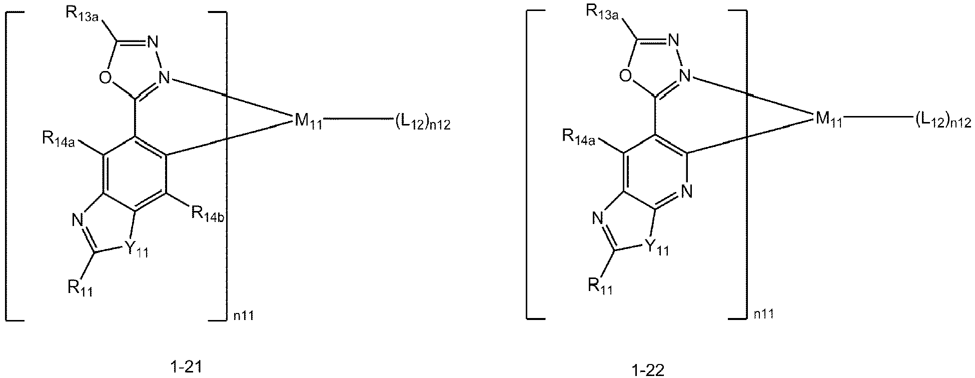

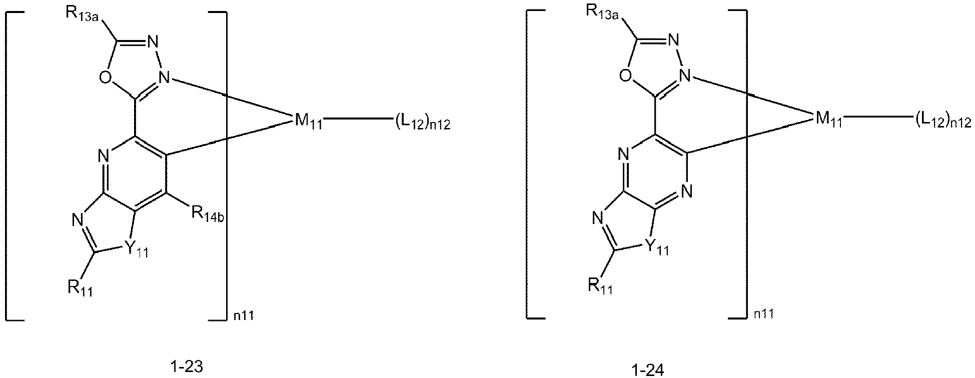

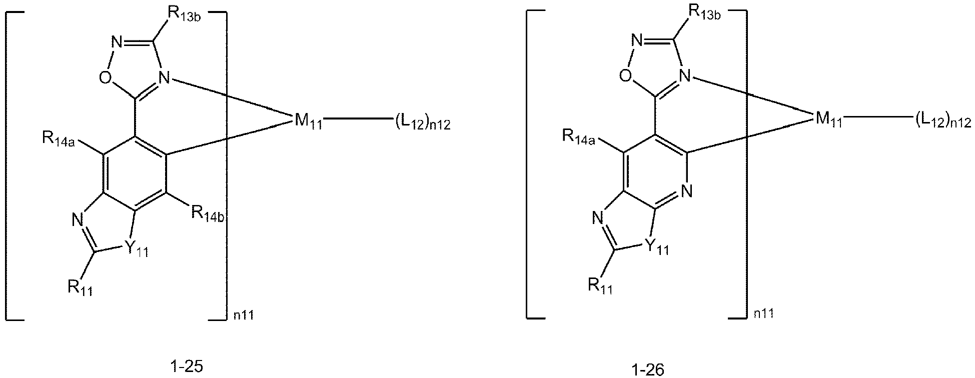

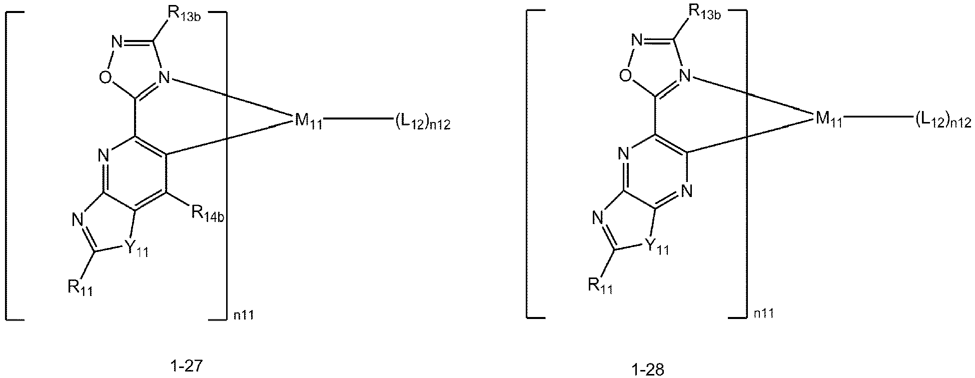

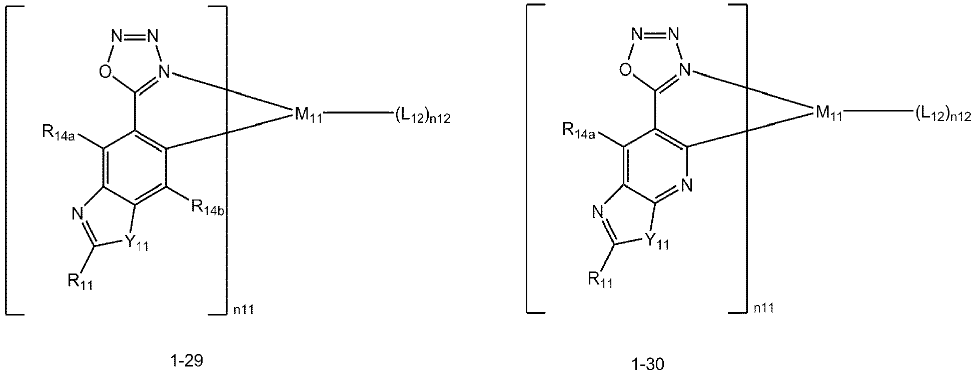

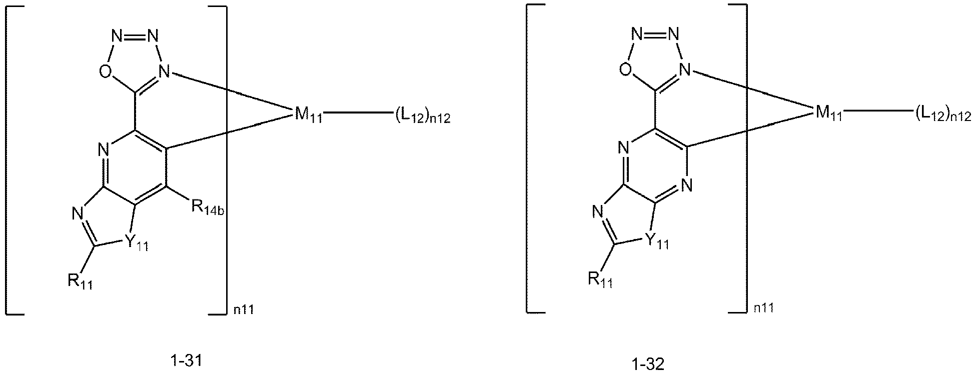

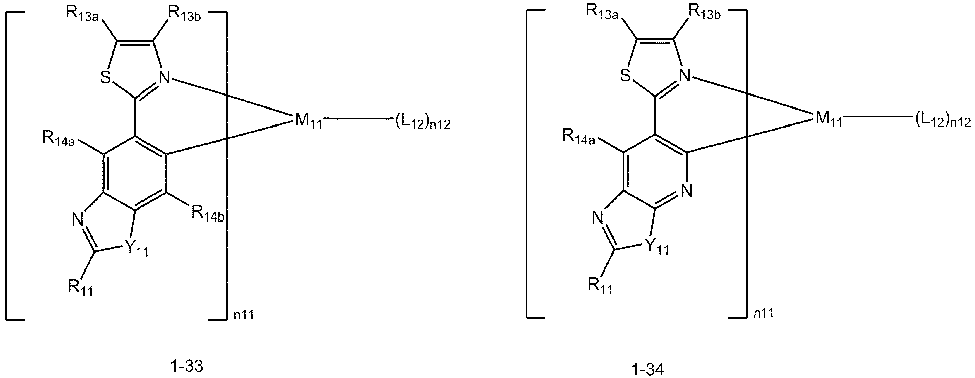

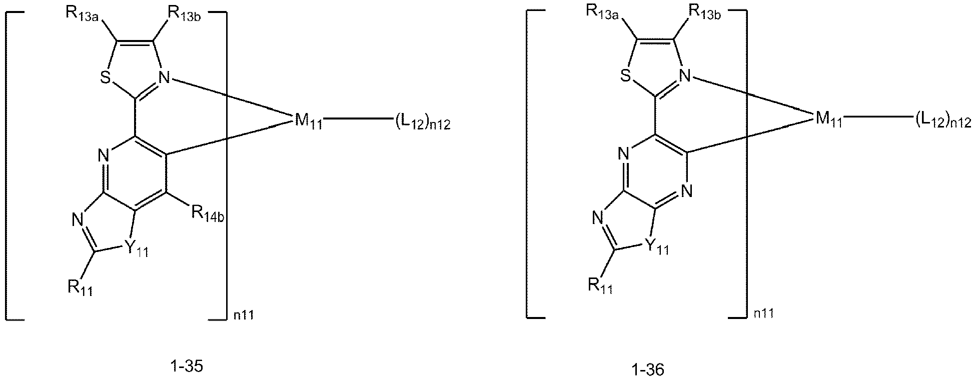

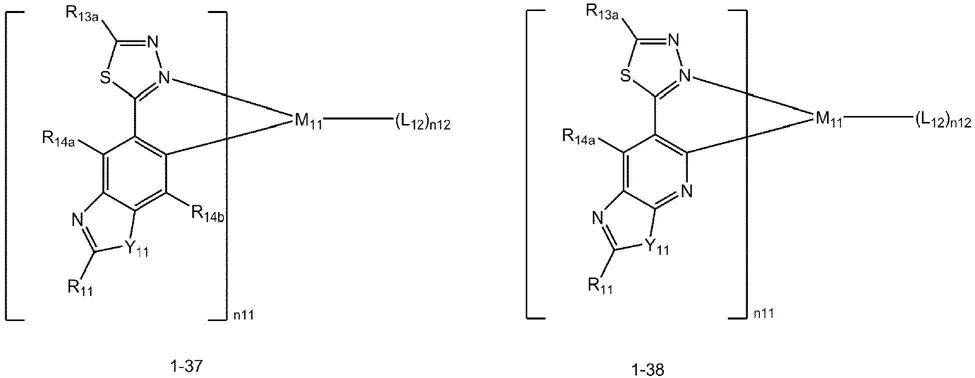

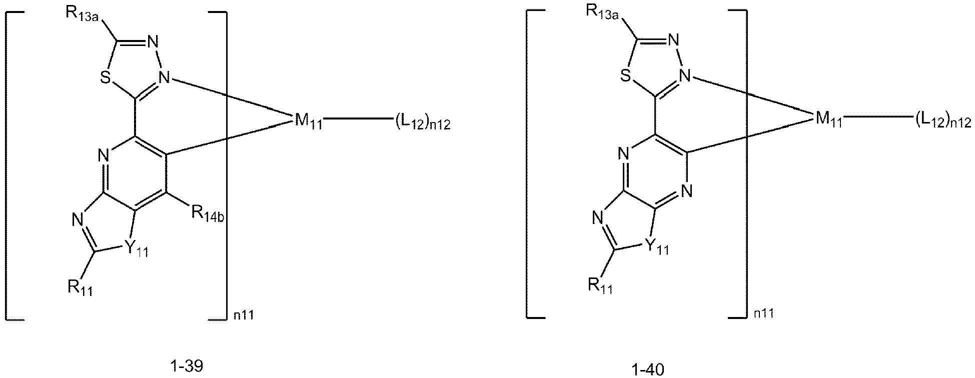

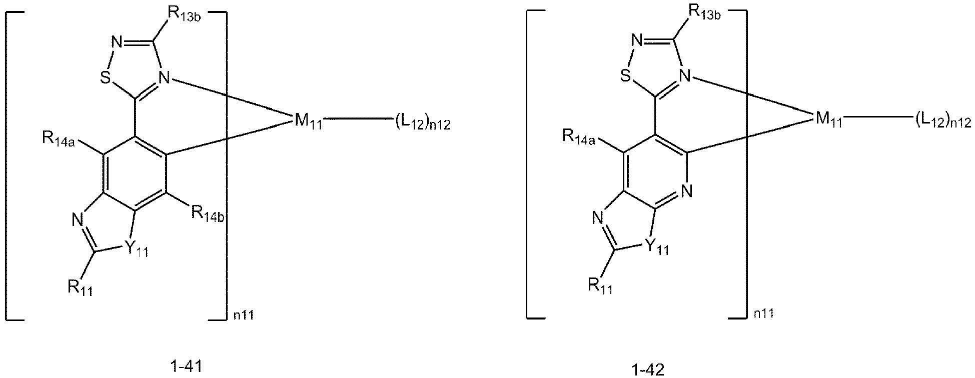

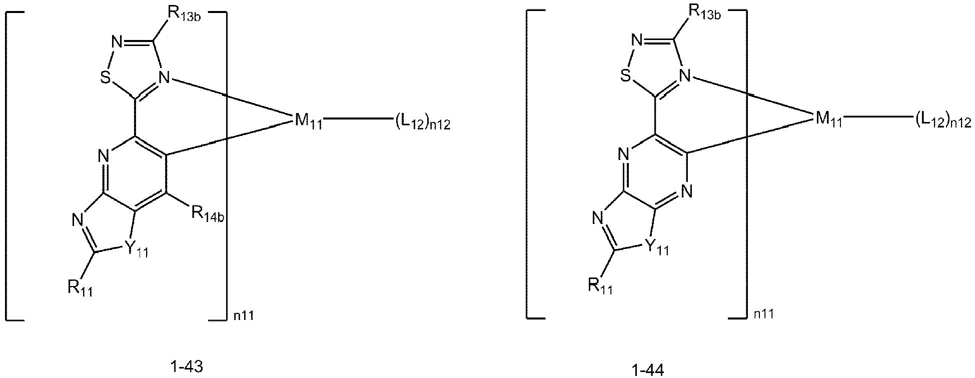

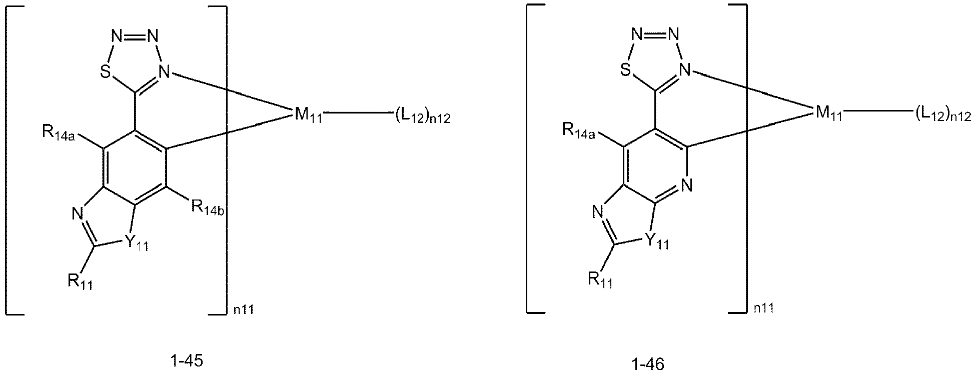

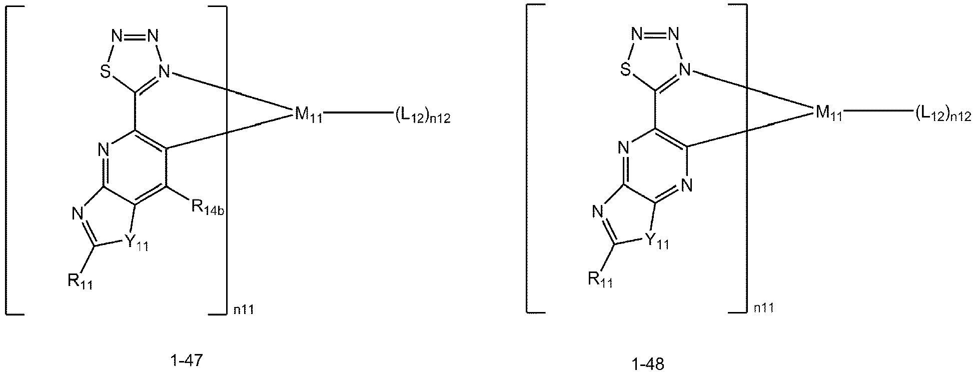

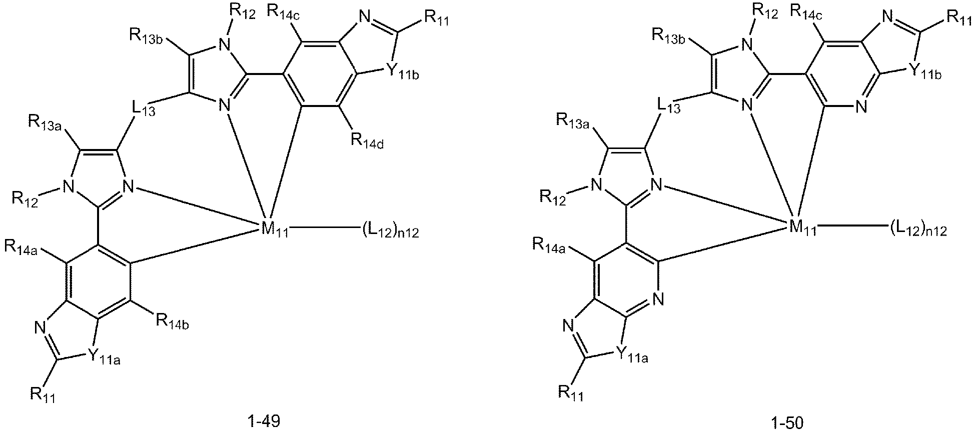

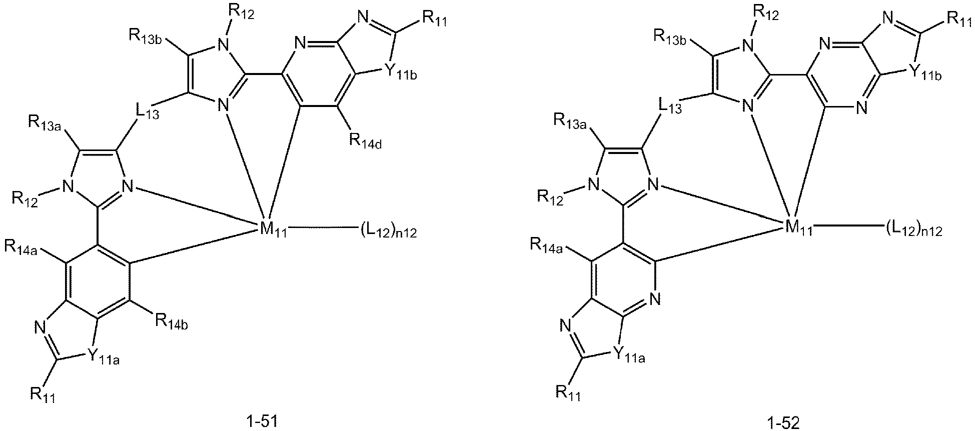

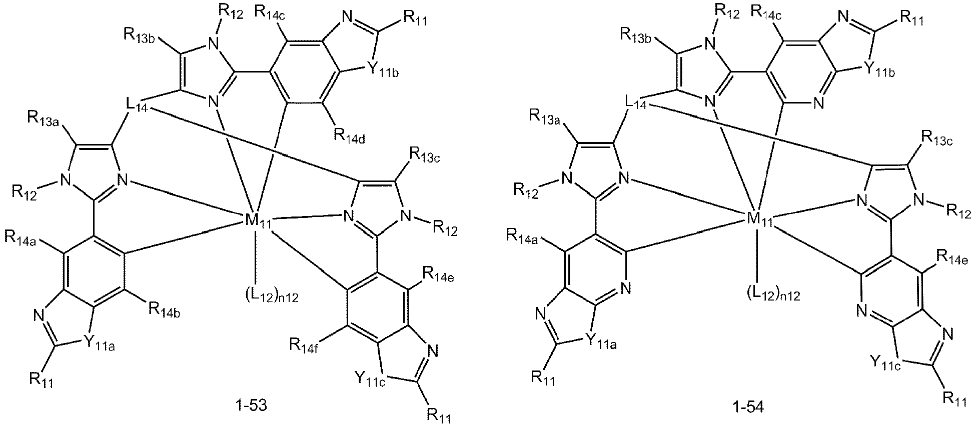

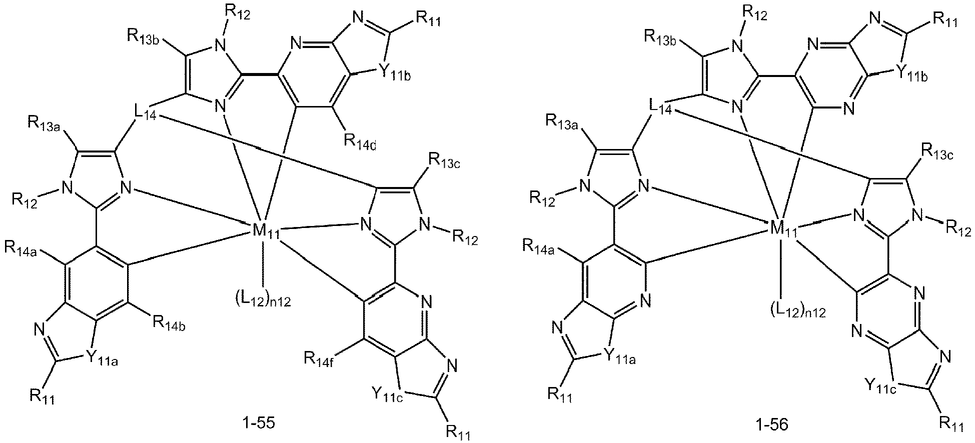

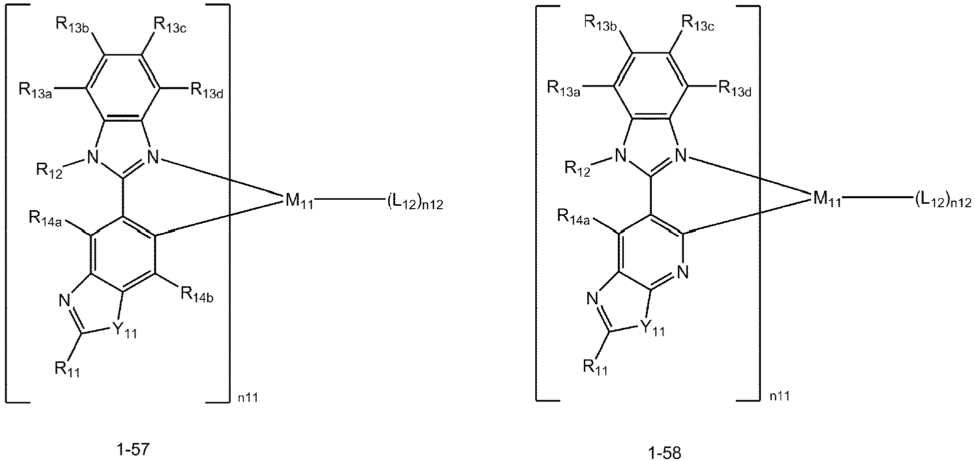

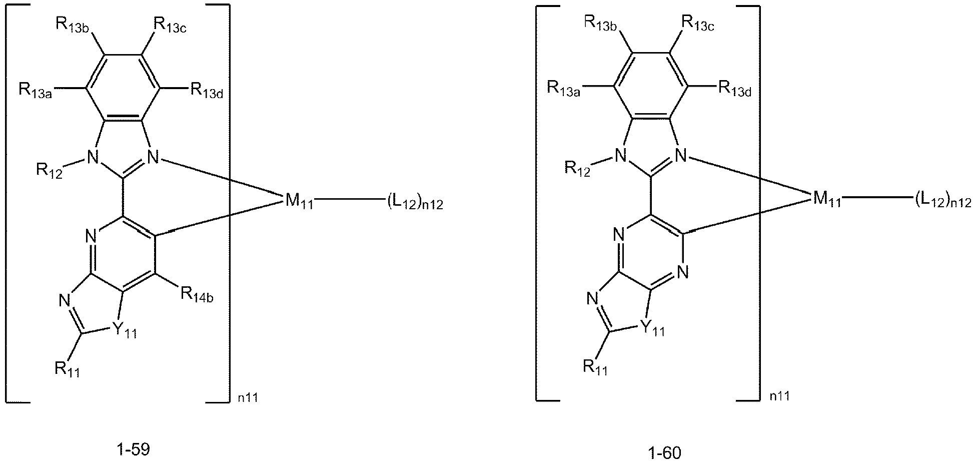

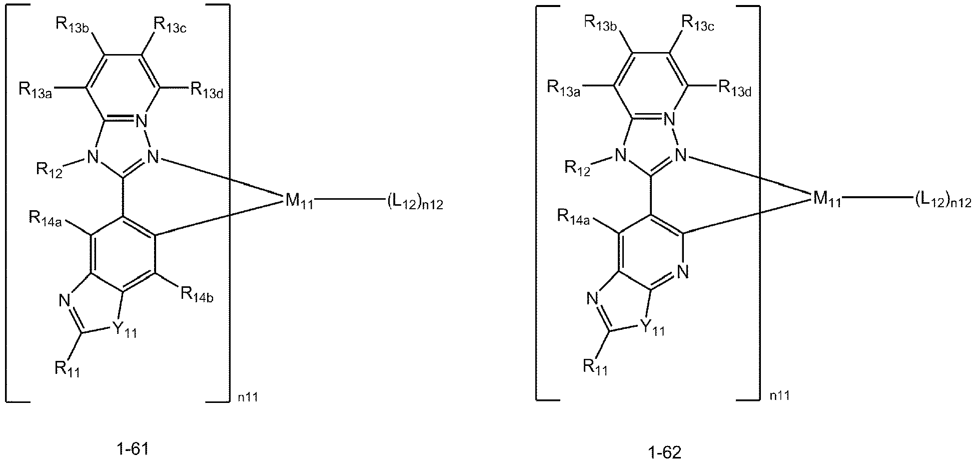

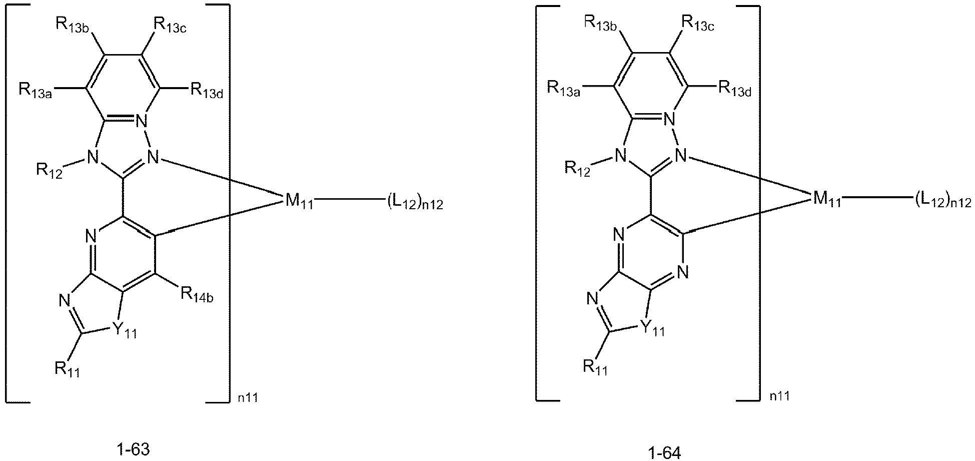

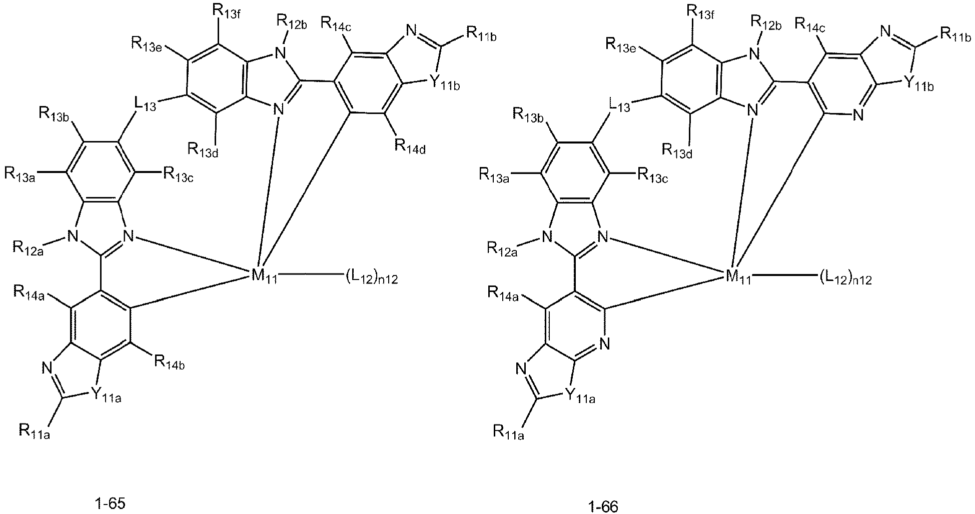

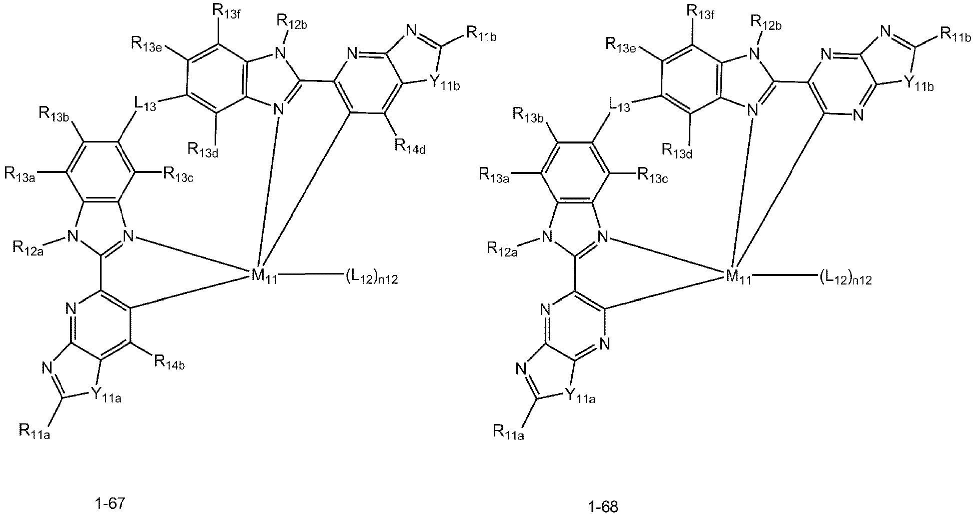

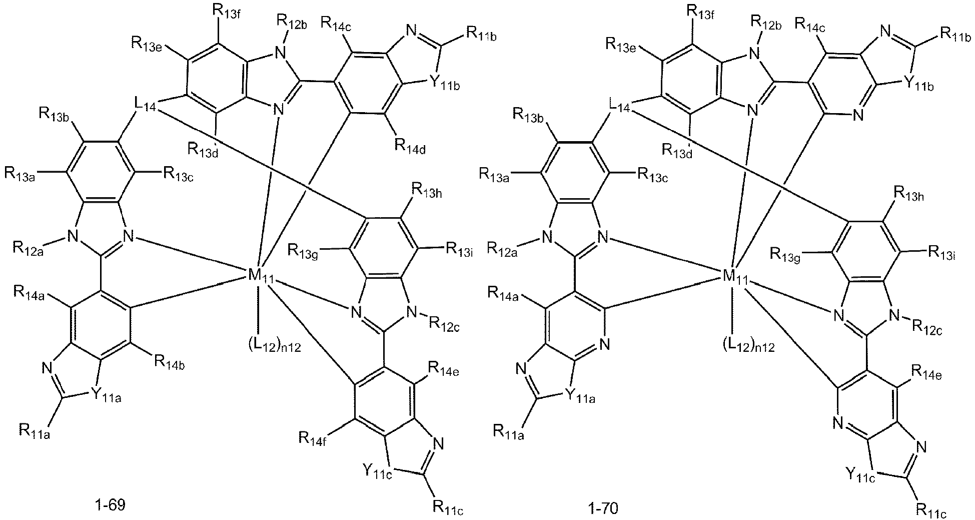

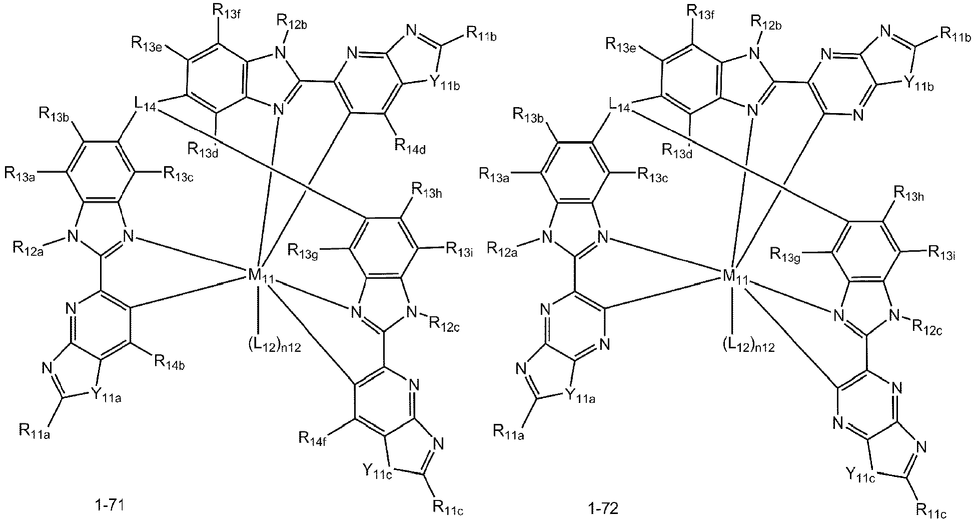

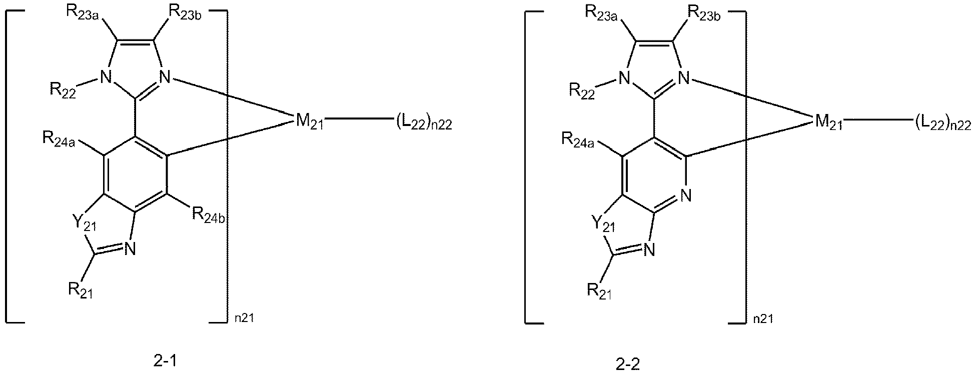

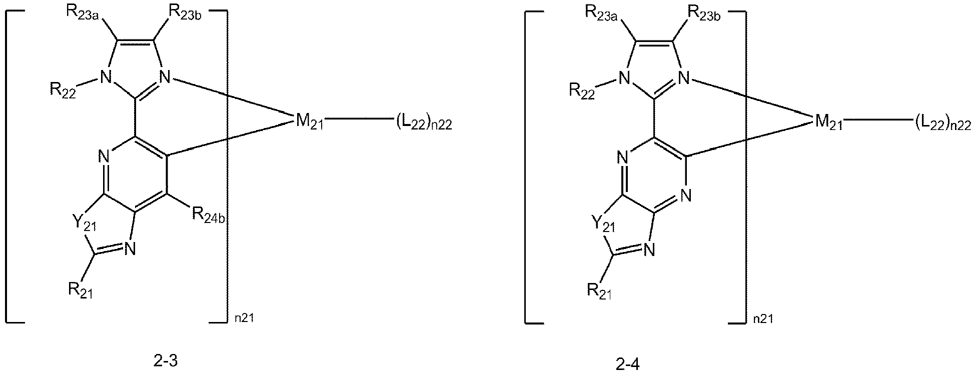

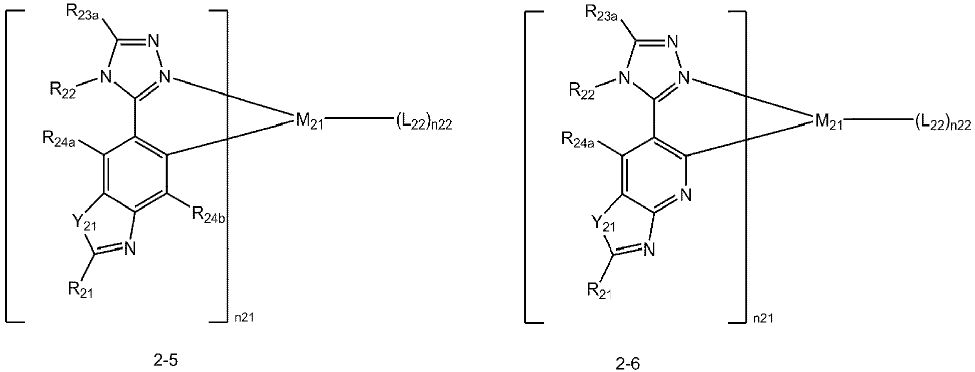

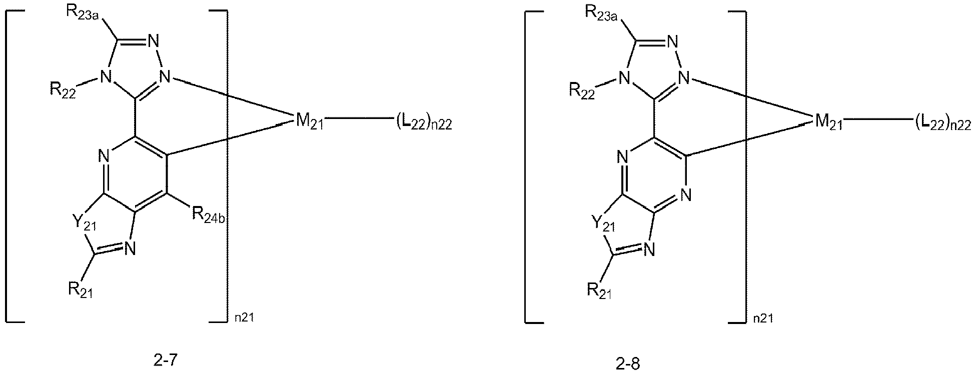

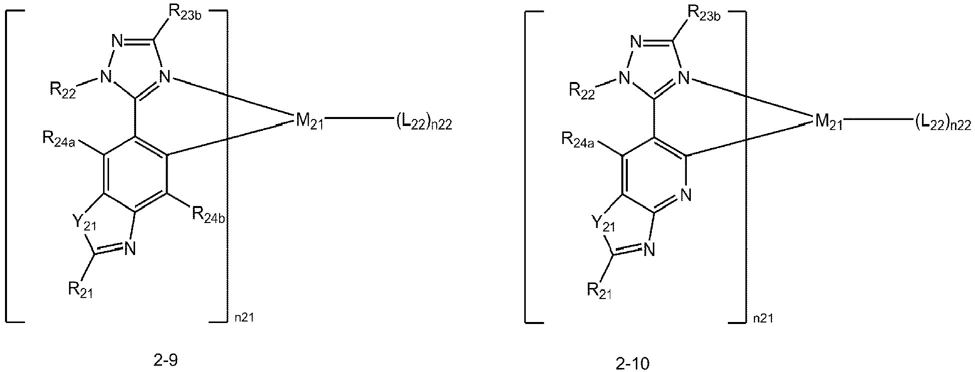

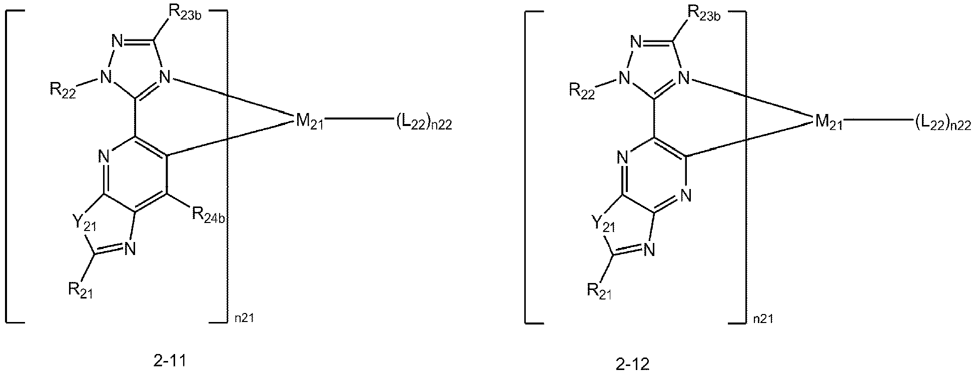

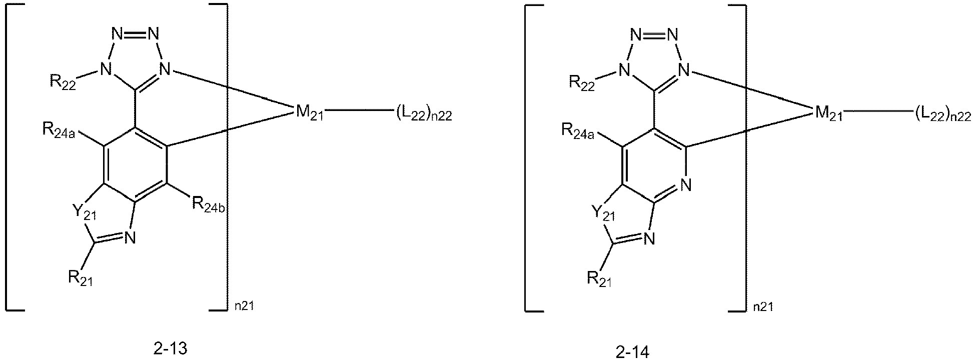

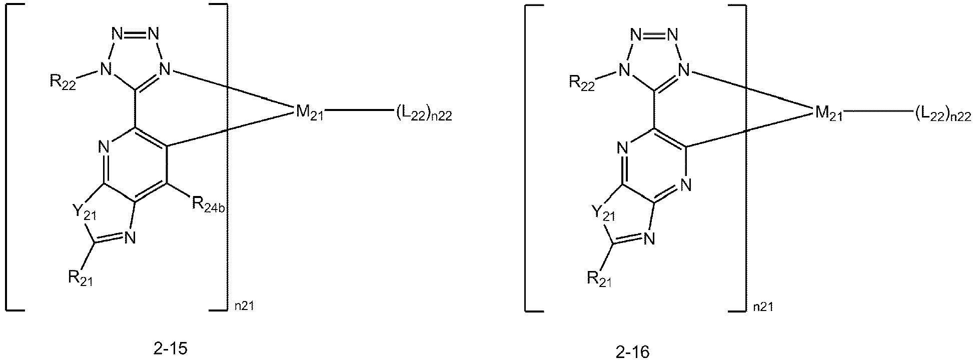

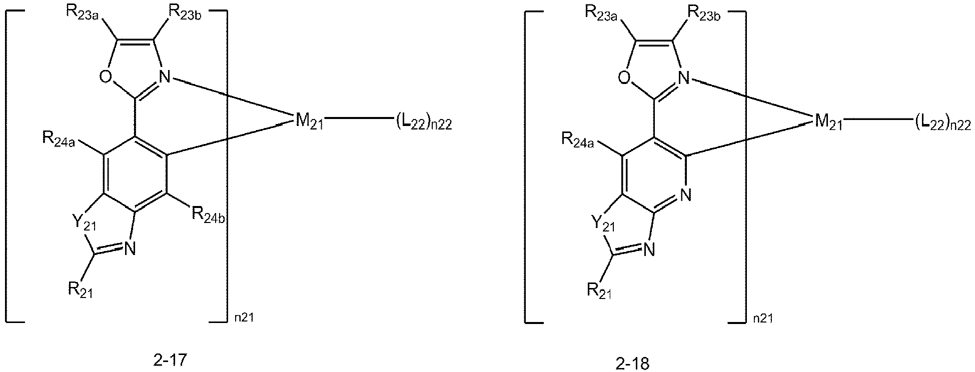

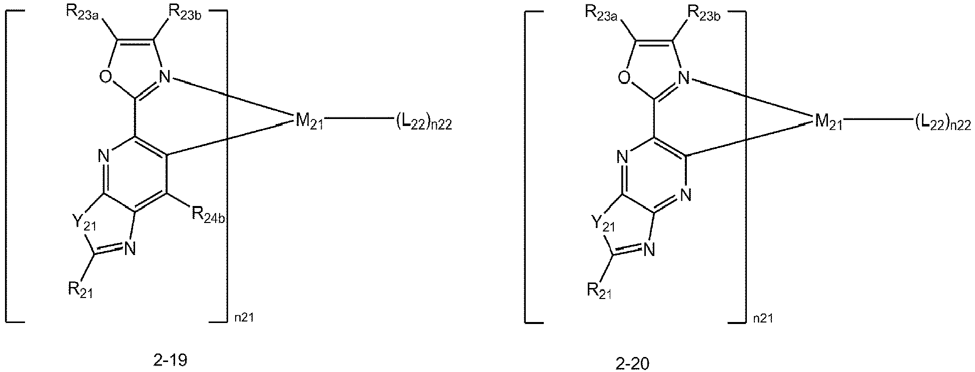

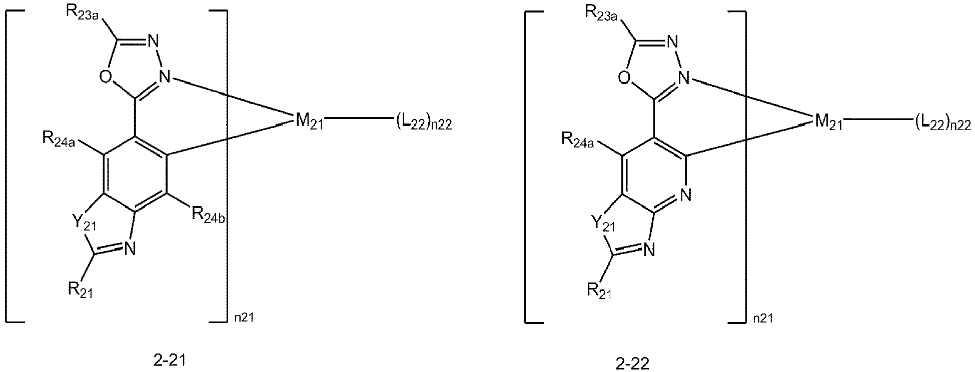

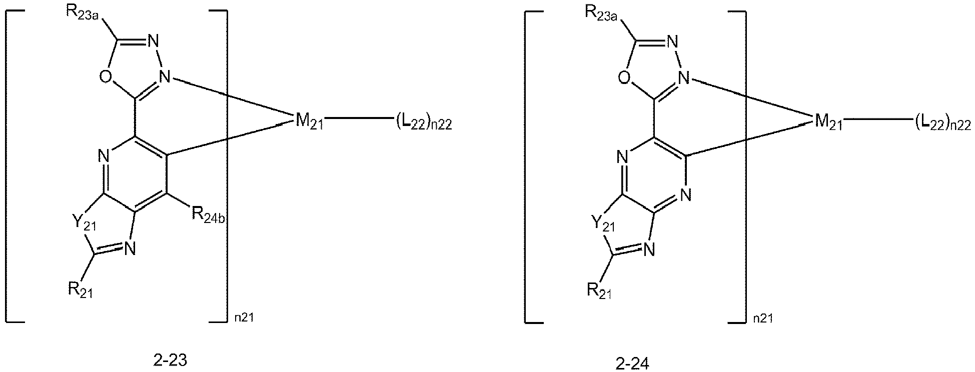

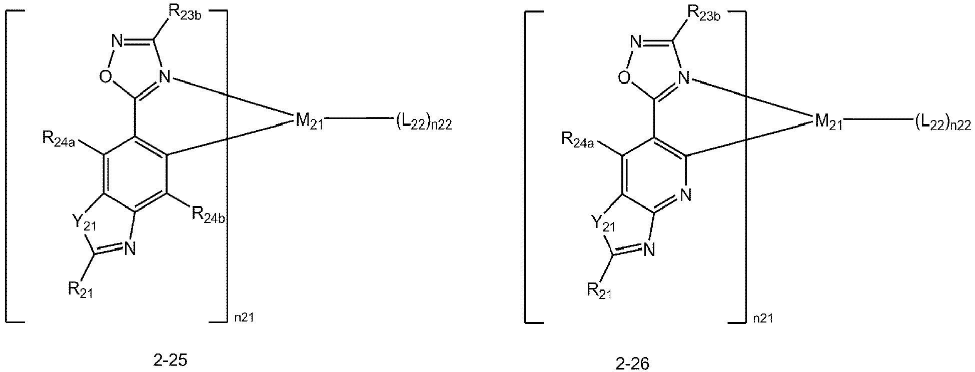

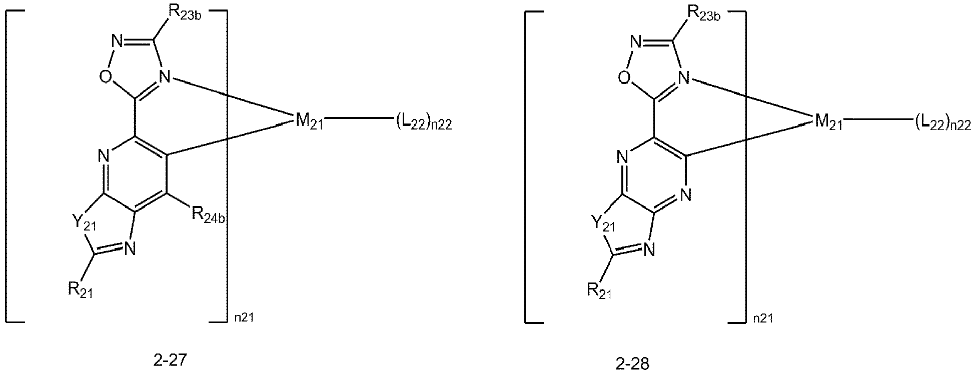

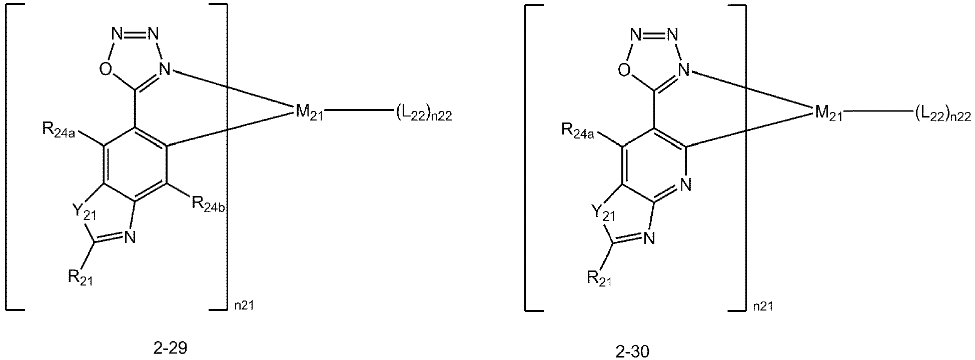

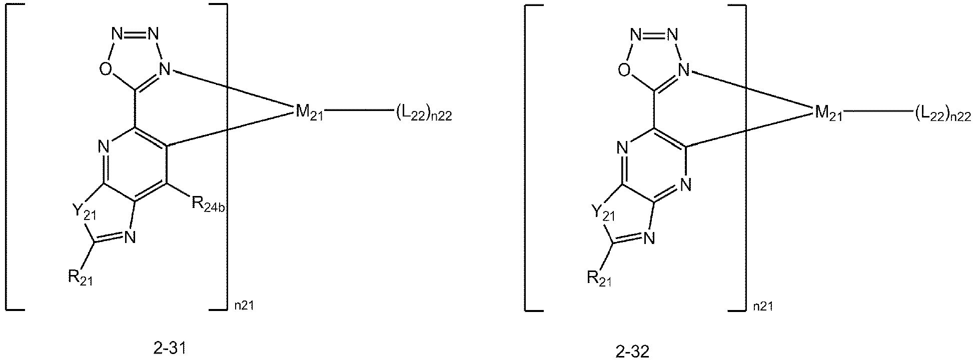

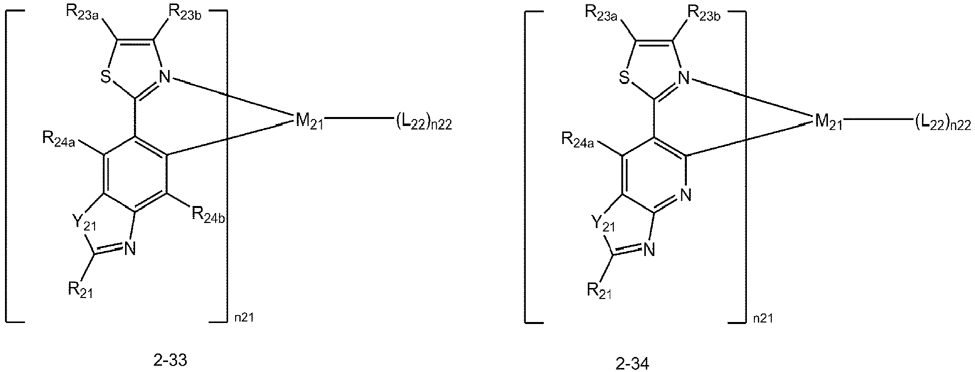

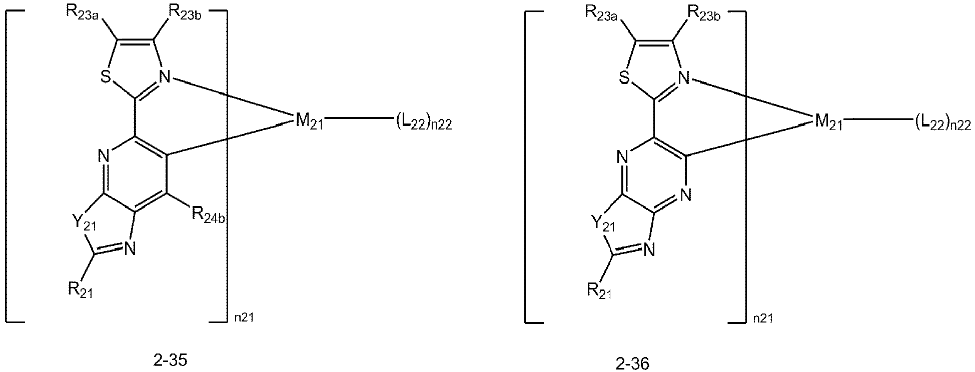

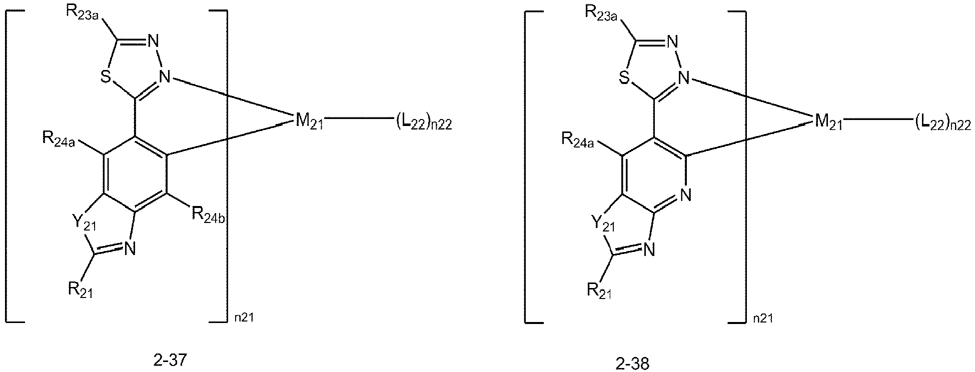

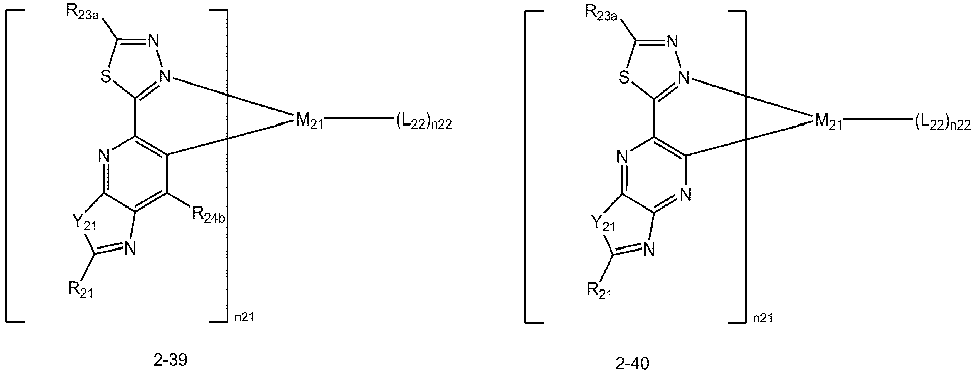

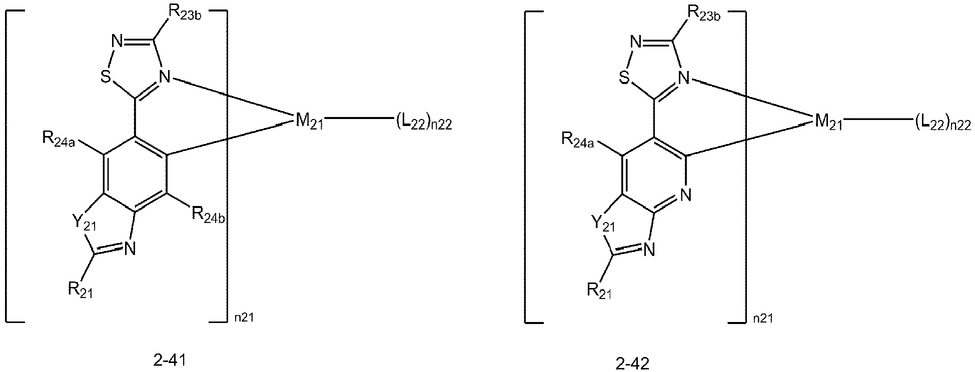

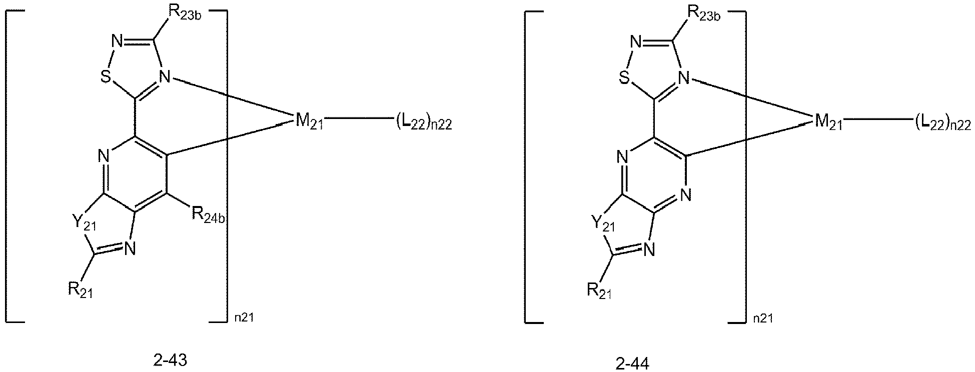

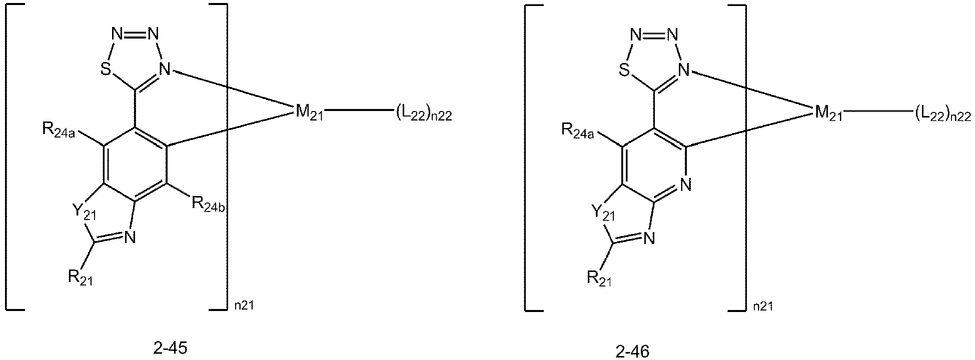

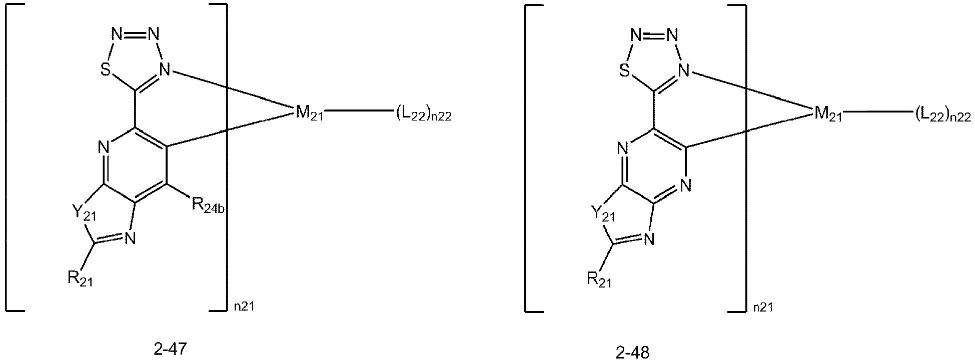

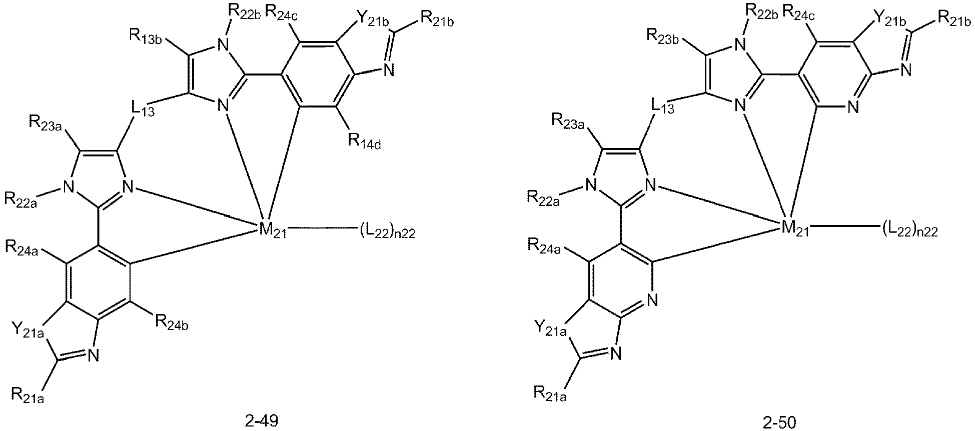

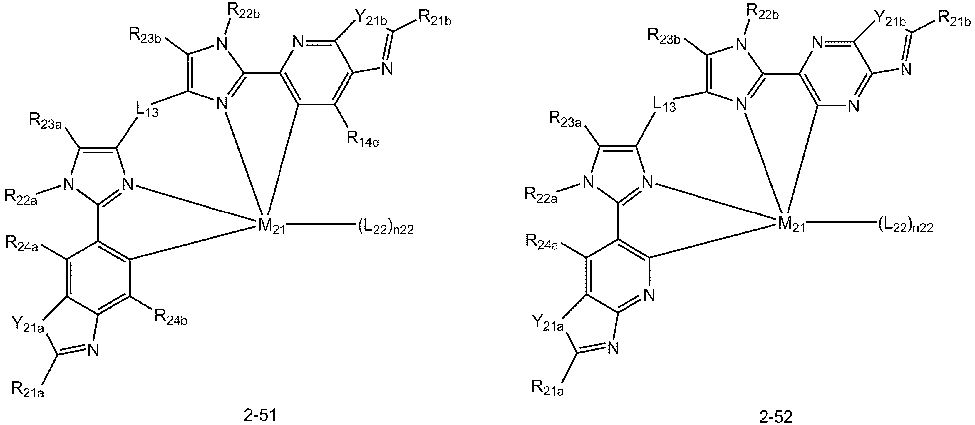

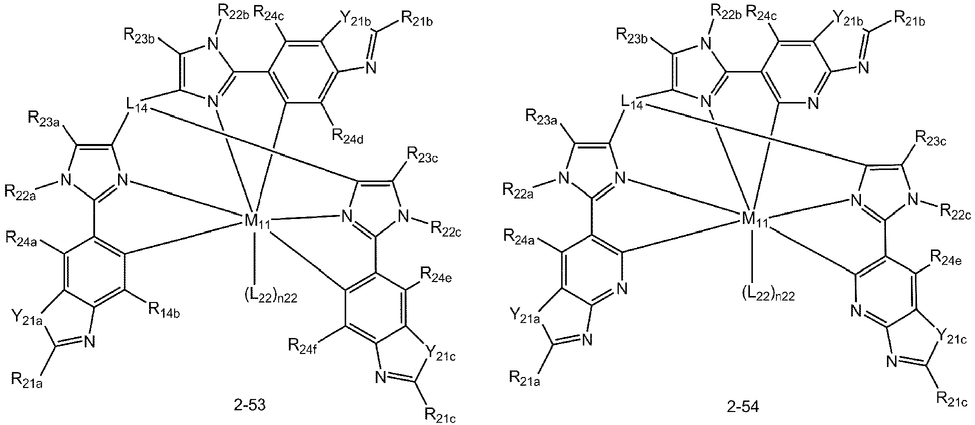

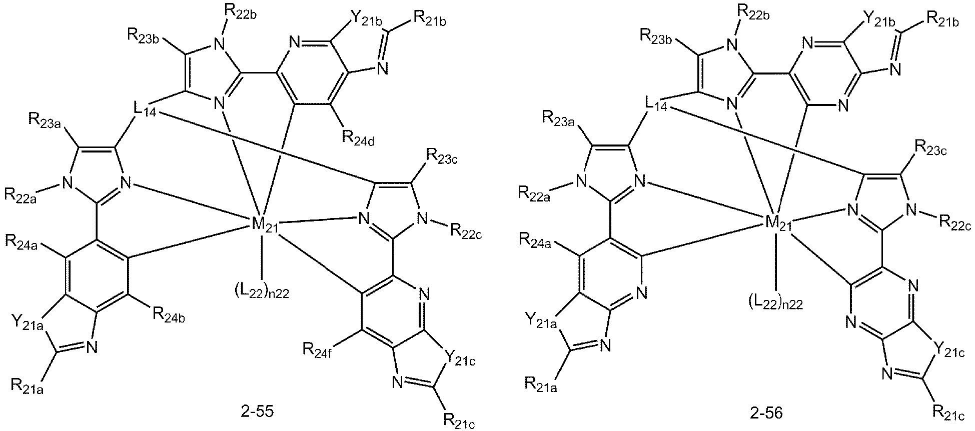

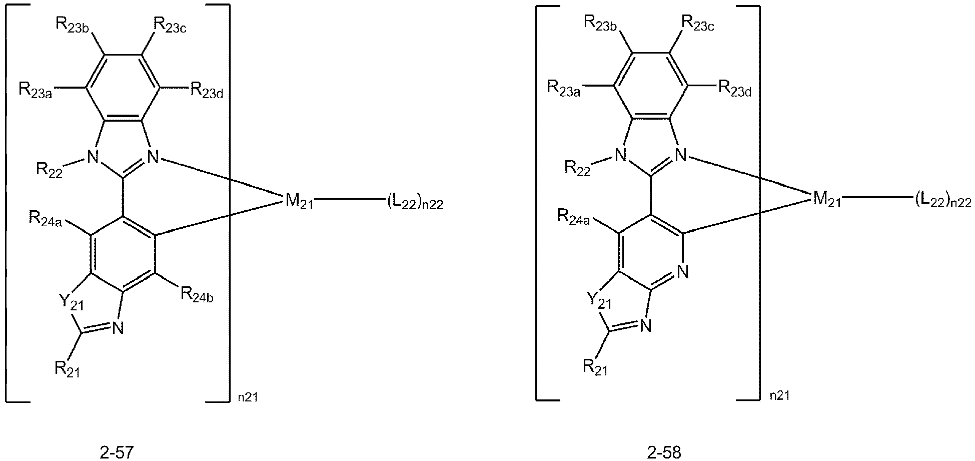

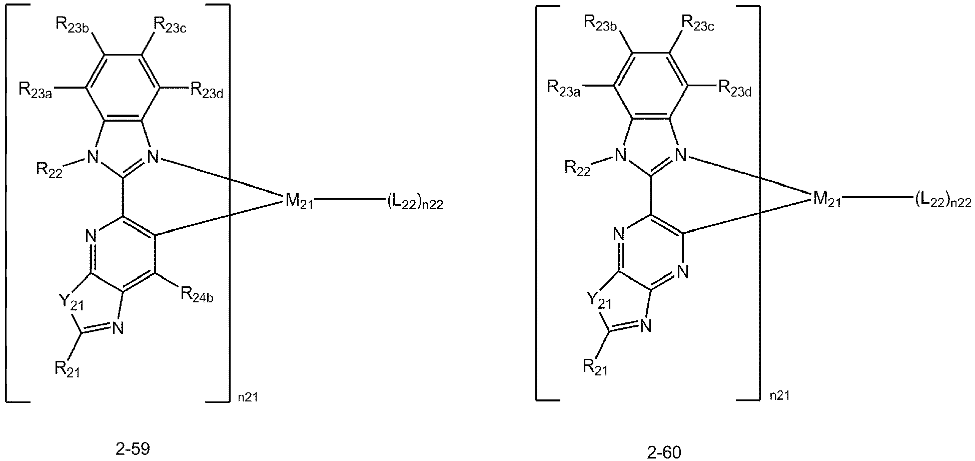

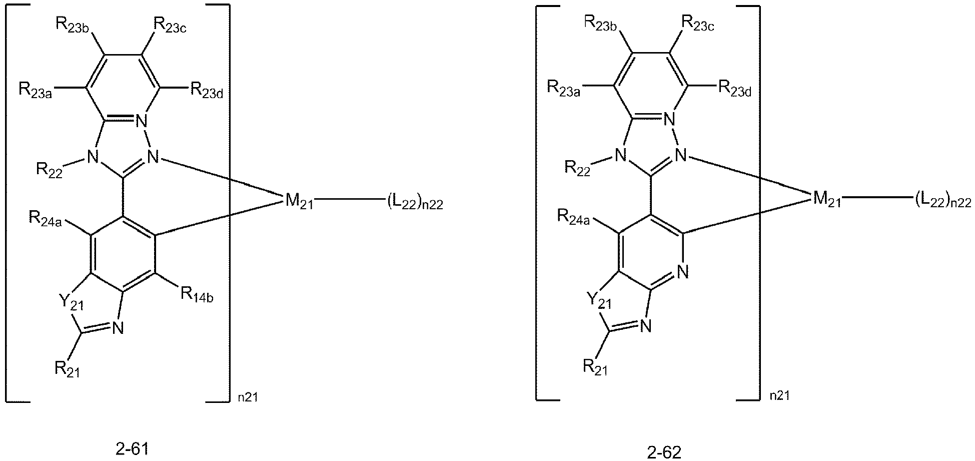

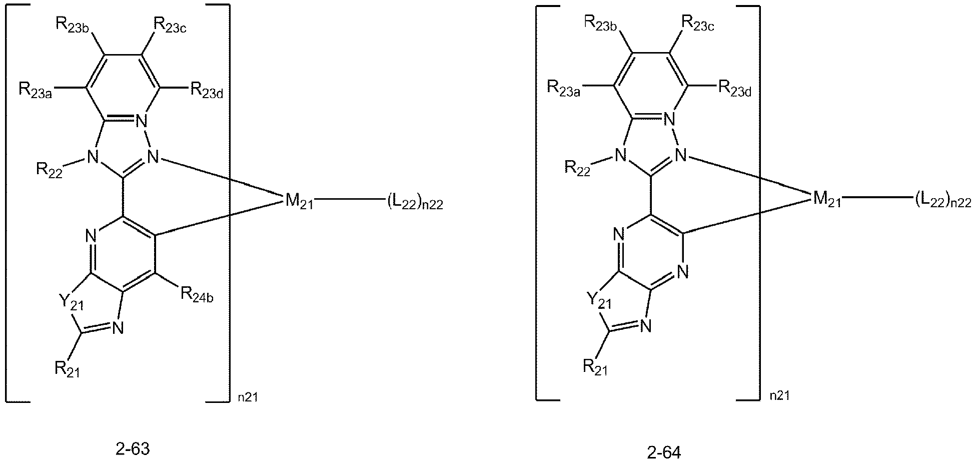

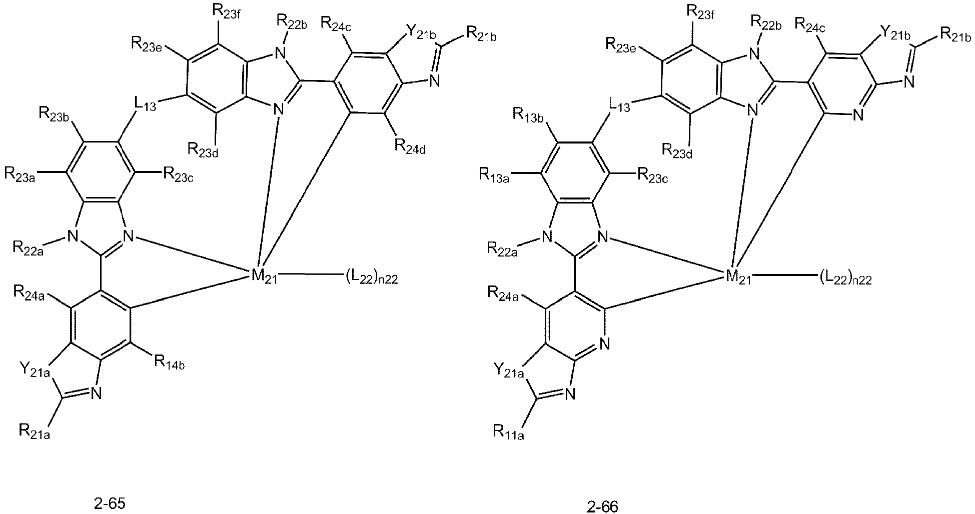

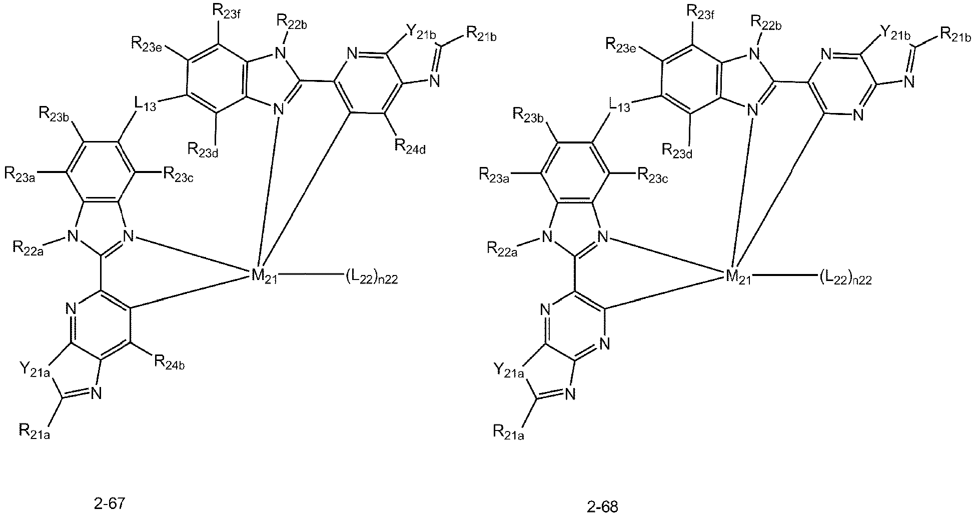

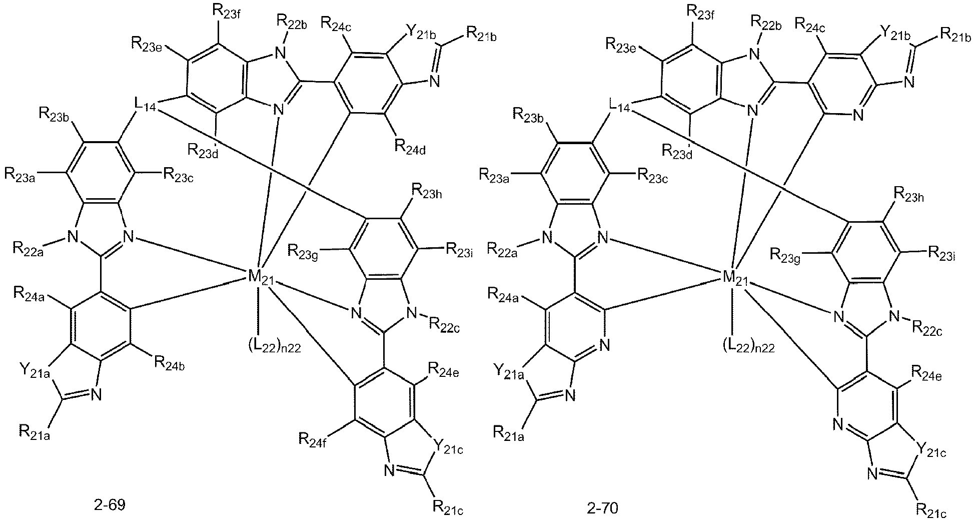

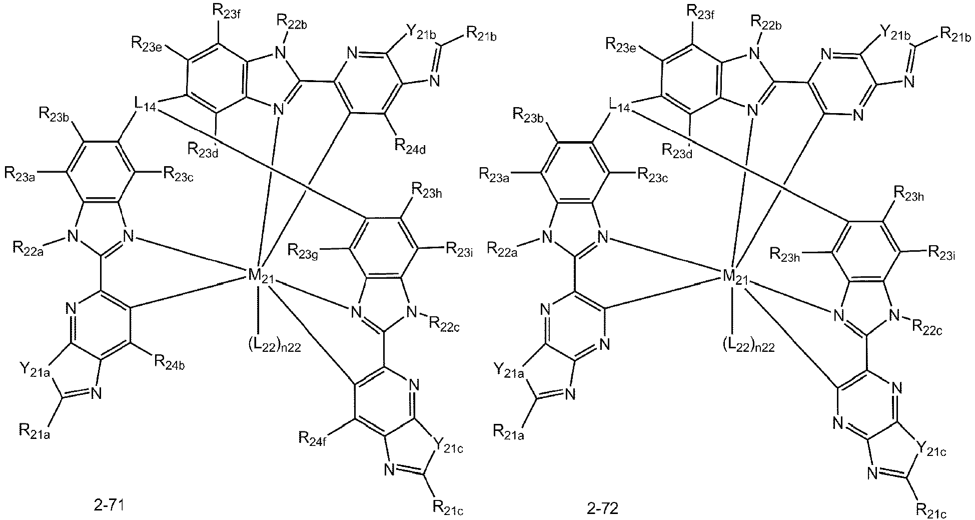

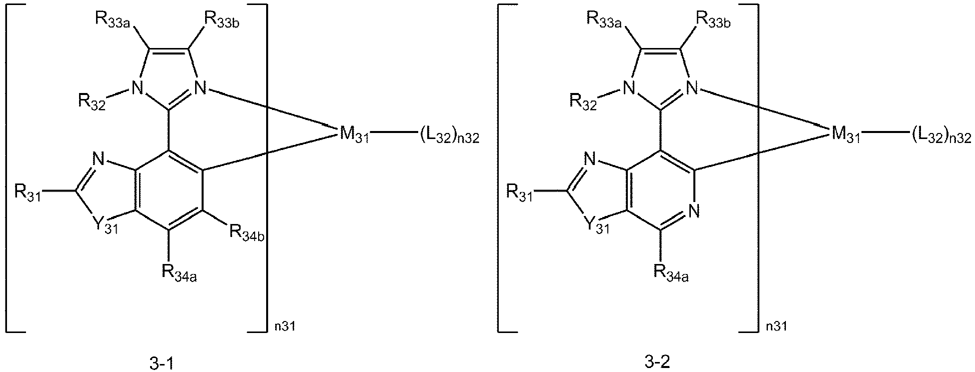

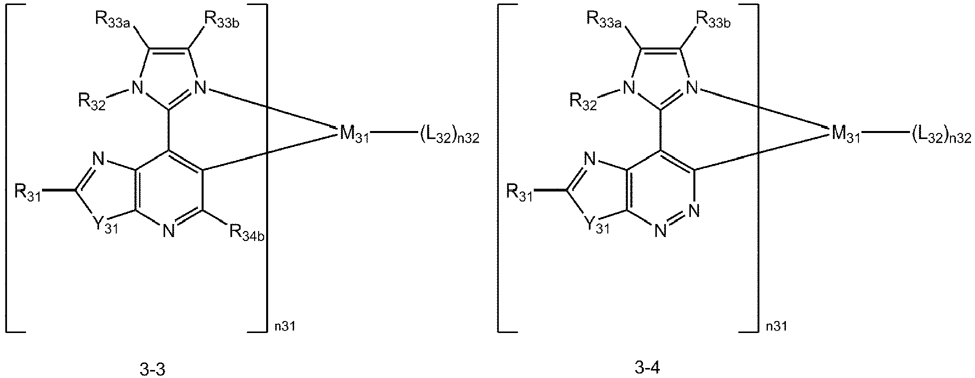

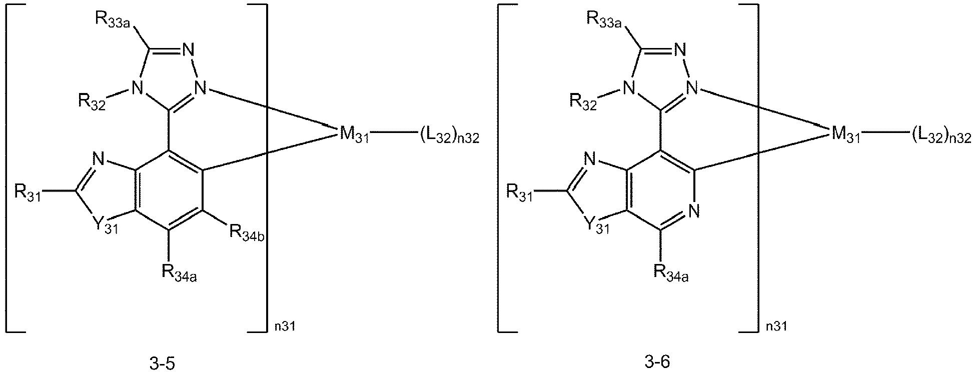

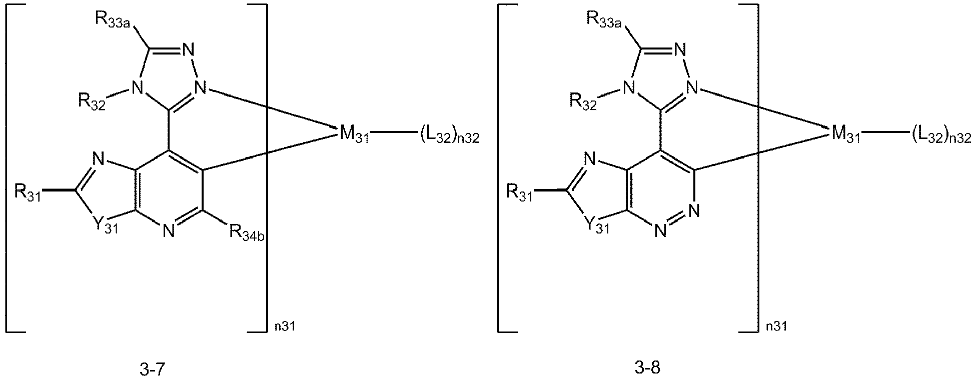

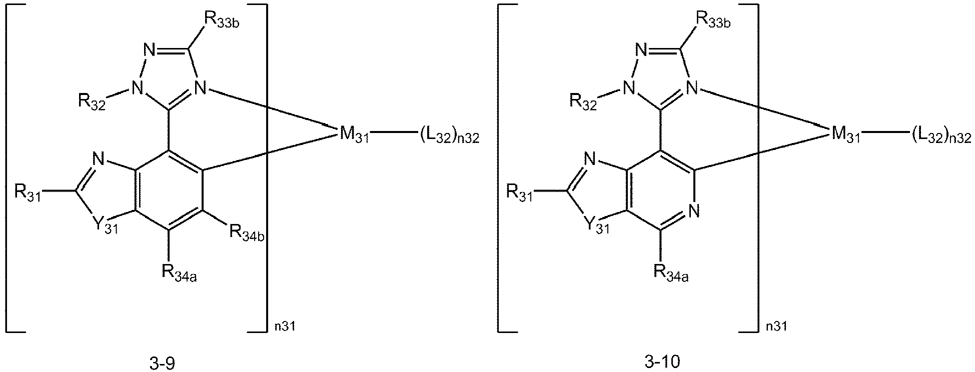

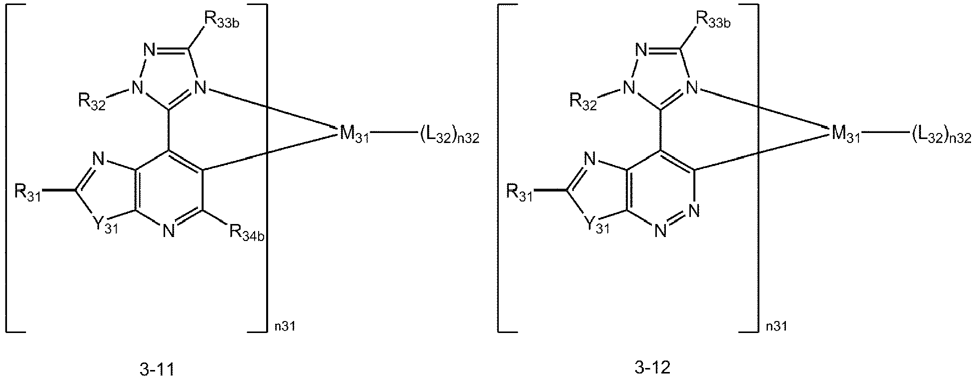

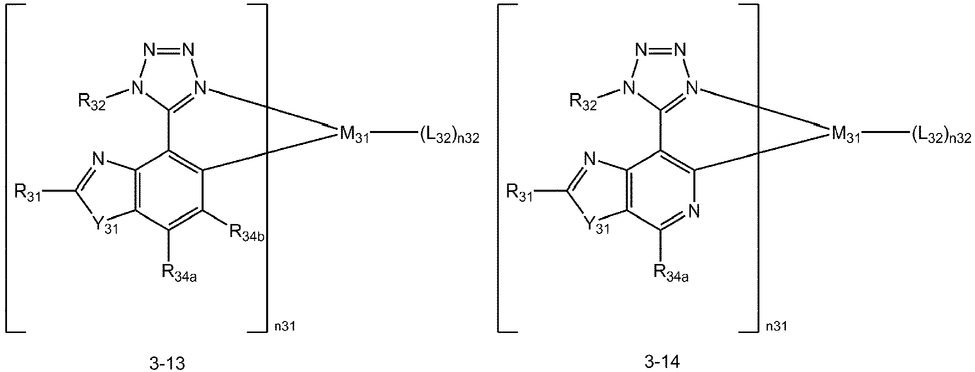

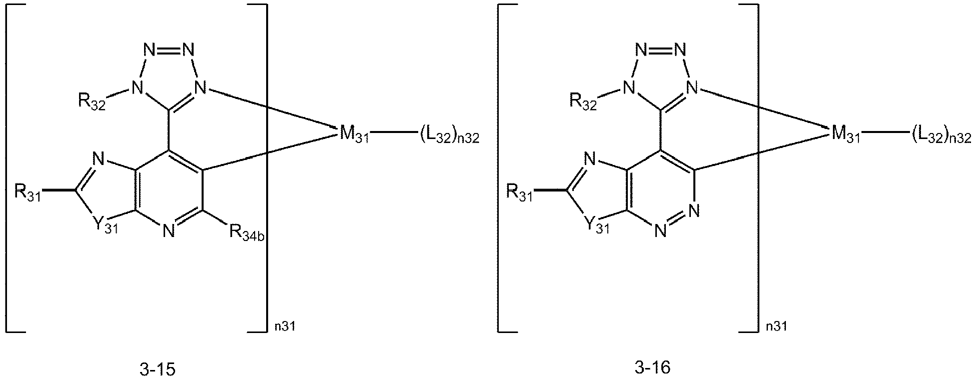

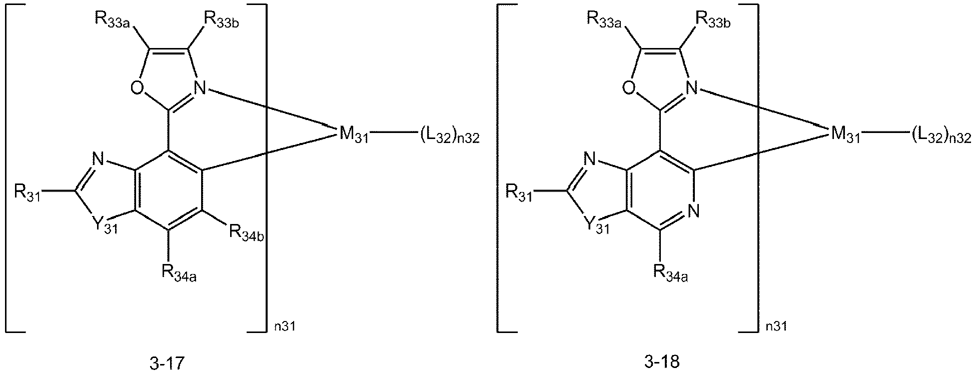

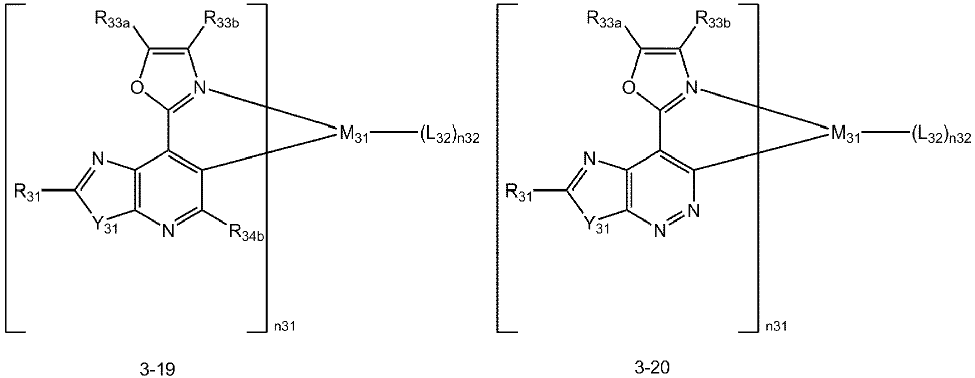

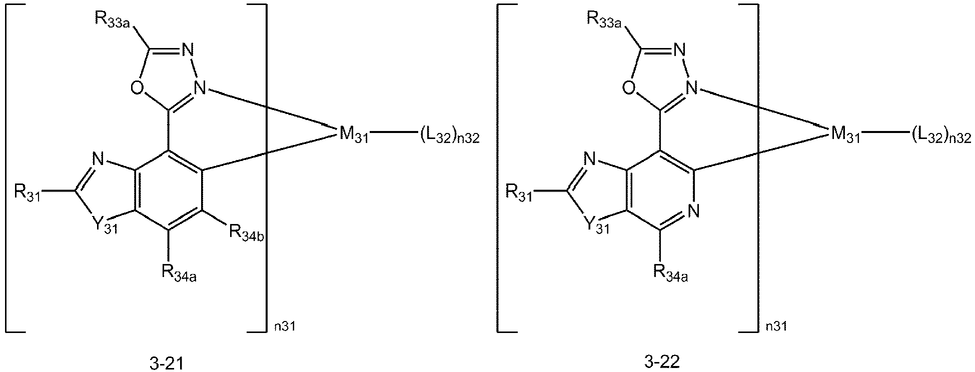

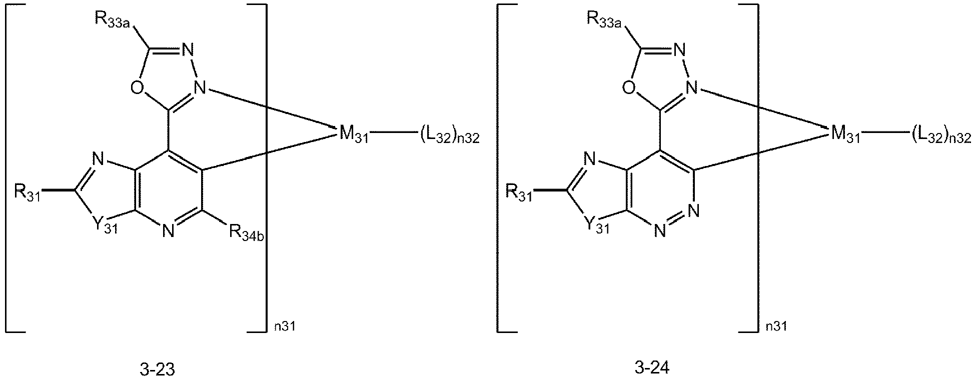

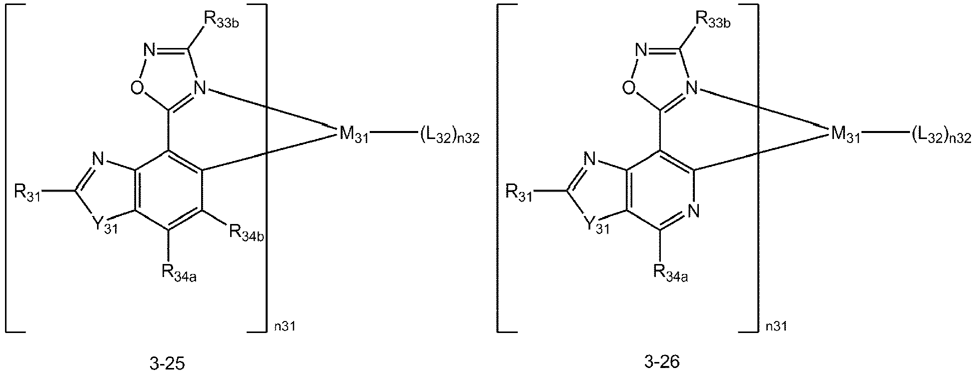

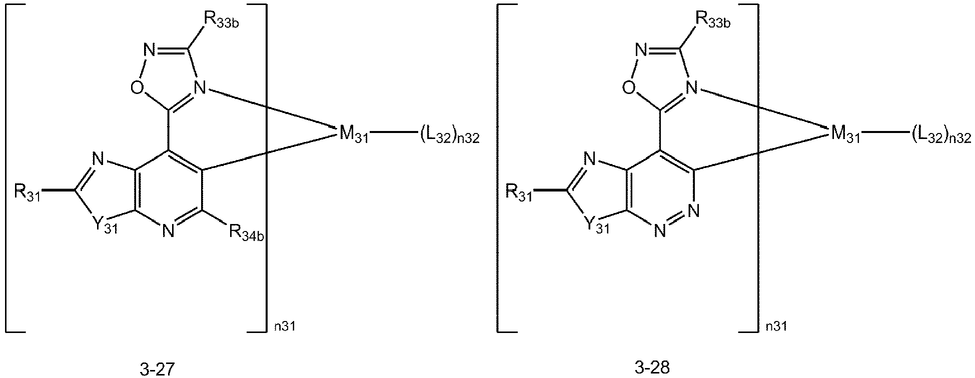

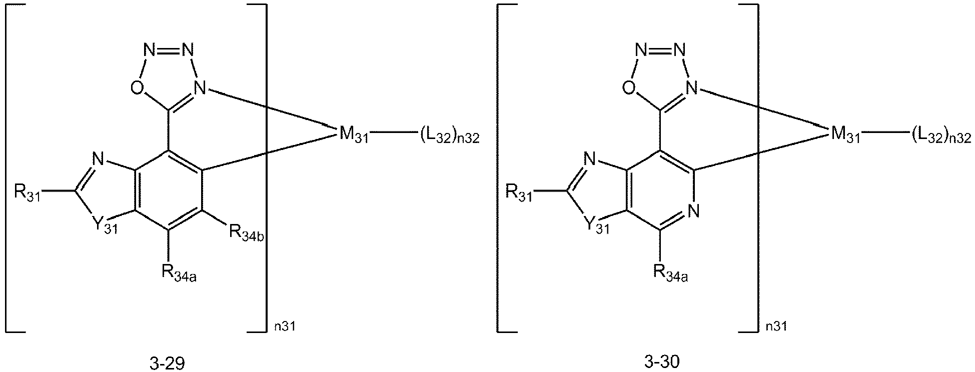

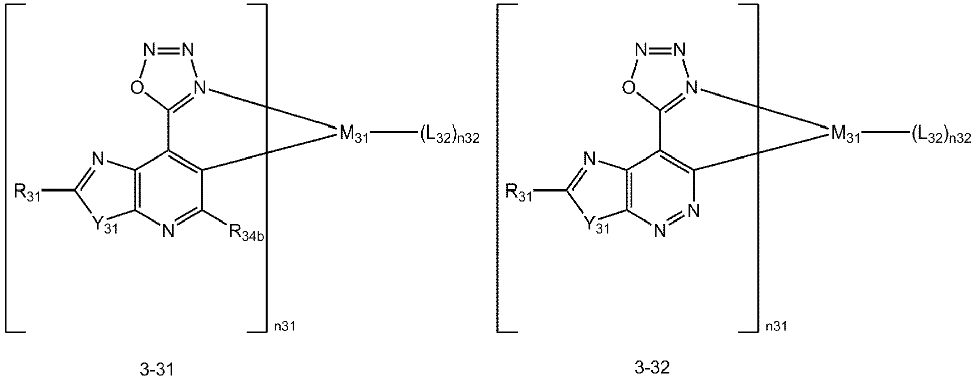

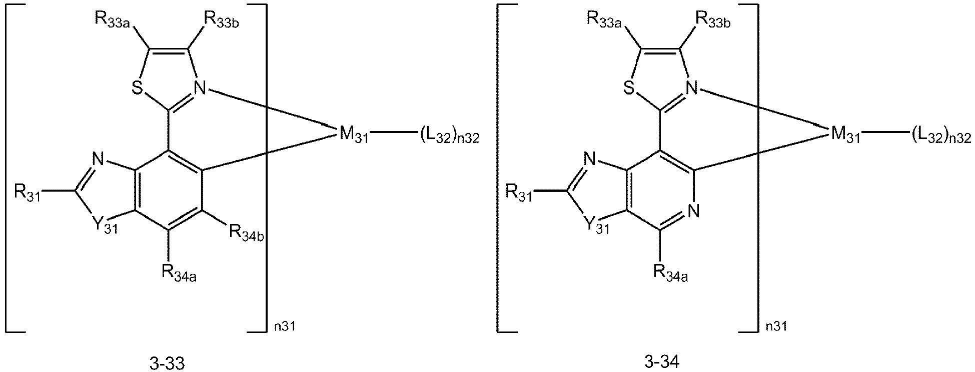

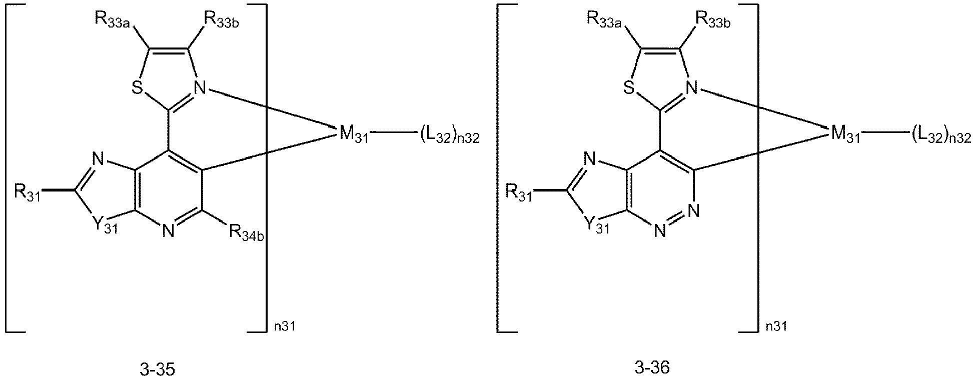

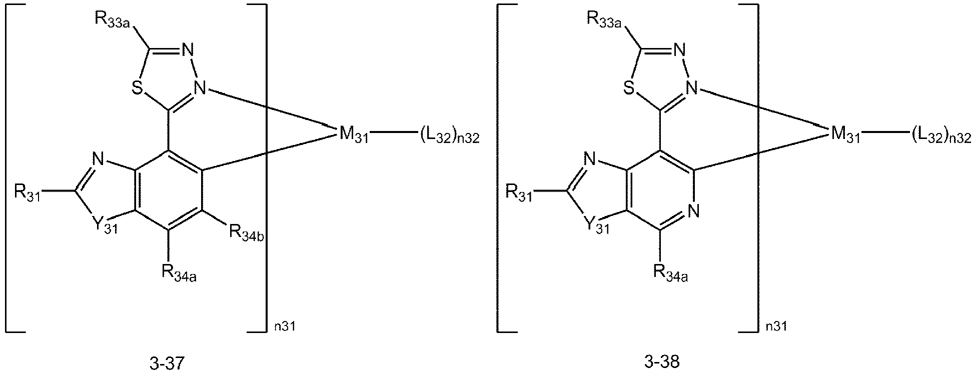

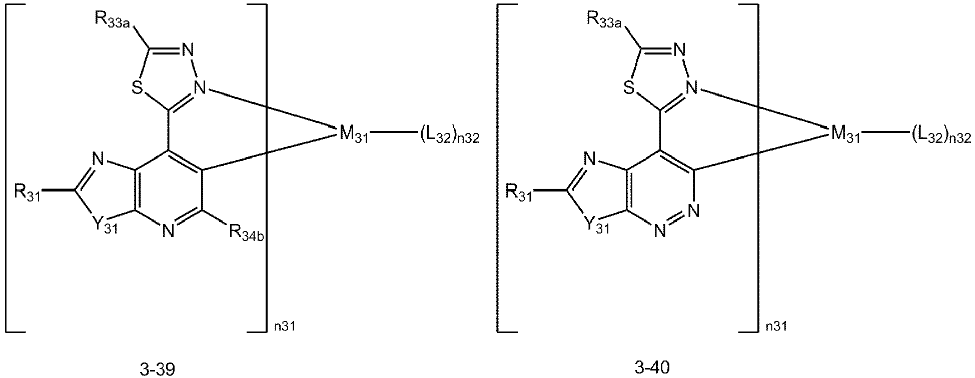

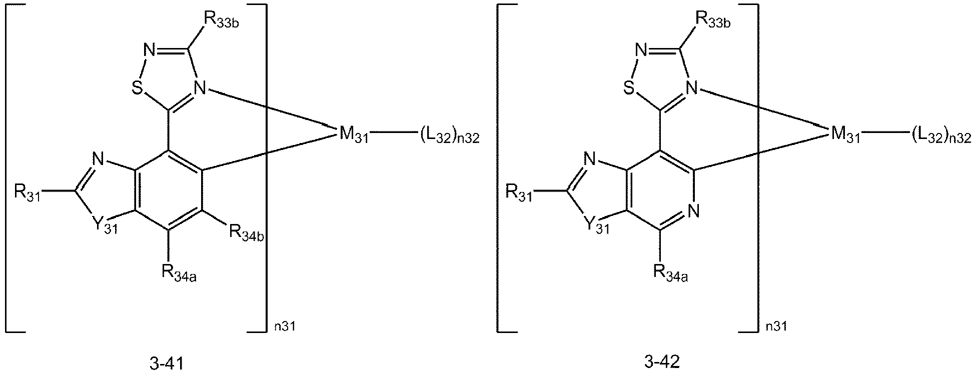

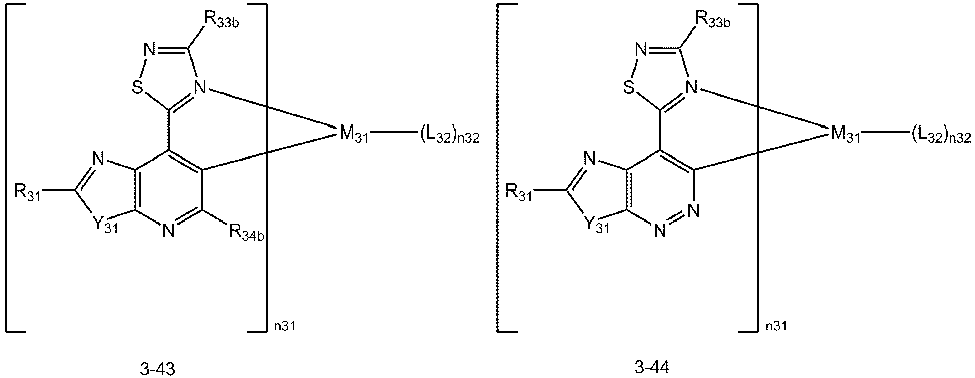

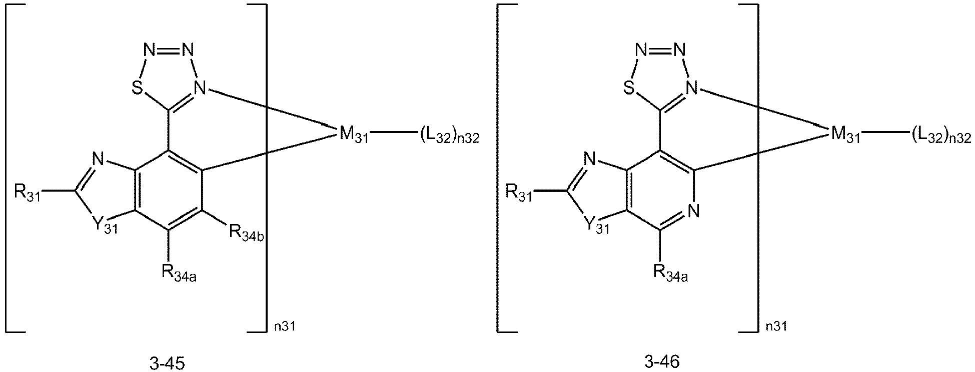

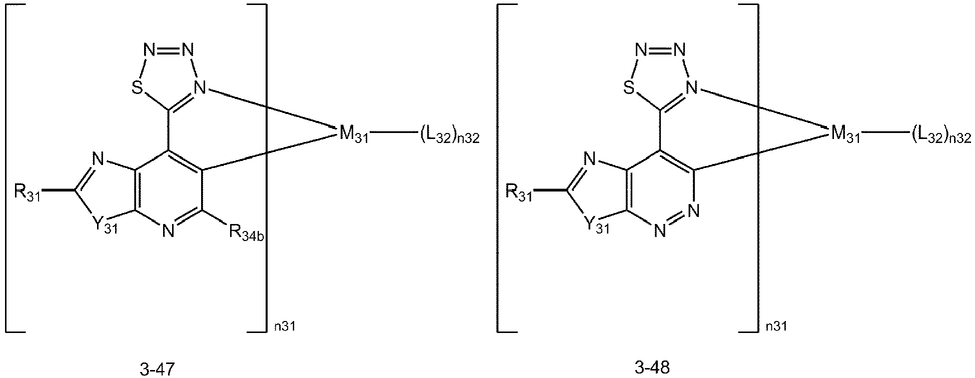

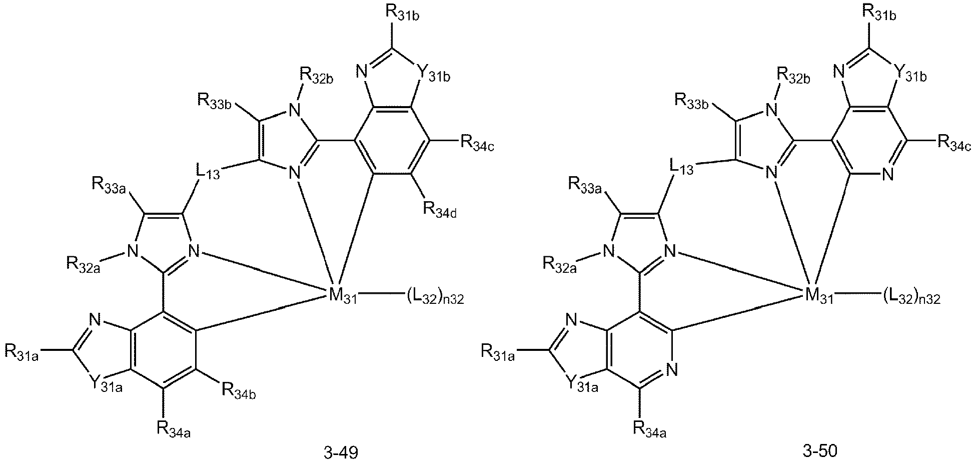

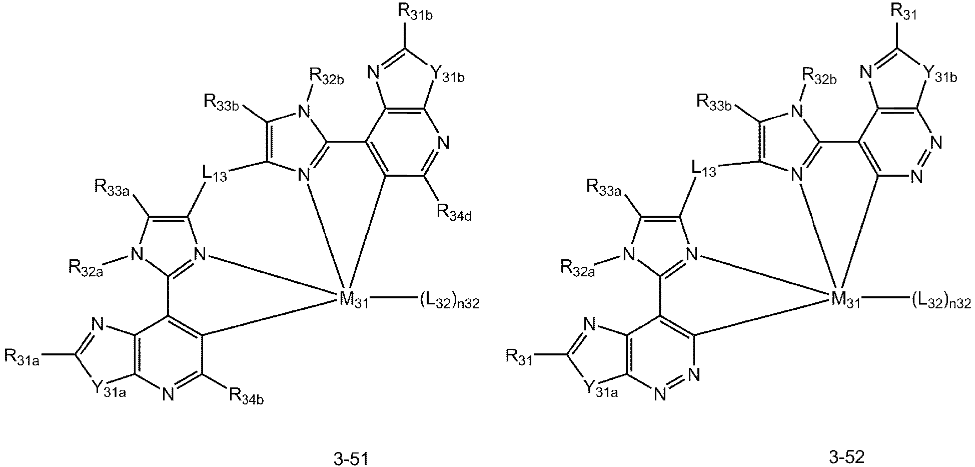

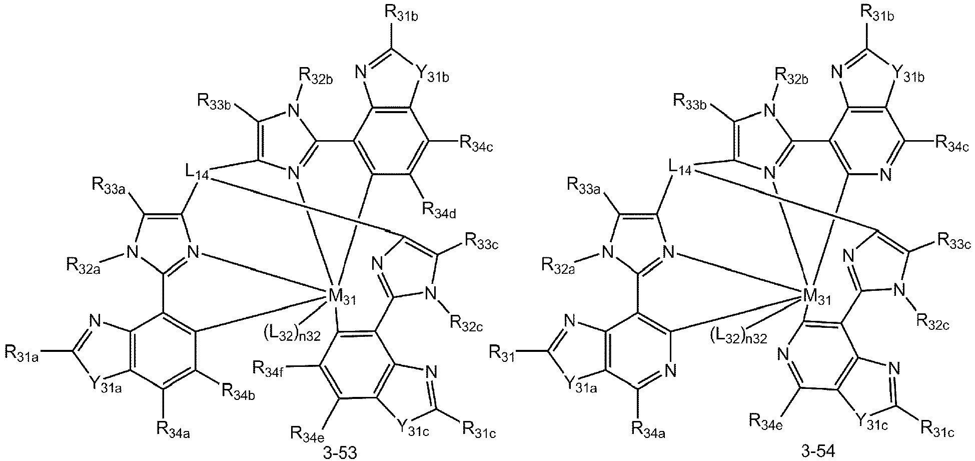

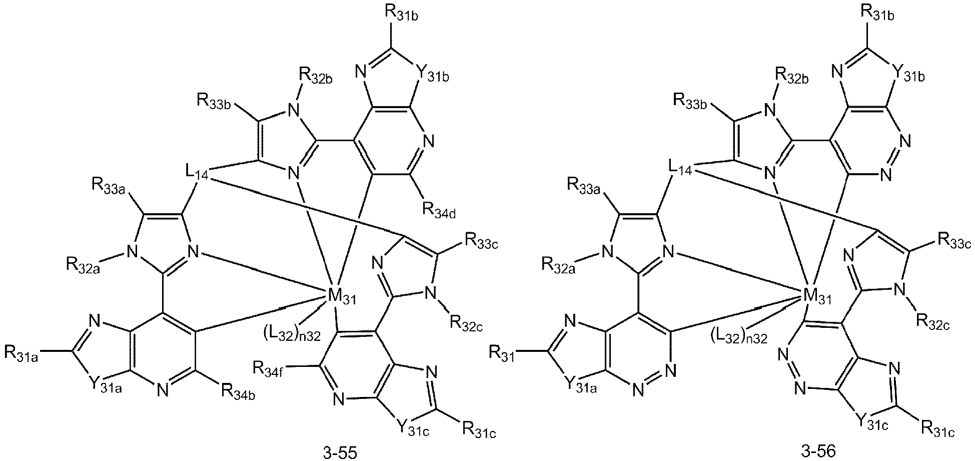

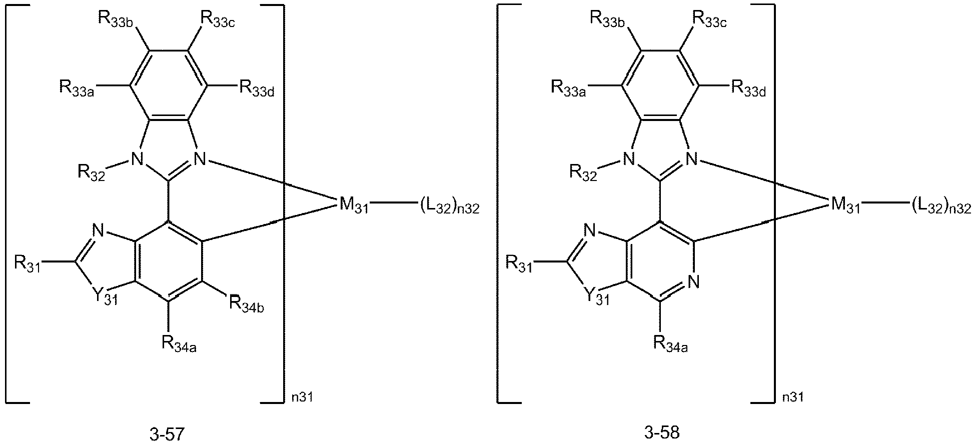

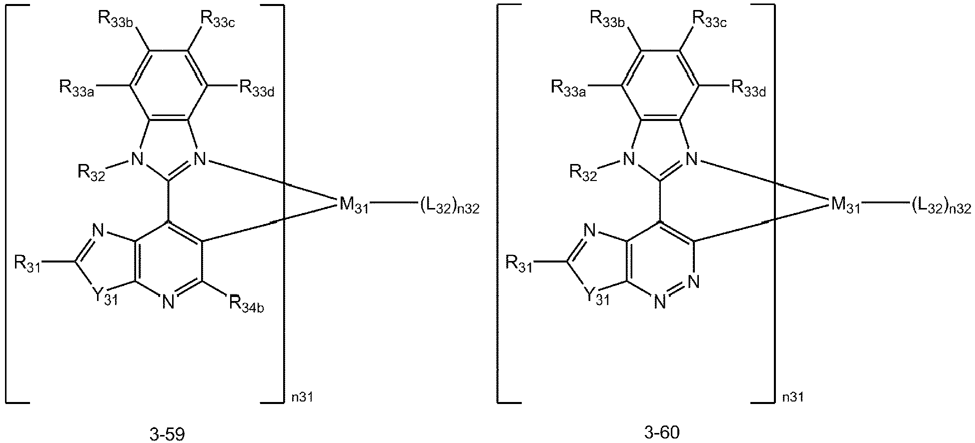

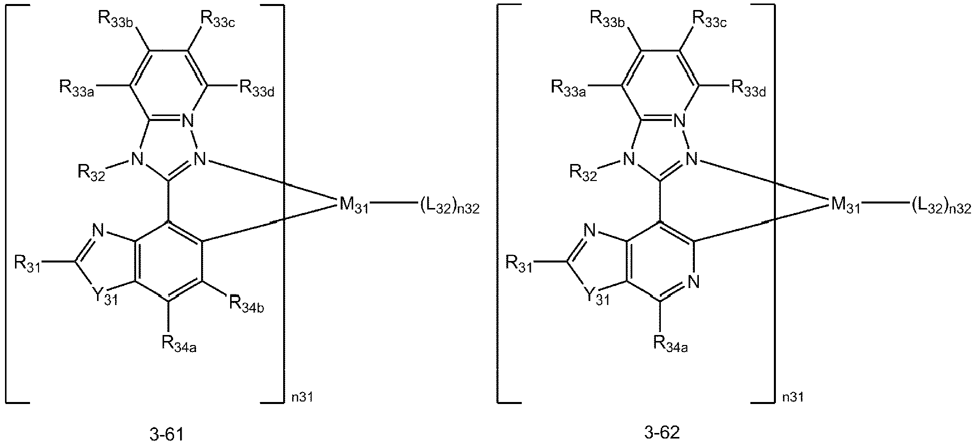

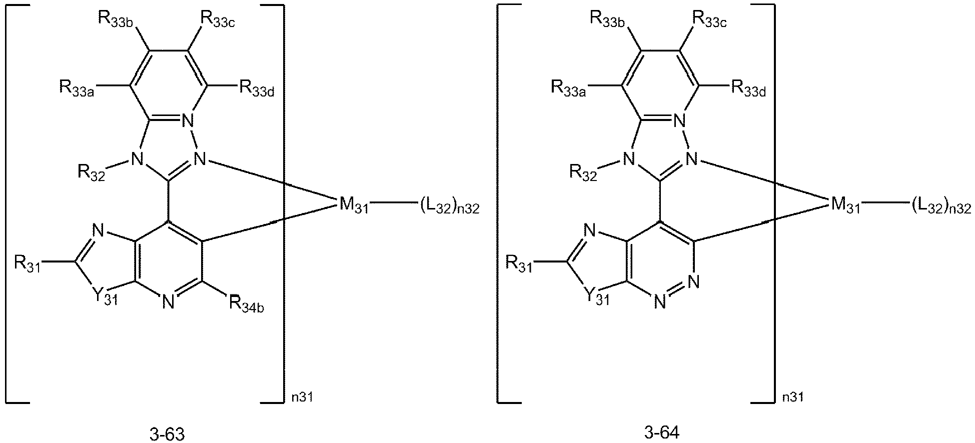

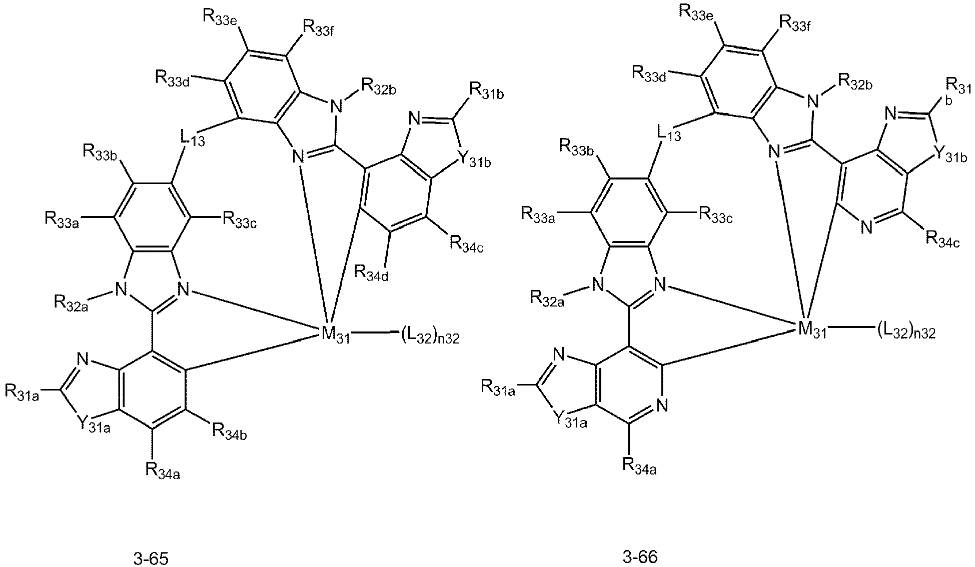

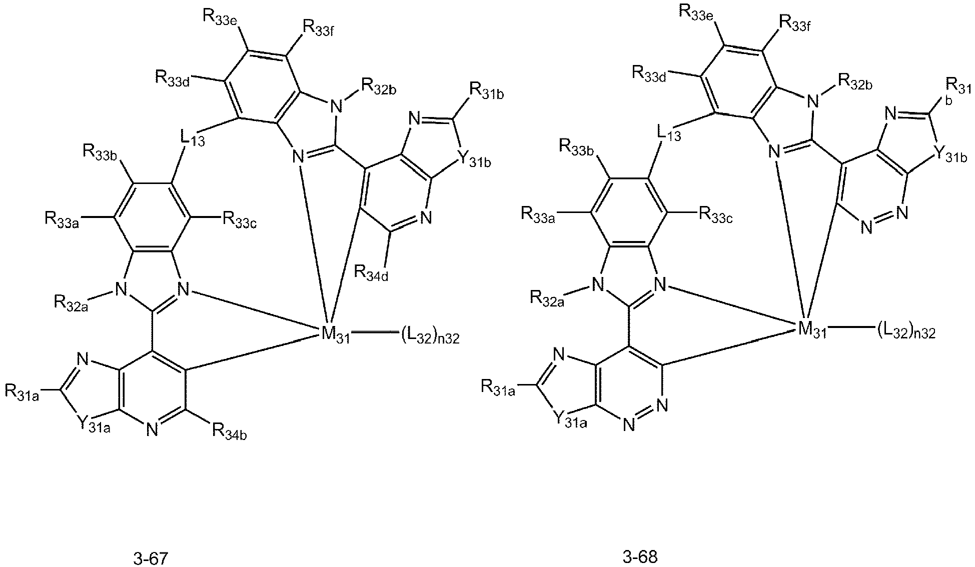

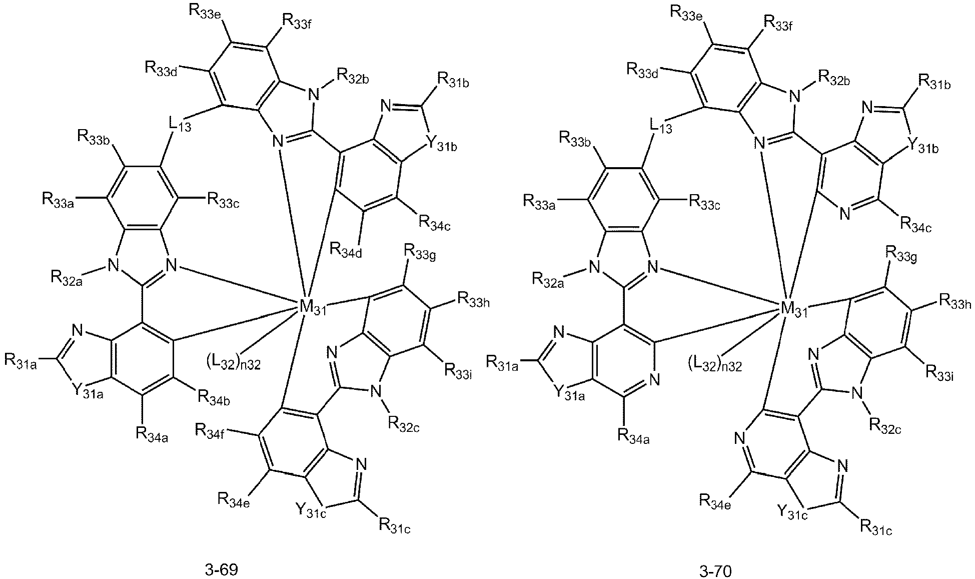

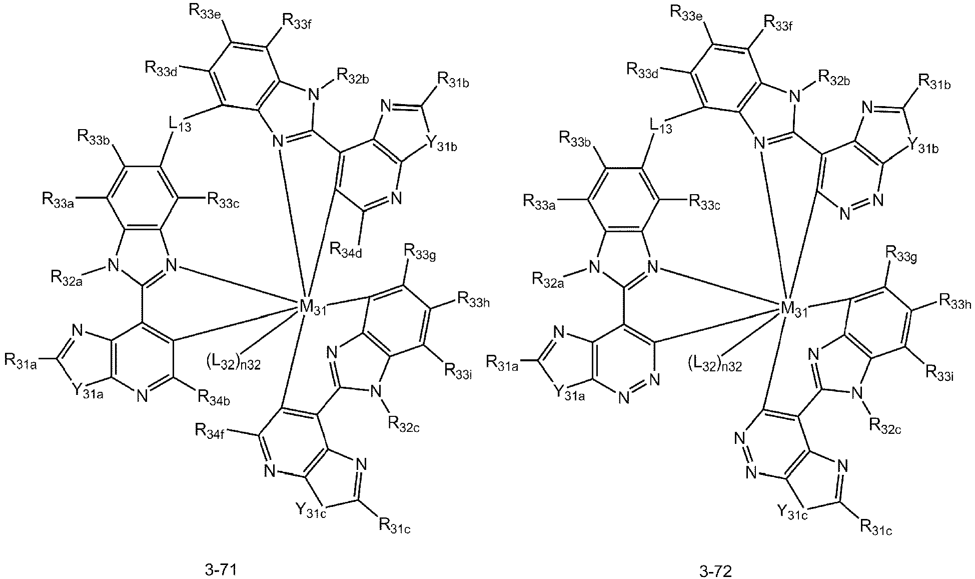

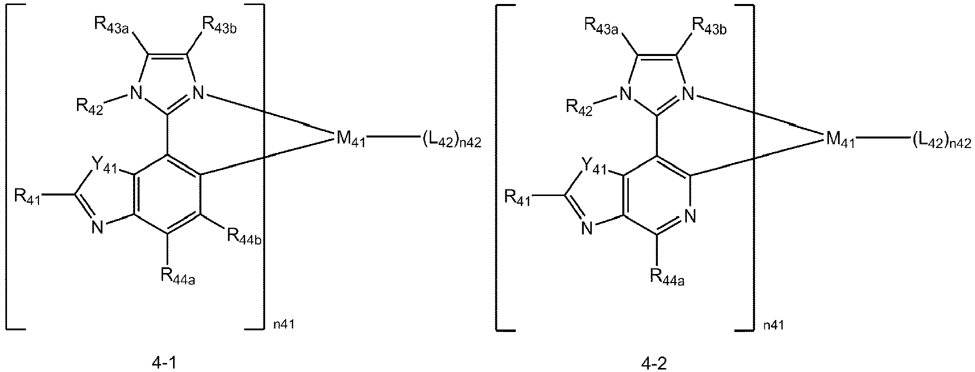

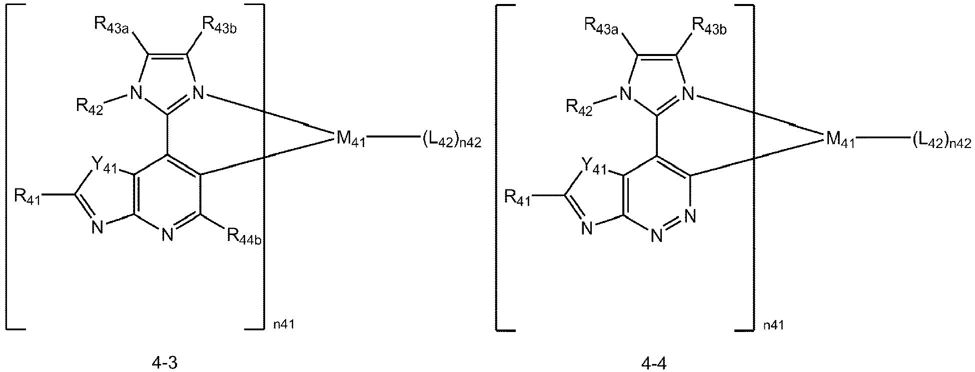

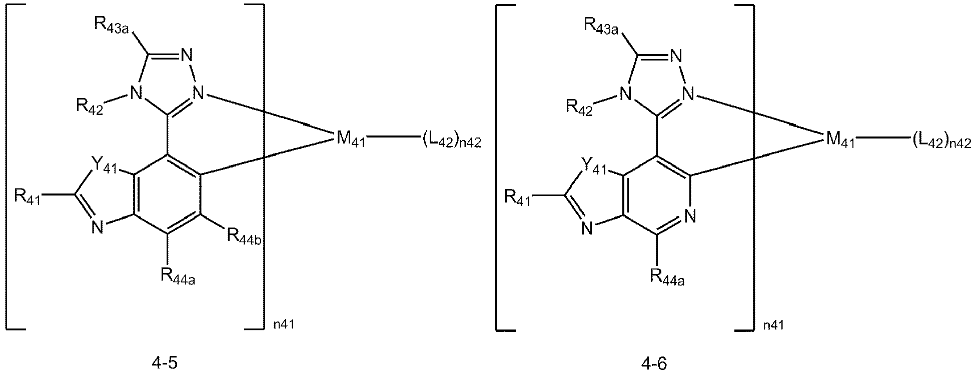

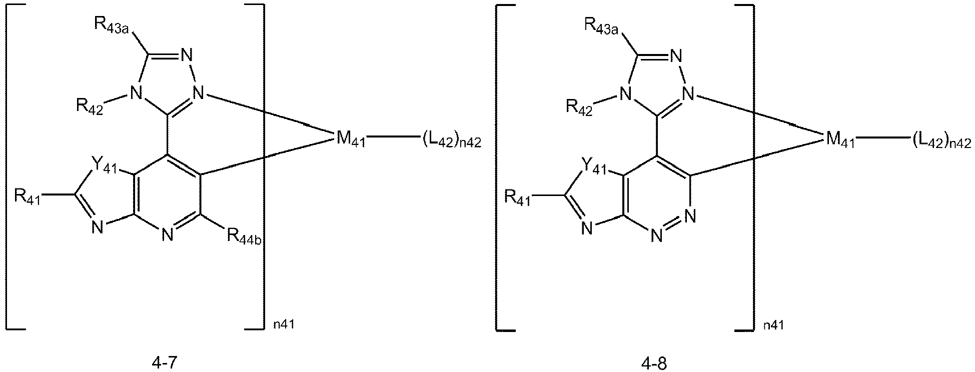

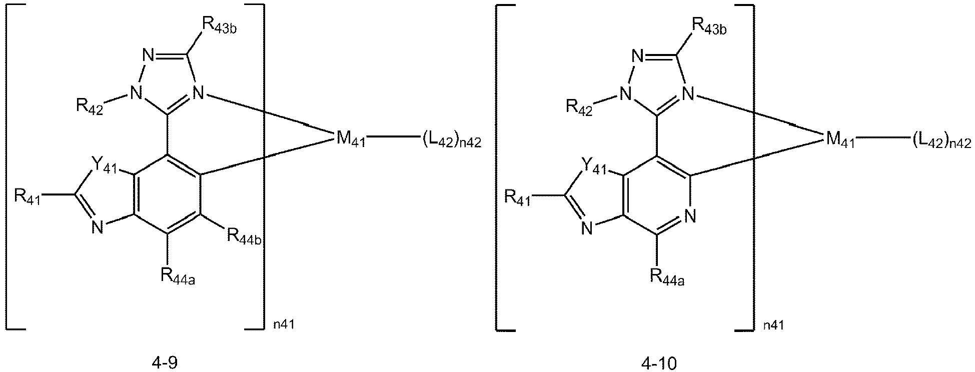

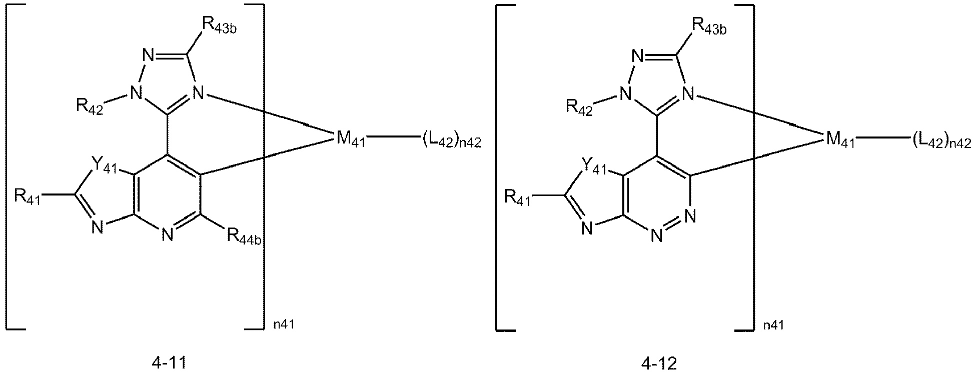

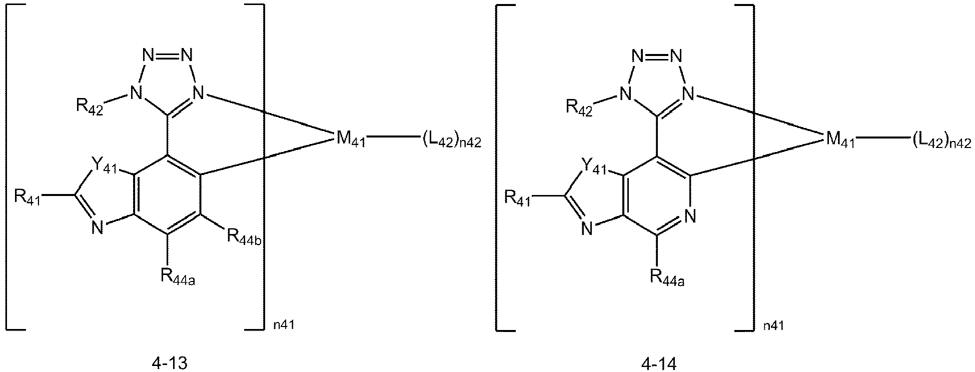

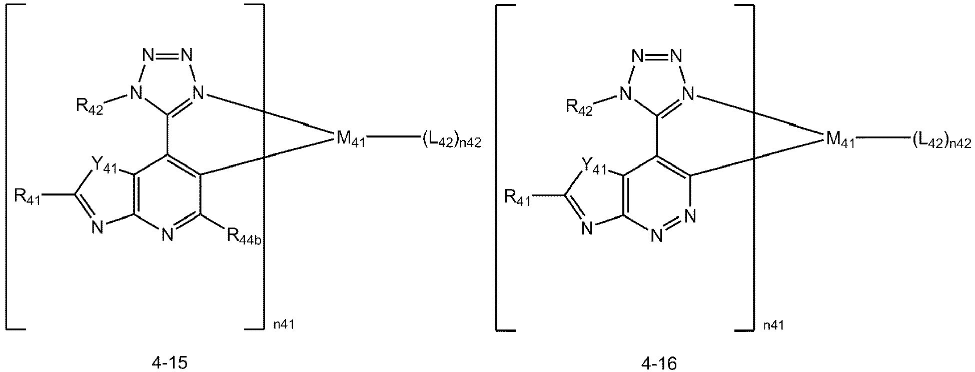

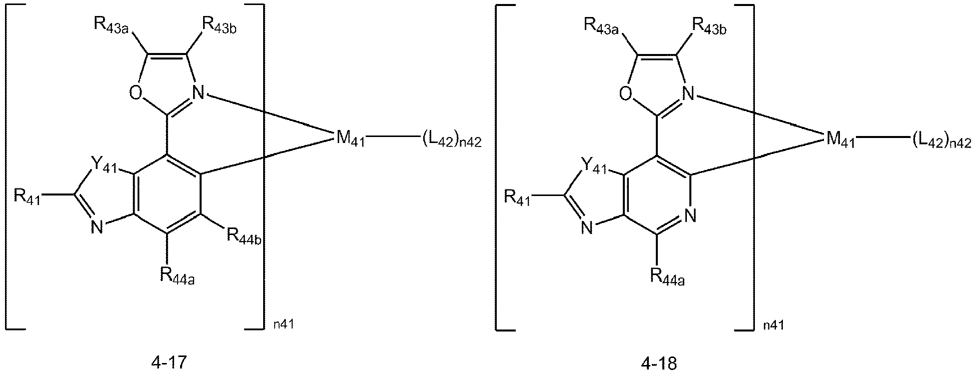

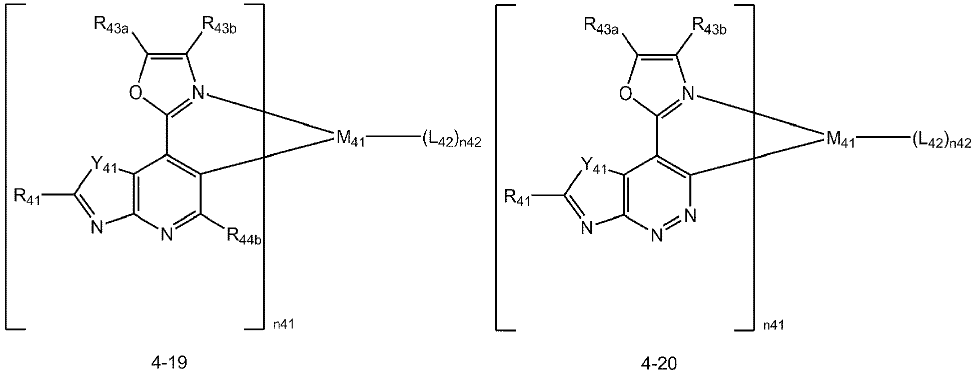

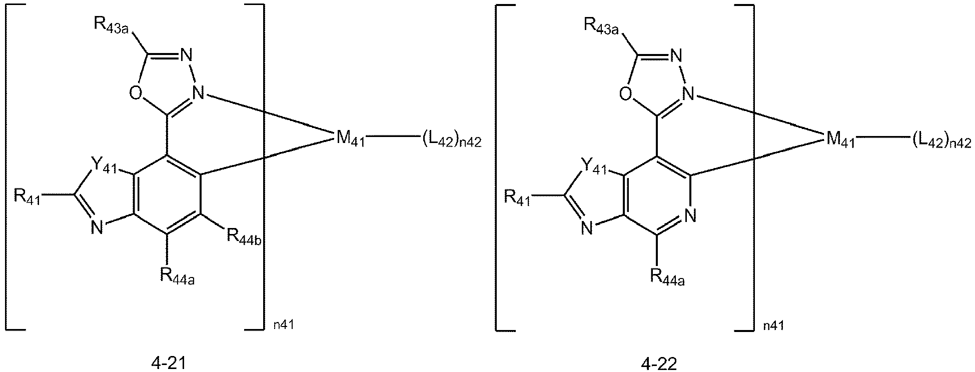

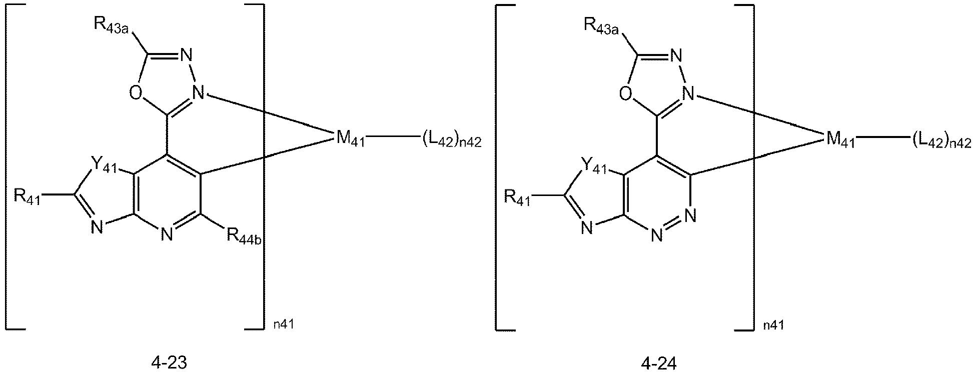

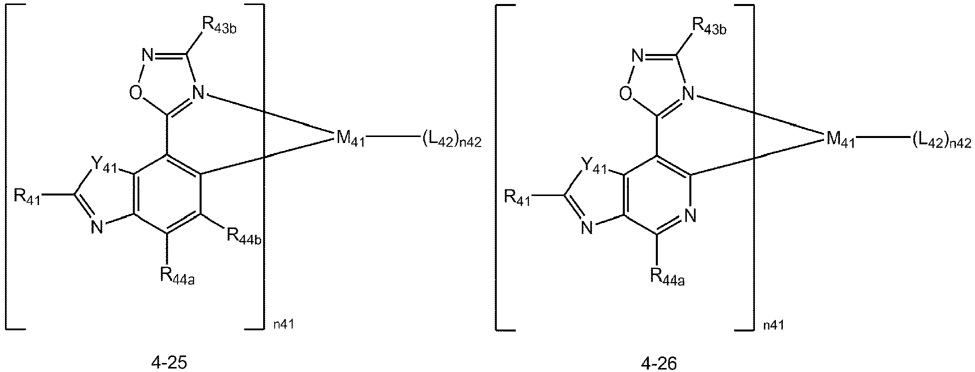

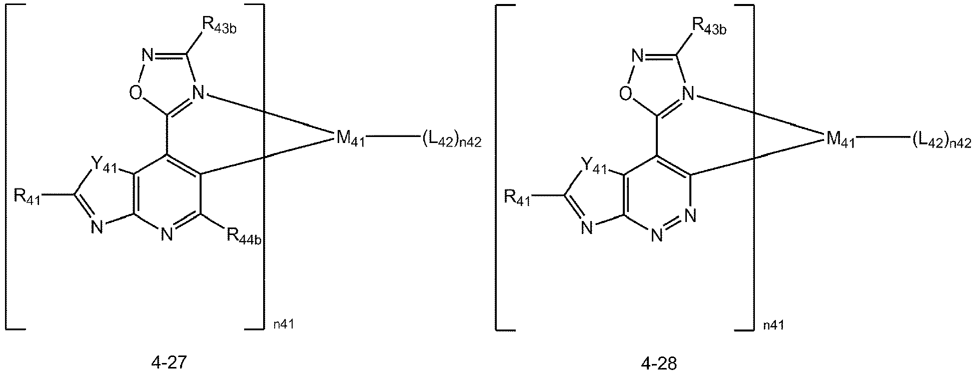

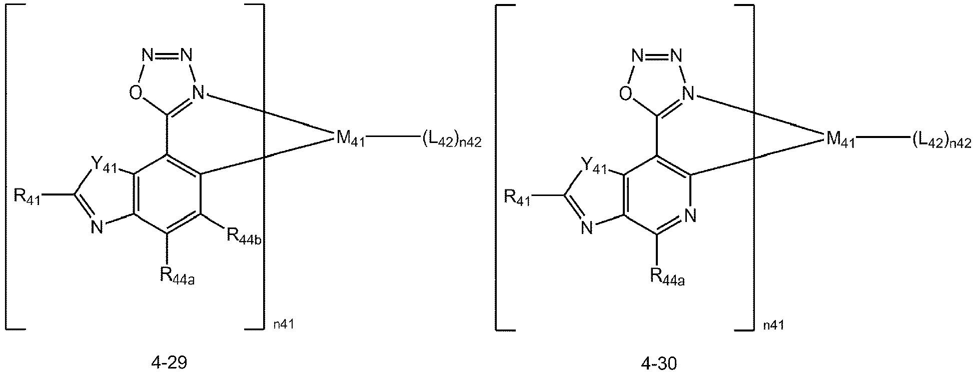

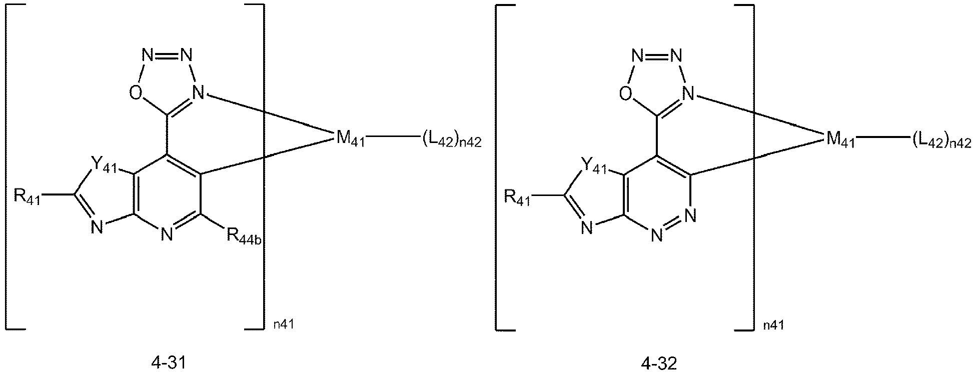

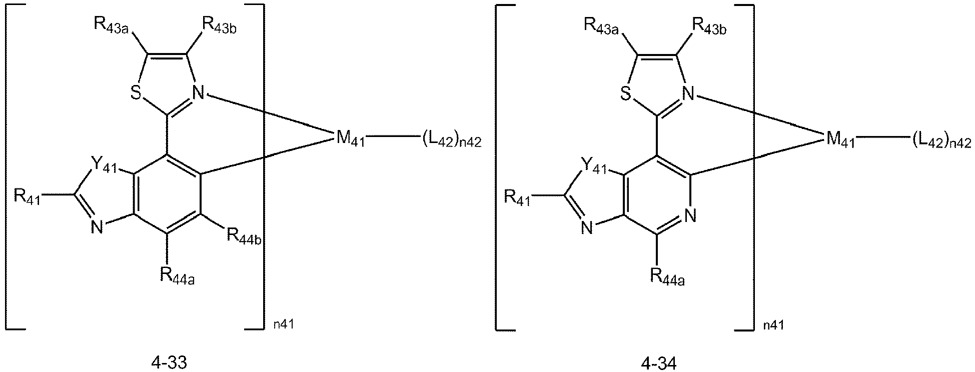

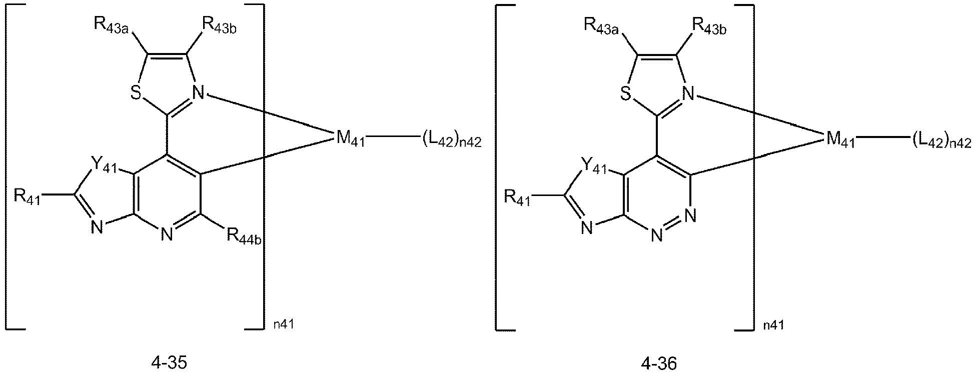

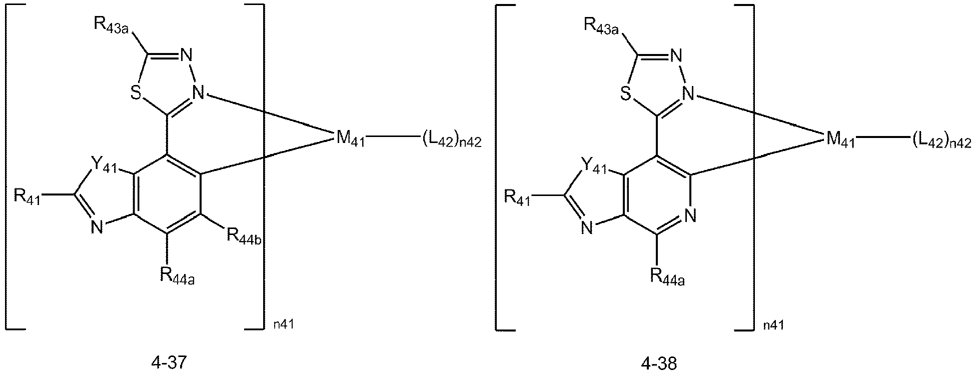

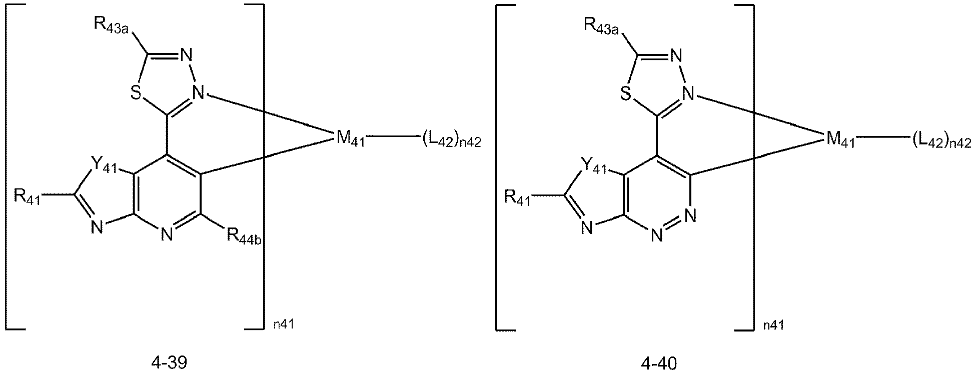

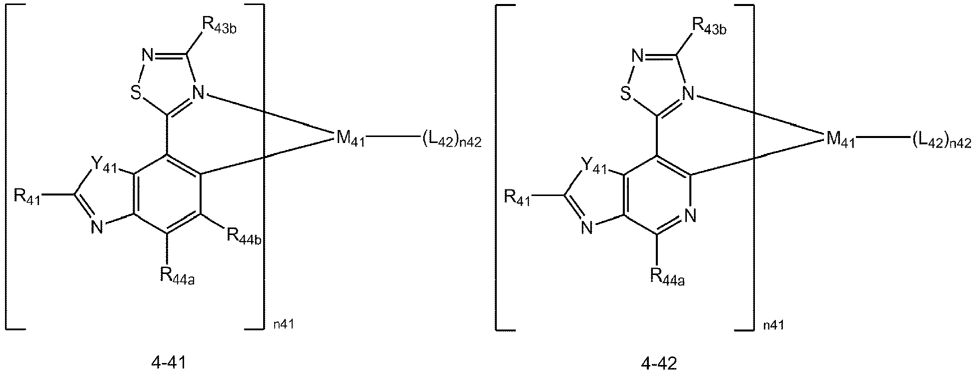

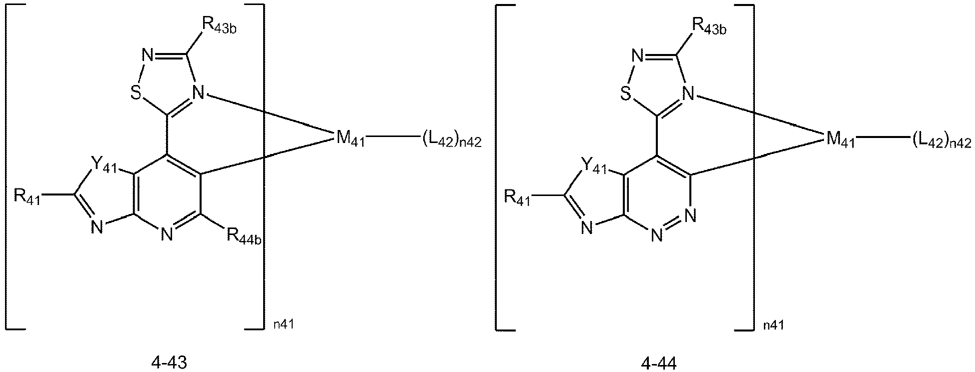

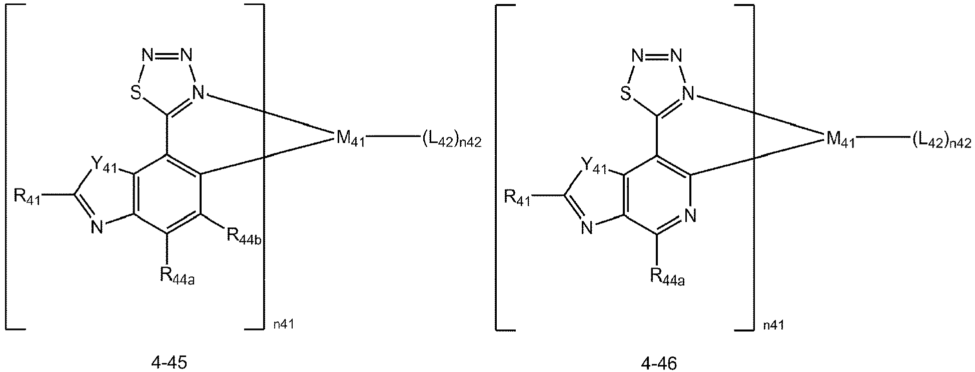

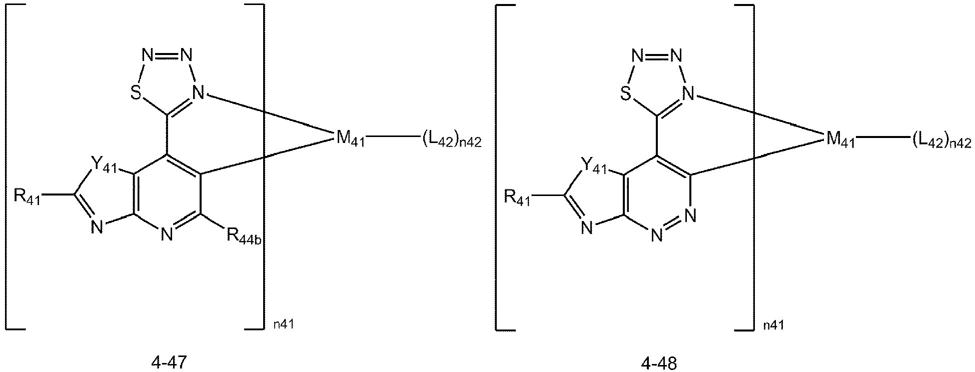

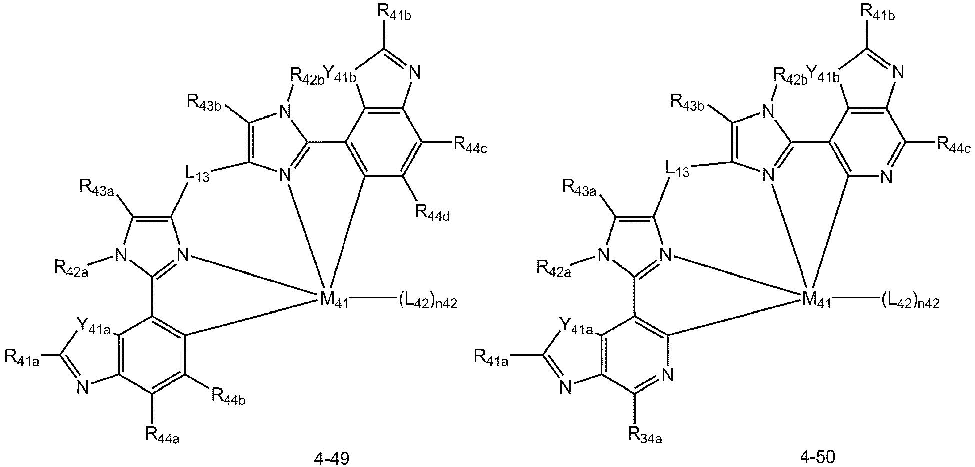

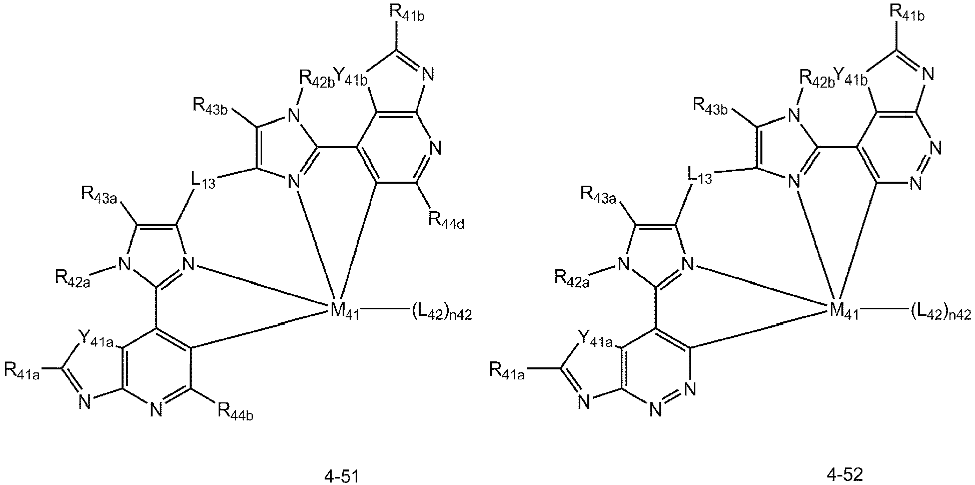

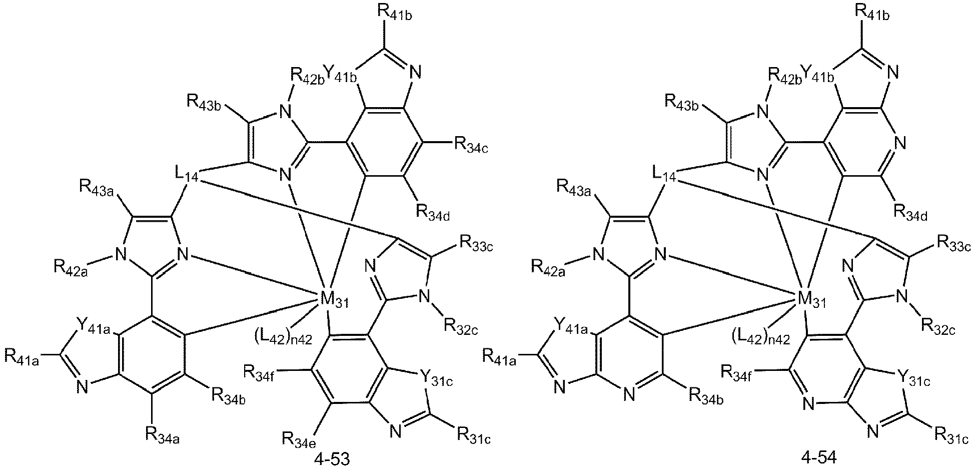

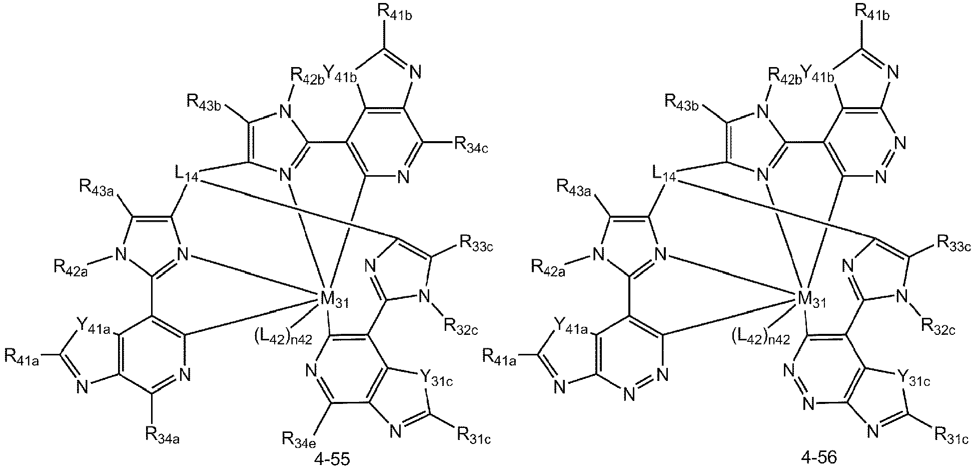

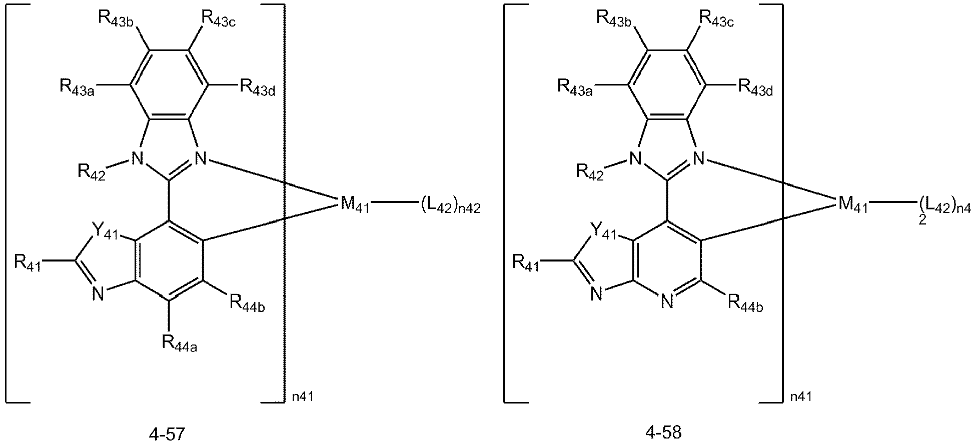

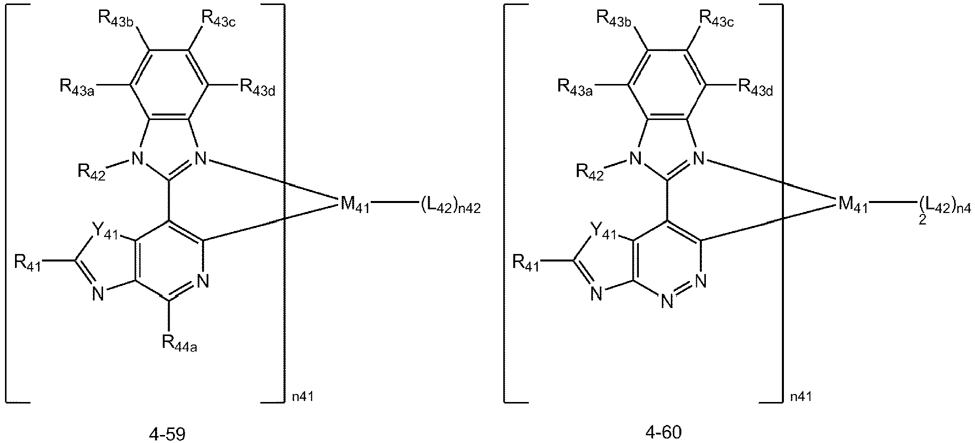

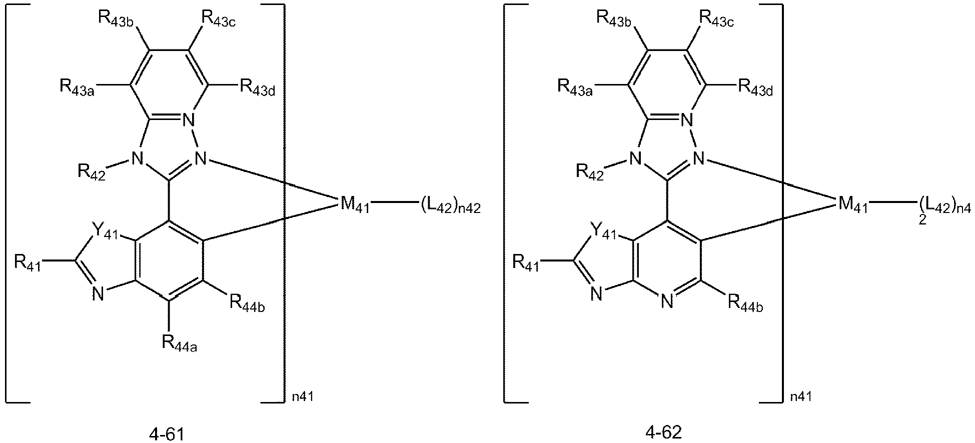

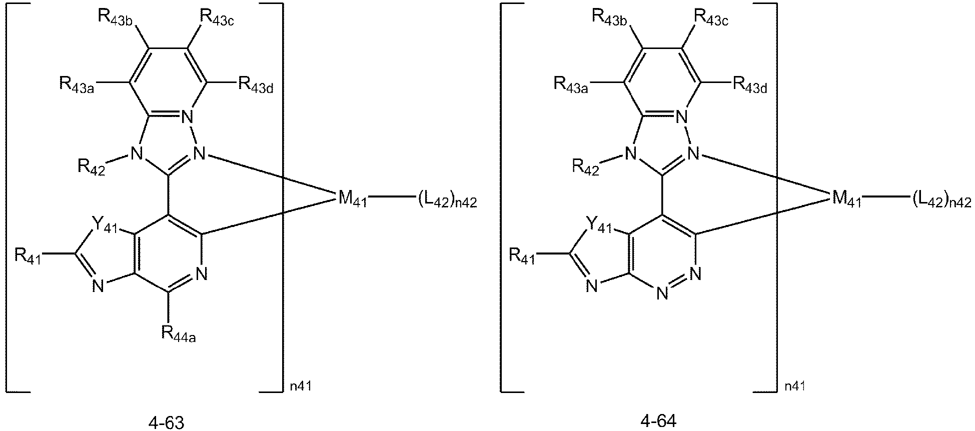

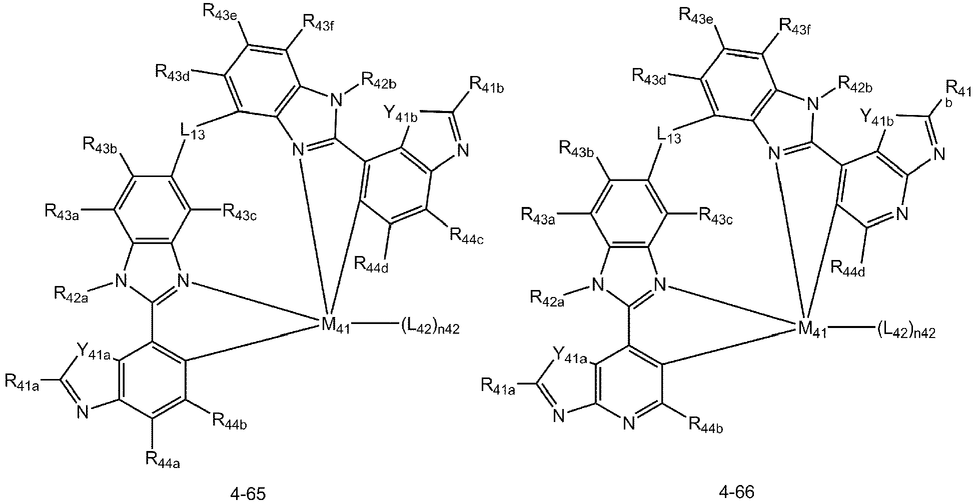

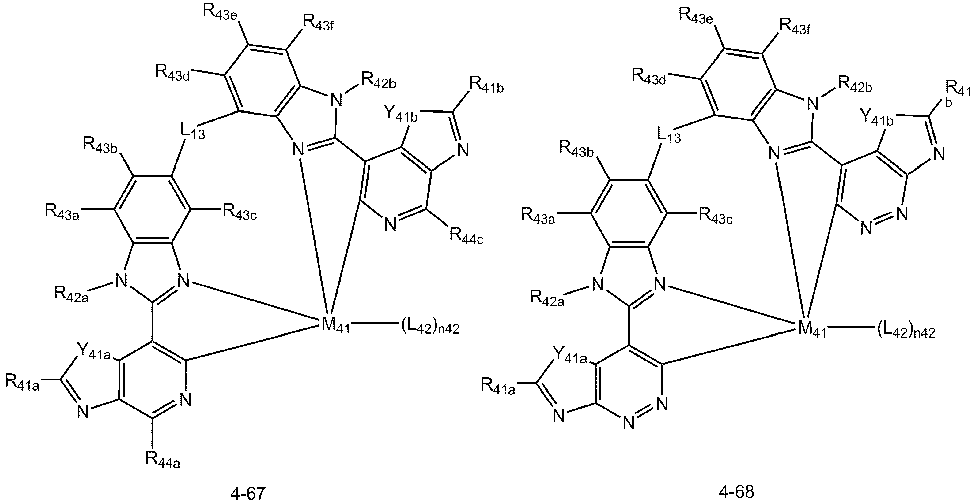

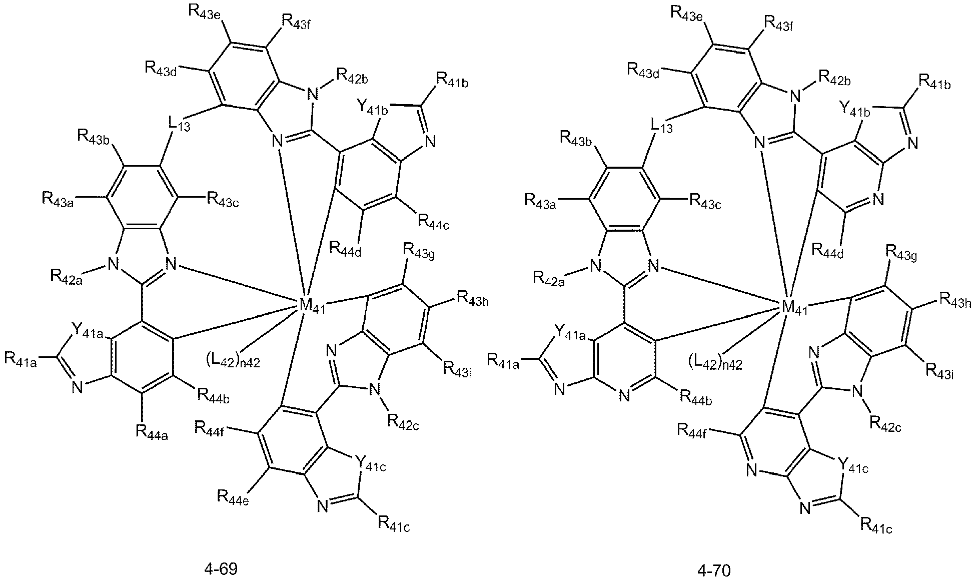

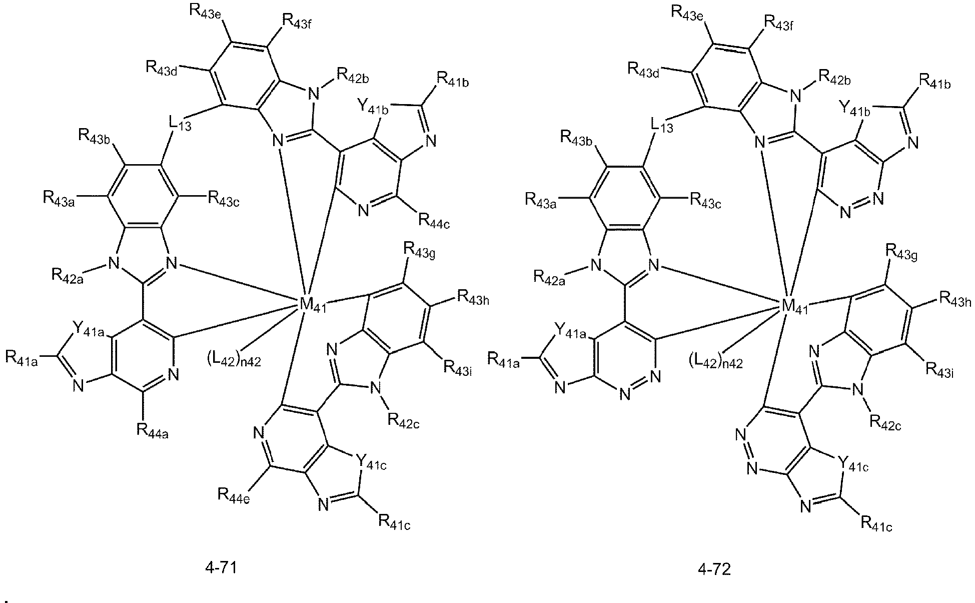

In Formulae 1-1 to 1-72, 2-1 to 2-72, 3-1 to 3-72, and 4-1 to 4-72,
R₁₃ₐ to R₁₃ᵢ are each independently the same as described in connection with R₁₃ in Formula 1,
R₁₄ₐ to R_{14f} are each independently the same as described in connection with R₁₄ in Formula 1,
Y₁₁ₐ and Y_{11c} are each independently the same as described in connection with Y₁₁ in Formula 1,
R₂₃ₐ to R₂₃ᵢ are each independently the same as described in connection with R₂₃ in Formula 2,
R₂₄ₐ to R_{24f} are each independently the same as described in connection with R₂₄ in Formula 2,
Y₂₁ₐ and Y_{21c} are each independently the same as described in connection with Y₂₁ in Formula 2,
R₃₃ₐ to R₃₃ᵢ are each independently the same as described in connection with R₃₃ in Formula 3,
R₃₄ₐ to R_{34f} are each independently the same as described in connection with R₃₄ in Formula 3,
Y₃₁ₐ and Y_{31c} are each independently the same as described in connection with Y₃₁ in Formula 3,
R₄₃ₐ to R₄₃ᵢ are each independently the same as described in connection with R₄₃ in Formula 4,
R₄₄ₐ to R_{44f} are each independently the same as described in connection with R₄₄ in Formula 4,
Y₄₁ₐ and Y_{41c} are each independently the same as described in connection with Y₄₁ in Formula 4,
L₁₃ may be selected from *-O-*', *-S-*', *-[C(R₁₉)(R₂₀)]ₖ₁₁-*', *-[Si(R₁₉)(R₂₀)]ₖ₁₁-*', and a substituted or unsubstituted benzene group,
L₁₄ may be selected from 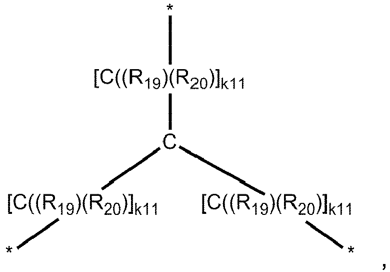 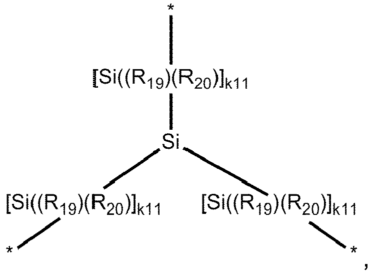 and a substituted or unsubstituted benzene group, and
R₁₉ and R₂₀ are each independently the same as described in connection with R₁₁, and k11 may be selected from 1, 2, and 3.

The organometallic compound represented by one of Formulae 1 to 4 may be selected from Compounds 1 to 782, but embodiments of the present disclosure are not limited thereto:

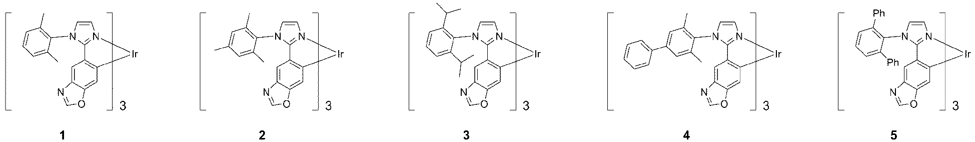

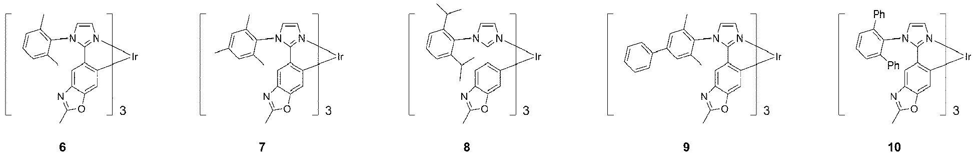

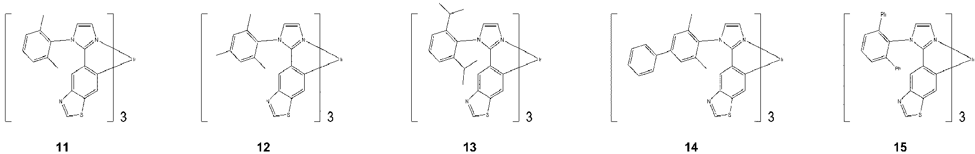

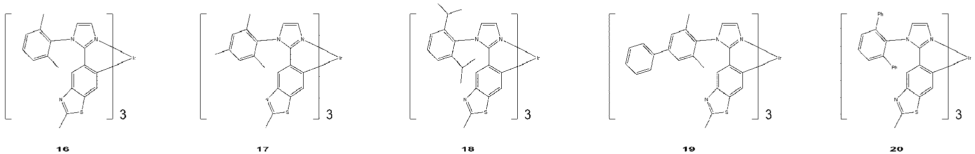

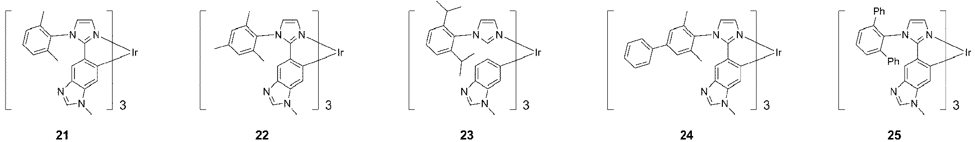

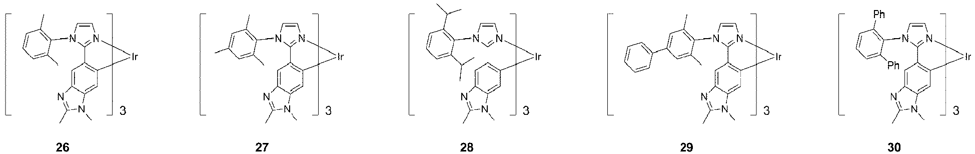

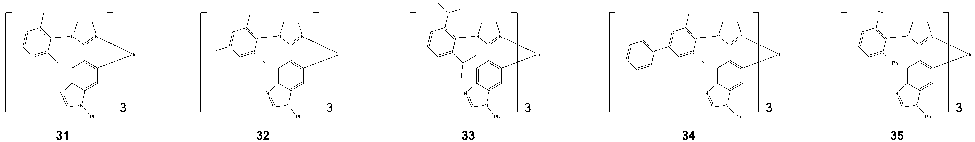

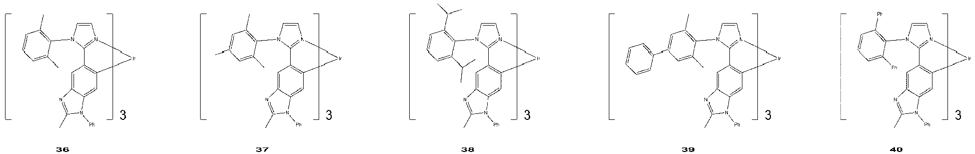

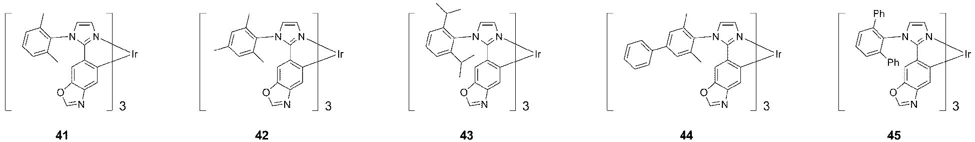

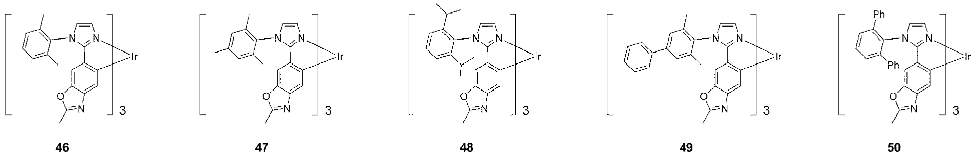

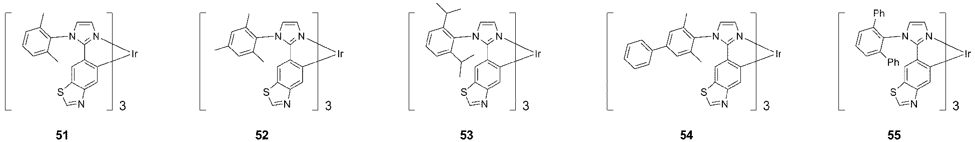

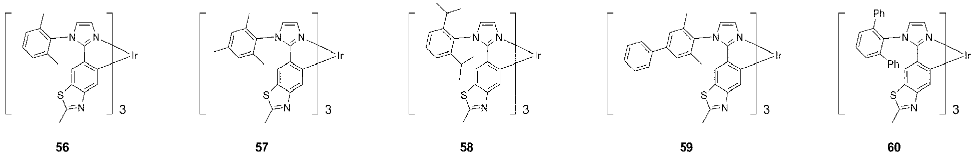

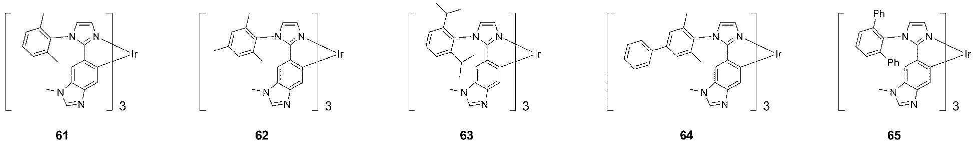

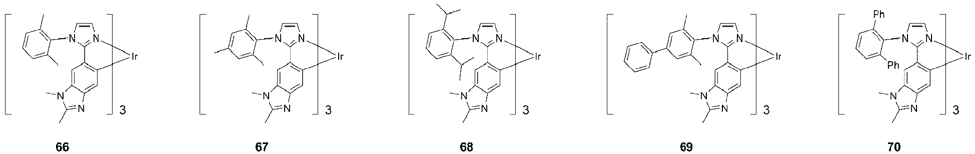

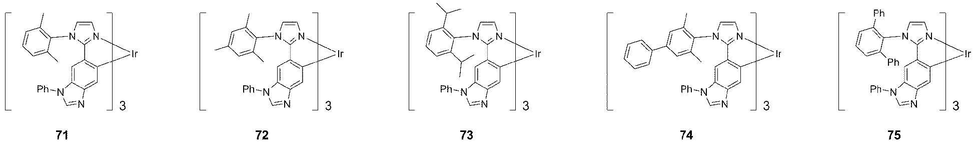

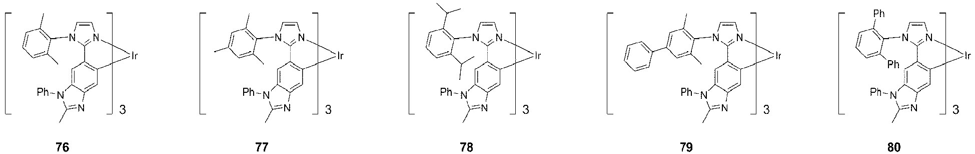

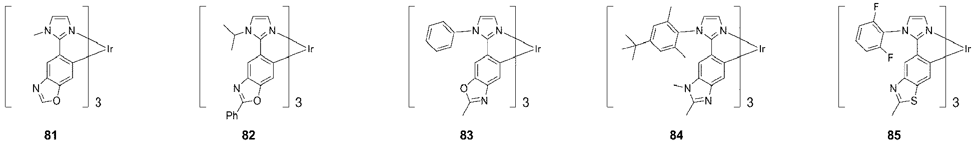

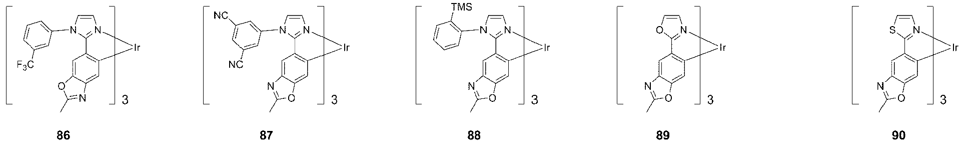

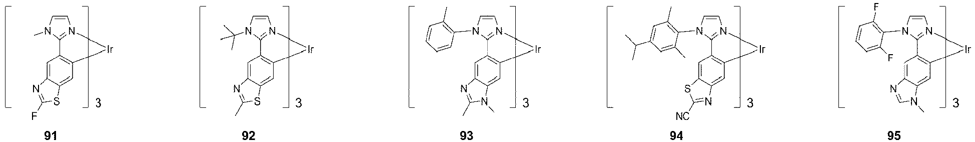

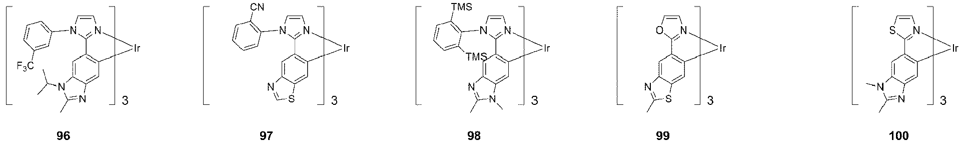

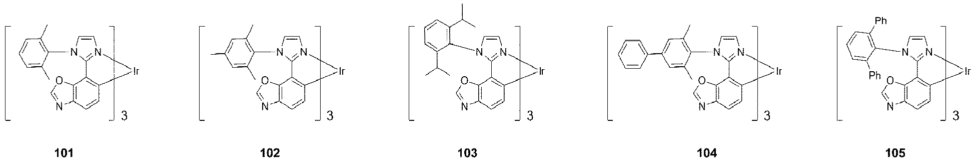

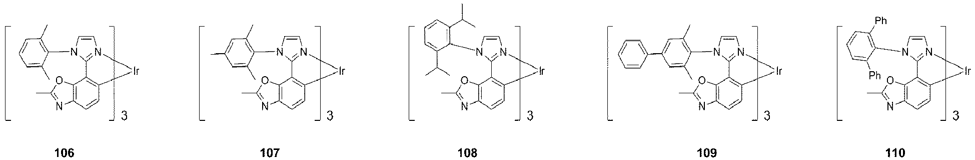

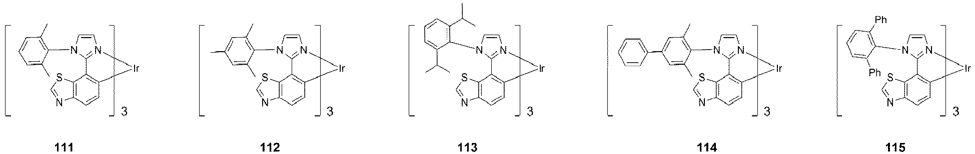

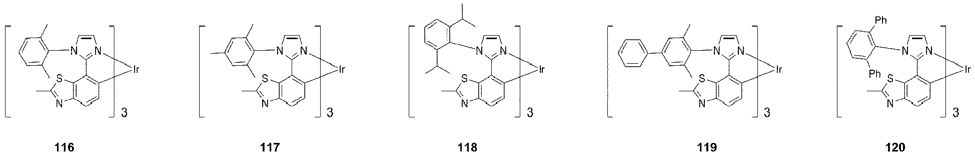

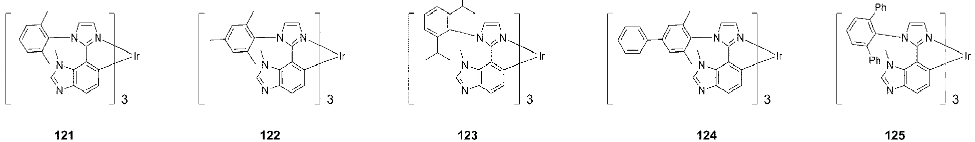

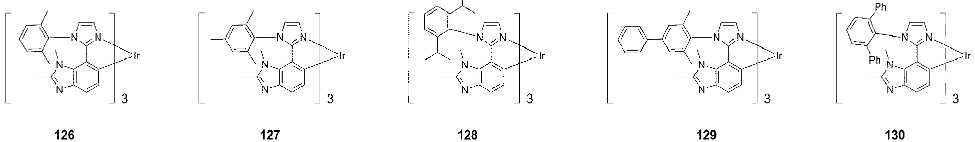

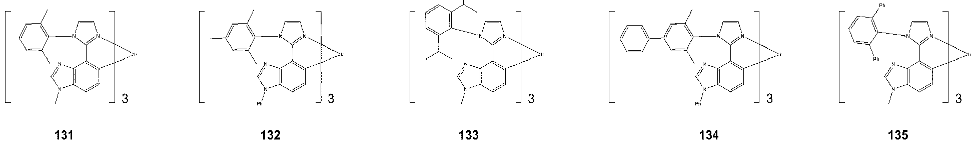

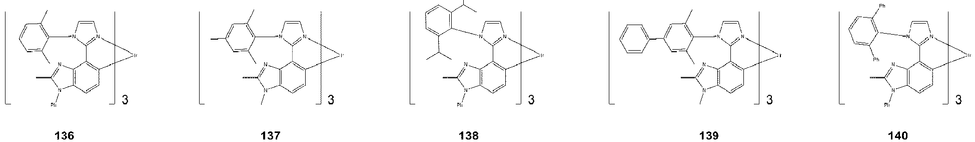

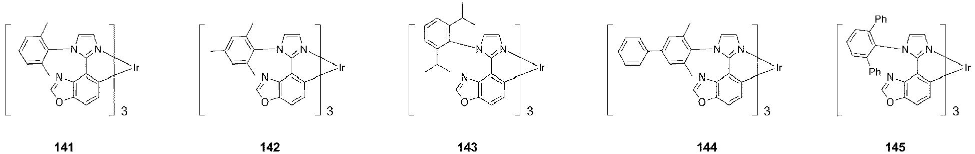

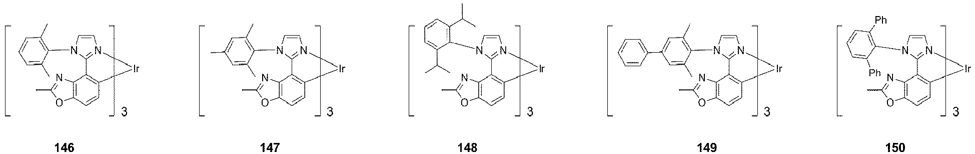

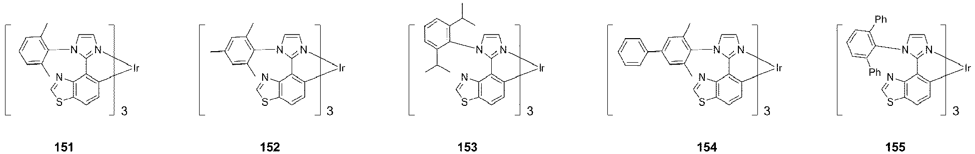

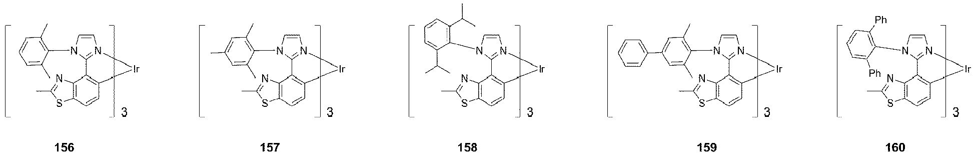

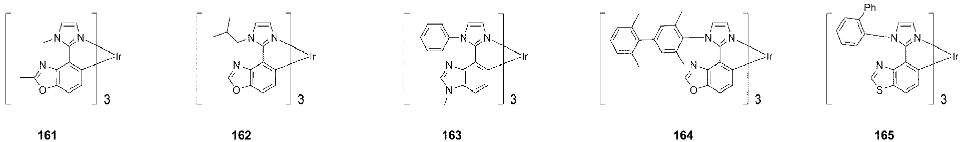

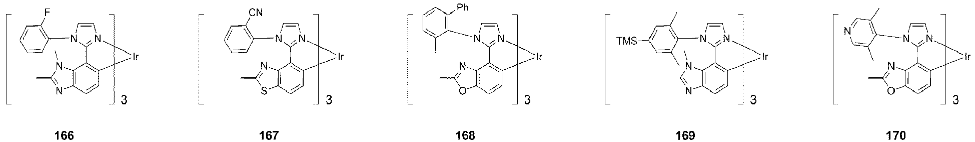

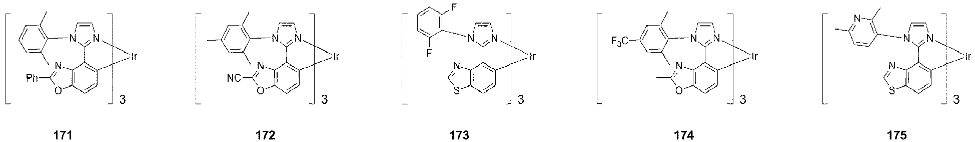

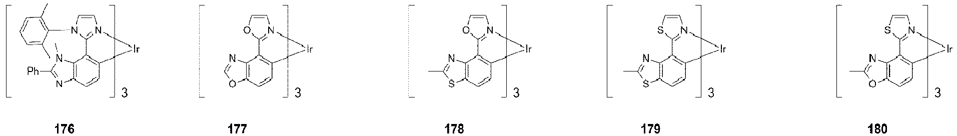

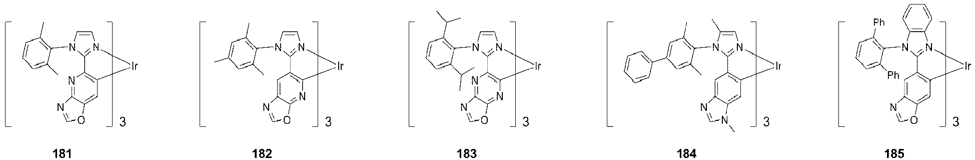

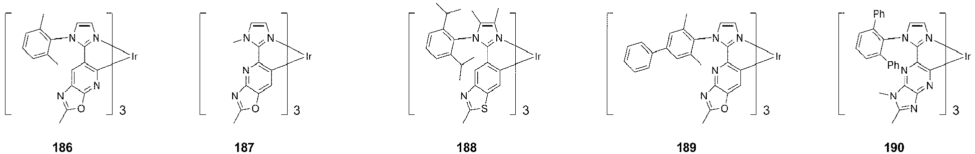

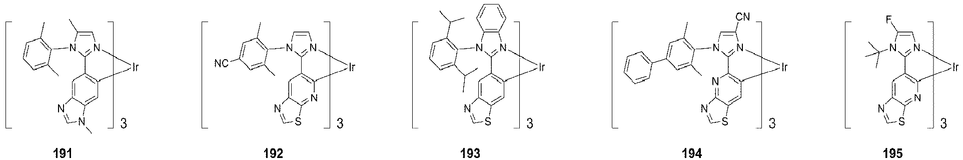

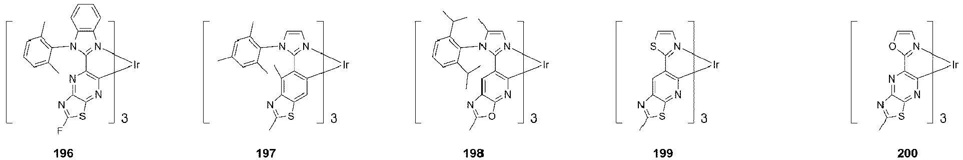

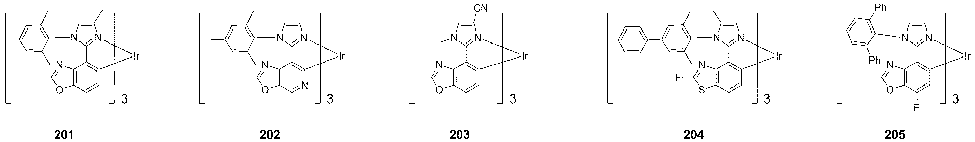

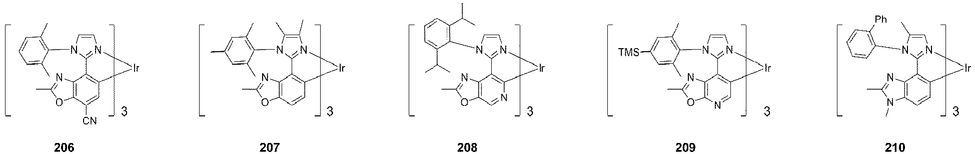

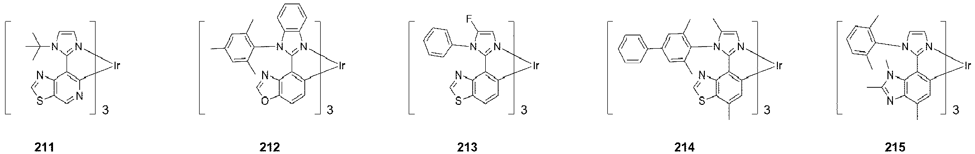

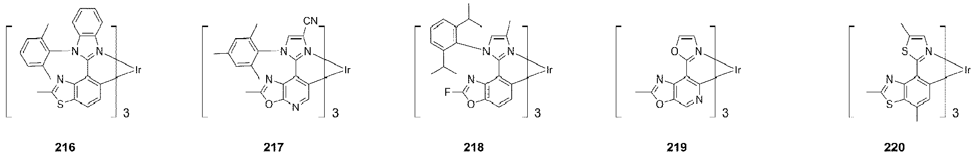

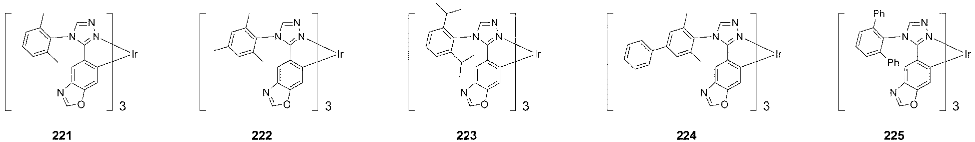

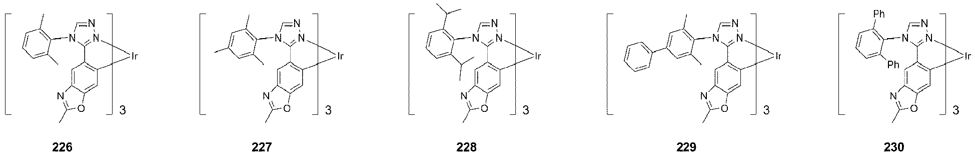

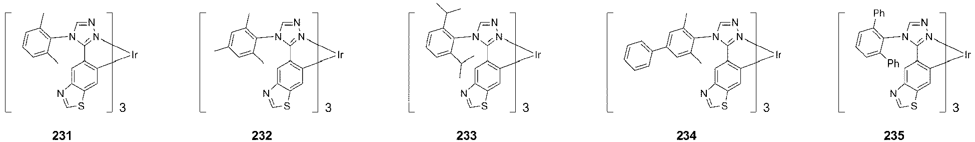

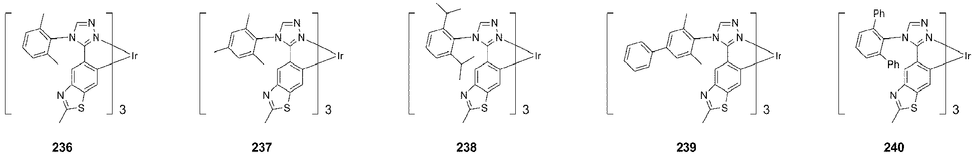

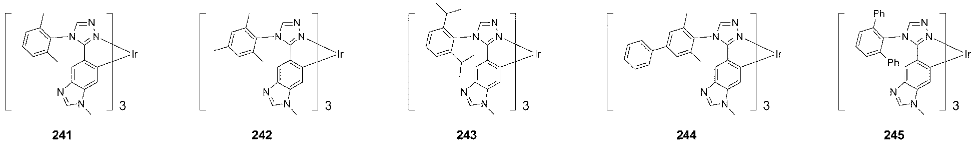

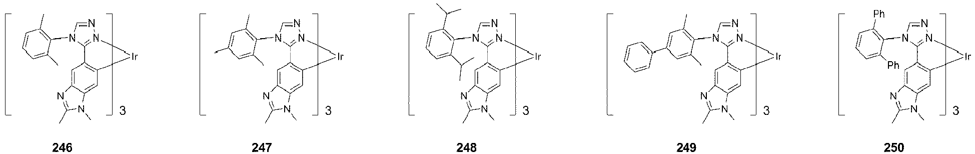

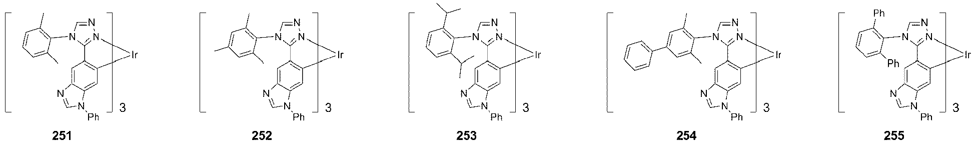

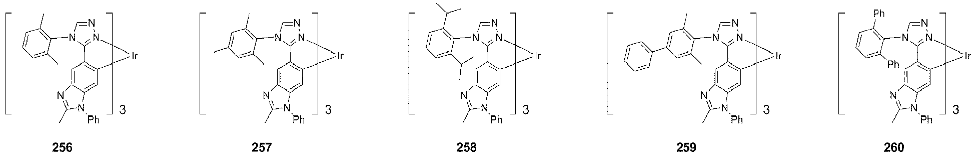

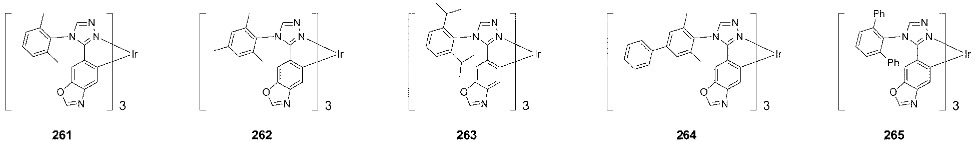

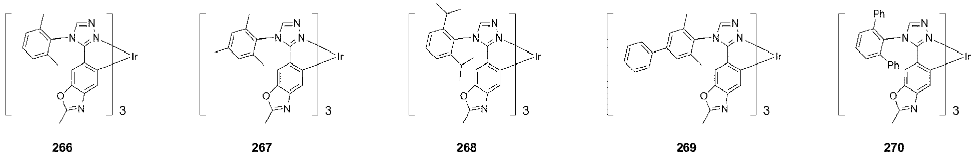

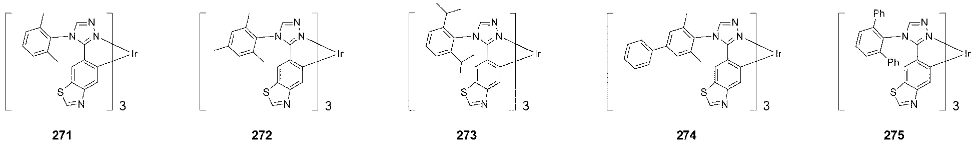

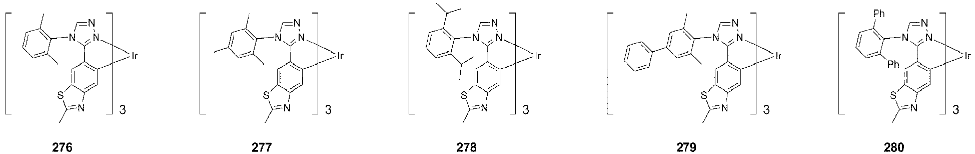

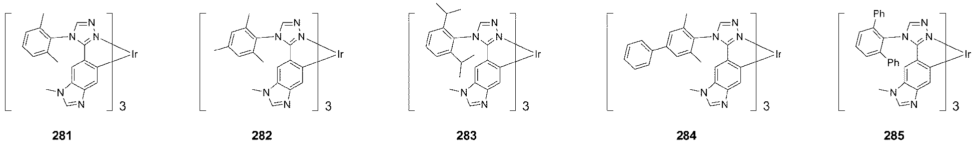

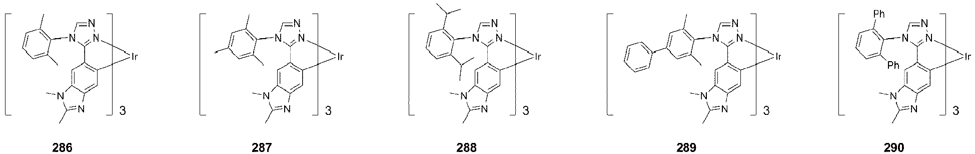

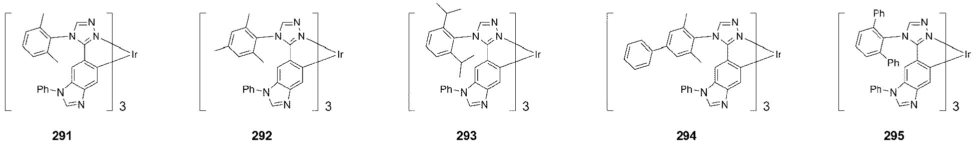

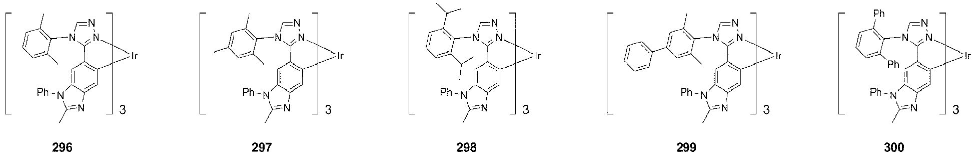

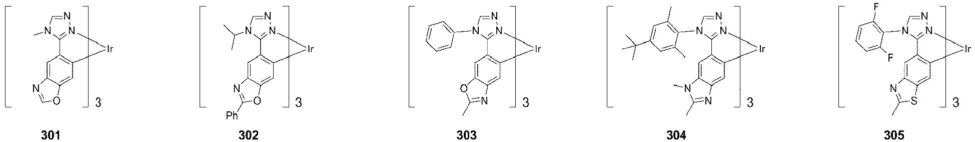

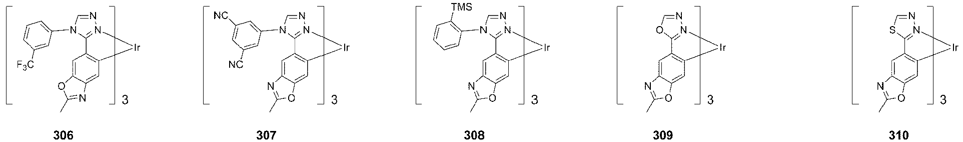

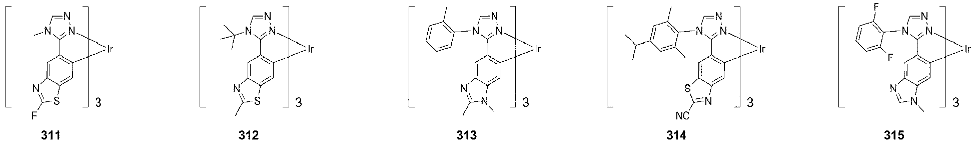

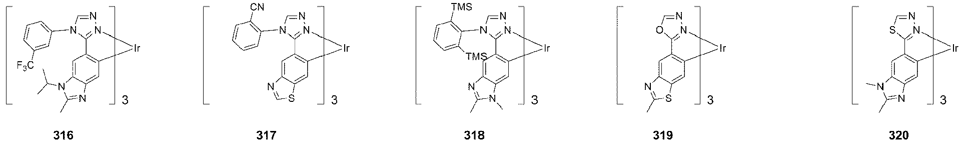

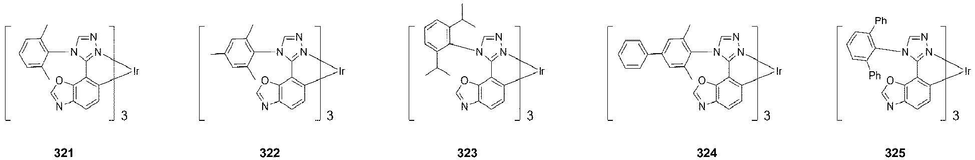

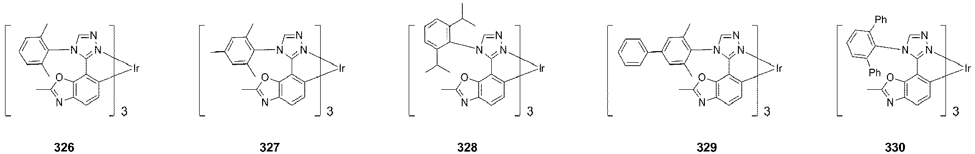

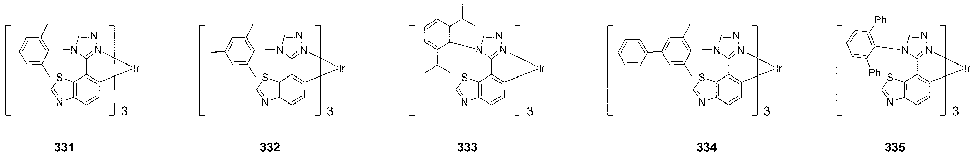

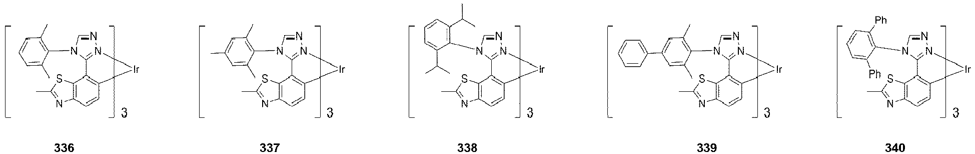

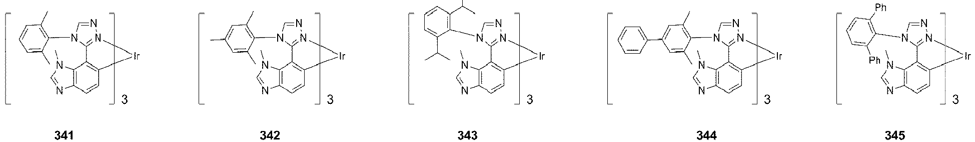

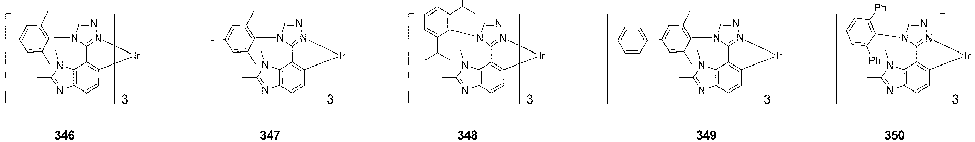

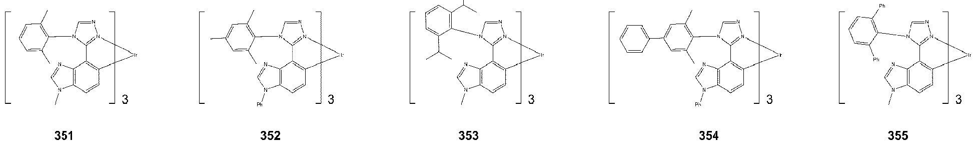

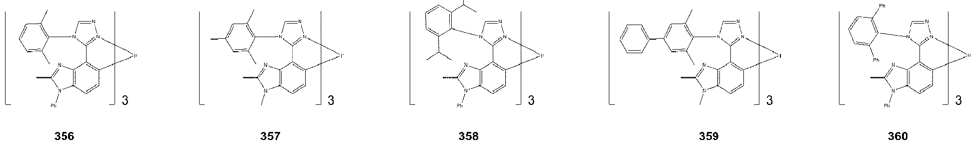

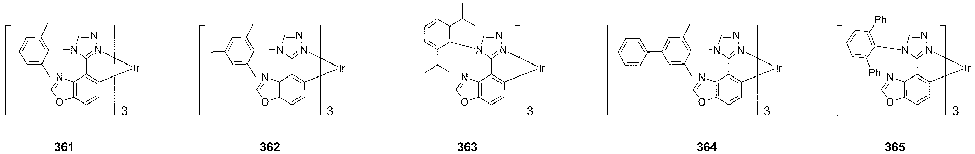

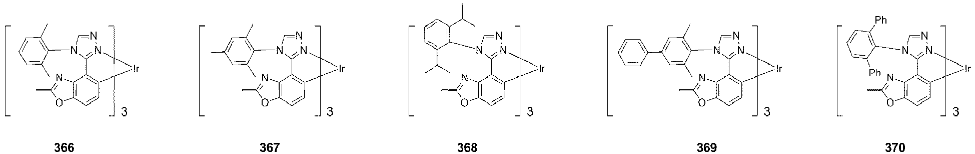

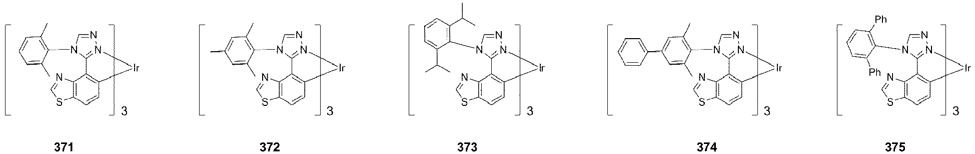

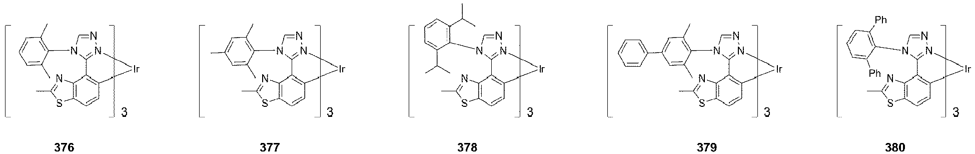

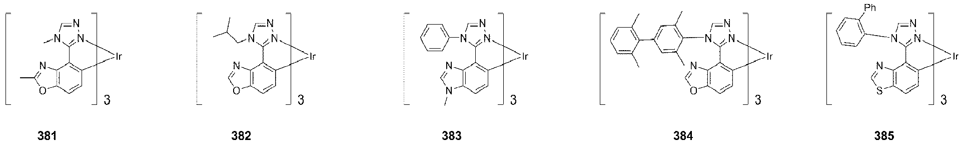

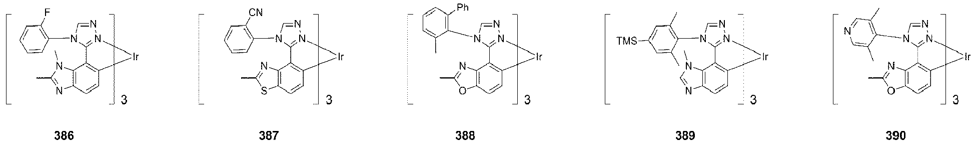

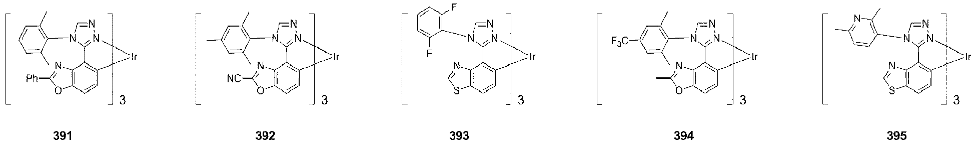

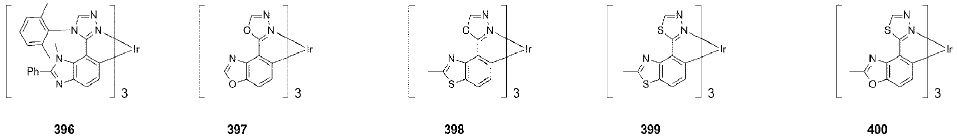

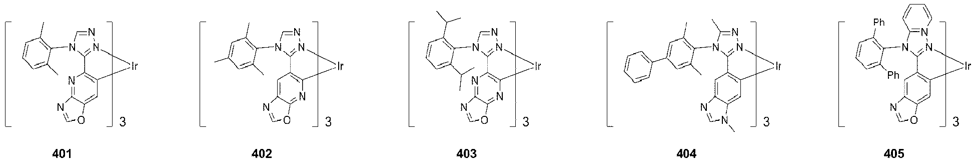

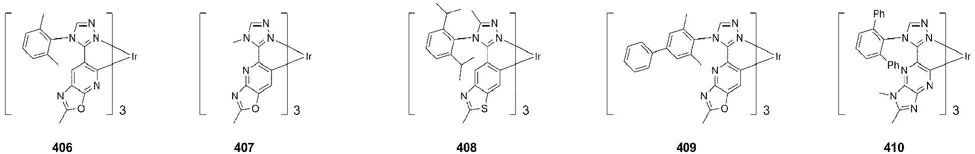

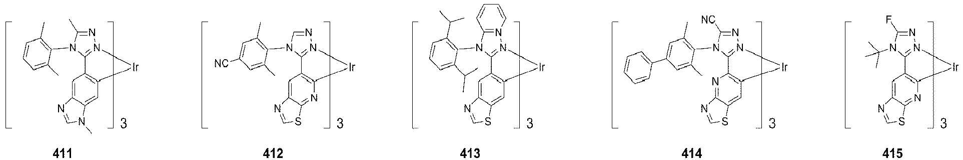

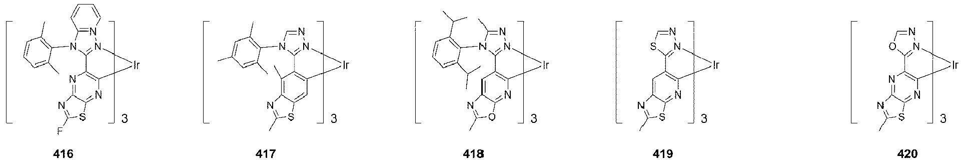

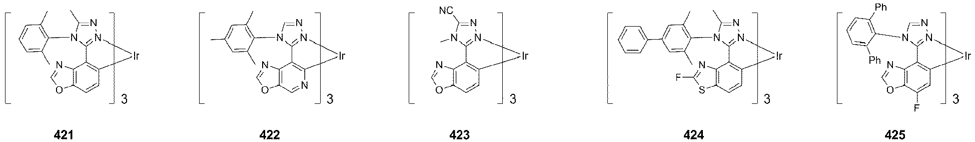

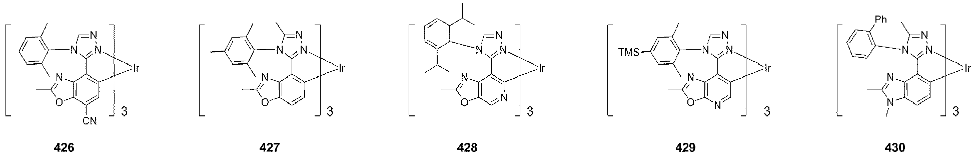

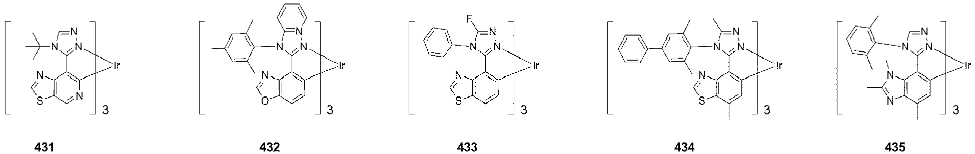

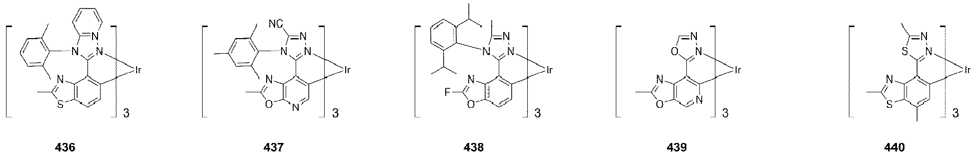

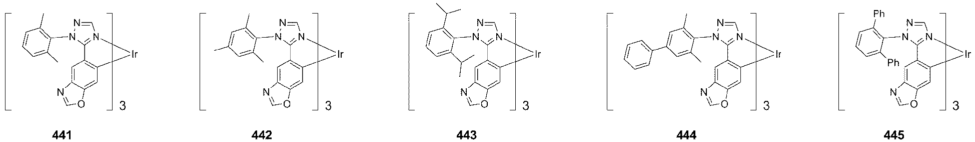

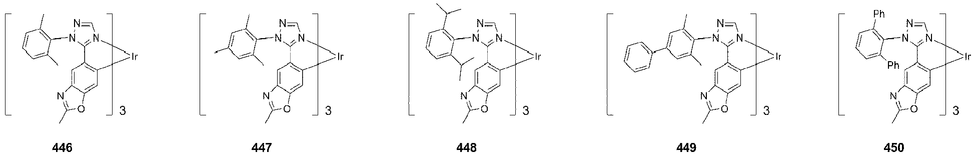

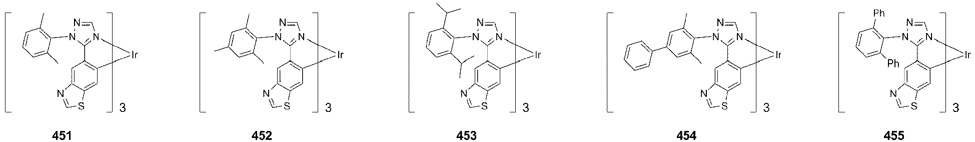

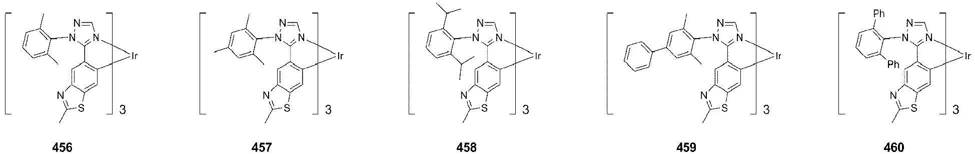

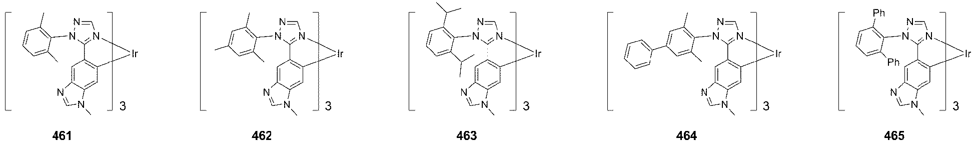

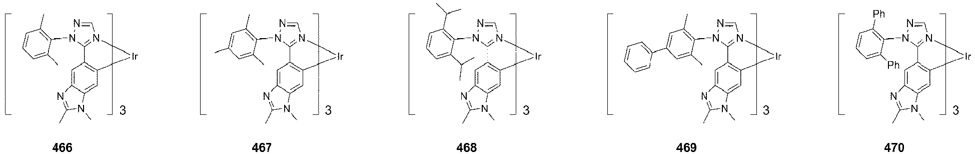

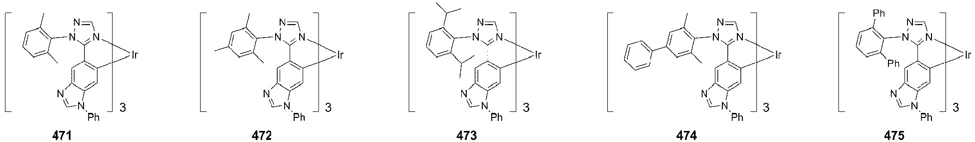

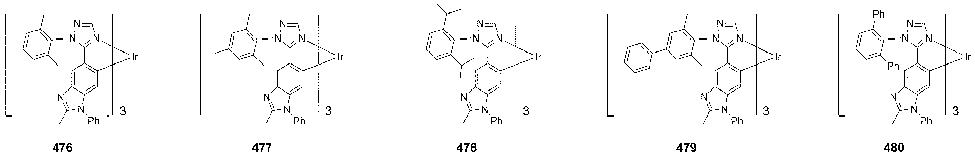

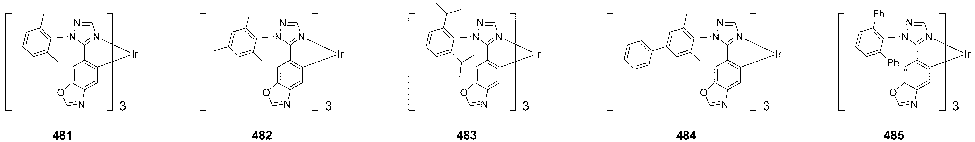

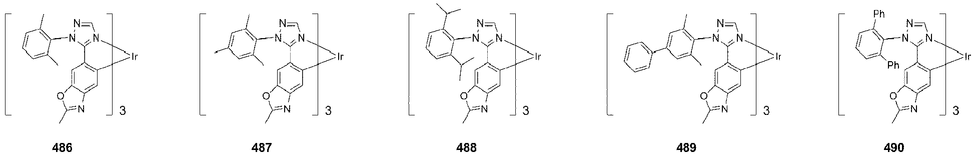

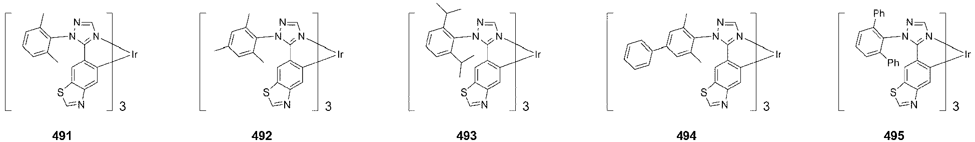

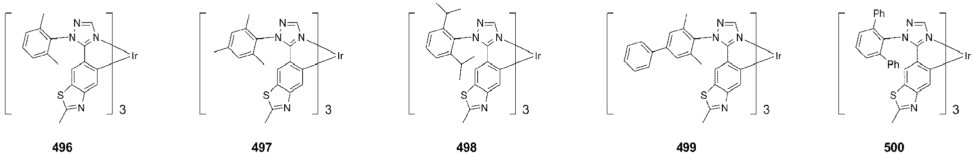

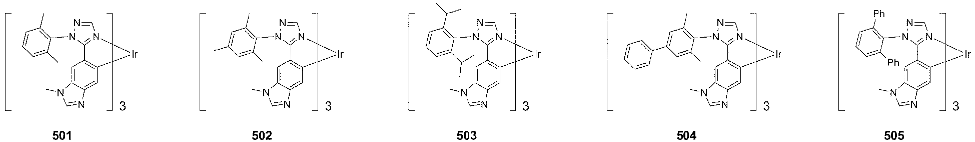

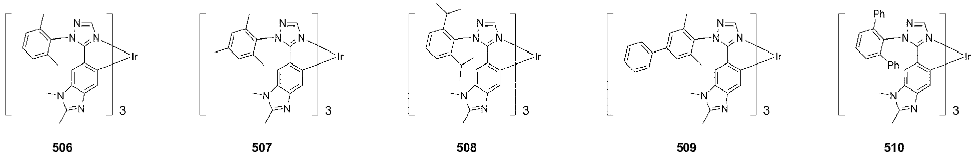

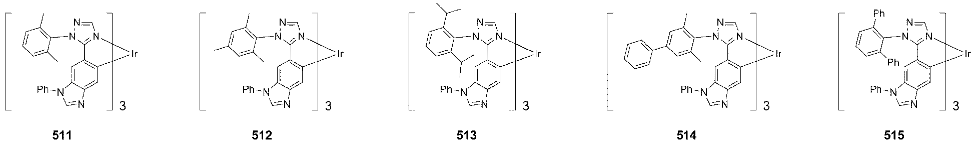

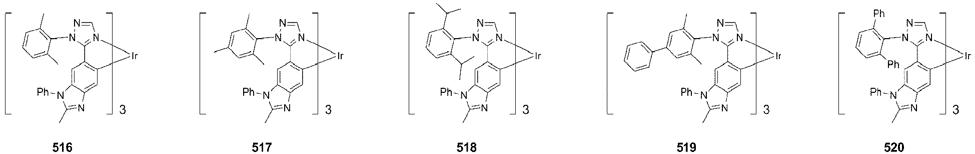

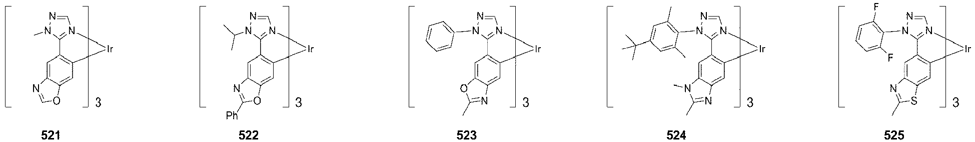

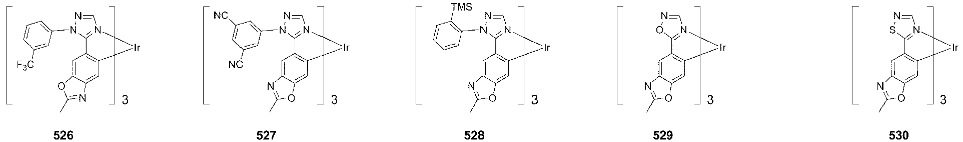

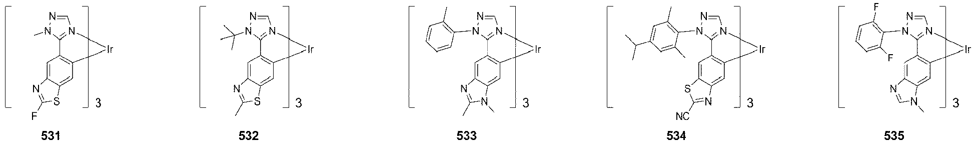

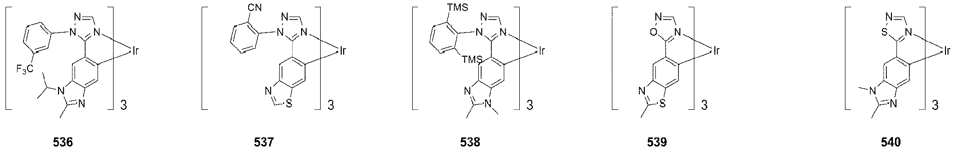

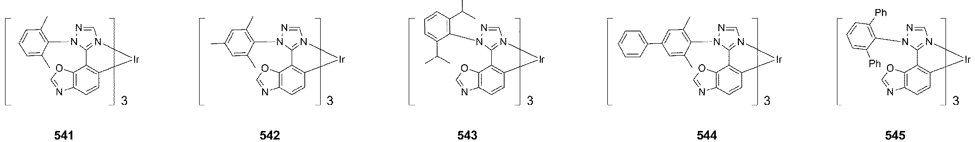

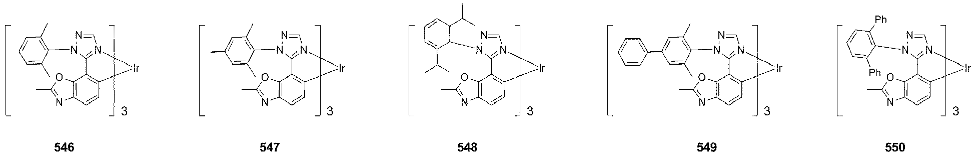

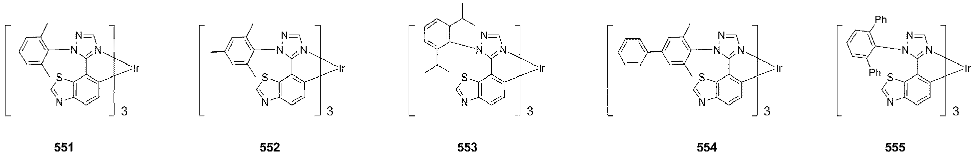

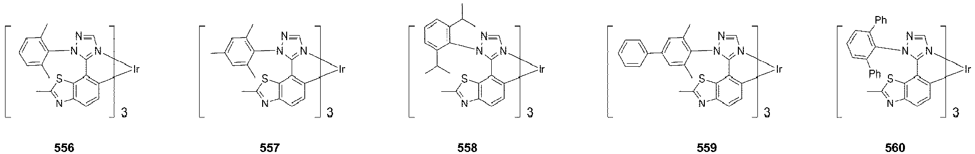

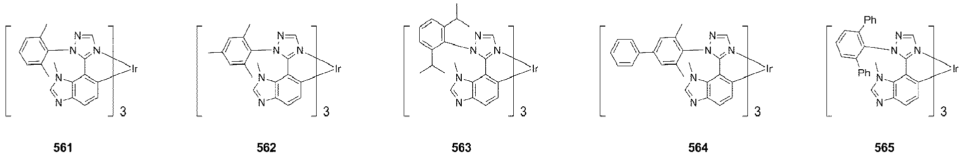

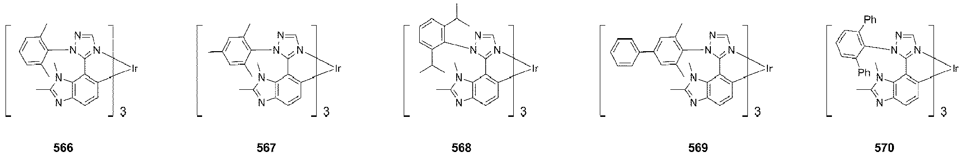

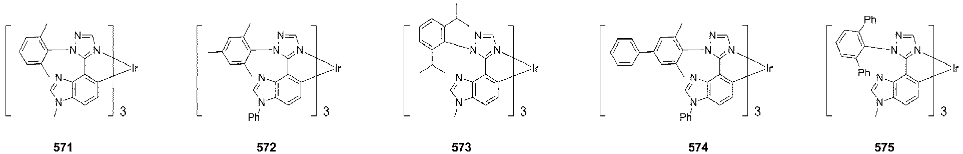

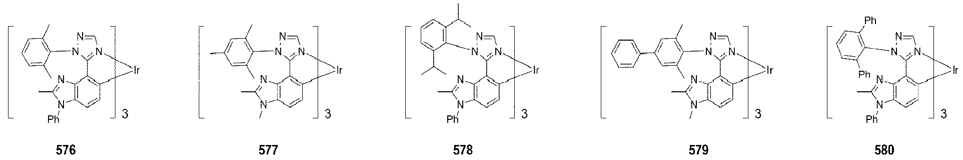

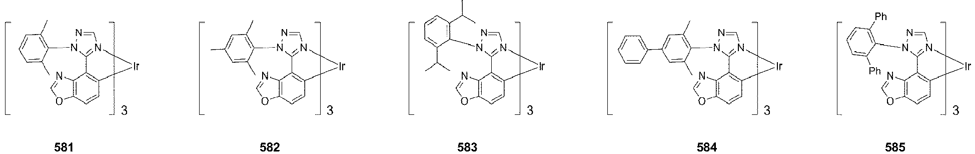

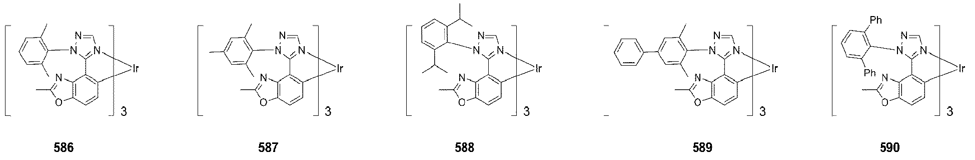

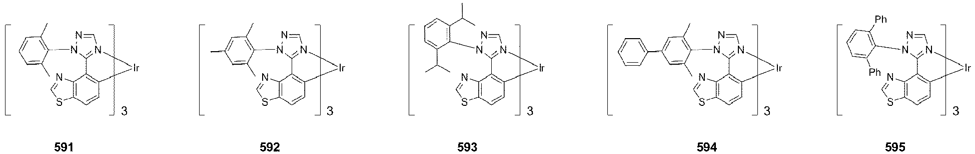

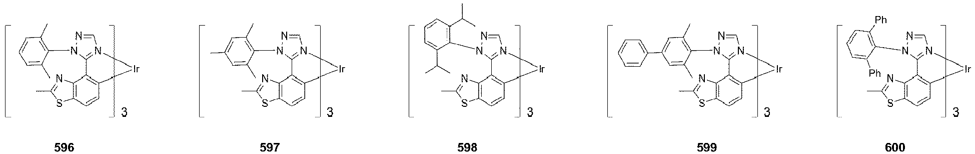

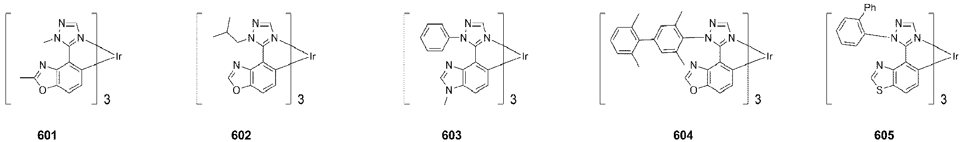

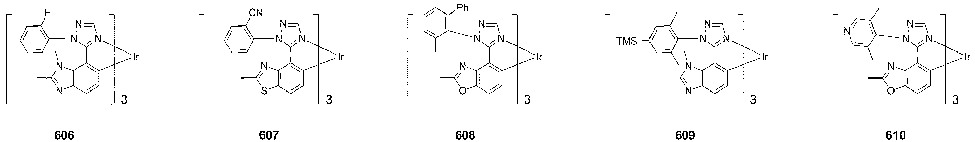

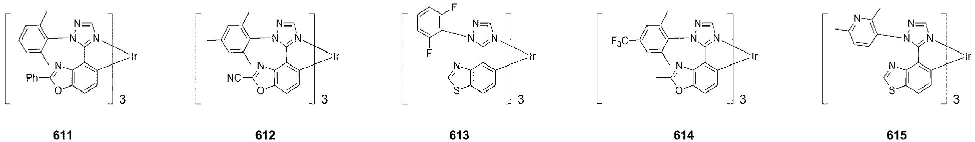

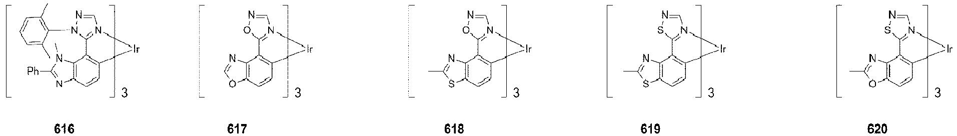

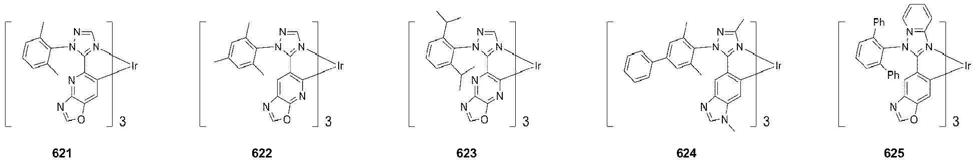

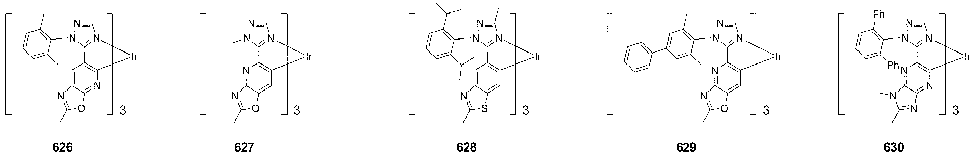

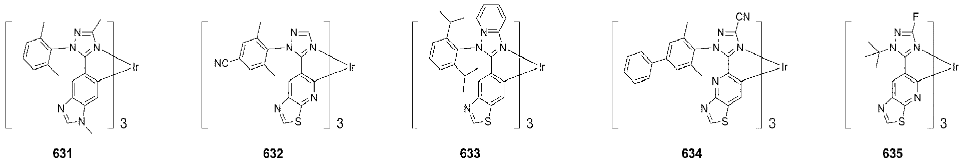

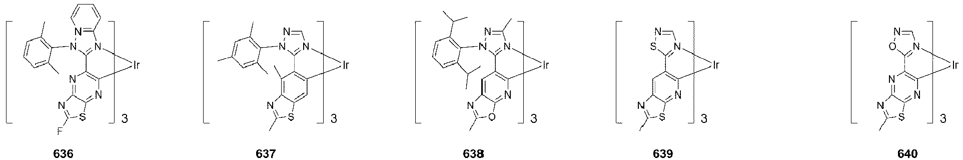

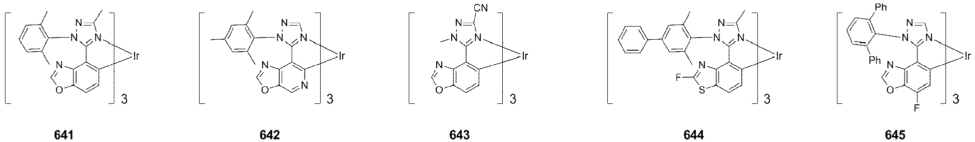

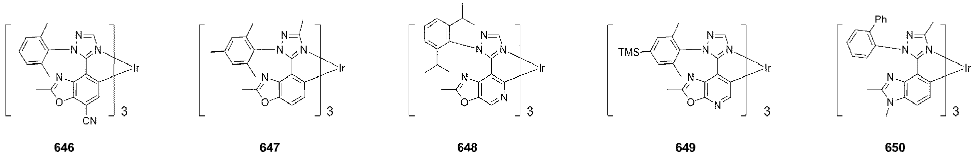

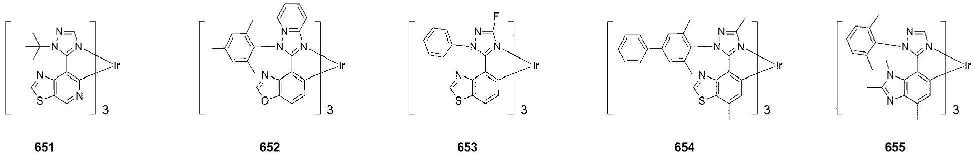

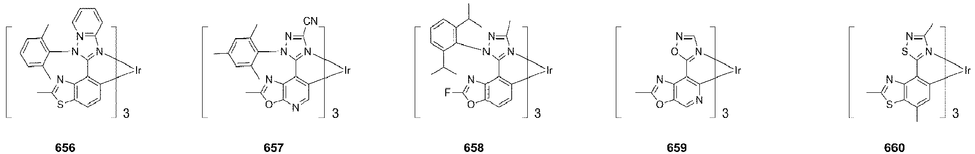

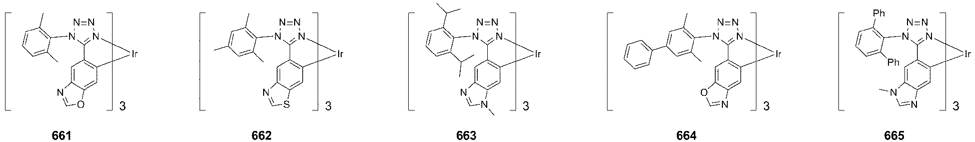

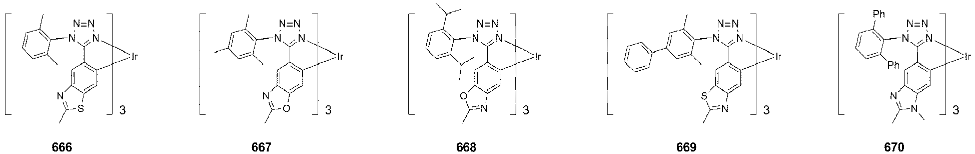

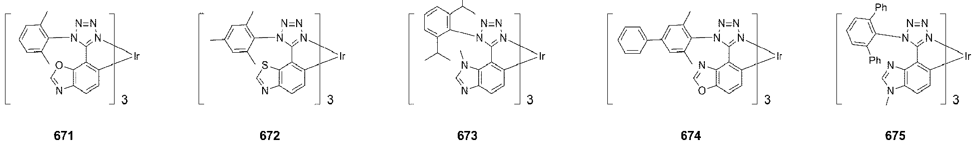

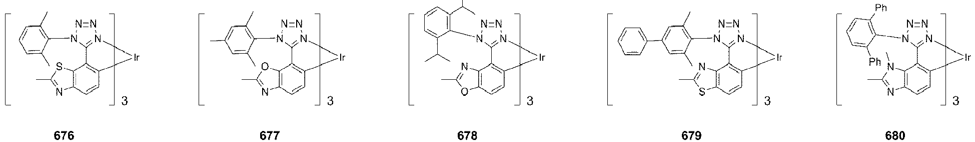

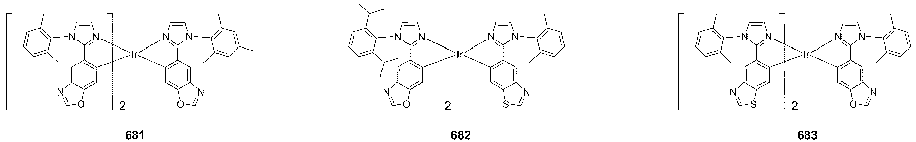

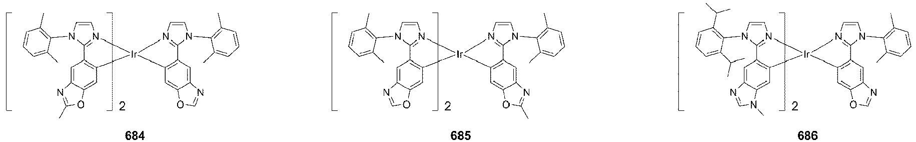

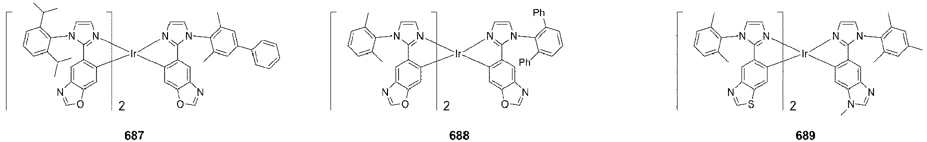

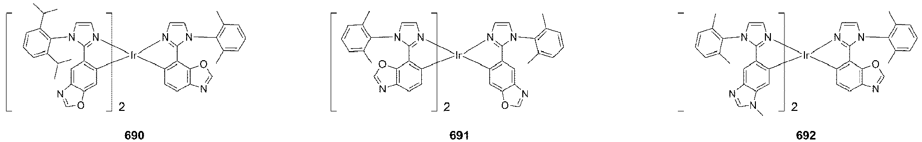

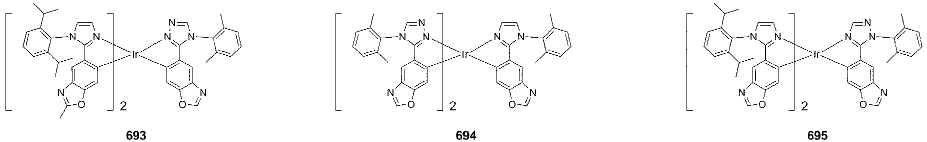

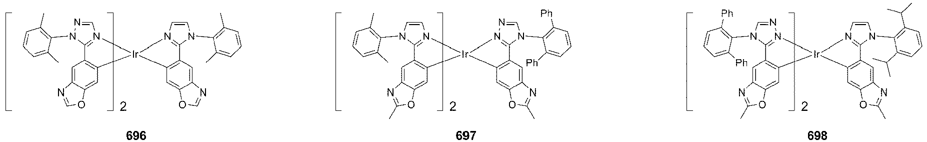

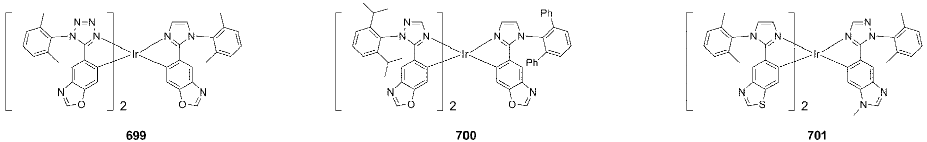

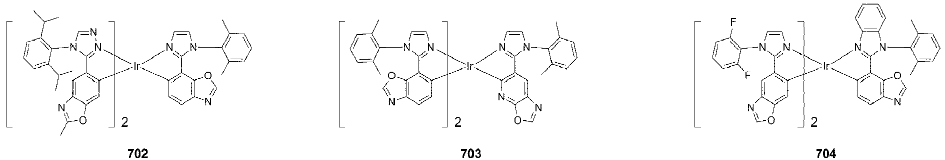

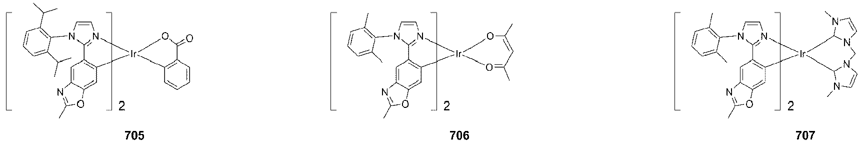

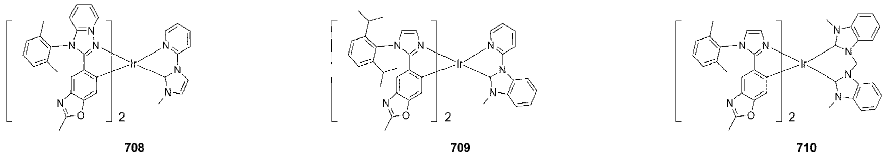

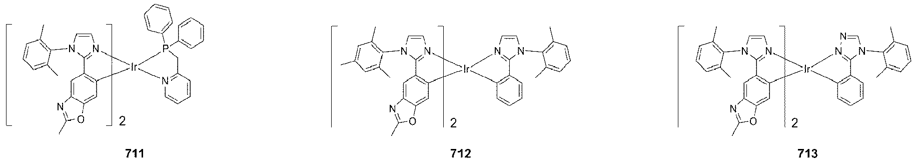

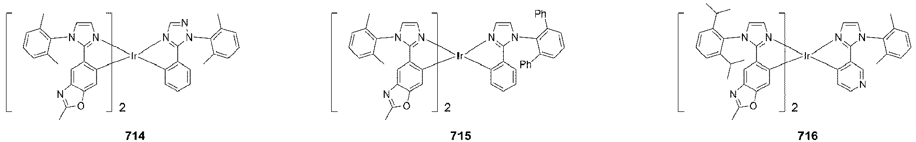

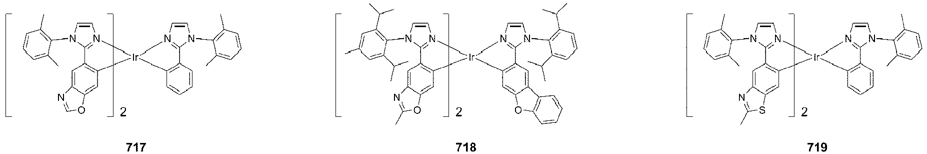

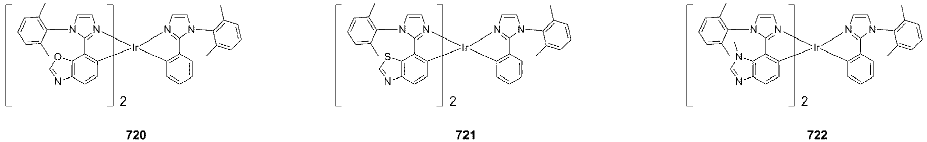

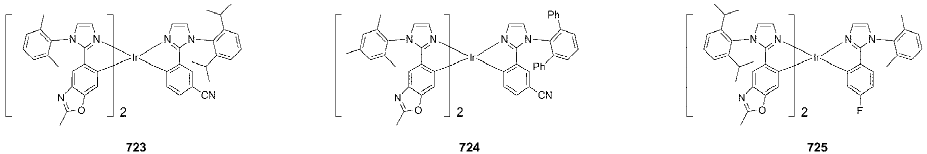

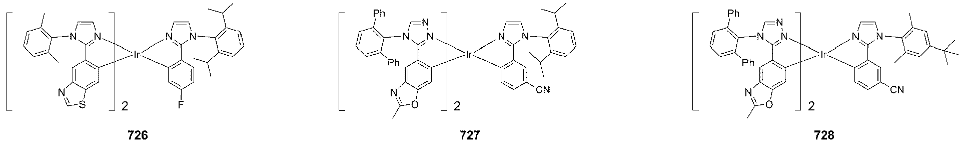

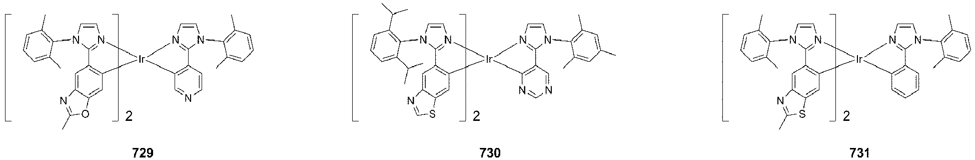

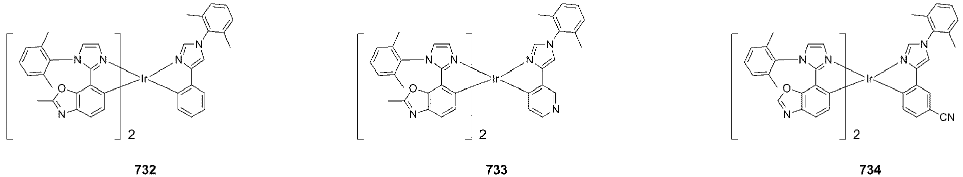

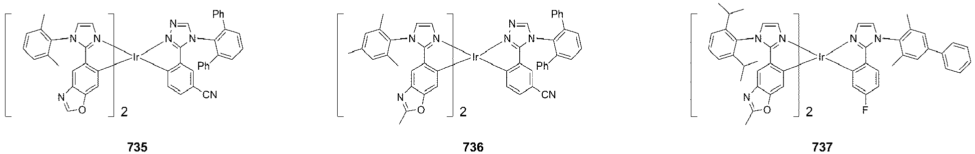

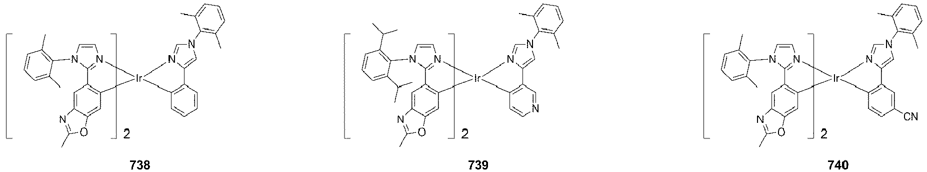

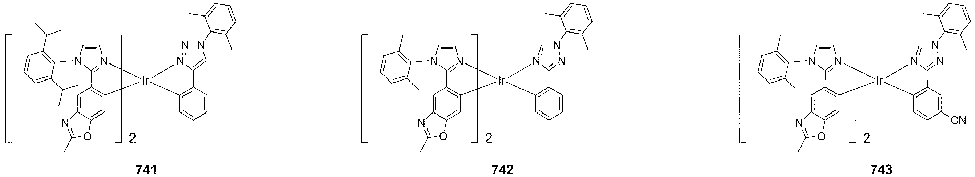

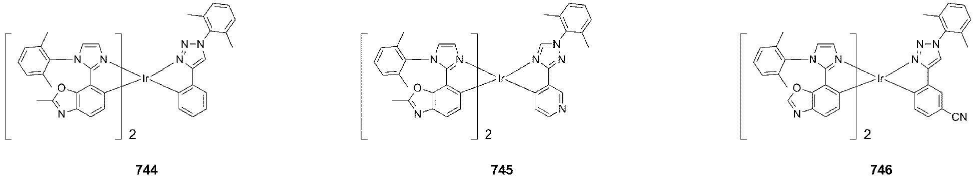

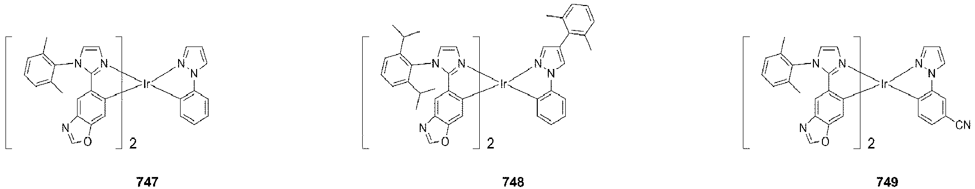

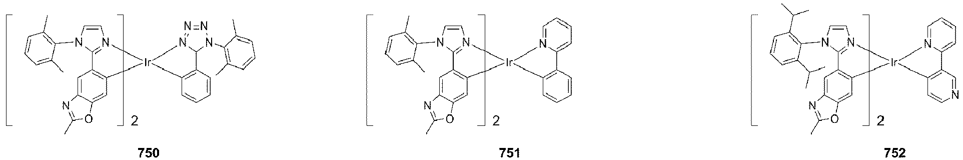

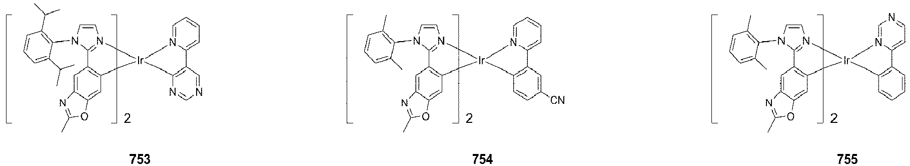

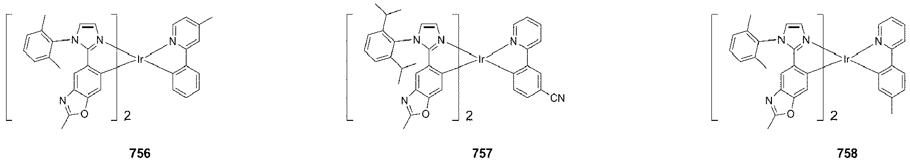

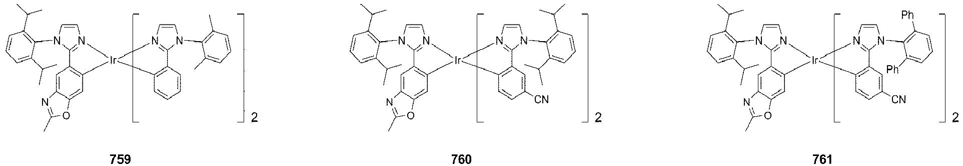

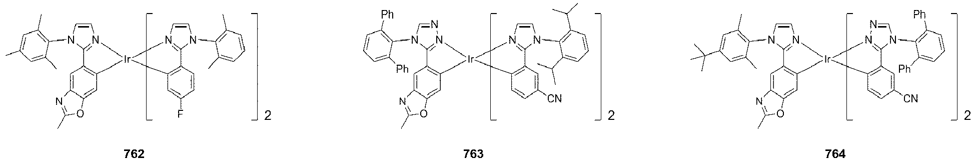

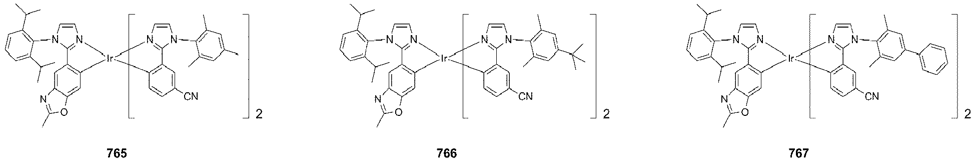

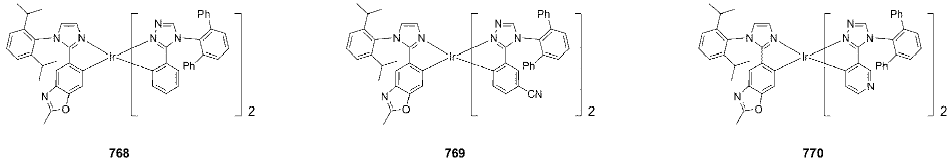

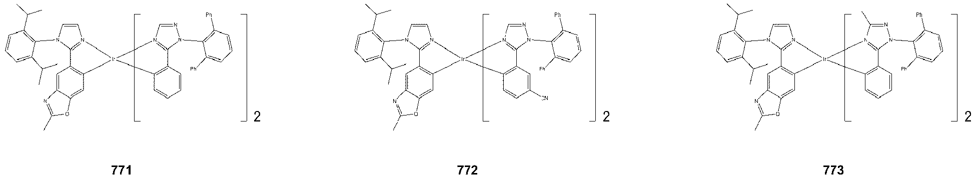

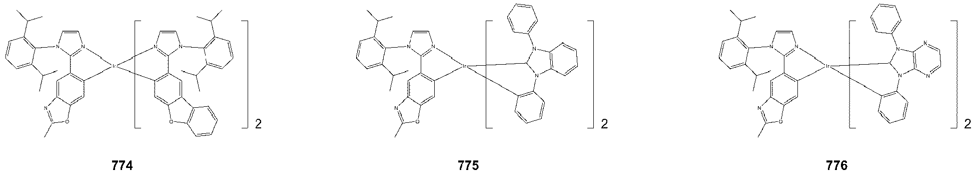

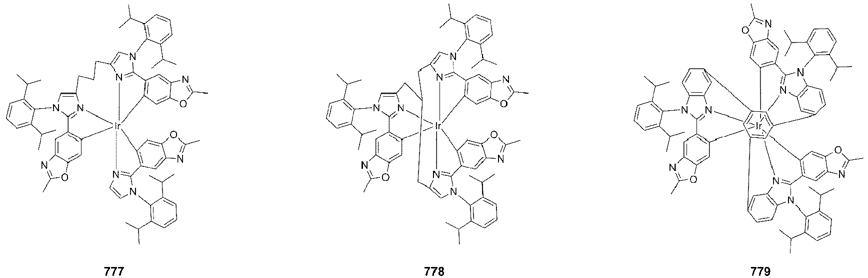

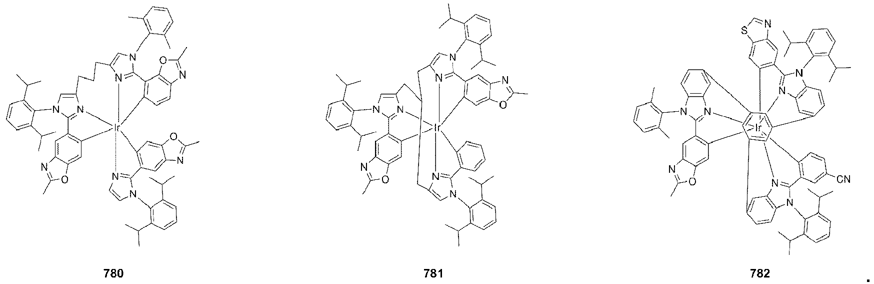

The organometallic compound represented by one of Formulae 1 to 4 may have a maximum emission wavelength (actually measured value) in a range of greater than or equal to about 420 nanometers (nm) and less than about 520 nm, for example, about 420 nm to about 495 nm. For example, when the maximum emission wavelength is about 420 nm to about 475 nm, an organic light-emitting device that emits deep blue light may be provided.

The organometallic compounds represented by Formulae 1 to 4 essentially include N at a specific position (see Formulae 1' to 4').

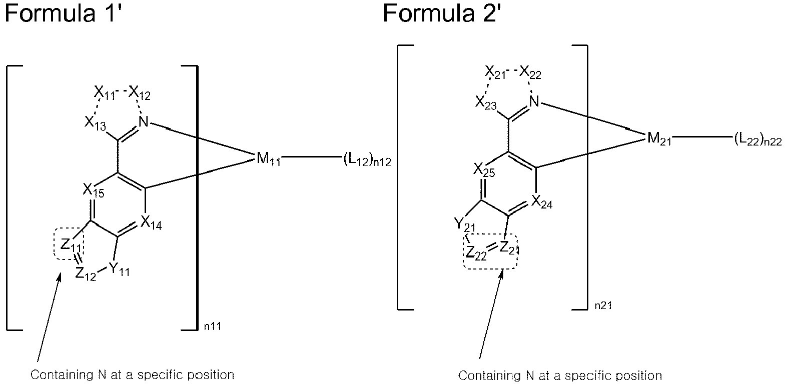

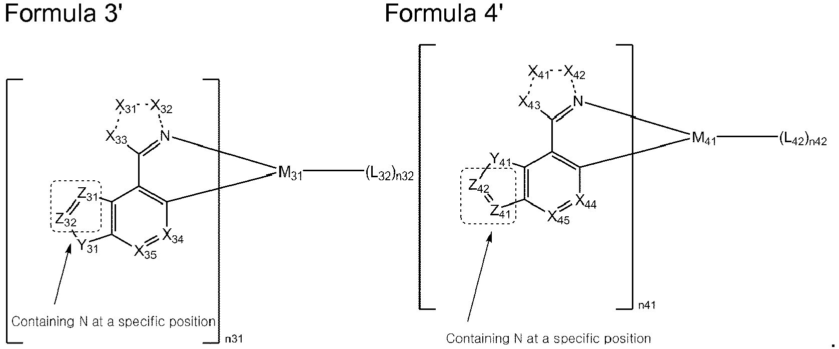

Since the organometallic compound represented by one of Formulae 1 to 4 reduces an electron density of a metal element represented by M₁₁ or the like, a T₁ energy level of the organometallic compound may increase to a level appropriate to emit blue light. Specifically, although a T₁ energy level of Compound A is about 2.28 eV, the organometallic compound represented by one of Formulae 1 to 4 may be higher than a T₁ energy level of Compound A.

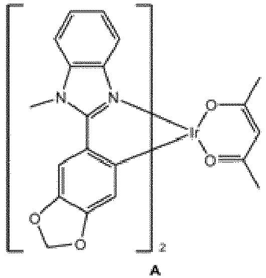

The organometallic compounds represented by Formulae 1 to 4 essentially include a 5-membered ring with N condensed at a specific position (see Formulae 1" to 4").

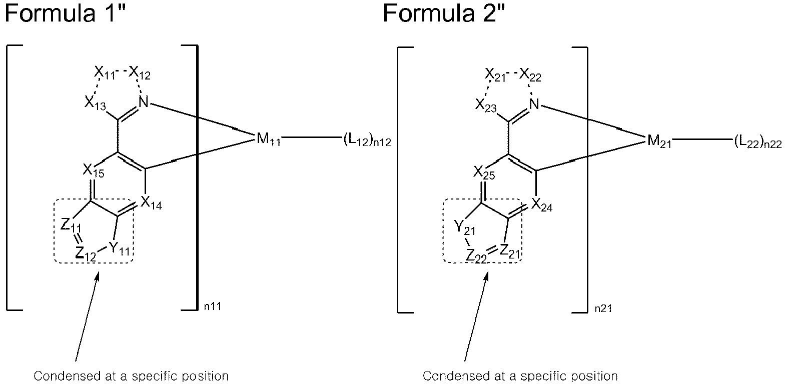

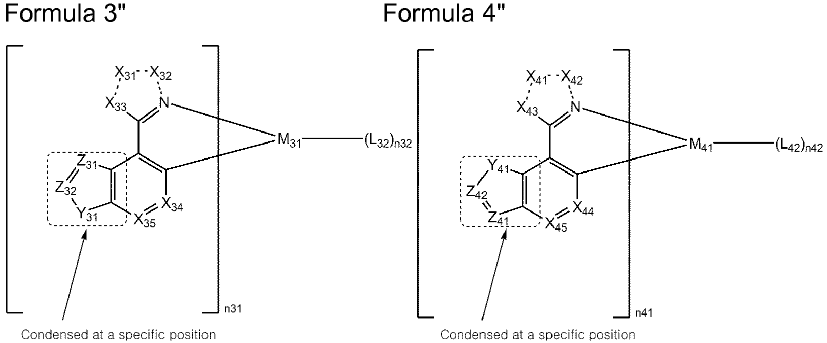

As described above, the organometallic compound represented by one of Formulae 1 to 4 may have a highest occupied molecular orbital (HOMO) energy level and a lowest unoccupied molecular orbital (LUMO) energy level, which are appropriate to manufacture an organic light-emitting device. Specifically, since Compound B has a relatively shallow HOMO energy level and a relatively shallow LUMO energy level and thus is easily oxidized, an organic light-emitting device including Compound B may have a short lifespan. However, since the organometallic compound represented by one of Formulae 1 to 4 has a relatively deep HOMO energy level and a relatively deep LUMO energy level, an organic light-emitting device including the organometallic compound may have a long lifespan.

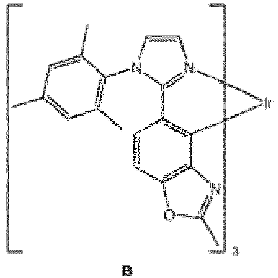

Also, the organometallic compound represented by one of Formulae 1 to 4 has a ligand essentially including one of an imidazole, a triazole, and a tetrazole and one of a benzoxazole, a benzothiazole, and a benzimidazole.

Hence, the organometallic compound represented by one of Formulae 1 to 4 may have a triplet energy level suitable for blue light and have a relatively short fluorescence lifespan. Therefore, the organometallic compound represented by one of Formulae 1 to 4 may provide a blue dopant having high absolute quantum yield. HOMO, LUMO, and T₁ energy levels of some compounds in the organometallic compound represented by one of Formulae 1 to 4 were evaluated by Gaussian 09 program accompanying molecular structure optimization through B3LYP-based density functional theory (DFT: structurally optimized at a level of B3LYP, 6-31 G(d,p)), and evaluation results thereof are shown in Table 1 below.

**Table 1**

| Compound No. | HOMO (eV) | LUMO (eV) | T₁ (eV) |
|---|---|---|---|
| 1 | -4.61 | -0.61 | 2.70 |
| 7 | -4.39 | -0.41 | 2.69 |
| 8 | -4.47 | -0.54 | 2.71 |
| 10 | -4.38 | -0.81 | 2.61 |
| 18 | -4.55 | -0.61 | 2.66 |
| 28 | -4.16 | -0.29 | 2.66 |
| 48 | -4.38 | -0.71 | 2.45 |
| 58 | -4.46 | -0.86 | 2.43 |
| 68 | -3.98 | -0.38 | 2.45 |
| 89 | -5.00 | -1.13 | 2.54 |
| 108 | -4.52 | -0.66 | 2.47 |
| 148 | -4.43 | -0.74 | 2.41 |
| 228 | -4.63 | -0.62 | 2.75 |
| 230 | -4.57 | -0.92 | 2.70 |
| 238 | -4.71 | -0.71 | 2.73 |
| 268 | -4.53 | -0.84 | 2.51 |
| 270 | -4.46 | -0.94 | 2.48 |
| 448 | -4.97 | -1.01 | 2.75 |
| 760 | -4.97 | -0.98 | 2.67 |
| 763 | -5.03 | -1.26 | 2.68 |
| 769 | -4.98 | -1.28 | 2.64 |
| 774 | -4.51 | -0.61 | 2.68 |
| Compound A | -4.50 | -0.93 | 2.28 |
| Compound B | -4.20 | -0.27 | 2.76 |

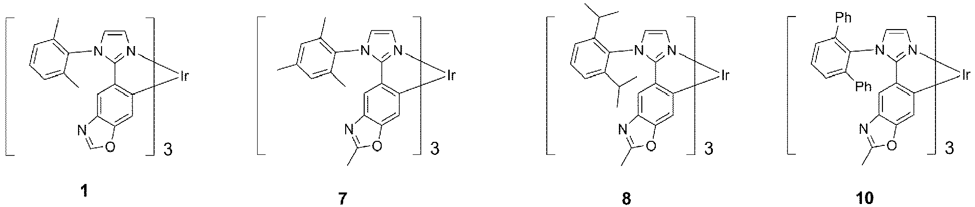

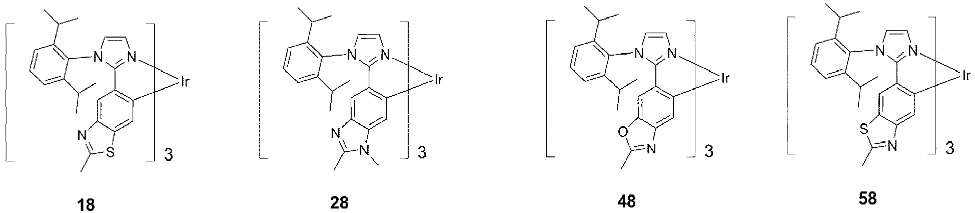

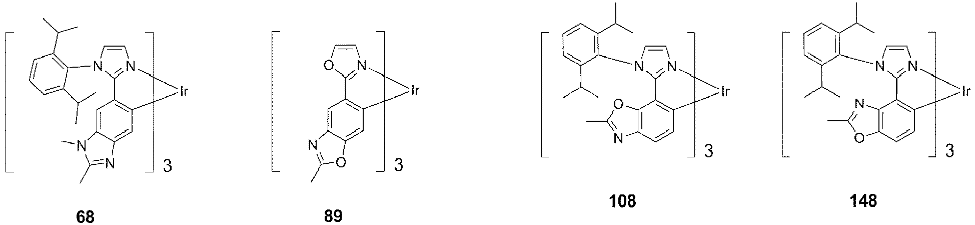

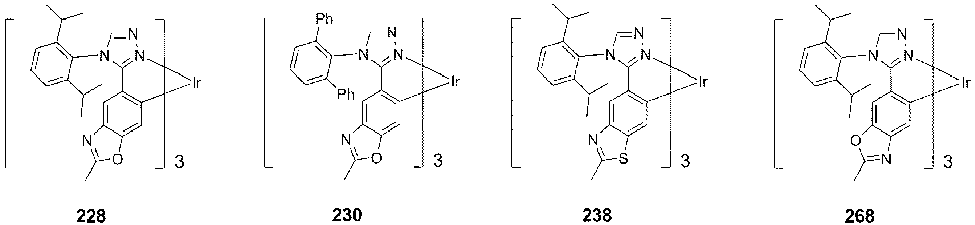

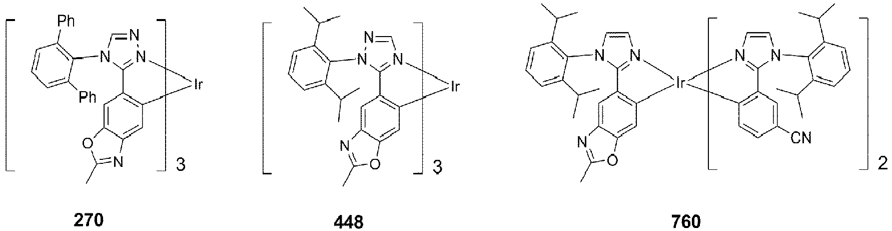

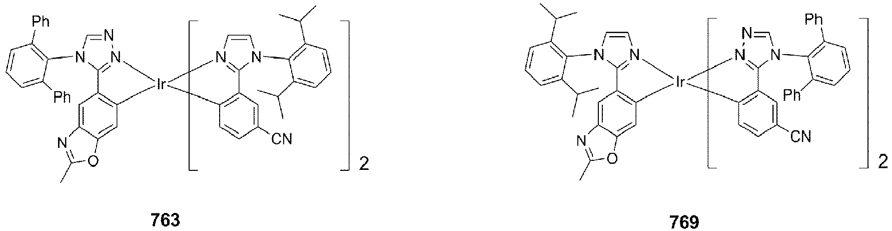

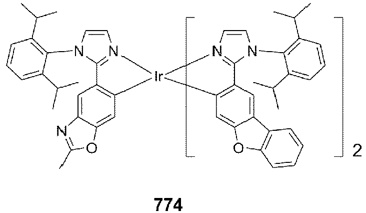

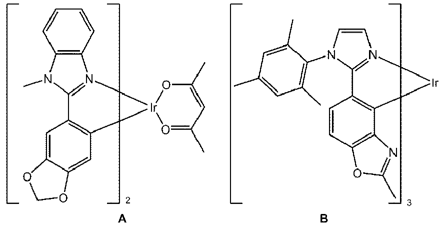

From Table 1, it is confirmed that the organometallic compound represented by one of Formulae 1 to 4 has such electrical characteristics that are suitable for use in an electronic device, for example, for use as a dopant for an organic light-emitting device.

A method of synthesizing the organometallic compound represented by one of Formulae 1 to 4 may be recognizable by one of ordinary skill in the art by referring to Synthesis Examples used herein.

The organometallic compound represented by one of Formulae 1 to 4 is suitable for use in an organic layer of an organic light-emitting device, for example, for use as a dopant in an emission layer of the organic layer. Thus, another aspect provides an organic light-emitting device that includes: a first electrode, a second electrode, and an organic layer that is disposed between the first electrode and the second electrode, wherein the organic layer includes an emission layer, and wherein the organic layer includes at least one organometallic compound represented by Formula 1.

The organic light-emitting device may have, due to the inclusion of an organic layer including the organometallic compound represented by one of Formulae 1 to 4, a low driving voltage, high efficiency, high power, high quantum efficiency, a long lifespan, a low roll-off ratio, and excellent color purity.

The organometallic compound represented by one of Formulae 1 to 4 may be used between a pair of electrodes of an organic light-emitting device. For example, the organometallic compound represented by one of Formulae 1 to 4 may be included in the emission layer. In this regard, the organometallic compound may act as a dopant, and the emission layer may further include a host (that is, an amount of the organometallic compound represented by one of Formulae 1 to 4 is smaller than an amount of the host). In this regard, the dopant may emit blue light.

The expression "(an organic layer) includes at least one organometallic compound" used herein may include an embodiment in which "(an organic layer) includes identical compounds represented by Formula 1" and an embodiment in which "(an organic layer) includes two or more different organometallic compounds represented by Formula 1."

For example, the organic layer may include, as the organometallic compound, only Compound 1. In this regard, Compound 1 may be included in an emission layer of the organic light-emitting device. In one or more embodiments, the organic layer may include, as the organometallic compound, Compound 1 and Compound 2. In this regard, Compound 1 and Compound 2 may be included in an identical layer (for example, Compound 1 and Compound 2 all may be included in an emission layer).

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

In an embodiment, in the organic light-emitting device, the first electrode is an anode, and the second electrode is a cathode, and the organic layer further includes a hole transport region disposed between the first electrode and the emission layer and an electron transport region disposed between the emission layer and the second electrode, wherein the hole transport region includes at least one selected from a hole injection layer, a hole transport layer, and an electron blocking layer, and wherein the electron transport region includes at least one selected from a hole blocking layer, an electron transport layer, and an electron injection layer.

The term "organic layer" as used herein refers to a single layer and/or a plurality of layers between the first electrode and the second electrode of the organic light-emitting device. The "organic layer" may include, in addition to an organic compound, an organometallic compound including metal.

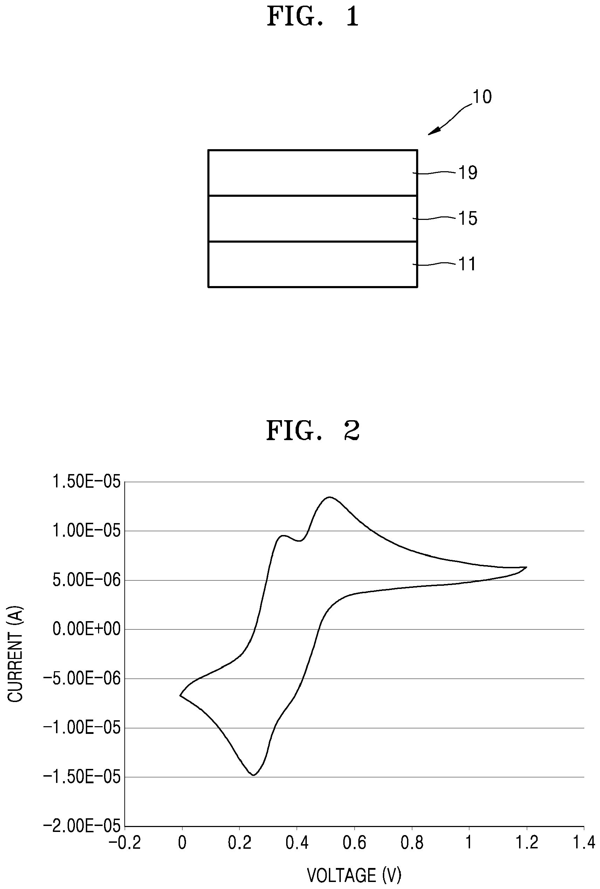

FIG. 1 is a schematic view of an organic light-emitting device 10 according to an embodiment. Hereinafter, the structure of an organic light-emitting device according to an embodiment and a method of manufacturing an organic light-emitting device according to an embodiment will be described in connection with FIG. 1. The organic light-emitting device 10 includes a first electrode 11, an organic layer 15, and a second electrode 19, which are sequentially stacked.

A substrate may be additionally disposed under the first electrode 11 or above the second electrode 19. For use as the substrate, any substrate that is used in general organic light-emitting devices may be used, and the substrate may be a glass substrate or a transparent plastic substrate, each having excellent mechanical strength, thermal stability, transparency, surface smoothness, ease of handling, and water resistance.

In one or more embodiments, the first electrode 11 may be formed by depositing or sputtering a material for forming the first electrode11 on the substrate. The first electrode 11 may be an anode. The material for forming the first electrode 11 may be selected from materials with a high work function to facilitate hole injection. The first electrode 11 may be a reflective electrode, a semi-transmissive electrode, or a transmissive electrode. The material for forming the first electrode 11 may be indium tin oxide (ITO), indium zinc oxide (IZO), tin oxide (SnO₂), or zinc oxide (ZnO). In one or more embodiments, the material for forming the first electrode 11 may be metal, such as magnesium (Mg), aluminum (Al), aluminum-lithium (Al-Li), calcium (Ca), magnesium-indium (Mg-In), or magnesium-silver (Mg-Ag).

The first electrode 11 may have a single-layered structure or a multi-layered structure including two or more layers. For example, the first electrode 11 may have a three-layered structure of ITO/Ag/ITO, but the structure of the first electrode 110 is not limited thereto.

The organic layer 15 is disposed on the first electrode 11.

The organic layer 15 may include a hole transport region, an emission layer, and an electron transport region.

The hole transport region may be disposed between the first electrode 11 and the emission layer.

The hole transport region may include at least one selected from a hole injection layer, a hole transport layer, an electron blocking layer, and a buffer layer.

The hole transport region may include only either a hole injection layer or a hole transport layer. In one or more embodiments, the hole transport region may have a hole injection layer/hole transport layer structure or a hole injection layer/hole transport layer/electron blocking layer structure, which are sequentially stacked in this stated order from the first electrode 11.

When the hole transport region includes a hole injection layer (HIL), the hole injection layer may be formed on the first electrode 11 by using one or more suitable methods, for example, vacuum deposition, spin coating, casting, and/or Langmuir-Blodgett (LB) deposition.

When a hole injection layer is formed by vacuum deposition, the deposition conditions may vary depending on a material that is used to form the hole injection layer, and the structure and thermal characteristics of the hole injection layer. For example, the deposition conditions may include a deposition temperature of about 100°C to about 500°C, a vacuum pressure of about 10⁻⁸ torr to about 10⁻³ torr, and a deposition rate of about 0 Angstroms per second (Å/sec) to about 100 Å/sec. However, the deposition conditions are not limited thereto.

When the hole injection layer is formed using spin coating, coating conditions may vary depending on the material used to form the hole injection layer, and the structure and thermal properties of the hole injection layer. For example, a coating speed may be from about 2,000 revolutions per minute (rpm) to about 5,000 rpm, and a temperature at which a heat treatment is performed to remove a solvent after coating may be from about 80°C to about 200°C. However, the coating conditions are not limited thereto.

Conditions for forming a hole transport layer and an electron blocking layer may be understood by referring to conditions for forming the hole injection layer.

The hole transport region may include at least one selected from m-MTDATA, TDATA, 2-TNATA, NPB, β-NPB, TPD, Spiro-TPD, Spiro-NPB, methylated-NPB, TAPC, HMTPD, 4,4',4"-tris(N-carbazolyl)triphenylamine (TCTA), polyaniline/dodecylbenzene sulfonic acid (PANI/DBSA), poly(3,4-ethylenedioxythiophene)/poly(4-styrene sulfonate) (PEDOT/PSS), polyaniline/camphor sulfonic acid (PANI/CSA), polyaniline/poly(4-styrene sulfonate)

(PANI/PSS), a compound represented by Formula 201 below, and a compound represented by Formula 202 below:

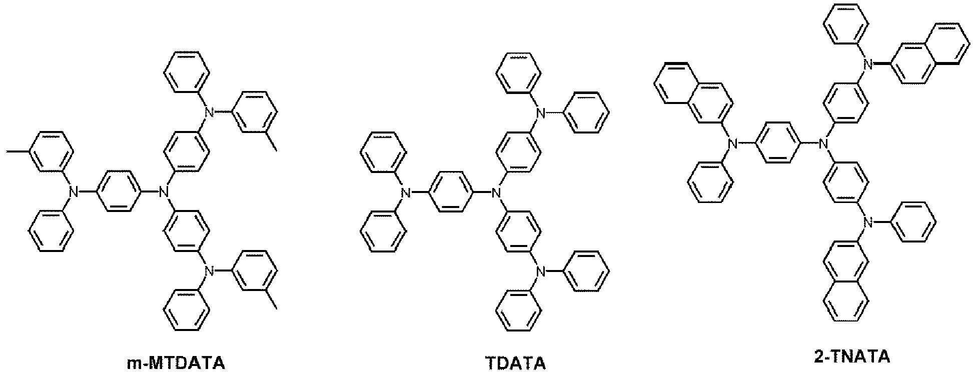

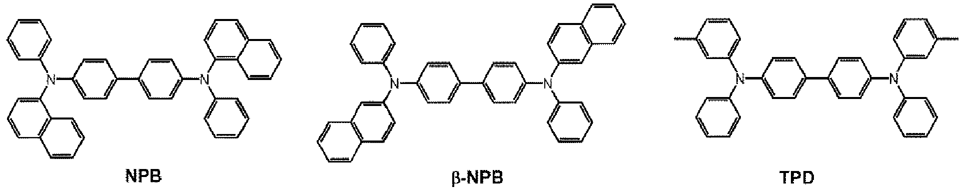

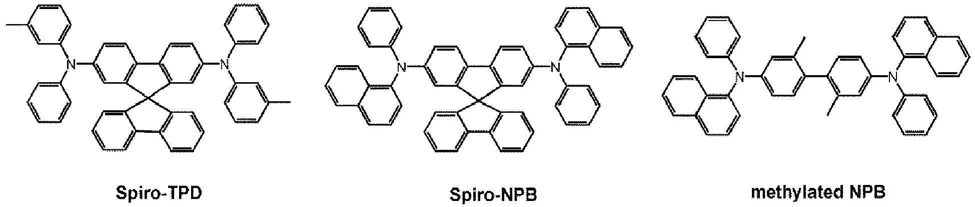

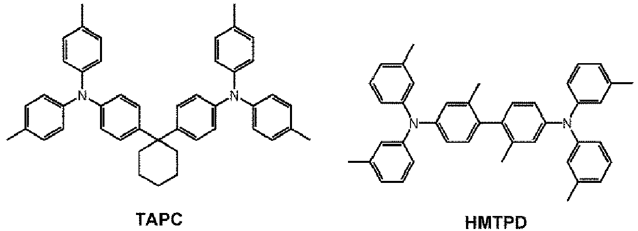

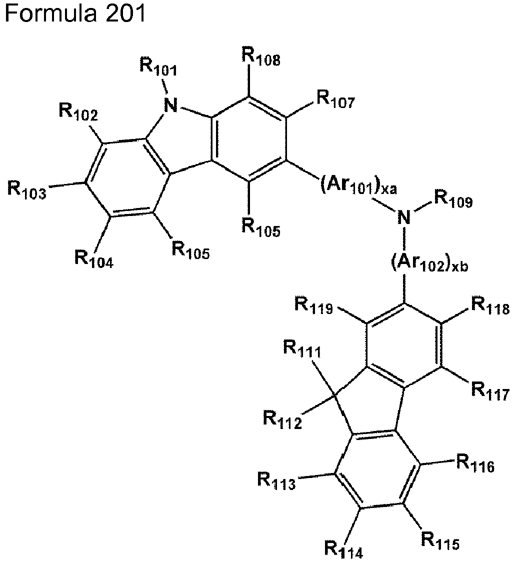

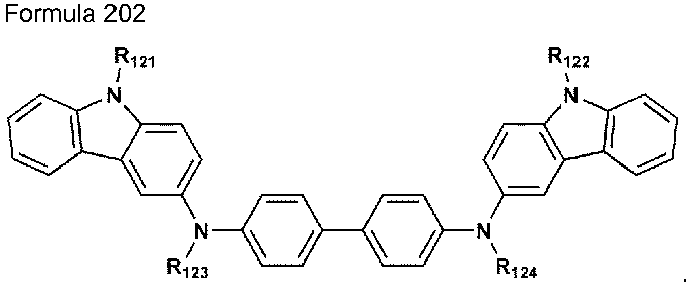

In Formula 201, Ar₁₀₁ and Ar₁₀₂ may each independently be selected from:
a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group; and
a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group, each substituted with at least one selected from deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C1-C₆₀ heteroaryloxy group, a C₁-C₆₀ heteroarylthio group, a C₂-C₆₀ heteroarylalkyl group, a monovalent non-aromatic condensed polycyclic group, and a monovalent non-aromatic condensed heteropolycyclic group.

In Formula 201, xa and xb may each independently be an integer from 0 to 5, or may be 0, 1, or 2. For example, xa may be 1, and xb may be 0, but embodiments of the present disclosure are not limited thereto.

In Formulae 201 and 202, R₁₀₁ to R₁₀₈, R₁₁₁ to R₁₁₉, and R₁₂₁ to R₁₂₄ may each independently be selected from:
hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, pentyl group, a hexyl group, and the like) and a C₁-C₁₀ alkoxy group (for example, a methoxy group, an ethoxy group, a propoxy group, a butoxy group, a pentoxy group, and the like);
a C₁-C₁₀ alkyl group and a C₁-C₁₀ alkoxy group, each substituted with at least one selected from deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, and a phosphoric acid group or a salt thereof;
a phenyl group, a naphthyl group, an anthracenyl group, a fluorenyl group, and a pyrenyl group; and
a phenyl group, a naphthyl group, an anthracenyl group, a fluorenyl group, and a pyrenyl group, each substituted with at least one selected from deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, and a C₁-C₁₀ alkoxy group, but embodiments of the present disclosure are not limited thereto.

In Formula 201, R₁₀₉ may be selected from:
a phenyl group, a naphthyl group, an anthracenyl group, and a pyridinyl group; and
a phenyl group, a naphthyl group, an anthracenyl group, and a pyridinyl group, each substituted with at least one selected from deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, an anthracenyl group, and a pyridinyl group.

According to an embodiment, the compound represented by Formula 201 may be represented by Formula 201A below, but embodiments of the present disclosure are not limited thereto:

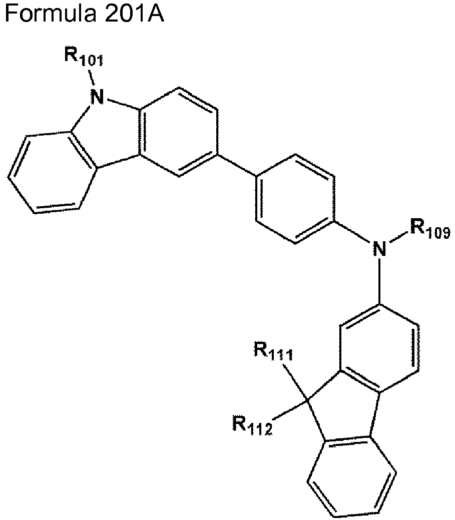

R₁₀₁, R₁₁₁, R₁₁₂, and R₁₀₉ in Formula 201A may be understood by referring to the description provided herein.

For example, the compound represented by Formula 201, and the compound represented by Formula 202 may include compounds HT1 to HT20 illustrated below, but are not limited thereto.

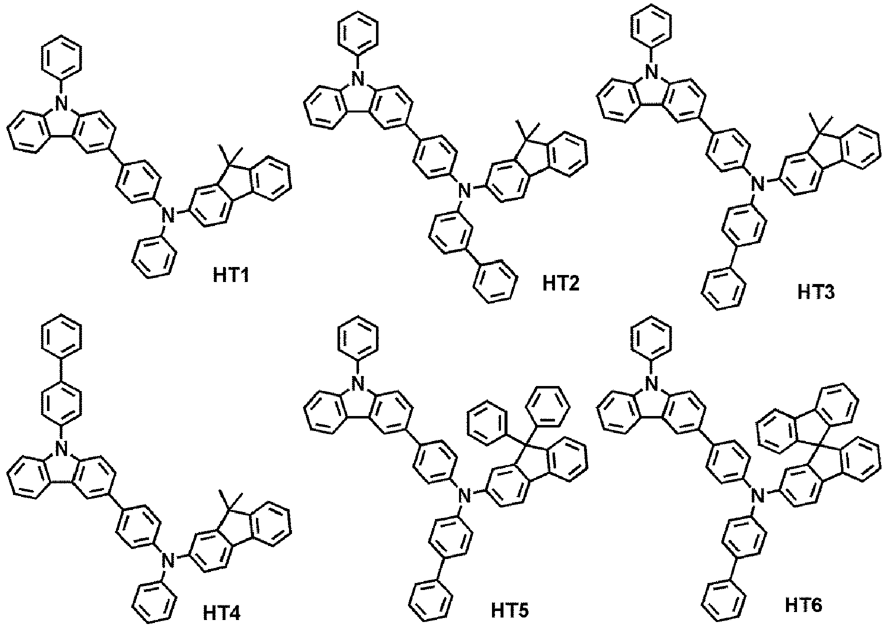

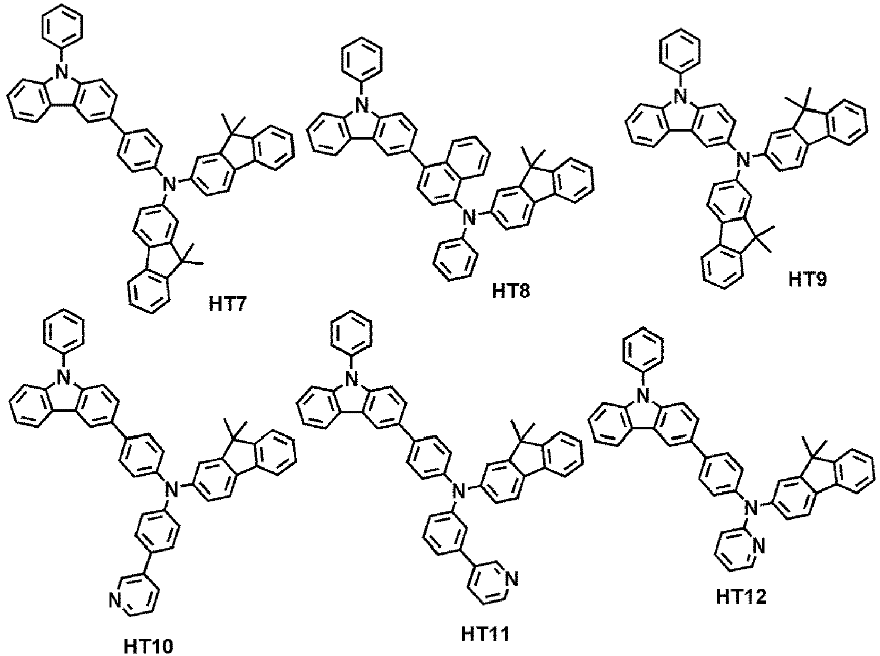

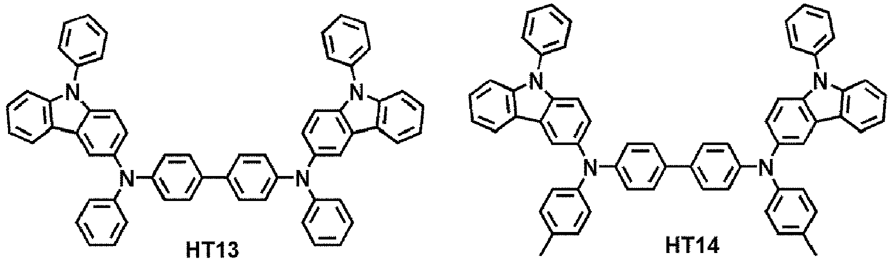

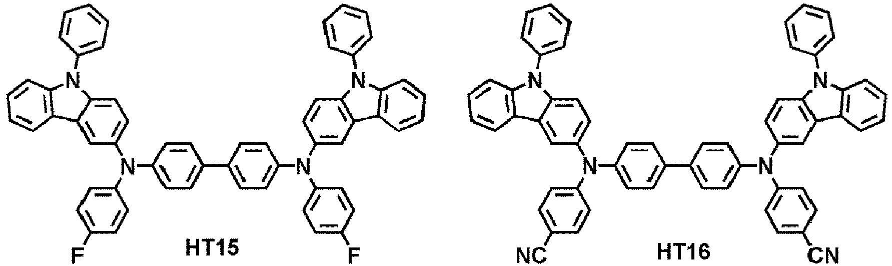

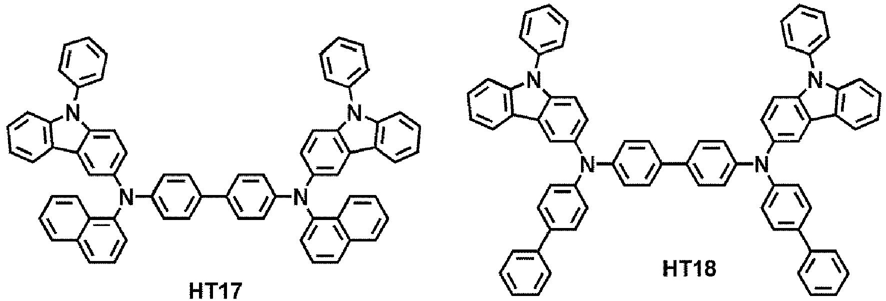

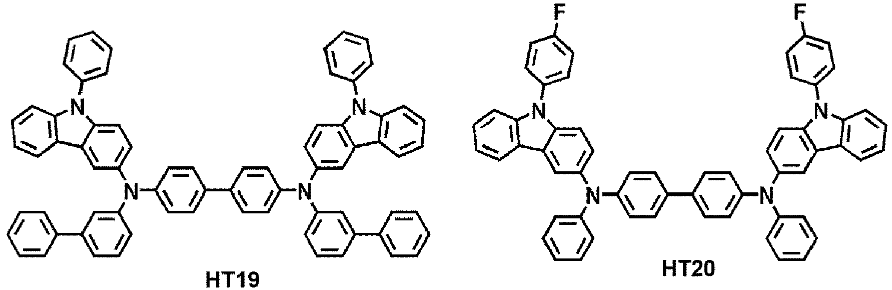

A thickness of the hole transport region may be in a range of about 100 Angstroms (Å) to about 10,000 Å, for example, about 100 Å to about 1,000 Å. While not wishing to be bound by theory, it is understood that when the hole transport region includes both a hole injection layer and a hole transport layer, a thickness of the hole injection layer may be in a range of about 100 Å to about 10,000 Å, for example, about 100 Å to about 1,000 Å, and a thickness of the hole transport layer may be in a range of about 50 Å to about 2,000 Å, for example about 100 Å to about 1,500 Å. While not wishing to be bound by theory, it is understood that when the thicknesses of the hole transport region, the hole injection layer, and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be one selected from a quinone derivative, a metal oxide, and a cyano group-containing compound, but embodiments of the present disclosure are not limited thereto. Non-limiting examples of the p-dopant are a quinone derivative, such as tetracyanoquinonedimethane (TCNQ) or 2,3,5,6-tetrafluoro-tetracyano-1,4-benzoquinonedimethane (F4-TCNQ); a metal oxide, such as a tungsten oxide or a molybdenium oxide; and a cyano group-containing compound, such as Compound HT-D1 or Compound HT-D2 below, but are not limited thereto.

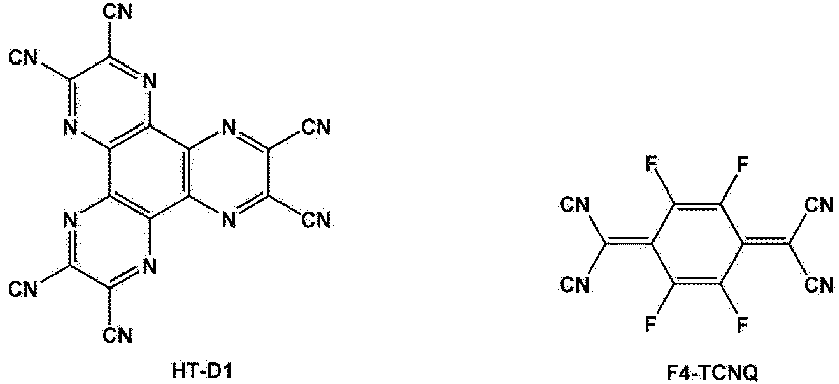

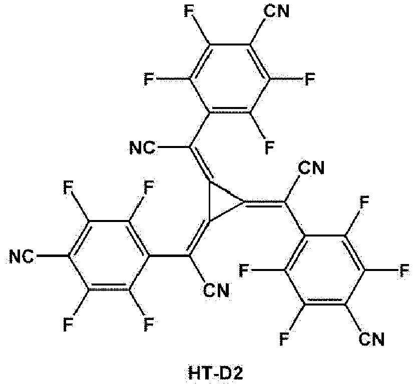

The hole transport region may include a buffer layer.

Also, the buffer layer may compensate for an optical resonance distance according to a wavelength of light emitted from the emission layer, and thus, efficiency of a formed organic light-emitting device may be improved.

Then, an emission layer may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a compound that is used to form the emission layer.

Meanwhile, when the hole transport region includes an electron blocking layer, a material for the electron blocking layer may be selected from materials for the hole transport region described above and materials for a host to be explained later. However, the material for the electron blocking layer is not limited thereto. For example, when the hole transport region includes an electron blocking layer, a material for the electron blocking layer may be mCP, which will be explained later.

The emission layer may include a host and a dopant, and the dopant may include the organometallic compound represented by one of Formulae 1 to 4.

The host may include at least one selected from TPBi, TBADN, ADN (also referred to as "DNA"), CBP, CDBP, TCP, mCP, Compounds H50 to H52:

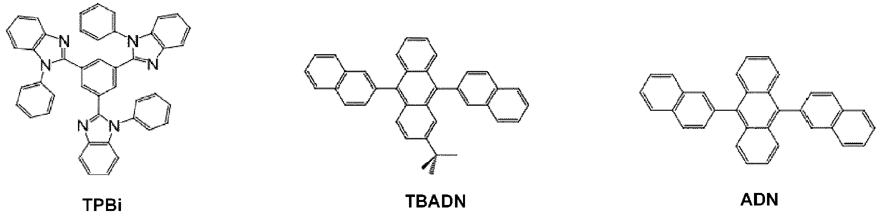

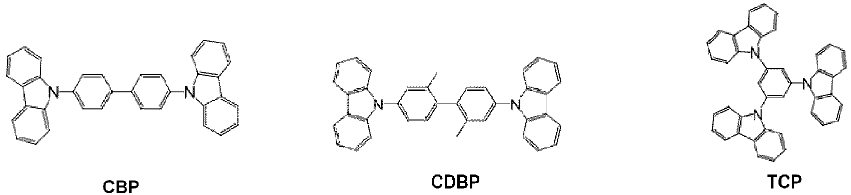

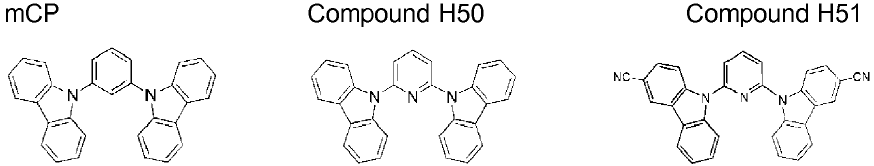

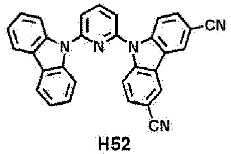

In one or more embodiments, the host may further include a compound represented by Formula 301 below.

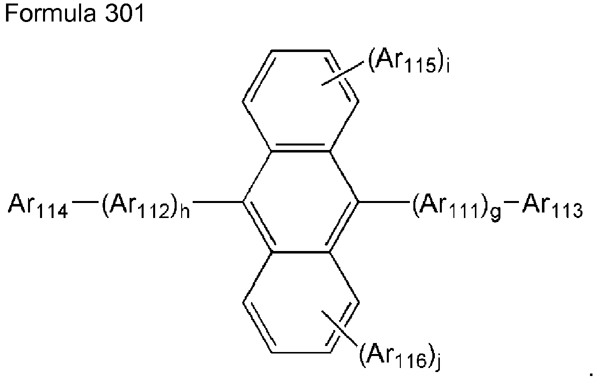

In Formula 301, Ar₁₁₁ and Ar₁₁₂ may each independently be selected from:
a phenylene group, a naphthylene group, a phenanthrenylene group, and a pyrenylene group; and
a phenylene group, a naphthylene group, a phenanthrenylene group, and a pyrenylene group, each substituted with at least one selected from a phenyl group, a naphthyl group, and an anthracenyl group.

In Formula 301, Ar₁₁₃ to Ar₁₁₆ may each independently be selected from:
a C₁-C₁₀ alkyl group, a phenyl group, a naphthyl group, a phenanthrenyl group, and a pyrenyl group; and
a phenyl group, a naphthyl group, a phenanthrenyl group, and a pyrenyl group, each substituted with at least one selected from a phenyl group, a naphthyl group, and an anthracenyl group.

In Formula 301, g, h, I, and j may each independently be an integer from 0 to 4, for example, may be 0, 1, or 2.

In Formula 301, Ar₁₁₃ to Ar₁₁₆ may each independently be selected from:
a C₁-C₁₀ alkyl group, each substituted with at least one selected from a phenyl group, a naphthyl group, and an anthracenyl group;
a phenyl group, a naphthyl group, an anthracenyl group, a pyrenyl group, a phenanthrenyl group, and a fluorenyl group;
a phenyl group, a naphthyl group, an anthracenyl group, a pyrenyl group, a phenanthrenyl group, and a fluorenyl group, each substituted with at least one selected from deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a phenyl group, a naphthyl group, an anthracenyl group, a pyrenyl group, a phenanthrenyl group, and a fluorenyl group; and 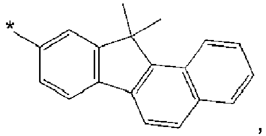 but embodiments of the present disclosure are not limited thereto.

In one or more embodiments, the host may include a compound represented by Formula 302:

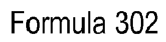

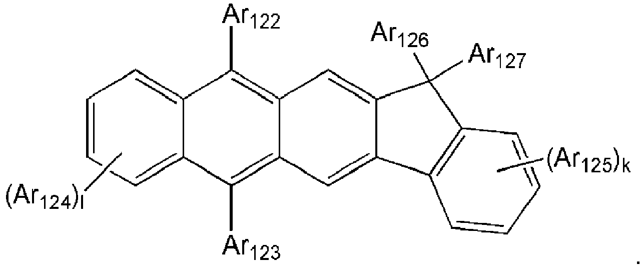

Ar₁₂₂ to Ar₁₂₅ in Formula 302 are the same as described in detail in connection with Ar₁₁₃ in Formula 301.

Ar₁₂₆ and Ar₁₂₇ in Formula 302 may each independently be a C₁-C₁₀ alkyl group (for example, a methyl group, an ethyl group, or a propyl group).

k and I in Formula 302 may each independently be an integer from 0 to 4. For example, k and I may be 0, 1, or 2.

The compound represented by Formula 301 and the compound represented by Formula 302 may include Compounds H1 to H42 illustrated below, but are not limited thereto:

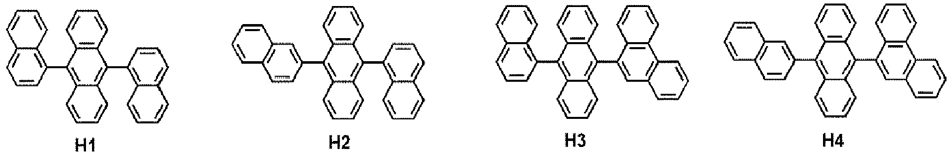

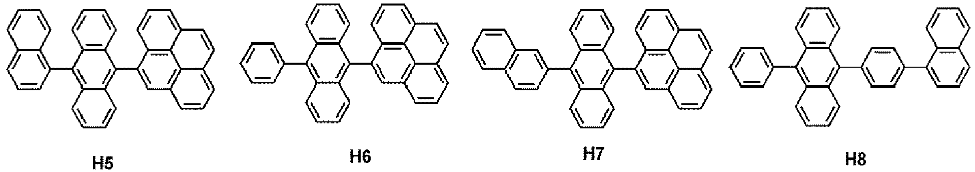

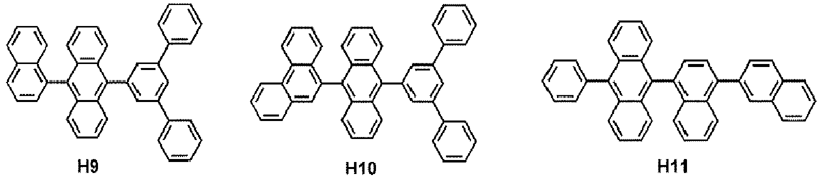

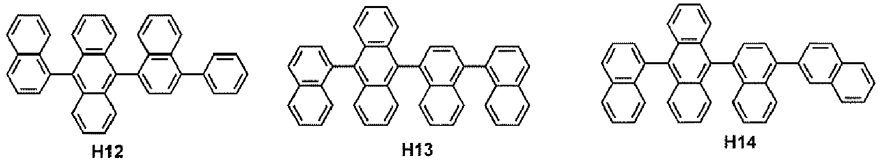

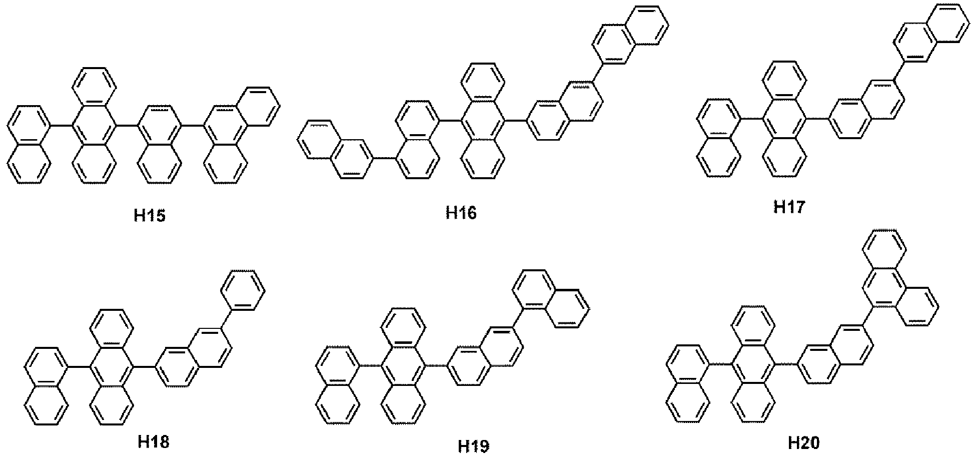

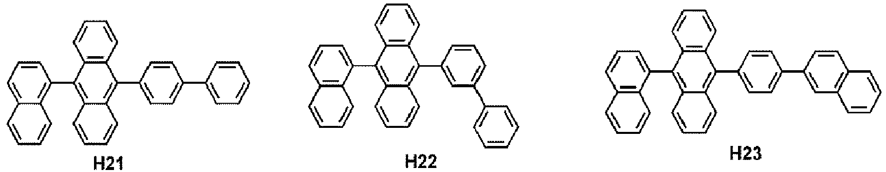

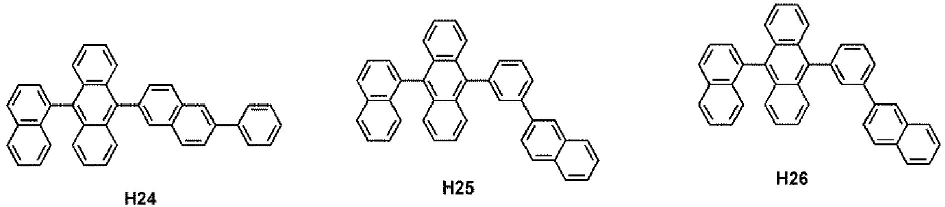

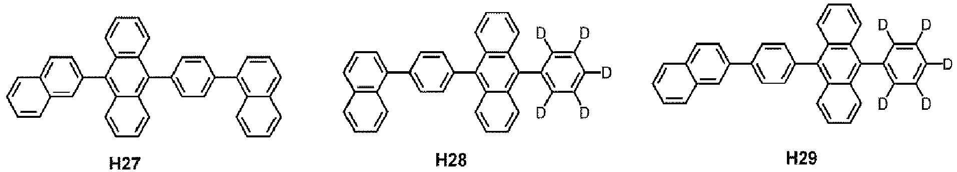

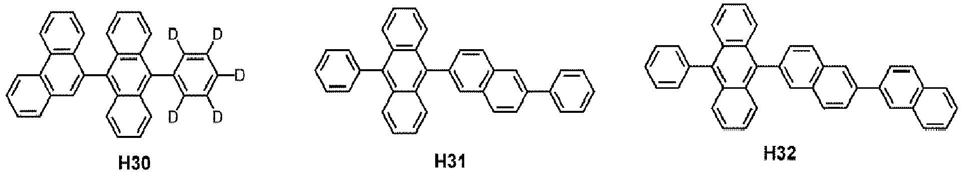

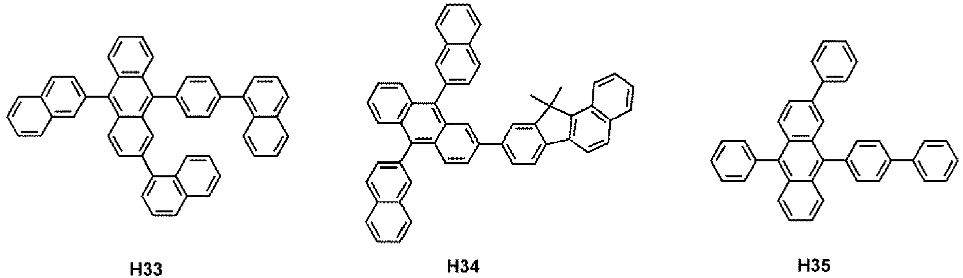

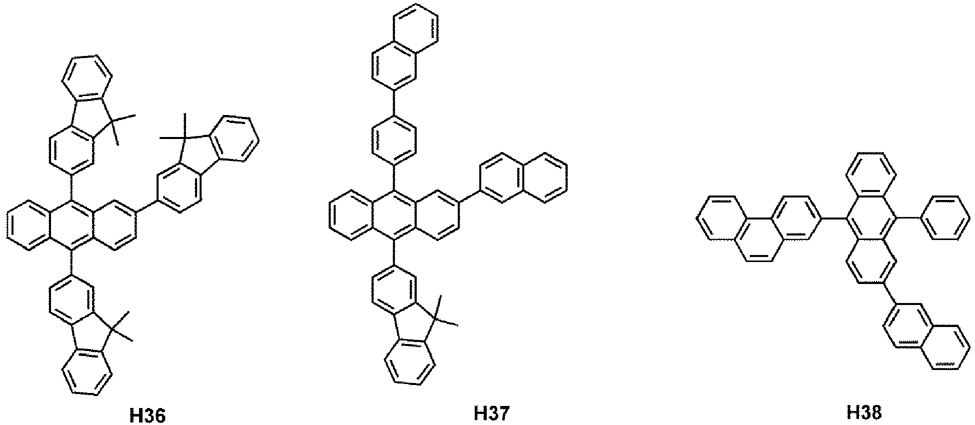

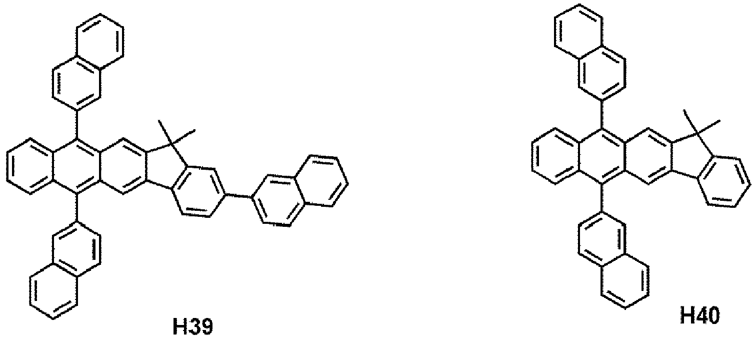

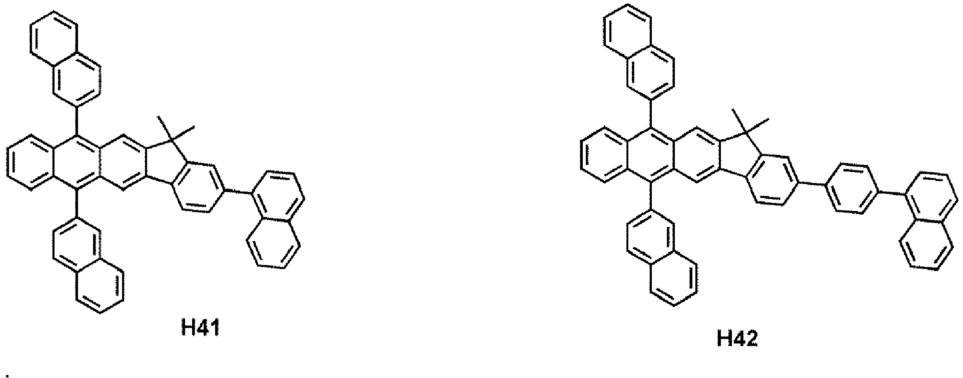

When the organic light-emitting device is a full-color organic light-emitting device, the emission layer may be patterned into a red emission layer, a green emission layer, and a blue emission layer. In one or more embodiments, due to a stacked structure including a red emission layer, a green emission layer, and/or a blue emission layer, the emission layer may emit white light.

When the emission layer includes a host and a dopant, an amount of the dopant may be in a range of about 0.01 parts by weight to about 15 parts by weight based on 100 parts by weight of the host, but embodiments of the present disclosure are not limited thereto.

The dopant may include at least one selected from organometallic compounds represented by Formulae 1 to 4.

A thickness of the emission layer may be in a range of about 100 Å to about 1,000 Å, for example, about 200 Å to about 600 Å. While not wishing to be bound by theory, it is understood that when the thickness of the emission layer is within this range, excellent light-emission characteristics may be obtained without a substantial increase in driving voltage.

Then, an electron transport region may be disposed on the emission layer.

The electron transport region may include at least one selected from a hole blocking layer, an electron transport layer, and an electron injection layer.

For example, the electron transport region may have a hole blocking layer/electron transport layer/electron injection layer structure or an electron transport layer/electron injection layer structure, but the structure of the electron transport region is not limited thereto. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, at least one of BCP, Bphen, and BAlq but embodiments of the present disclosure are not limited thereto:

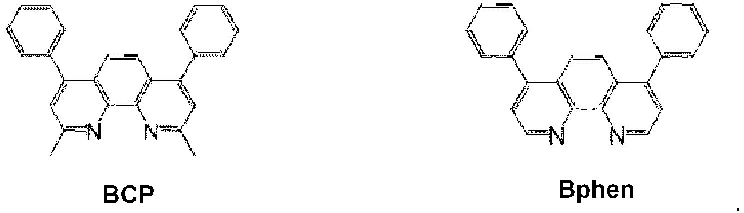

A thickness of the hole blocking layer may be in a range of about 20 Å to about 1,000 Å, for example, about 30 Å to about 300 Å. While not wishing to be bound by theory, it is understood that when the thickness of the hole blocking layer is within these ranges, the hole blocking layer may have excellent hole blocking characteristics without a substantial increase in driving voltage.

The electron transport layer may further include, in addition to the organometallic compound represented by Formula 1, at least one selected from BCP, Bphen, Alq₃, BAlq, TAZ, and NTAZ:

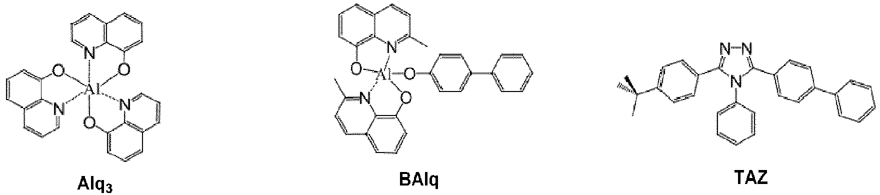

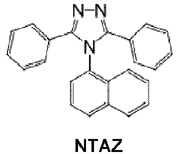

In one or more embodiments, the electron transport layer may include at least one of ET1 and ET25, but are not limited thereto:

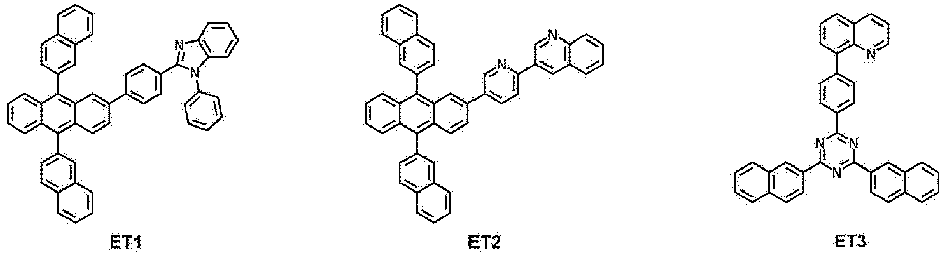

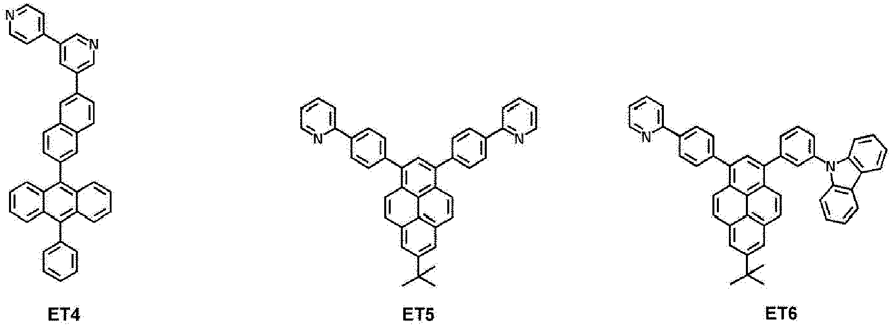

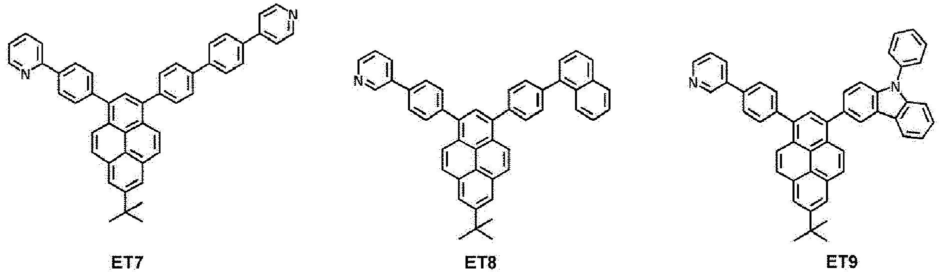

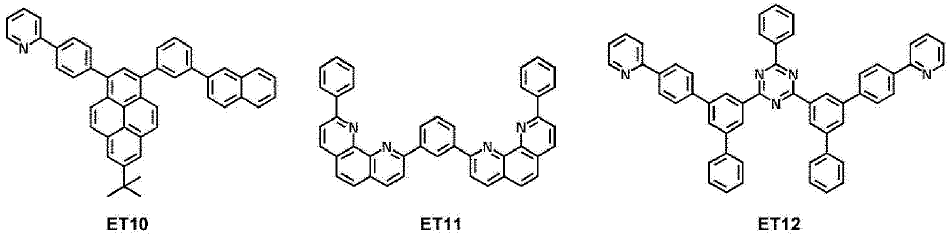

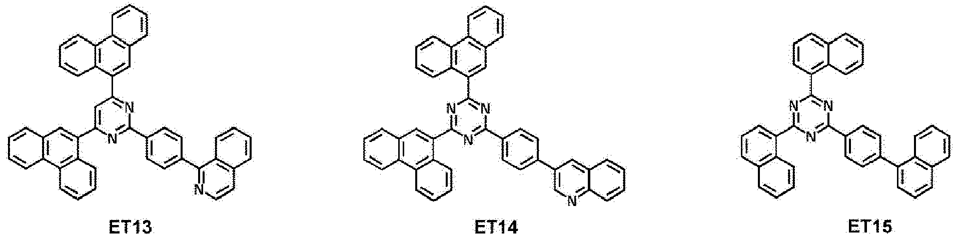

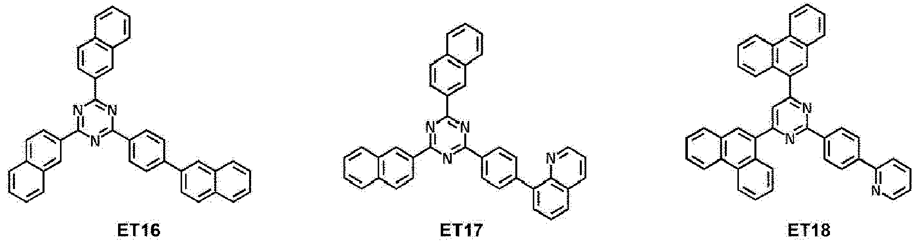

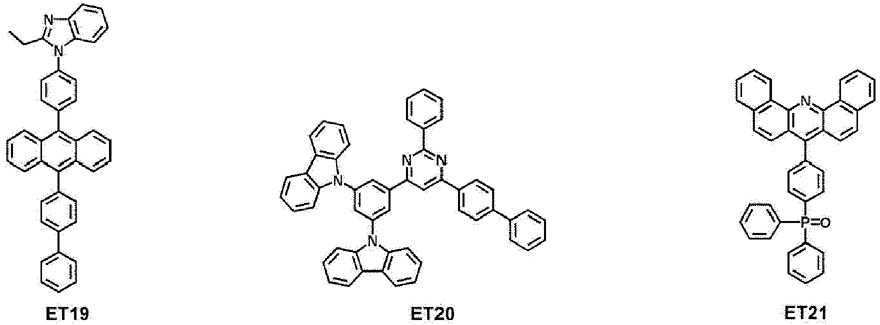

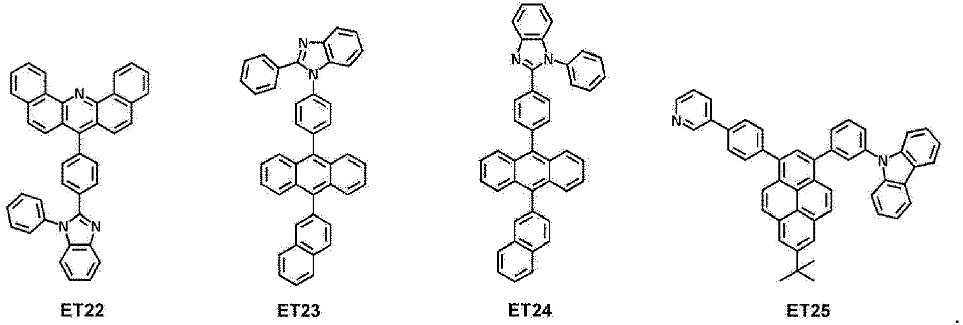

A thickness of the electron transport layer may be in a range of about 100 Å to about 1,000 Å, for example, about 150 Å to about 500 Å. While not wishing to be bound by theory, it is understood that when the thickness of the electron transport layer is within the range described above, the electron transport layer may have satisfactory electron transport characteristics without a substantial increase in driving voltage.

Also, the electron transport layer may further include, in addition to the materials described above, a metal-containing material.

The metal-containing material may include a Li complex. The Li complex may include, for example, Compound ET-D1 (lithium 8-hydroxyquinolate, LiQ) or ET-D2:

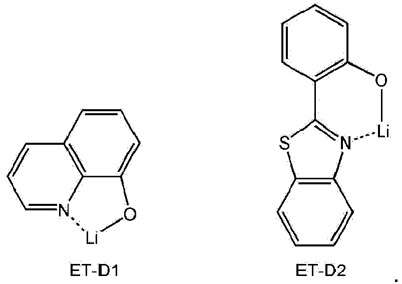

The electron transport region may include an electron injection layer that promotes flow of electrons from the second electrode 19 thereinto.

The electron injection layer may include at least one selected from LiF, NaCl, CsF, Li₂O, and BaO.

A thickness of the electron injection layer may be in a range of about 1 Å to about 100 Å, for example, about 3 Å to about 90 Å. While not wishing to be bound by theory, it is understood that when the thickness of the electron injection layer is within the range described above, the electron injection layer may have satisfactory electron injection characteristics without a substantial increase in driving voltage.

The second electrode 19 is disposed on the organic layer 15. The second electrode 19 may be a cathode. A material for forming the second electrode 19 may be metal, an alloy, an electrically conductive compound, or a combination thereof, which have a relatively low work function. For example, lithium (Li), magnesium (Mg), aluminum (Al), aluminum-lithium (Al-Li), calcium (Ca), magnesium-indium (Mg-In), or magnesium-silver (Mg-Ag) may be formed as the material for forming the second electrode 19. To manufacture a top-emission type light-emitting device, a transmissive electrode formed using ITO or IZO may be used as the second electrode 19.

Hereinbefore, the organic light-emitting device has been described with reference to FIG. 1, but embodiments of the present disclosure are not limited thereto.

The term "first-row transition metals" as used herein refers to d-block elements from Period 4 of the Periodic Table of Elements, and examples thereof are scandium (Sc), titanium (Ti), vanadium (V), chromium (Cr), manganese (Mn), iron (Fe), cobalt (Co), nickel (Ni), copper (Cu), and zinc (Zn).

The term "second-row transition metals" as used refers to d-block elements from Period 5 of the Periodic Table of Elements, and examples thereof are yttrium (Y), zirconium (Zr), niobium (Nb), molybdenum (Mo), technetium (Tc), ruthenium (Ru), rhodium (Rh), palladium (Pd), silver (Ag), and cadmium (Cd).

The term "third-row transition metals" as used herein refers to d-block and f-block elements of Period 6 of the Periodic Table of Elements, and examples thereof are lanthanum (La), samarium (Sm), europium (Eu), terbium (Tb), thulium (Tm), ytterbium (Yb), lutetium (Lu), hafnium (Hf), tantalum (Ta), tungsten (W), rhenium (Re), osmium (Os), iridium (Ir), platinum (Pr), gold (Au), and mercury (Hg).

The term "C₁-C₆₀ alkyl group" as used herein refers to a linear or branched saturated aliphatic hydrocarbon monovalent group having 1 to 60 carbon atoms, and examples thereof include a methyl group, an ethyl group, a propyl group, an iso-butyl group, a sec-butyl group, a tert-butyl group, a pentyl group, an iso-amyl group, and a hexyl group. The term "C₁-C₆₀ alkylene group" as used herein refers to a divalent group having the same structure as the C₁-C₆₀ alkyl group.

The term "C₁-C₆₀ alkoxy group" as used herein refers to a monovalent group represented by -OA₁₀₁ (wherein A₁₀₁ is the C₁-C₆₀ alkyl group), and examples thereof include a methoxy group, an ethoxy group, and an iso-propyloxy group.

The term "C₂-C₆₀ alkenyl group" as used herein refers to a hydrocarbon group having at least one carbon-carbon double bond in the middle or at the terminus of the C₂-C₆₀ alkyl group, and examples thereof include an ethenyl group, a propenyl group, and a butenyl group. The term "C₂-C₆₀ alkenylene group" as used herein refers to a divalent group having the same structure as the C₂-C₆₀ alkenyl group.

The term "C₂-C₆₀ alkynyl group" as used herein refers to a hydrocarbon group having at least one carbon-carbon triple bond in the middle or at the terminus of the C₂-C₆₀ alkyl group, and examples thereof include an ethynyl group, and a propynyl group. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon monocyclic group having 3 to 10 carbon atoms, and examples thereof include a cyclopropyl group, a cyclobutyl group, a cyclopentyl group, a cyclohexyl group, and a cycloheptyl group. The term "C₃-C₁₀ cycloalkylene group" as used herein refers to a divalent group having the same structure as the C₃-C₁₀ cycloalkyl group.

The term "C₁-C₁₀ heterocycloalkyl group" as used herein refers to a monovalent saturated monocyclic group having at least one heteroatom selected from N, O, P, Si and S as a ring-forming atom and 1 to 10 carbon atoms, and non-limiting examples thereof include a tetrahydrofuranyl group, and a tetrahydrothiophenyl group. The term "C₁-C₁₀ heterocycloalkylene group" as used herein refers to a divalent group having the same structure as the C₁-C₁₀ heterocycloalkyl group.

The term "C₃-C₁₀ cycloalkenyl group" as used herein refers to a monovalent monocyclic hydrocarbon group that has 3 to 10 carbon atoms and at least one carbon-carbon double bond in the ring thereof and no aromaticity, and non-limiting examples thereof include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group that has at least one heteroatom selected from N, O, P, Si, and S as a ring-forming atom, 1 to 10 carbon atoms, and at least one carbon-carbon double bond in its ring. Examples of the C₁-C₁₀ heterocycloalkenyl group are a 2,3-dihydrofuranyl group, and a 2,3-dihydrothiophenyl group. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms, and the term "C₆-C₆₀ arylene group" as used herein refers to a divalent group having a carbocyclic aromatic system having 6 to 60 carbon atoms. Examples of the C₆-C₆₀ aryl group are a phenyl group, a naphthyl group, an anthracenyl group, a phenanthrenyl group, a pyrenyl group, and a chrysenyl group. When the C₆-C₆₀ aryl group and the C₆-C₆₀ arylene group each include two or more rings, the rings may be fused to each other.

The term "C₁-C₆₀ heteroaryl group" as used herein refers to a monovalent group having a cyclic aromatic system that has at least one heteroatom selected from N, O, P, Si, and S as a ring-forming atom, in addition to 1 to 60 carbon atoms. The term "C₁-C₆₀ heteroarylene group" as used herein refers to a divalent group having a carbocyclic aromatic system that has at least one heteroatom selected from N, O, P, Si, and S as a ring-forming atom, in addition to 1 to 60 carbon atoms. Examples of the C₁-C₆₀ heteroaryl group are a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each include two or more rings, the rings may be fused to each other.

The term "C₆-C₆₀ aryloxy group" as used herein indicates -OA₁₀₂ (wherein A₁₀₂ is the C₆-C₆₀ aryl group), the term "C₆-C₆₀ arylthio group" as used herein indicates-SA₁₀₃ (wherein A₁₀₃ is the C₆-C₆₀ aryl group), and the term "C₇-C₆₀ arylalkyl group" as used herein indicates -A₁₀₄A₁₀₅ (wherein A₁₀₅ is the C₆-C₅₉ aryl group and A₁₀₄ is the C1-C53 alkylene group).

The term "C₁-C₆₀ heteroaryloxy group" as used herein refers to -OA₁₀₆ (wherein A₁₀₆ is the C₂-C₆₀ heteroaryl group), the term "C₁-C₆₀ heteroarylthio group" as used herein indicates -SA₁₀₇ (wherein A₁₀₇ is the C₁-C₆₀ heteroaryl group), and the term "C₂-C₆₀ heteroarylalkyl group" as used herein refers to -A₁₀₈A₁₀₉ (A₁₀₉ is a C₁-C₅₉ heteroaryl group, and A₁₀₈ is a C₁-C₅₉ alkylene group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group," used herein, refers to a divalent group having the same structure as the monovalent non-aromatic condensed polycyclic group.

The term "monovalent non-aromatic condensed heteropolycyclic group" as used herein refers to a monovalent group (for example, having 2 to 60 carbon atoms) having two or more rings condensed to each other, a heteroatom selected from N, O, P, Si, and S, other than carbon atoms, as a ring-forming atom, and no aromaticity in its entire molecular structure. Non-limiting examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group.

The term "C₅-C₃₀ carbocyclic group" as used herein refers to a saturated or unsaturated cyclic group having, as a ring-forming atom, 5 to 30 carbon atoms only. The term "C5-C₅ carbocyclic group" as used herein refers to a monocyclic group or a polycyclic group, and, according to its chemical structure, a monovalent, divalent, trivalent, tetravalent, pentavalent, or hexavalent group.

The term "C₁-C₃₀ heterocyclic group" as used herein refers to a saturated or unsaturated cyclic group having, as a ring-forming atom, at least one heteroatom selected from N, O, Si, P, and S other than 1 to 30 carbon atoms. The term "C₁-C₃₀ heterocyclic group" as used herein refers to a monocyclic group or a polycyclic group, and, according to its chemical structure, a monovalent, divalent, trivalent, tetravalent, pentavalent, or hexavalent group.

At least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₉ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₇-C₆₀ arylalkyl group, the substituted C₁-C₆₀ heteroaryl group, the substituted C₁-C₆₀ heteroaryloxy group, the substituted C₁-C₆₀ heteroarylthio group, the substituted C₂-C₆₀ heteroarylalkyl group, the substituted monovalent non-aromatic condensed polycyclic group, and the substituted monovalent non-aromatic condensed heteropolycyclic group may be selected from:
deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₇-C₆₀ arylalkyl group, a C1-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -B(Q₁₆)(Q₁₇), and -P(=O)(Q₁₈)(Q₁₉);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₇-C₆₀ arylalkyl group, a C1-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₇-C₆₀ arylalkyl group, a C1-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, and a monovalent non-aromatic condensed heteropolycyclic group, each substituted with at least one selected from deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₇-C₆₀ arylalkyl group, a C1-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -B(Q₂₆)(Q₂₇), and -P(=O)(Q₂₈)(Q₂₉); and
-N(Q₃₁)(Q₃₂), -Si(Q₃₃)(Q₃₄)(Q₃₅), -B(Q₃₆)(Q₃₇), and -P(=O)(Q₃₈)(Q₃₉), and
Q₁ to Q₉, Q₁₁ to Q₁₉, Q₂₁ to Q₂₉, and Q₃₁ to Q₃₉ may each independently be selected from hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with at least one selected from a C₁-C₆₀ alkyl group and a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, and a monovalent non-aromatic condensed heteropolycyclic group.

Hereinafter, a compound and an organic light-emitting device according to embodiments are described in detail with reference to Synthesis Examples and Examples. However, the organic light-emitting device is not limited thereto. The wording " 'B' was used instead of 'A'" used in describing Synthesis Examples means that a molar equivalent of 'A' was identical to a molar equivalent of 'B'.

### EXAMPLES

### Synthesis Example 1: Synthesis of Compound 1

Compound 1 was synthesized according to Reaction Scheme 1.

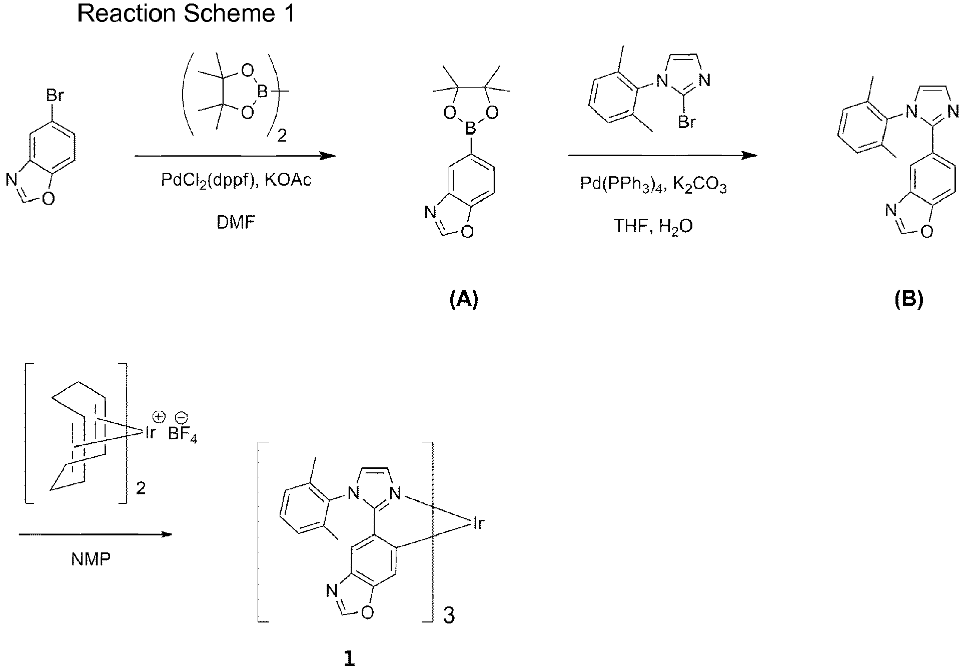

### (1) Synthesis of Intermediate (A)

10.0 grams (g) (50.5 millimoles, mmol) of 5-bromobenzo[d]oxazole, 15.4 g (60.6 mmol) of bis(pinacolato)diboron, 2.06 g (2.52 mmol) of PdCl₂(dppf)•CH₂Cl₂, and 14.9 g (152 mmol) of potassium acetate were dissolved in 168 milliliters (mL) of dimethylformamide (DMF), and stirred at a temperature of 100°C for 20 hours. After the reaction was completed, the reaction product was cooled to room temperature and filtered through silica gel under reduced pressure, and a filtrate was concentrated under reduced pressure. The product obtained therefrom was separated by silica gel column chromatography. The product was recrystallized with dichloromethane (DCM)/n-hexane as an eluent to obtain 8.91 g (yield: 72%) of Intermediate (A).
LC-Mass (calc: 245.12 g/mol, found: M+1 = 246 g/mol).

### (2) Synthesis of Intermediate (B)

8.91 g (36.4 mmol) of Intermediate (A), 9.13 g (36.4 mmol) of 2-bromo-1-(2,6-dimethylphenyl)-1H-imidazole, 2.10 g (1.82 mmol) of tetrakis(triphenylphophine)palladium(0) (Pd(PPh₃)₄), and 12.6 g (90.9 mmol) of potassium carbonate were added to a mixed solution including 80 mL of THF and 40 mL of water and stirred under reflux. After the reaction was completed, the reaction product was cooled to room temperature, extracted to remove an aqueous solution layer, and filtered through silica gel under reduced pressure, and a filtrate was concentrated under reduced pressure. The product obtained therefrom was separated by silica gel column chromatography to obtain 4.73 g (yield: 45%) of Intermediate (B).
LC-Mass (calc: 289.12 g/mol, found: M+1 = 290 g/mol).

### (3) Synthesis of Compound 1

4.73 g (16.3 mmol) of Intermediate (B) and 2.02 g (4.08 mmol) of Ir(COD)₂BF₄ were dissolved in 50 mL of NMP and stirred at a temperature of 200°C for 20 hours. After the reaction was completed, 100 mL of dichloromethane (DCM) was added thereto, and an organic layer was sequentially washed by using 100 mL of 10% NH₄OH aqueous solution, 100 mL of saturated NaHCO₃ aqueous solution, and 100 mL of saturated NaCl aqueous solution (brine). The obtained organic layer was dried by using anhydrous MgSO₄, filtered, and then concentrated under reduced pressure. The product obtained therefrom was separated by silica gel column chromatography to obtain 0.65 g (yield: 11%) of Compound 1.
LC-Mass (calc: 1057.30 g/mol, found: M+1 = 1058 g/mol).

### Synthesis Example 2: Synthesis of Compound 7

Compound 7 was synthesized according to Reaction Scheme 2.

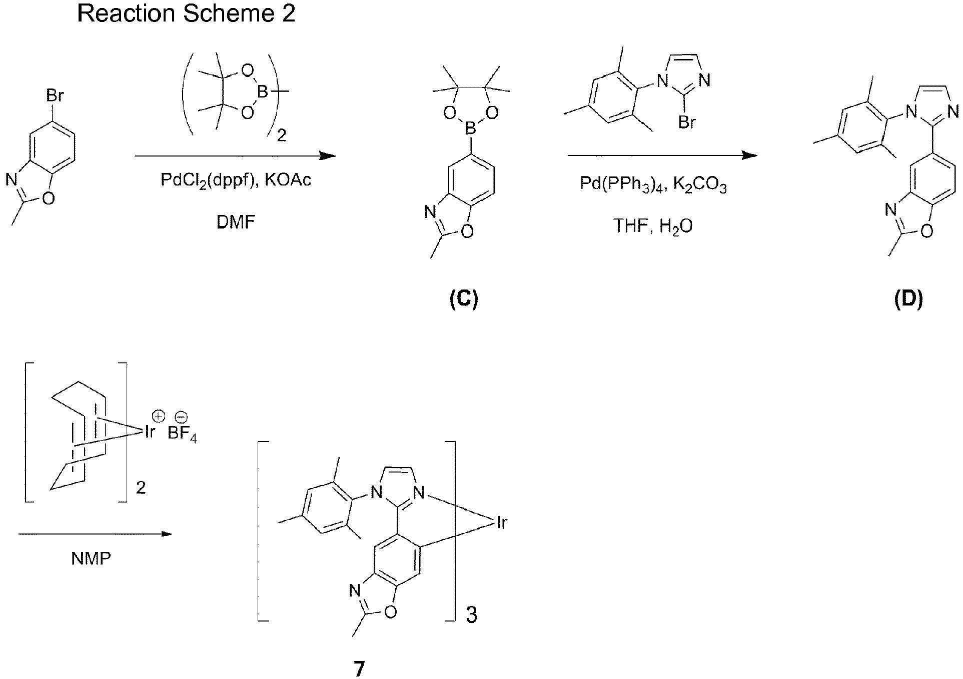

### (1) Synthesis of Intermediate (C)

11.7 g (yield: 84%) of Intermediate (C) was synthesized in the same manner as Intermediate (A), except that 12.0 g (56.6 mmol) of 5-bromo-2-methylbenzo[d]oxazole was used instead of 5-bromobenzo[d]oxazole.
LC-Mass (calc: 259.14 g/mol, found: M+1 = 260 g/mol).

### (2) Synthesis of Intermediate (D)

8.21 g (yield: 67%) of Intermediate (D) was synthesized in the same manner as Intermediate (B), except that 10.0 g (38.6 mmol) of Intermediate (B) was used instead of Intermediate (A), and 10.2 g (38.6 mmol) of 2-bromo-1-mesityl-1H-imidazole was used instead of 2-bromo-1-(2,6-dimethylphenyl)-1H-imidazole.
LC-Mass (calc: 317.15 g/mol, found: M+1 = 318 g/mol).

### (3) Synthesis of Compound 7

0.58 g (yield: 13%) of Compound 7 was synthesized in the same manner as Compound 1, except that 5.00 g (15.8 mmol) of Intermediate (D) was used instead of Intermediate (B).
LC-Mass (calc: 1141.40 g/mol, found: M+1 = 1142 g/mol).

### Synthesis Example 3 : Synthesis of Compound 8

Compound 8 was synthesized according to Reaction Scheme 3.

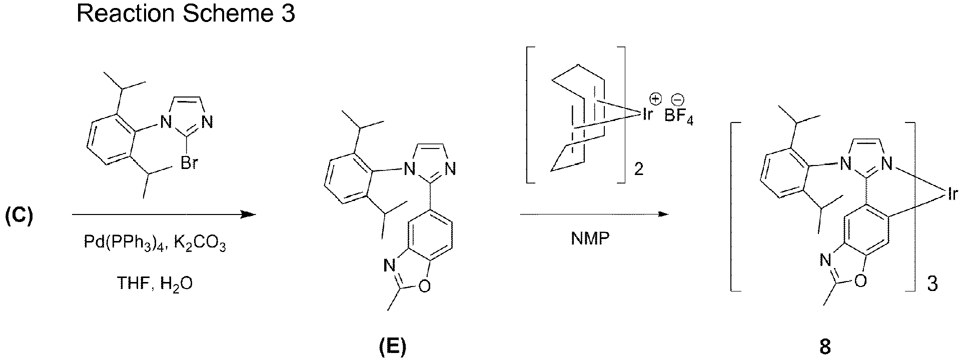

### (1) Synthesis of Intermediate (E)

8.88 g (yield: 64%) of Intermediate (E) was synthesized in the same manner as Intermediate (D), except that 11.9 g (38.6 mmol) of 2-bromo-1-(2,6-diisopropylphenyl)-1H-imidazole was used instead of 2-bromo-1-mesityl-1H-imidazole.
LC-Mass calc: 359.20 g/mol, found: M+1 = 360 g/mol).

### (2) Synthesis of Compound 8

0.57 g (yield: 13%) of Compound 8 was synthesized in the same manner as Compound 1, except that 5.00 g (13.9 mmol) of Intermediate (E) was used instead of Intermediate (B).
LC-Mass (calc: 1267.54 g/mol, found: M+1 = 1268 g/mol).

### Synthesis Example 4: Synthesis of Compound 10

Compound 10 was synthesized according to Reaction Scheme 4.

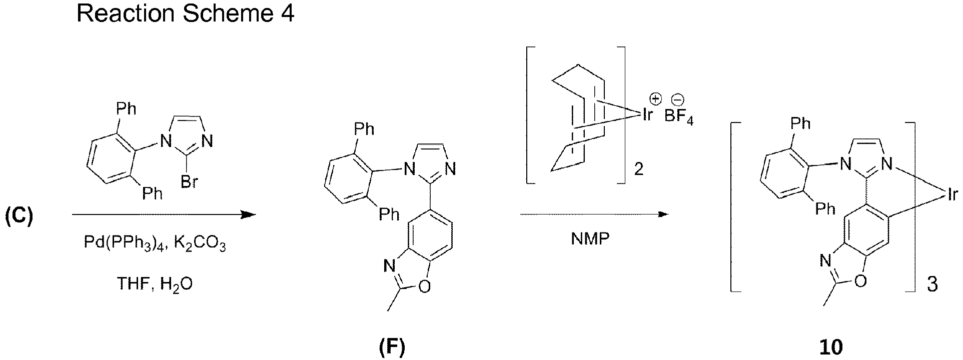

### (1) Synthesis of Intermediate (F)

9.57 g (yield: 58%) of Intermediate (F) was synthesized in the same manner as Intermediate (D), except that 14.5 g (38.6 mmol) of 1-([1,1':3',1"-terphenyl]-2'-yl)-2-bromo-1H-imidazole was used instead of 2-bromo-1-mesityl-1H-imidazole.
LC-Mass (calc: 427.17 g/mol, found: M+1 = 428 g/mol).

### (2) Synthesis of Compound 10

0.36 g (yield: 6%) of Compound 10 was synthesized in the same manner as Compound 1, except that 7.00 g (16.4 mmol) of Intermediate (F) was used instead of Intermediate (B).
LC-Mass (calc: 1471.44 g/mol, found: M+1 = 1472 g/mol).

### Synthesis Example 5: Synthesis of Compound 18

Compound 18 was synthesized according to Reaction Scheme 5.

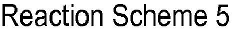

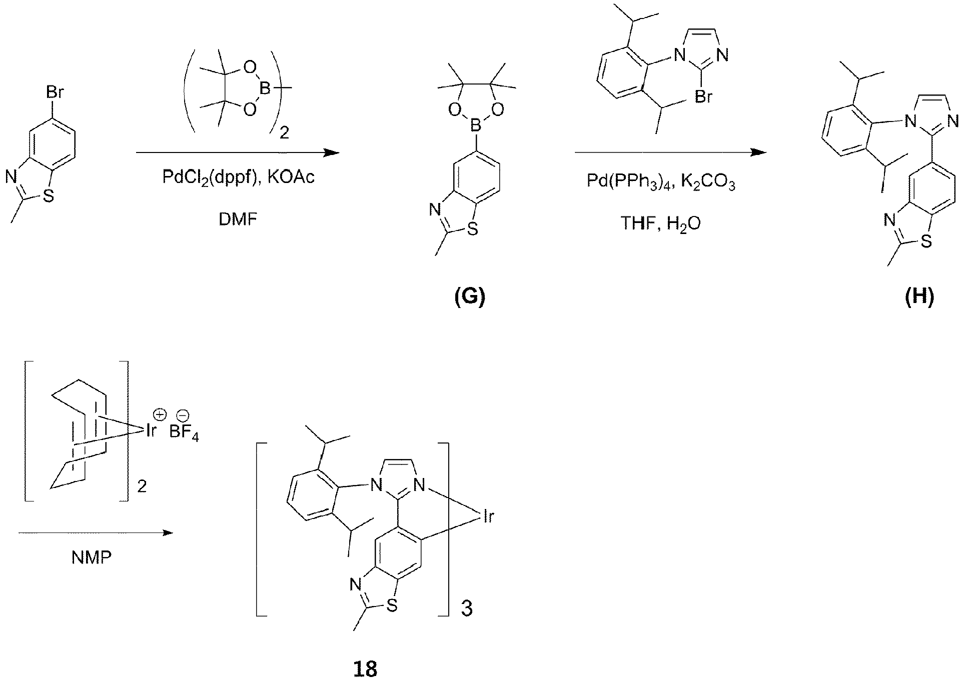

### (1) Synthesis of Intermediate (G)

13.2 g (yield: 91%) of Intermediate (G) was synthesized in the same manner as Intermediate (A), except that 12.0 g (52.6 mmol) of 5-bromo-2-methylbenzo[d]thiazole was used instead of 5-bromobenzo[d]oxazole.
LC-Mass (calc: 275.12 g/mol, found: M+1 = 276 g/mol).

### (2) Synthesis of Intermediate (H)

10.2 g (yield: 75%) of Intermediate (D) was synthesized in the same manner as Intermediate (E), except that 10.0 g (36.3 mmol) of Intermediate (G) was used instead of Intermediate (C).
LC-Mass (calc: 375.18 g/mol, found: M+1 = 376 g/mol).

### (3) Synthesis of Compound 18

0.39 g (yield: 9%) of Compound 18 was synthesized in the same manner as Compound 1, except that 5.00 g (13.3 mmol) of Intermediate (H) was used instead of Intermediate (B).
LC-Mass (calc: 1315.47 g/mol, found: M+1 = 1316 g/mol).

### Synthesis Example 6: Synthesis of Compound 28

Compound 28 was synthesized according to Reaction Scheme 6.

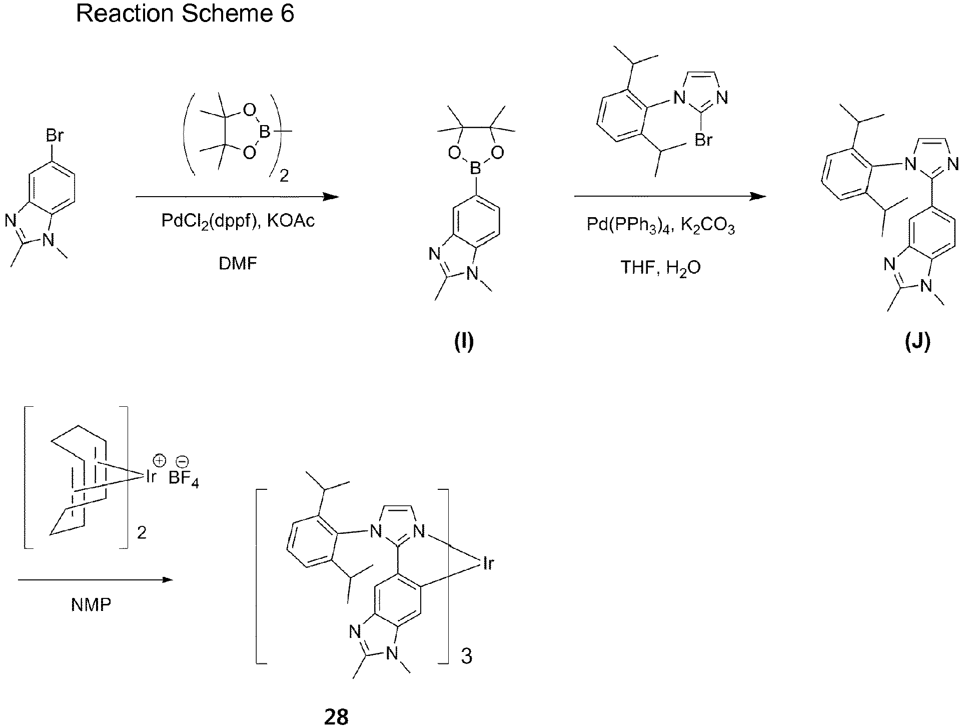

### (1) Synthesis of Intermediate (I)

10.3 g (yield: 71%) of Intermediate (I) was synthesized in the same manner as Intermediate (A), except that 12.0 g (53.3 mmol) of 5-bromo-1,2-dimethyl-1H-benzo[d]imidazole was used instead of 5-bromobenzo[d]oxazole.
LC-Mass (calc: 272.17 g/mol, found: M+1 = 273 g/mol).

### (2) Synthesis of Intermediate (J)

9.03 g (yield: 66%) of Intermediate (J) was synthesized in the same manner as Intermediate (E), except that 10.0 g (36.7 mmol) of Intermediate (I) was used instead of Intermediate (C).
LC-Mass (calc: 372.23 g/mol, found: M+1 = 373 g/mol).

### (3) Synthesis of Compound 28

0.35 g (yield: 8%) of Compound 28 was synthesized in the same manner as Compound 1, except that 5.00 g (13.4 mmol) of Intermediate (J) was used instead of Intermediate (B).
LC-Mass (calc: 1306.63 g/mol, found: M+1 = 1307 g/mol).

### Synthesis Example 7: Synthesis of Compound 48

Compound 48 was synthesized according to Reaction Scheme 7.

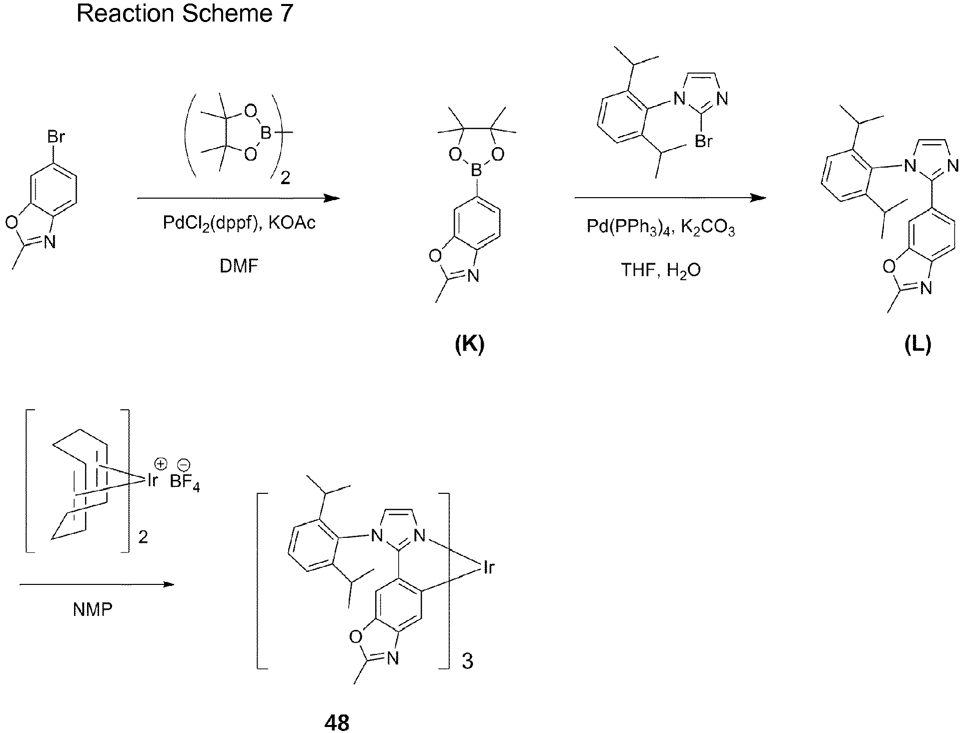

### (1) Synthesis of Intermediate (K)

10.4 g (yield: 75%) of Intermediate (K) was synthesized in the same manner as Intermediate (A), except that 12.0 g (56.6 mmol) of 6-bromo-2-methylbenzo[d]oxazole was used instead of 5-bromobenzo[d]oxazole.
LC-Mass (calc: 259.14 g/mol, found: M+1 = 260 g/mol).

### (2) Synthesis of Intermediate (L)

9.71 g (yield: 70%) of Intermediate (L) was synthesized in the same manner as Intermediate (D), except that 10.0 g (38.6 mmol) of Intermediate (K) was used instead of Intermediate (C).
LC-Mass (calc: 359.20 g/mol, found: M+1 = 360 g/mol).

### (3) Synthesis of Compound 48

0.31 g (yield: 7%) of Compound 48 was synthesized in the same manner as Compound 1, except that 5.00 g (13.9 mmol) of Intermediate (L) was used instead of Intermediate (B).
LC-Mass (calc: 1267.54 g/mol, found: M+1 = 1268 g/mol).

### Synthesis Example 8: Synthesis of Compound 108

Compound 108 was synthesized according to Reaction Scheme 8.

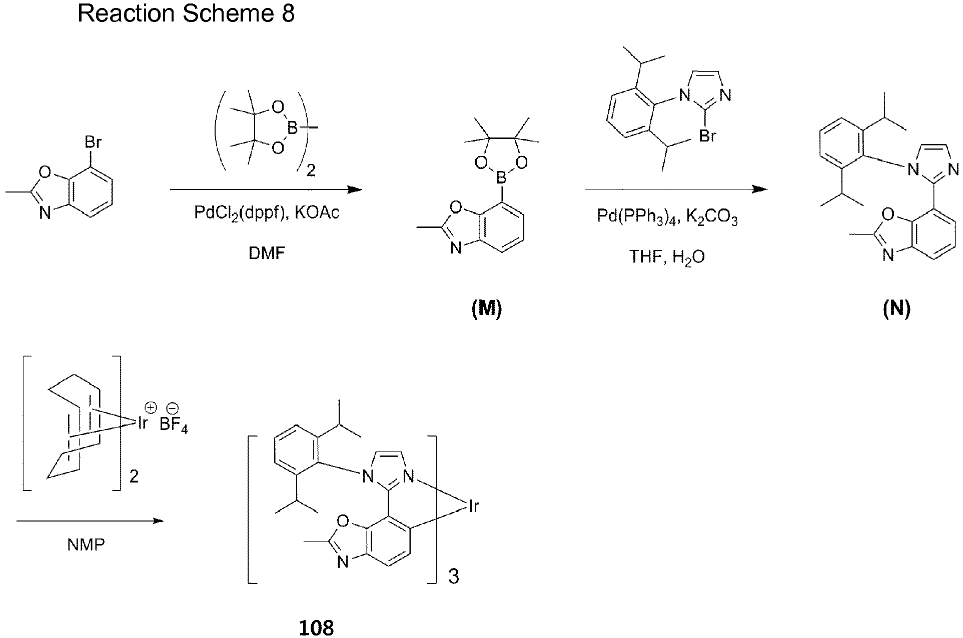

### (1) Synthesis of Intermediate (M)

11.0 g (yield: 79%) of Intermediate (M) was synthesized in the same manner as in Intermediate (A), except that 12.0 g (56.6 mmol) of 7-bromo-2-methylbenzo[d]oxazole was used instead of 5-bromobenzo[d]oxazole.
LC-Mass (calc: 259.14 g/mol, found: M+1 = 260 g/mol).

### (2) Synthesis of Intermediate (N)

6.80 g (yield: 49%) of Intermediate (N) was synthesized in the same manner as Intermediate (D), except that 10.0 g (38.6 mmol) of Intermediate (M) was used instead of Intermediate (C).
LC-Mass (calc: 359.20 g/mol, found: M+1 = 360 g/mol).

### (3) Synthesis of Compound 108

0.18 g (yield: 4%) of Compound 108 was synthesized in the same manner as Compound 1, except that 5.00 g (13.9 mmol) of Intermediate (N) was used instead of Intermediate (B).
LC-Mass (calc: 1267.54 g/mol, found: M+1 = 1268 g/mol).

### Synthesis Example 9: Synthesis of Compound 148

Compound 148 was synthesized according to Reaction Scheme 9.

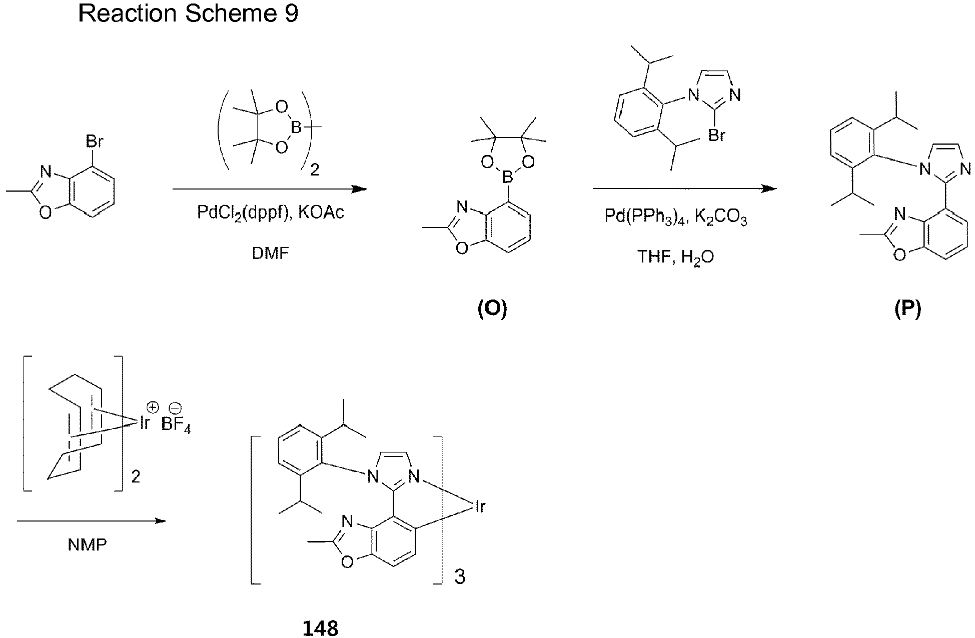

### (1) Synthesis of Intermediate (O)

11.0 g (yield: 79%) of Intermediate (O) was synthesized in the same manner as Intermediate (A), except that 12.0 g (56.6 mmol) of 4-bromo-2-methylbenzo[d]oxazole was used instead of 5-bromobenzo[d]oxazole.
LC-Mass (calc: 259.14 g/mol, found: M+1 = 260 g/mol).

### (2) Synthesis of Intermediate (P)

6.24 g (yield: 45%) of Intermediate (P) was synthesized in the same manner as Intermediate (D), except that 10.0 g (38.6 mmol) of Intermediate (O) was used instead of Intermediate (C).
LC-Mass (calc: 359.20 g/mol, found: M+1 = 360 g/mol).

### (3) Synthesis of Compound 148

0.23 g (yield: 5%) of Compound 148 was synthesized in the same manner as Compound 1, except that 5.00 g (13.9 mmol) of Intermediate (N) was used instead of Intermediate (B).
LC-Mass (calc: 1267.54 g/mol, found: M+1 = 1268 g/mol).

### Synthesis Example 10: Synthesis of Compound 230

Compound 230 was synthesized according to Reaction Scheme 10.

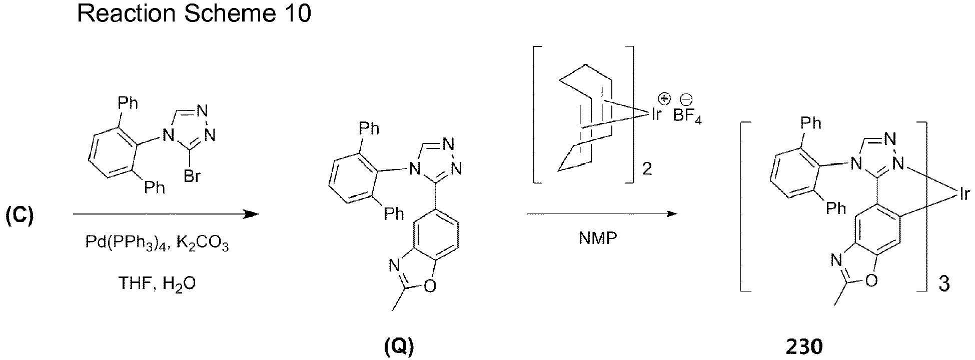

### (1) Synthesis of Intermediate (Q)

10.1 g (yield: 61%) of Intermediate (Q) was synthesized in the same manner as Intermediate (D), except that 14.5 g (38.6 mmol) of 4-([1,1':3',1"-terphenyl]-2'-yl)-3-bromo-4H-1,2,4-triazol) was used instead of 2-bromo-1-mesityl-1H-imidazole.
LC-Mass (calc: 428.16 g/mol, found: M+1 = 429 g/mol).

### (2) Synthesis of Compound 230

0.26 g (yield: 3%) of Compound 230 was synthesized in the same manner as Compound 1, except that 10.0 g (23.3 mmol) of Intermediate (Q) was used instead of Intermediate (B).
LC-Mass (calc: 1474.43 g/mol, found: M+1 = 1475 g/mol).

### Synthesis Example 11: Synthesis of Compound 270

Compound 270 was synthesized according to Reaction Scheme 11.

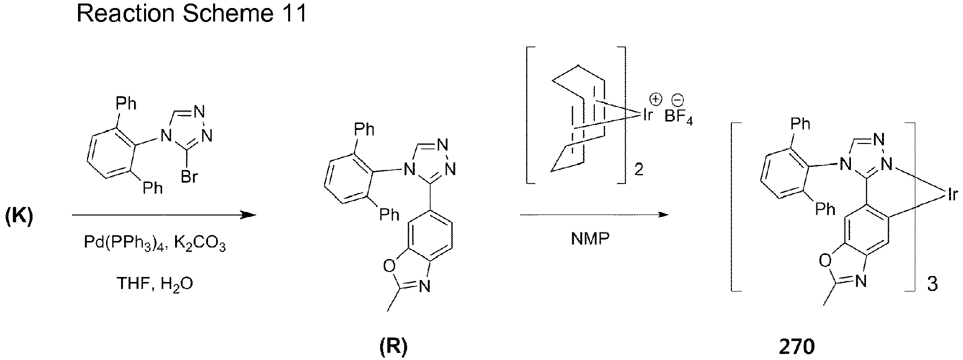

### (1) Synthesis of Intermediate (R)

10.9 g (yield: 66%) of Intermediate (R) was synthesized in the same manner as Intermediate (Q), except that 10.0 g (38.6 mmol) of Intermediate (K) was used instead of Intermediate (C).
LC-Mass (calc: 428.16 g/mol, found: M+1 = 429 g/mol).

### (2) Synthesis of Compound 270

0.24 g (yield: 3%) of Compound 230 was synthesized in the same manner as Compound 1, except that 10.0 g (23.3 mmol) of Intermediate (R) was used instead of Intermediate (B).
LC-Mass (calc: 1474.43 g/mol, found: M+1 = 1475 g/mol).

### Synthesis Example 12: Synthesis of Compound 760

Compound 760 was synthesized according to Reaction Scheme 12.

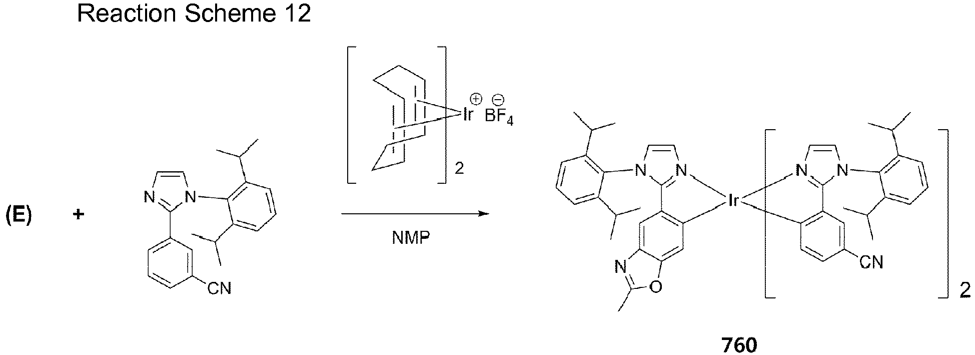

### (1) Synthesis of Compound 760

3.27 g (9.08 mmol) of Intermediate (E), 5.99 g (27.3 mmol) of 3-(1-(2,6-diisopropylphenyl)-1H-imidazol-2-yl)benzonitrile, and 3.00 g (6.06 mmol) of Ir(COD)₂BF₄ were dissolved in 90 mL of NMP, and stirred at a temperature of 200°C for 20 hours. After the reaction was completed, 200 mL of dichloromethane (DCM) was added to the reaction product, and an organic layer was sequentially washed by using 200 mL of 10% NH₄OH aqueous solution, 200 mL of saturated NaHCO₃ aqueous solution, and 200 mL of brine (saturated NaCl aqueous solution). The obtained organic layer was dried by using anhydrous MgSO₄, filtered, and then concentrated under reduced pressure. The product was separated by silica gel column chromatography to obtain 0.29 g (yield: 4%) of Compound 270.
LC-Mass (calc: 1207.52 g/mol, found: M+1 = 1208 g/mol).

### Synthesis Example 13: Synthesis of Compound 774

Compound 774 was synthesized according to Reaction Scheme 13.

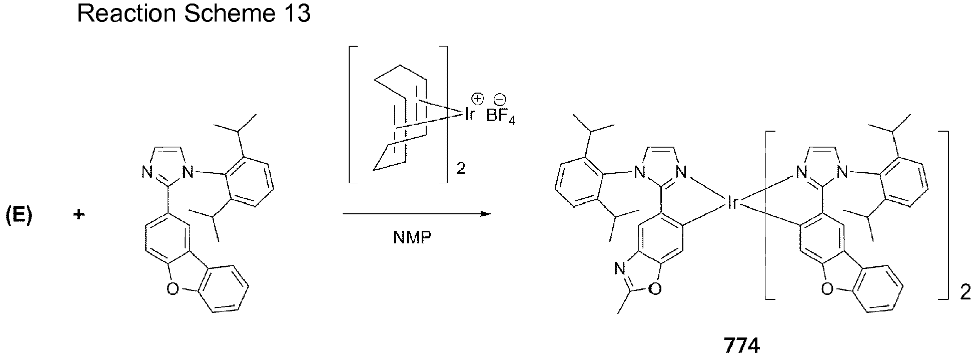

### (1) Synthesis of Compound 774

0.28 g (yield: 3%) of Compound 774 was synthesized in the same manner as Compound 760, except that 7.17 g (27.3 mmol) of 2-(dibenzo[b,d]furan-2-yl)-1-(2,6-diisopropylphenyl)-1H-imidazole was used instead of 3-(1-(2,6-diisopropylphenyl)-1H-imidazol-2-yl)benzonitrile.
LC-Mass (calc: 1337.55 g/mol, found: M+1 = 1338 g/mol).

### Evaluation Example 1: Evaluation of HOMO, LUMO, and triplet (T₁) energy levels

HOMO and LUMO energy levels of Compound 8 were evaluated according to methods described in Table 2, and results thereof are shown in Table 3. A cyclic voltammetry (CV) graph of Compound 8 is shown in FIG. 2.

**Table 2**

| | |
|---|---|
| HOMO energy level evaluation method | A voltage-current (V-A) graph of each Compound was obtained by using a CV (electrolyte: 0.1 molar (M) Bu₄NClO₄ / solvent: CH₂Cl₂ / electrode: 3-electrode system (work electrode: GC, reference electrode: Ag/AgCl, auxiliary electrode: Pt)), and then, a HOMO energy level of each Compound was calculated from reduction onset. |
| LUMO energy level evaluation method | Each Compound was diluted at a concentration of 1x10⁻⁵ M in CHCl₃, a UV absorption spectrum thereof was measured at room temperature by using a Shimadzu UV-350 spectrometer, and a LUMO energy level thereof was calculated by using an optical band gap (E_{g}) from an edge of the absorption spectrum. |
| T₁ energy level evaluation method | After a mixture of toluene and each Compound (1 milligram (mg) of each Compound was dissolved in 3 mL of toluene) was added to a quartz cell and then added to liquid nitrogen (77 Kelvins, K), a photoluminescence spectrum was measured by using a photoluminescence measurement apparatus. The T₁ energy level was calculated by analyzing peaks alone observed only at a low temperature through comparison with a general roomtemperature photoluminescence spectrum. |

**Table 3**

| Compound No. | HOMO (eV) | LUMO (eV) | T₁ (eV) |
|---|---|---|---|
| 8 | -4.96 | -2.28 | 2.68 |

Referring to Table 3, it is confirmed that Compound 8 has electrical characteristics suitable for use as a material of an organic light-emitting device.

### Evaluation Example 2: Evaluation of thermal characteristics

Thermal analysis (1-Pa vacuum atmosphere, temperature range: room temperature to 600°C (10°C/min), Pan Type: Pt Pan in disposable Al Pan) was performed on Compound 8 by using TG-DTA analysis, and results thereof are shown in Table 4. A sublimation temperature was determined as a point at which a weight change amount reached 10% in the TG-DTA analysis.

**Table 4**

| Compound No. | T_{d} (1%,°C) | Sublimation temperature (°C) |
|---|---|---|
| 8 | 208 | 250 |

Referring to Table 4, it is confirmed that Compound 8 has excellent thermal stability and has a relatively low sublimation temperature.

### Evaluation Example 3: Evaluation of photoluminescence spectrum

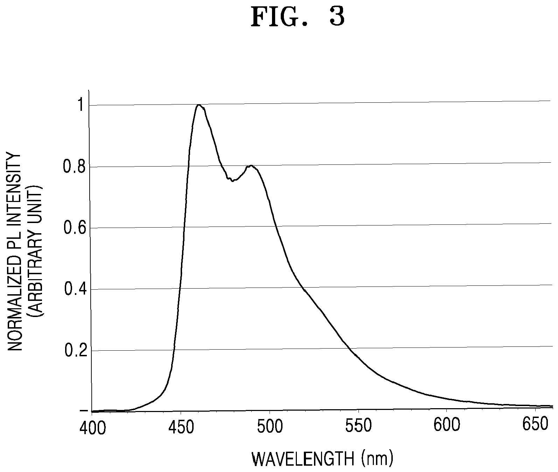

Luminescent characteristics of each Compound were evaluated by evaluating a photoluminescence (PL) spectrum of Compound 8. After Compound 8 was diluted at a concentration of 10 millimolar (mM) in CHCl₃, a PL spectrum thereof was measured at room temperature by using an ISC PC1 spectrofluorometer equipped with a xenon lamp. A maximum wavelength of the PL spectrum of Compound 8 is shown in Table 5 and FIG. 3.

**Table 5**

| Compound No. | λₘₐₓ (nm) |
|---|---|
| 8 | 462, 491 |

Referring to Table 5, it is confirmed that Compound 8 has PL characteristics suitable for deep blue light emission.

### Example 1

A glass substrate, on which an ITO electrode (first electrode, anode) having a thickness of 1,500 Angstroms (Å) was formed, was sonicated with distilled water. Then, the glass substrate was sonicated with a solvent such as iso-propyl alcohol, acetone, and methanol and then dried. The glass substrate was provided to a plasma cleaner, and the glass substrate was cleaned for 5 minutes by using oxygen plasma. Then, the glass substrate was provided to a vacuum deposition apparatus. Compound HT3 and Compound HT-D1 were co-deposited on the ITO electrode of the glass substrate to form a hole injection layer having a thickness of 100 Å, Compound HT3 was deposited on the hole injection layer to form a hole transport layer having a thickness of 1,300 Å, and mCP was deposited on the hole transport layer to form an electron blocking layer having a thickness of 100 Å, thereby forming a hole transport region.

Compound H52 (host) and Compound 1 (dopant, 10 percent by weight, wt%) were co-deposited on the hole transport region to form an emission layer having a thickness of 400 Å.

BCP was vacuum-deposited on the emission layer to form a hole blocking layer having a thickness of 100 Å, Compound ET3 and ET-D1 (LiQ) were vacuum-deposited on the hole blocking layer to form an electron transport layer having a thickness of 300 Å, ET-D1 (LiQ) was deposited on the electron transport layer to form an electron injection layer having a thickness of 10 Å, and Al was deposited on the electron injection layer to form an Al second electrode (cathode) having a thickness of 1,200 Å, thereby completing the manufacture of an organic light-emitting device.

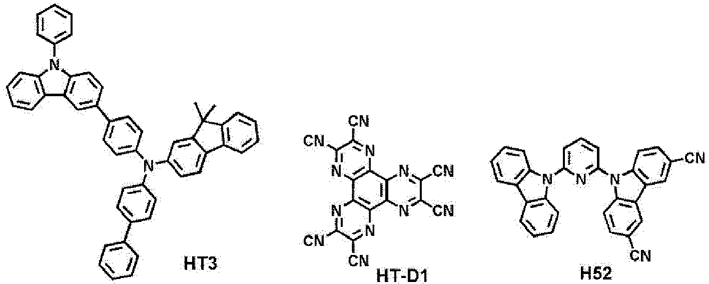

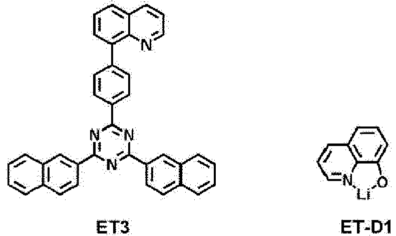

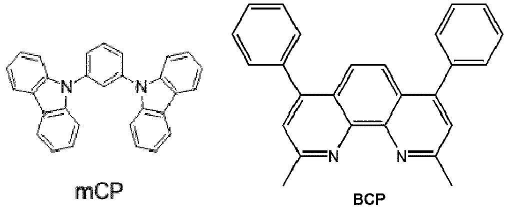

### Examples 2 to 13 and Comparative Examples 1 and 2

Organic light-emitting devices were manufactured in the same manner as in Example 1, except that Compounds shown in Table 6 were each used instead of Compound 1 as a dopant in forming an emission layer.

### Evaluation Example 4: Evaluation of characteristics of organic light-emitting devices

A current density change according to a voltage change, a luminance change according to a voltage change, luminescent efficiency, and durability were measured with respect to the organic light-emitting devices manufactured according to Examples 1 to 13 and Comparative Examples 1 and 2. Detailed measurement methods are as follows, and results thereof are shown in Table 6.

### (1) Measurement of current density change according to voltage change

A current value flowing through unit element in each manufactured organic light-emitting device was measured by using a current-voltage meter (Keithley 2400) while increasing a voltage from 0 volts (V) to 10 V, and a result was obtained by dividing the measured current value by an area.

### (2) Measurement of luminance change according to voltage change

Luminance in each manufactured organic light-emitting device was measured by using a luminance meter (Minolta Cs-1000A) while increasing a voltage from 0 V to 10 V.

### (3) Measurement of luminescent efficiency

Current efficiency (candelas per ampere, cd/A) at the same current density (10 milliamperes per square centimeter, mA/cm²) was calculated by using the current density and the luminance measured in the above (1) and (2) and the voltage.

### (4) Measurement of durability

An amount time that lapsed when luminance was 95% of initial luminance (100%) was evaluated.

**Table 6**

| No. | Dopant | Driving voltage (relative value) | Current efficiency (relative value) | Durability (relative value) | Color |
|---|---|---|---|---|---|
| Example 1 | Compound 1 | 95% | 112% | 174% | Blue |
| Example 2 | Compound 7 | 92% | 115% | 252% | Blue |
| Example 3 | Compound 8 | 94% | 110% | 412% | Blue |
| Example 4 | Compound 10 | 114% | 121% | 520% | Blue |
| Example 5 | Compound 18 | 101% | 105% | 214% | Blue |
| Example 6 | Compound 28 | 87% | 104% | 181% | Blue |
| Example 7 | Compound 48 | 95% | 120% | 424% | Bluish-green |
| Example 8 | Compound 108 | 107% | 104% | 142% | Bluish-green |
| Example 9 | Compound 148 | 115% | 117% | 175% | Bluish-green |
| Example 10 | Compound 230 | 120% | 103% | 135% | Blue |
| Example 11 | Compound 270 | 111% | 110% | 210% | Bluish-green |
| Example 12 | Compound 760 | 82% | 125% | 445% | Blue |
| Example 13 | Compound 774 | 89% | 124% | 374% | Blue |
| Comparative Example 1 | Compound A | 120% | 65% | 74% | Green |
| Comparative Example 2 | Compound B | 100% | 100% | 100% | Blue |

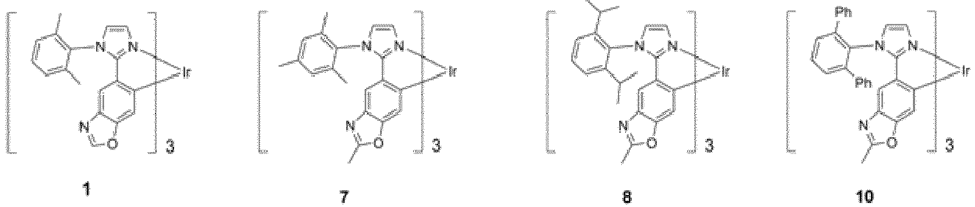

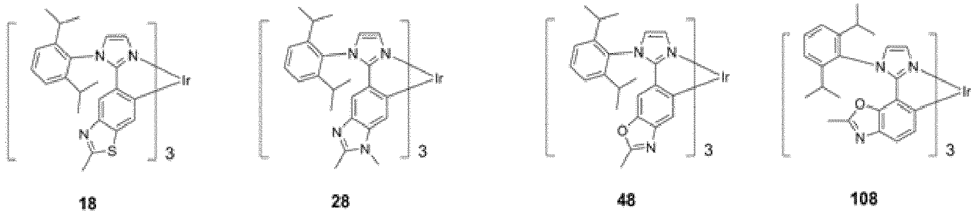

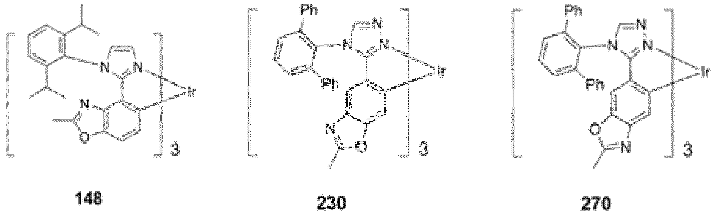

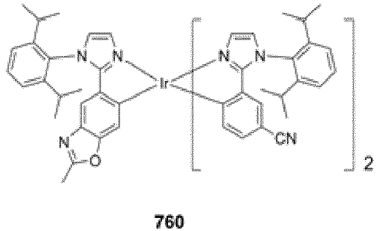

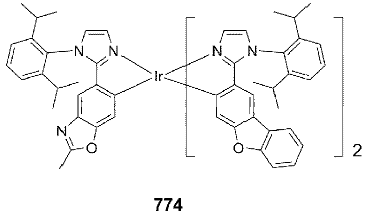

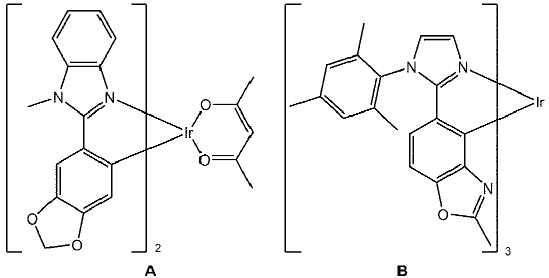

Referring to Table 6, it is confirmed that the organic light-emitting device of Example 1 has excellent efficiency, external quantum efficiency, and lifespan characteristics, as compared with those of the organic light-emitting devices of Comparative Examples 1 and 2.

Since the organometallic compounds according to embodiments of the present disclosure have excellent electrical characteristics and/or thermal stability, organic light-emitting devices including such organometallic compounds may have improved driving voltage, current density, efficiency, power, color purity, lifespan characteristics.
It should be understood that embodiments described herein should be considered in a descriptive sense only and not for purposes of limitation. Descriptions of features or aspects within each embodiment should typically be considered as available for other similar features or aspects in other embodiments.

While one or more embodiments have been described with reference to the figures, it will be understood by those of ordinary skill in the art that various changes in form and details may be made therein without departing from the scope as defined by the following claims.

## Claims

1. An organometallic compound represented by one of Formulae 1 to 4: 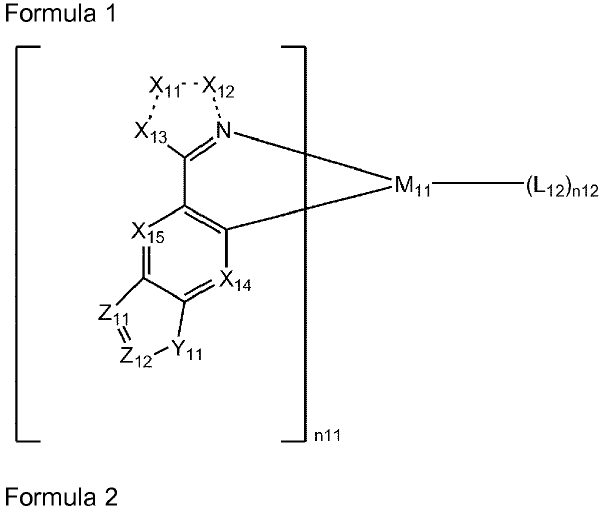 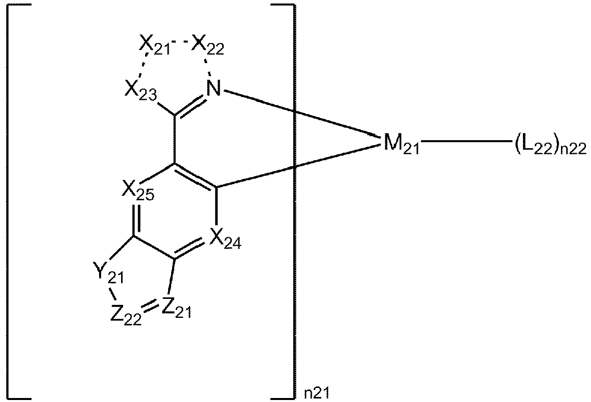 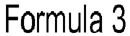 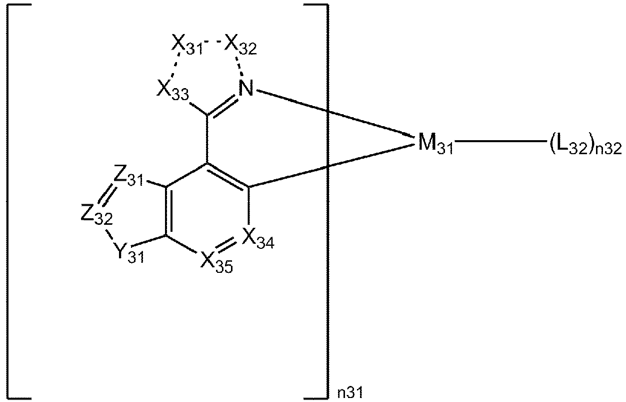 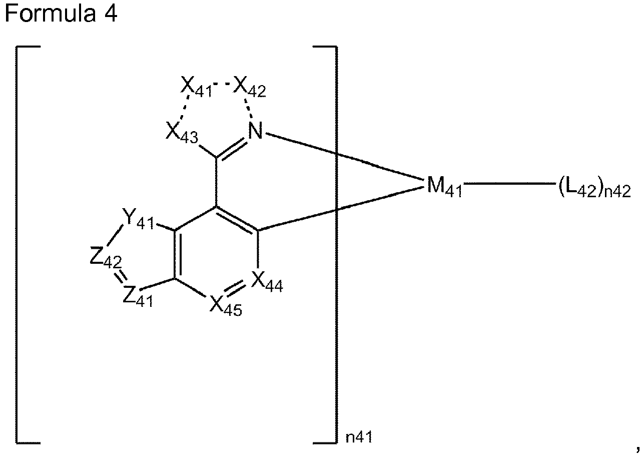 wherein, in Formulae 1 to 4,
M₁₁, M₂₁, M₃₁, and M₄₁ are each independently selected from first-row transition metals, second-row transition metals, and third-row transition metals,
X₁₁ to X₁₃ are each independently selected from N, N(R₁₂), O, S, C(R₁₃), and C(R₁₂)(R₁₃), and two neighboring constituents R₁₂, neighboring R₁₂ and R₁₃, and/or two neighboring constituents R₁₃ are optionally linked to form a substituted or unsubstituted C₅-C₃₀ carbocyclic group or a substituted or unsubstituted C₁-C₃₀ heterocyclic group,
X₂₁ to X₂₃ are each independently selected from N, N(R₂₂), O, S, C(R₂₃), and C(R₂₂)(R₂₃), and two neighboring constituents R₂₂, neighboring R₂₂ and R₂₃, and/or two neighboring constituents R₂₃ are optionally linked to form a substituted or unsubstituted C₅-C₃₀ carbocyclic group or a substituted or unsubstituted C₁-C₃₀ heterocyclic group,
X₃₁ to X₃₃ are each independently selected from N, N(R₃₂), O, S, C(R₃₃), and C(R₃₂)(R₃₃), and two neighboring constituents R₃₂, neighboring R₃₂ and R₃₃, and/or two neighboring constituents R₃₃ are optionally linked to form a substituted or unsubstituted C₅-C₃₀ carbocyclic group or a substituted or unsubstituted C₁-C₃₀ heterocyclic group,
X₄₁ to X₄₃ are each independently selected from N, N(R₄₂), O, S, C(R₄₃), and C(R42)(R43), and two neighboring constituents R₄₂, neighboring R₄₂ and R₄₃, and/or two neighboring constituents R₄₃ are optionally linked to form a substituted or unsubstituted C₅-C₃₀ carbocyclic group or a substituted or unsubstituted C₁-C₃₀ heterocyclic group,
a bond between X₁₁ and X₁₃, a bond between X₁₁ and X₁₂, a bond between X₁₂ and N, a bond between X₂₁ and X₂₃, a bond between X₂₁ and X₂₂, a bond between X₂₂ and N, a bond between X₃₁ and X₃₃, a bond between X₃₁ and X₃₂, a bond between X₃₂ and N, a bond between X₄₁ and X₄₃, a bond between X₄₁ and X₄₂, and a bond between X₄₂ and N are each independently a single bond or a double bond,
X₁₄ and X₁₅ are each independently N or C(R₁₄),
X₂₄ and X₂₅ are each independently N or C(R₂₄),
X₃₄ and X₃₅ are each independently N or C(R₃₄),
X₄₄ and X₄₅ are each independently N or C(R₄₄),
Y₁₁ is selected from N(R₁₅), O, and S,
Y₂₁ is selected from N(R₂₅), O, and S,
Y₃₁ is selected from N(R₃₅), O, and S,
Y₄₁ is selected from N(R₄₅), O, and S,
Z₁₁ and Z₁₂ are each independently N or C(R₁₁), provided at least one of Z₁₁ and Z₁₂ is N,
Z₂₁ and Z₂₂ are each independently N or C(R₂₁), provided at least one of Z₂₁ and Z₂₂ is N,
Z₃₁ and Z₃₂ are each independently N or C(R₃₁), provided at least one of Z₃₁ and Z₃₂ is N,
Z₄₁ and Z₄₂ are each independently N or C(R₄₁), provided at least one of Z₄₁ and Z₄₂ is N,
R₁₁ to R₁₅, R₂₁ to R₂₅, R₃₁ to R₃₅, and R₄₁ to R₄₅ are each independently selected from hydrogen, deuterium, -F, -CI, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₇-C₆₀ arylalkyl group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted C₂-C₆₀ heteroarylalkyl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -B(Q₆)(Q₇), and-P(=O)(Q₈)(Q₉),
two, three, or four neighboring constituents selected from R₁₁ to R₁₅, two, three, or four neighboring constituents selected from R₂₁ to R₂₅, two, three, or four neighboring constituents selected from R₃₁ to R₃₅, and/or two, three, or four neighboring constituents selected from R₄₁ to R₄₅ are optionally linked to form a four-coordinate, six-coordinate, or eight-coordinate ligand,
n11, n21, n31, and n41 are each independently selected from 1, 2, 3, and 4,
n12, n22, n32, and n42 are each independently selected from 0, 1, 2, 3, and 4,
L₁₂, L₂₂, L₃₂, and L₄₂ are each independently selected from a one-coordinate ligand, a two-coordinate ligand, and a three-coordinate ligand, and
Q₁ to Q₉ are each independently selected from hydrogen, deuterium, -F, -CI,-Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₁-C₆₀ alkyl group substituted with at least one selected from deuterium, a C₁-C₆₀ alkyl group, and a C₆-C₆₀ aryl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with at least one selected from deuterium, a C₁-C₆₀ alkyl group, and a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, and a monovalent non-aromatic condensed heteropolycyclic group.

2. The organometallic compound of claim 1, wherein
M₁₁, M₂₁, M₃₁, and M₄₁ are each independently selected from platinum (Pt), palladium (Pd), copper (Cu), silver (Ag), gold (Au), rhodium (Rh), iridium (Ir), ruthenium (Ru), osmium (Os), titanium (Ti), zirconium (Zr), hafnium (Hf), europium (Eu), terbium (Tb), and thulium (Tm);
preferably wherein
M₁₁, M₂₁, M₃₁, and M₄₁ are each independently selected from Pt, Pd, Cu, Ag, Au, Rh, Ir, Ru, and Os;
preferably wherein
M₁₁, M₂₁, M₃₁, and M₄₁ are each independently selected from Rh, Ir, Ru, and Os.

3. The organometallic compound of claims 1 or 2, wherein
X₁₃ is N(R₁₂), and X₁₁ and X₁₂ are each independently N or C(R₁₃), provided that at least one of X₁₁ and X₁₂ is N; X₂₃ is N(R₂₂), and X₂₁ and X₂₂ are each independently N or C(R₂₃), provided that at least one of X₂₁ and X₂₂ is N; X₃₃ is N(R₃₂), and X₃₁ and X₃₂ are each independently N or C(R₃₃), provided that at least one of X₃₁ and X₃₂ is N; and X₄₃ is N(R₄₂), and X₄₁ and X₄₂ are each independently N or C(R₄₃), provided that at least one of X₄₁ and X₄₂ is N;
X₁₂ is C(R₁₃), X₁₁ is N or C(R₁₃), X₁₃ is N(R₁₂), X₂₂ is C(R₂₃), X₂₁ is N or C(R₂₃), X₂₃ is N(R₂₂), X₃₂ is C(R₃₃), X₃₁ is N or C(R₃₃), X₃₃ is N(R₃₂), X₄₂ is C(R₄₃), X₄₁ is N or C(R₄₃), and X₄₃ is N(R₄₂);
X₁₁ is N, X₁₂ is N or C(R₁₃), X₁₃ is N(R₁₂), X₂₁ is N, X₂₂ is N or C(R₂₃), X₂₃ is N(R₂₂), X₃₁ is N, X₃₂ is N or C(R₃₃), X₃₃ is N(R₃₂), X₄₁ is N, X₄₂ is N or C(R₄₃), and X₄₃ is N(R₄₂);
X₁₂ is N, X₁₁ is N or C(R₁₃), X₁₃ is N(R₁₂), X₂₂ is N, X₂₁ is N or C(R₂₃), X₂₃ is N(R₂₂), X₃₂ is N, X₃₁ is N or C(R₃₃), X₃₃ is N(R₃₂), X₄₂ is N, X₄₁ is N or C(R₄₃), and X₄₃ is N(R₄₂); or
X₁₃ is O or S, X₁₁ and X₁₂ are each independently N or C(R₁₃), X₂₃ is O or S, X₂₁ and X₂₂ are each independently N or C(R₂₃), X₃₃ is O or S, X₃₁ and X₃₂ are each independently N or C(R₃₃), X₄₃ is O or S, and X₄₁ and X₄₂ are each independently N or C(R₄₃).

4. The organometallic compound of any of claims 1-3, wherein
X₁₄ and X₁₅ are each C(R₁₄),
X₂₄ and X₂₅ are each C(R₂₄),
X₃₄ and X₃₅ are each C(R₃₄), and
X₄₄ and X₄₅ are each C(R₄₄);
and/or wherein
Z₁₁ is N,
Z₂₁ is N,
Z₃₁ is N, and
Z₄₁ is N.

5. The organometallic compound of any of claims 1-4, wherein
R₁₁ to R₁₅, R₂₁ to R₂₅, R₃₁ to R₃₅, and R₄₁ to R₄₅ are each independently selected from:
hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -CI, -Br, -I, -CD₃, -CD₂H, -CDH₂, -CF₃, -CF₂H,-CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclopentyl group substituted with deuterium, a cyclohexyl group, a cyclohexyl group substituted with deuterium, a cycloheptyl group, a cycloheptyl group substituted with deuterium, a cyclooctyl group, a cyclooctyl group substituted with deuterium, a bicyclo[2.2.1]heptanyl group, an adamantanyl group, a norbornanyl group, a norbornenyl group, a cyclopentenyl group, a cyclohexenyl group, a cycloheptenyl group, a phenyl group, a naphthyl group, a pyridinyl group, and a pyrimidinyl group;
a cyclopentyl group, a cyclohexyl group, a cycloheptyl group, a cyclooctyl group, a bicyclo[2.2.1]heptanyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group;
a cyclopentyl group, a cyclohexyl group, a cycloheptyl group, a cyclooctyl group, a bicyclo[2.2.1]heptanyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group, each substituted with at least one selected from deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclopentyl group substituted with deuterium, a cyclohexyl group, a cyclohexyl group substituted with deuterium, a cycloheptyl group, a cycloheptyl group substituted with deuterium, a cyclooctyl group, a cyclooctyl group substituted with deuterium, a bicyclo[2.2.1]heptanyl group, an adamantanyl group, a norbornanyl group, a norbornenyl group, a cyclopentenyl group, a cyclohexenyl group, a cycloheptenyl group, a phenyl group, a C₁-C₂₀ alklphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group, and -Si(Q33)(Q34)(Q35); and
-N(Q₁)(Q₂), -Si(Q₃)(Q₄)(Q₅), -B(Q₆)(Q₇), and -P(=O)(Q₈)(Q₉), and
Q₁ to Q₉ and Q₃₃ to Q₃₅ are each independently selected from:
-CH₃, -CD₃, -CD₂H, -CDH₂, -CH₂CH₃, -CH₂CD₃, -CH₂CD₂H, -CH₂CDH₂,-CHDCH₃, -CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from deuterium, a C₁-C₁₀ alkyl group, and a phenyl group.

6. The organometallic compound of any of claims 1-5, wherein
R₁₁ to R₁₅, R₂₁ to R₂₅, R₃₁ to R₃₅, and R₄₁ to R₄₅ are each independently selected from hydrogen, deuterium, -F, a cyano group, a nitro group, -SF₅, -CH₃,-CF₃, groups represented by Formulae 9-1 to 9-13, groups represented by Formulae 10-17 to 10-79, and groups represented by Formulae 10-247 to 10-256: 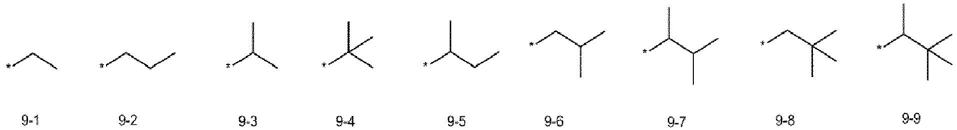 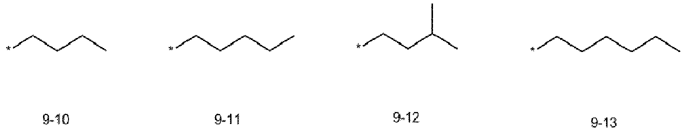 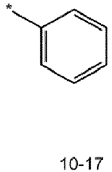 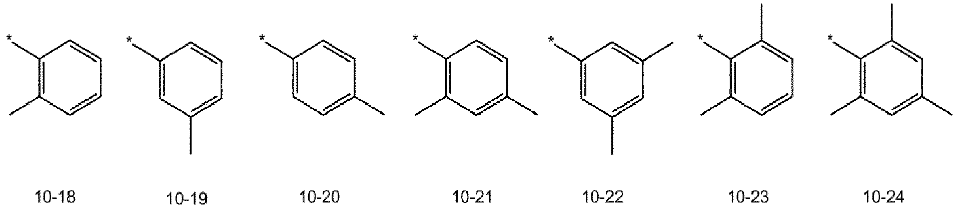 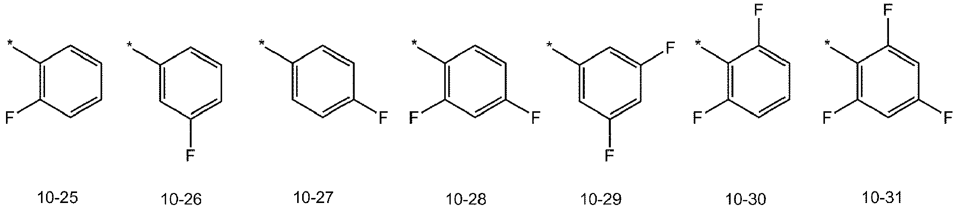 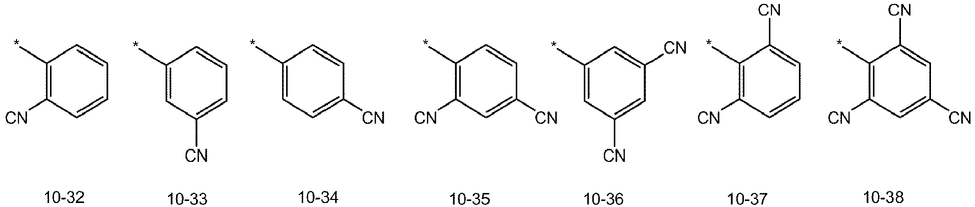 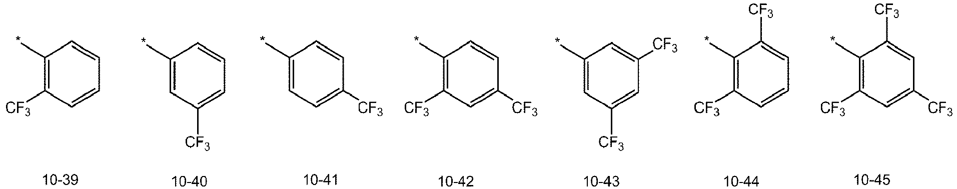 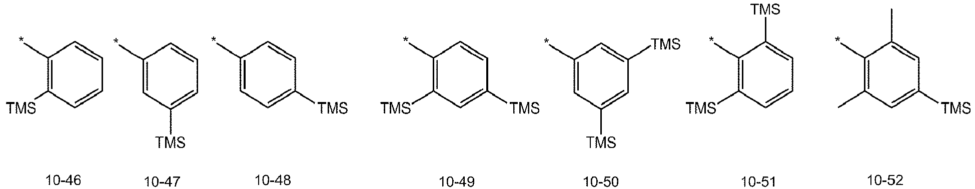 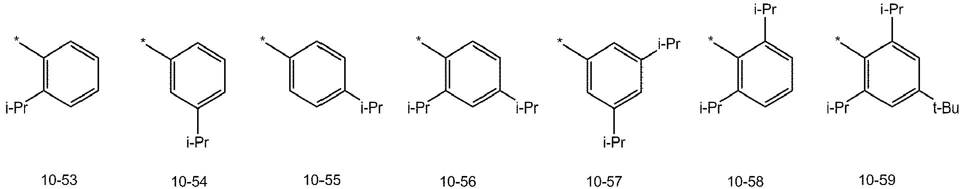 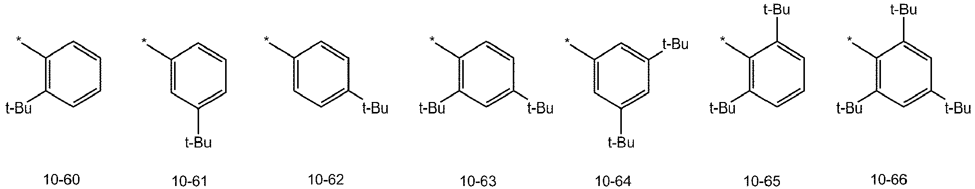 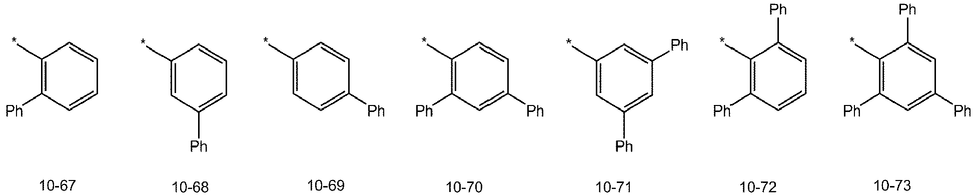 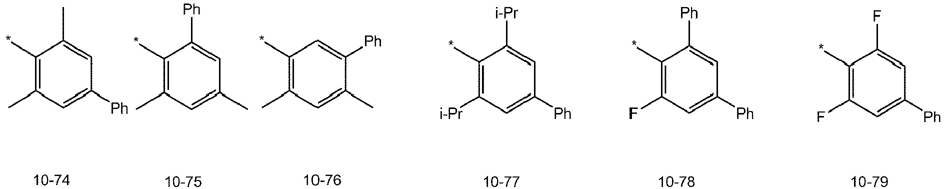 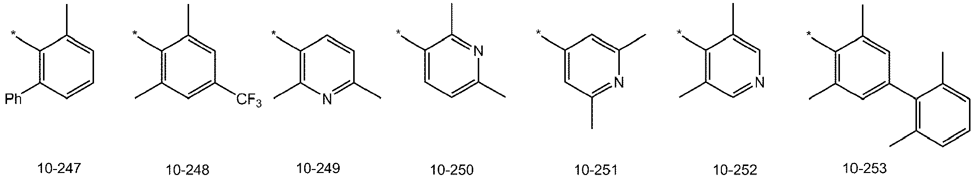 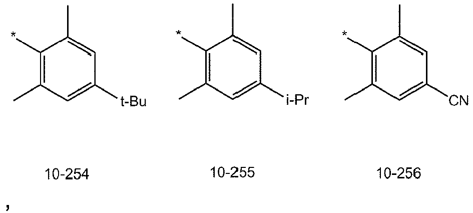 wherein, in the groups represented by Formulae 9-1 to 9-13, the groups represented by Formulae 10-17 to 10-79, and groups represented by Formulae 10-247 to 10-256,
* indicates a binding site to a neighboring atom,
i-Pr indicates an iso-propyl group, and t-Bu indicates a t-butyl group,
Ph indicates a phenyl group, and
TMS indicates a trimethylsilyl group.

7. The organometallic compound of any of claims 1-6, wherein
X₁₃ is N(R₁₂), X₂₃ is N(R₂₂), X₃₃ is N(R₃₂), and X₄₃ is N(R₄₂),
R₁₂, R₂₂, R₃₂, and R₄₂ are each independently selected from a phenyl group, a naphthyl group, a pyridinyl group, a pyrimidinyl group, a fluorenyl group, a carbazolyl group, a dibenzofuranyl group, a dibenzothiophenyl group, and a dibenzosilolyl group, each substituted with at least one selected from deuterium, -F, -CD₃, -CD₂H, -CDH₂,-CF₃, -CF₂H, -CFH₂, a cyano group, nitro group, a C₁-C₁₀ alkyl group, a C₁-C₁₀ alkoxy group, a cyclopentyl group, a cyclopentyl group substituted with deuterium, a cyclohexyl group, a cyclohexyl group substituted with deuterium, a cycloheptyl group, a cycloheptyl group substituted with deuterium, a cyclooctyl group, a cyclooctyl group substituted with deuterium, a bicyclo[2.2.1]heptanyl group, an adamantanyl group, a norbonanyl group, a norbornenyl group, a cyclopentenyl group, a cyclohexenyl group, a cycloheptenyl group, a phenyl group, a C₁-C₂₀ alkylphenyl group, a naphthyl group, a pyridinyl group, a pyrimidinyl group, a fluorenyl group, a carbazolyl group, a dibenzofuranyl group, a dibenzothiophenyl group, dibenzosilolyl group, and-Si(Q₃₃)(Q₃₄)(Q₃₅), and
Q₃₃ to Q₃₅ are each independently selected from:
-CH₃, -CD₃, -CD₂H, -CDH₂, -CH₂CH₃, -CH₂CD₃, -CH₂CD₂H, -CH₂CDH₂,-CHDCH₃, -CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group and a naphthyl group, each substituted with at least one selected from deuterium, a C₁-C₁₀ alkyl group, and a phenyl group.

8. The organometallic compound of any of claims 1-7, wherein
n11, n21, n31, and n41 are each independently selected from 1, 2, and 3; and/or
wherein
n12, n22, n32, and n42 are each independently selected from 0, 1, and 2.

9. The organometallic compound of any of claims 1-8, wherein
M₁₁, M₂₁, M₃₁, and M₄₁ are each iridium (Ir),
n11, n21, n31, and n41 are each independently 2 or 3, and
n12, n22, n32, and n42 are each independently selected from 0, 1, and 2.

10. The organometallic compound of any of claims 1-9, wherein
L₁₂, L₂₂, L₃₂, and L₄₂ are each a ligand represented by one of Formulae 7-1 to 7-11: 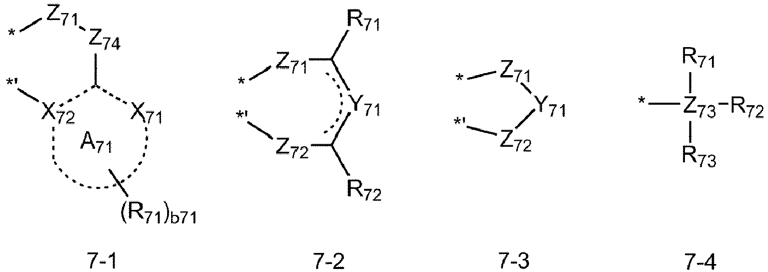 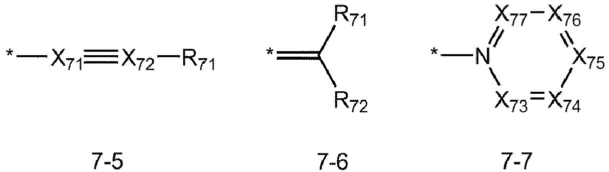 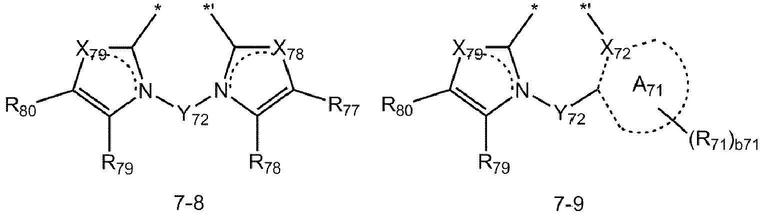 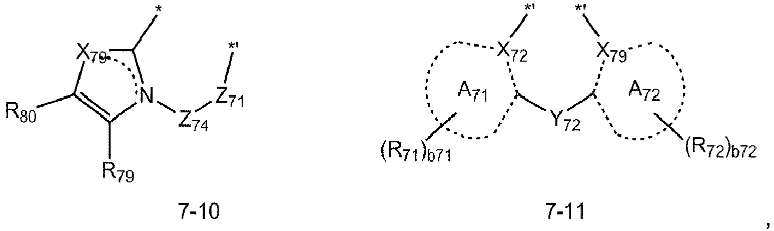 wherein, in Formulae 7-1 to 7-11,
A₇₁ and A₇₂ are each independently a C₅-C₂₀ carbocyclic group or a C₁-C₂₀ heterocyclic group,
X₇₁ and X₇₂ are each independently C or N,
X₇₃ is N or C(Q73), X₇₄ is N or C(Q74), X₇₅ is N or C(Q₇₅), X₇₆ is N or C(Q₇₆), and X₇₇ is N or C(Q77),
X₇₈ is O, S, or N(Q78), and X₇₉ is O, S, or N(Q79),
Y₇₁ and Y₇₂ are each independently selected from a single bond, a double bond, a substituted or unsubstituted C₁-C₅ alkylene group, a substituted or unsubstituted C₂-C₅ alkenylene group, and a substituted or unsubstituted C₆-C₁₀ arylene group,
Z₇₁ and Z₇₂ are each independently selected from N, O, N(R₇₄), P(R₇₅)(R₇₆), and AS(R₇₅)(R₇₆),
Z₇₃ is P or As,
Z₇₄ is CO or CH₂,
R₇₁ to R₈₀ and Q₇₃ to Q₇₉ are each independently selected from hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₇-C₆₀ arylalkyl group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted C₂-C₆₀ heteroarylalkyl group, a substituted or unsubstituted monovalent non-aromatic condensed polycyclic group, and a substituted or unsubstituted monovalent non-aromatic condensed heteropolycyclic group, wherein R₇₁ and R₇₂ are optionally linked to form a ring, R₇₇ and R₇₈ are optionally linked to form a ring, R₇₈ and R₇₉ are optionally linked to form a ring, and R₇₉ and R₈₀ are optionally linked to form a ring,
b71 and b72 are each independently selected from 1, 2, and 3, and
* and *' each indicate a binding site to a neighboring atom.

11. The organometallic compound of any of claims 1-10, wherein
the organometallic compound represented by one of Formulae 1 to 4 is represented by one of Formulae 1-1 to 1-72, 2-1 to 2-72, 3-1 to 3-72, and 4-1 to 4-72: 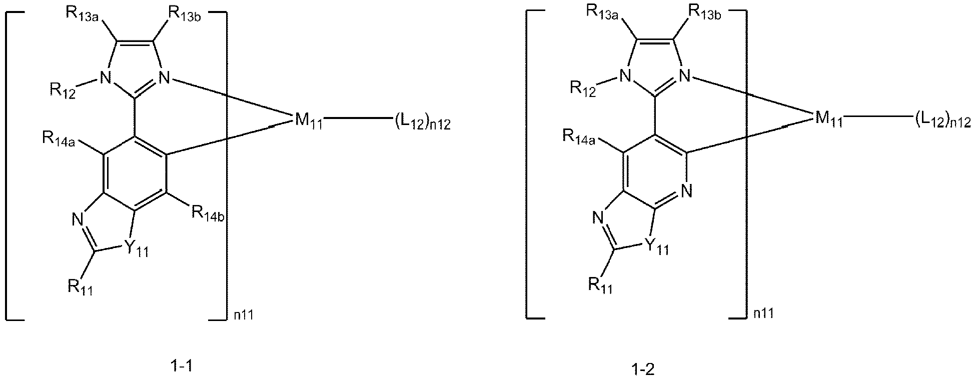 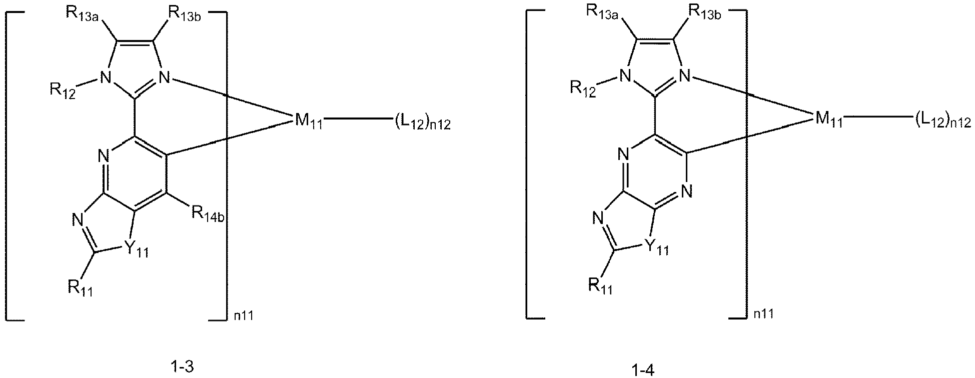 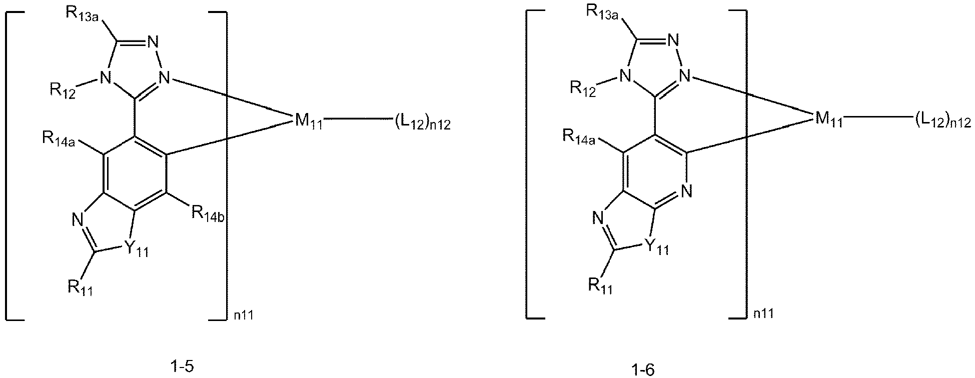 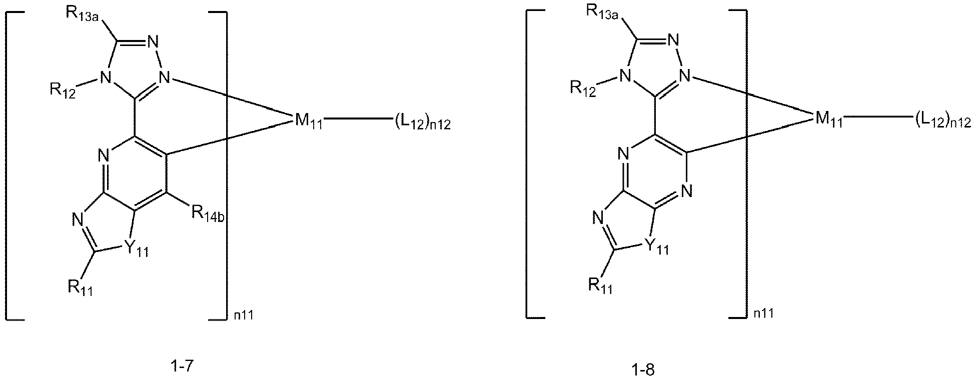 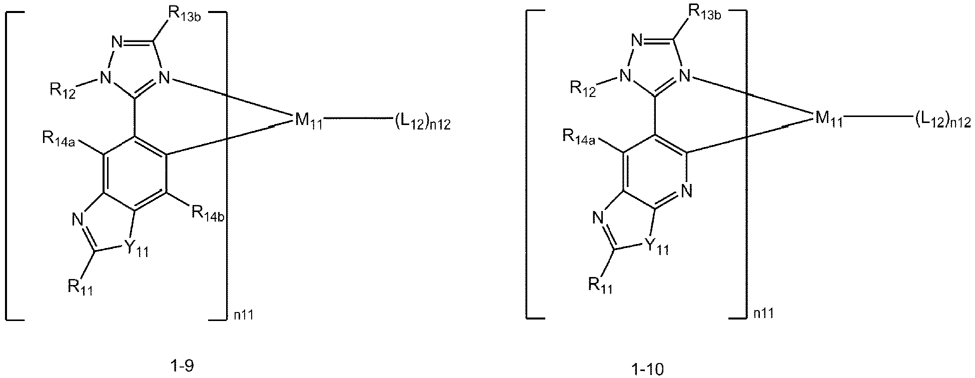 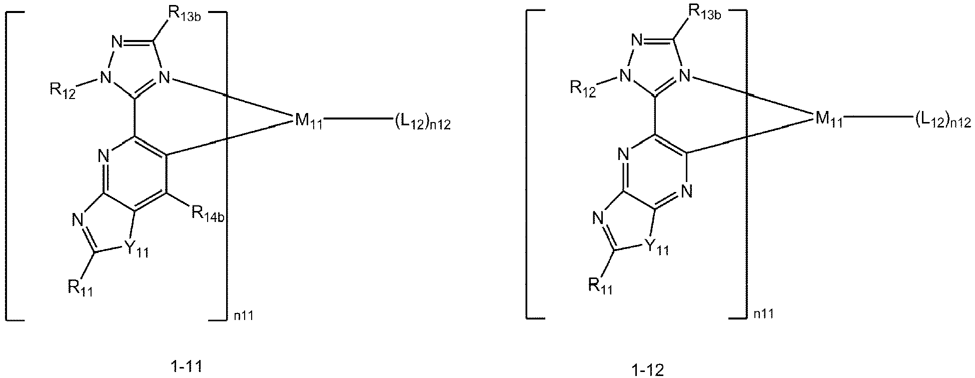 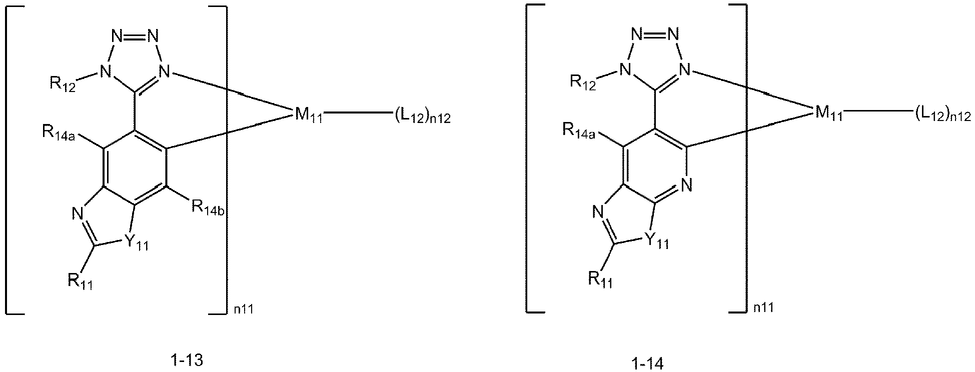 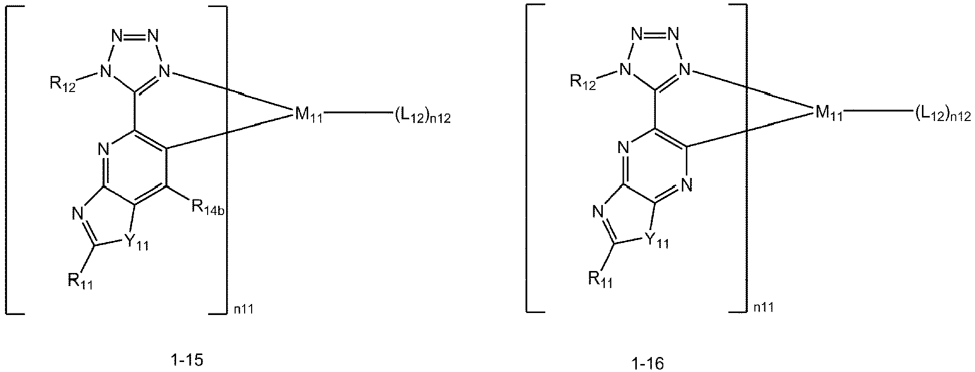 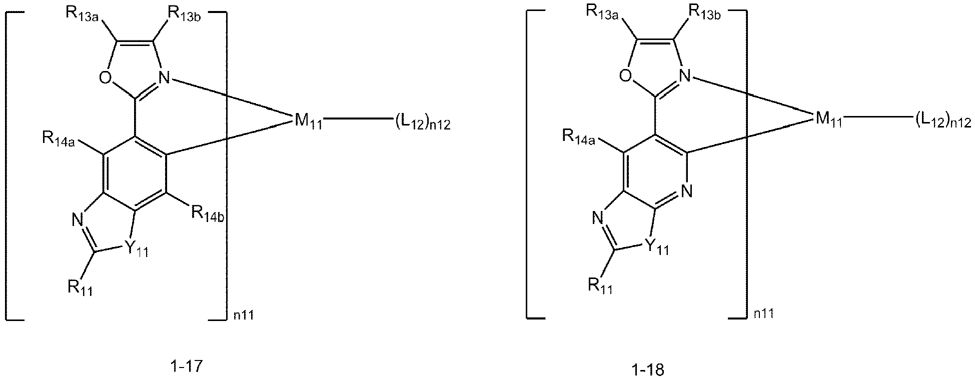 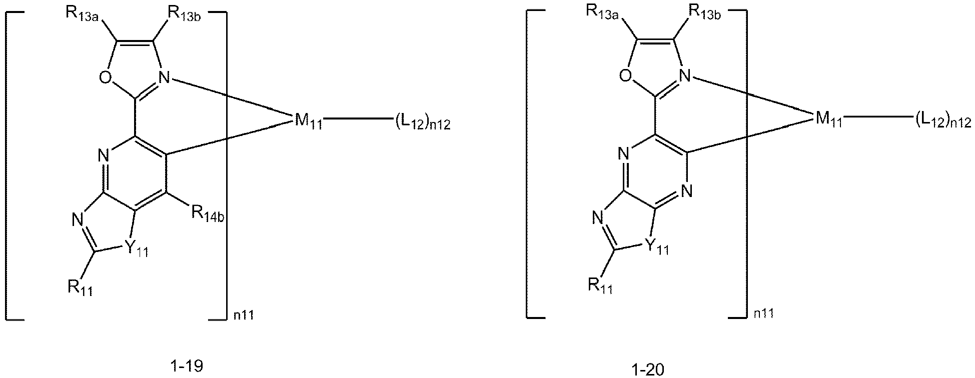 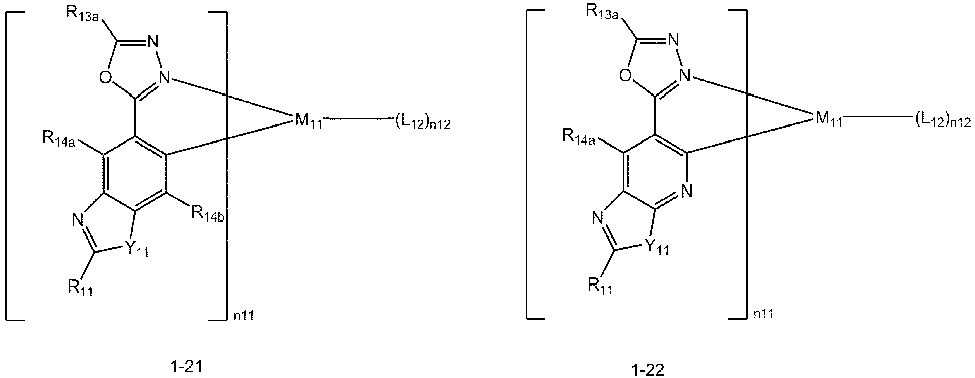 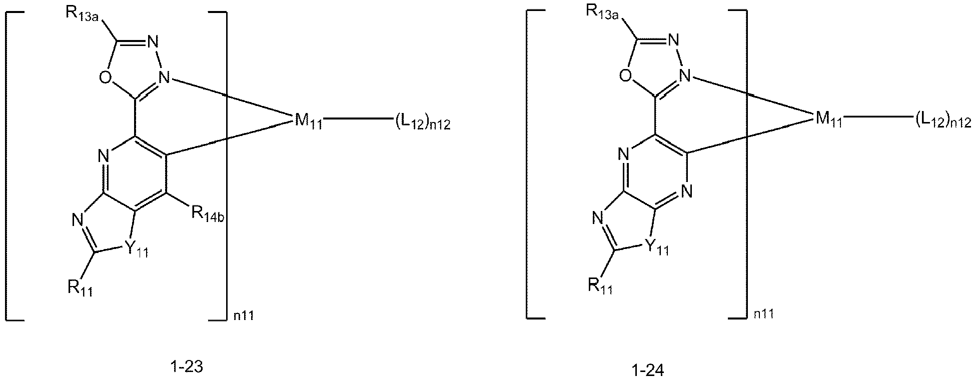 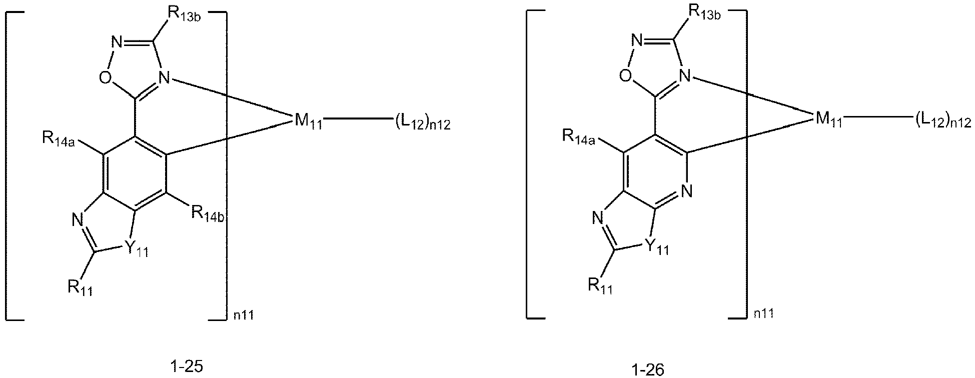 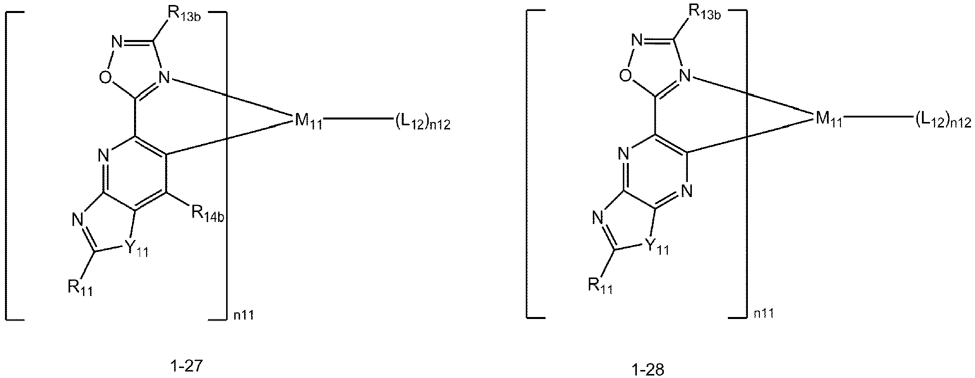 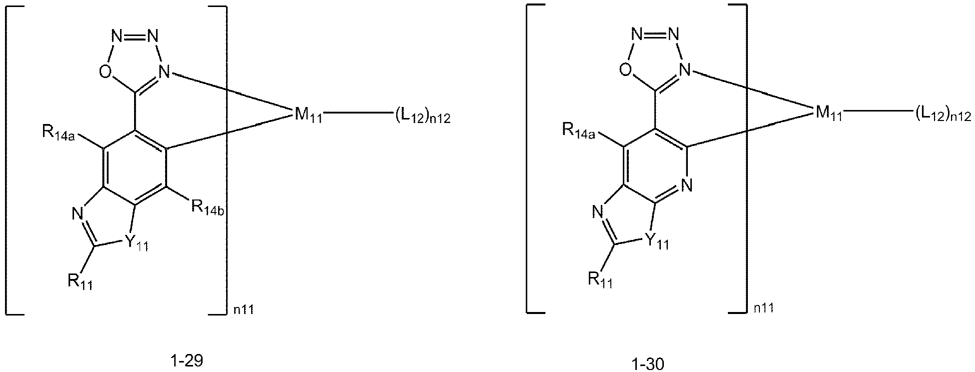 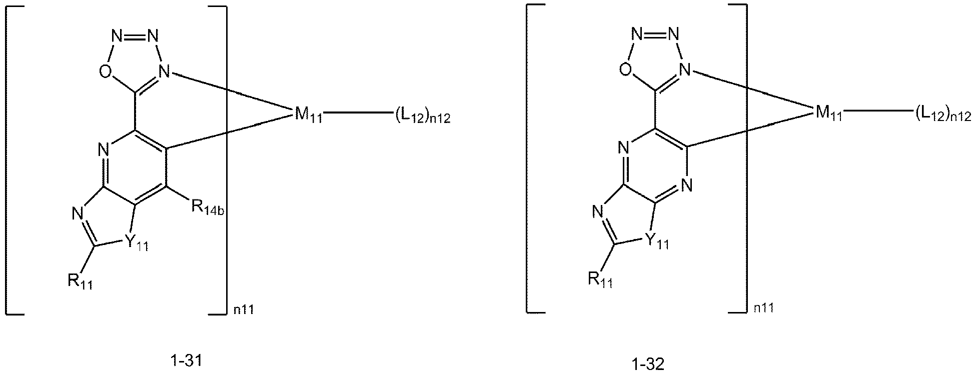 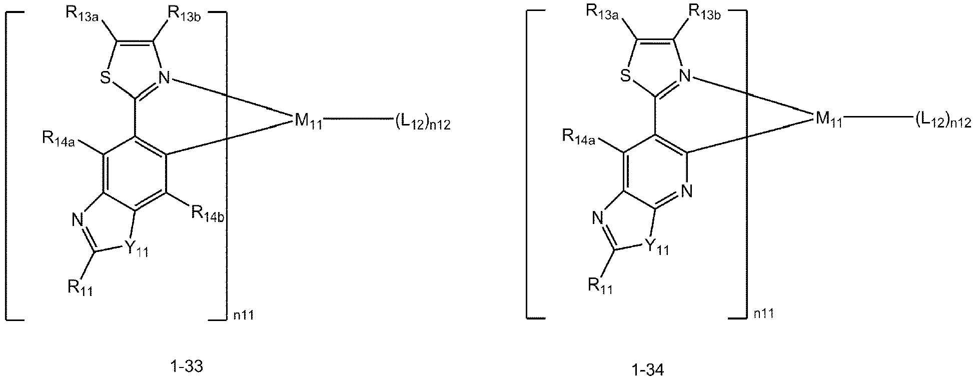 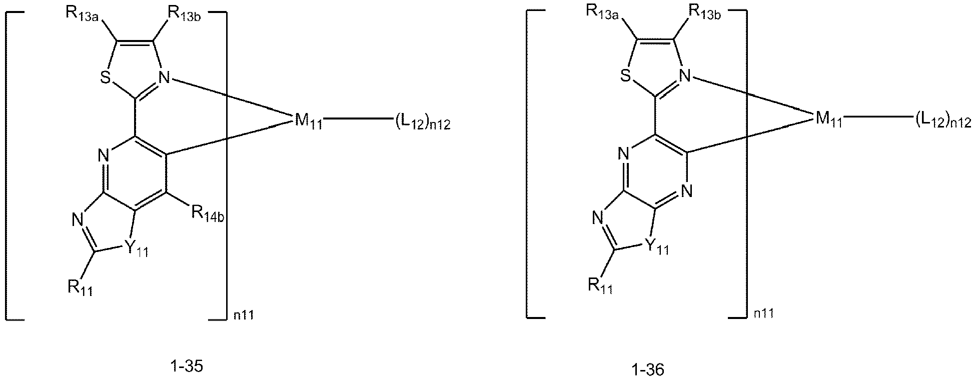 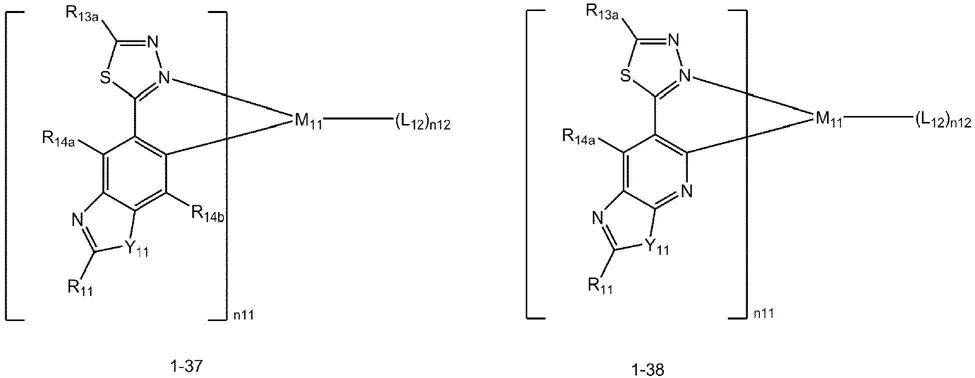 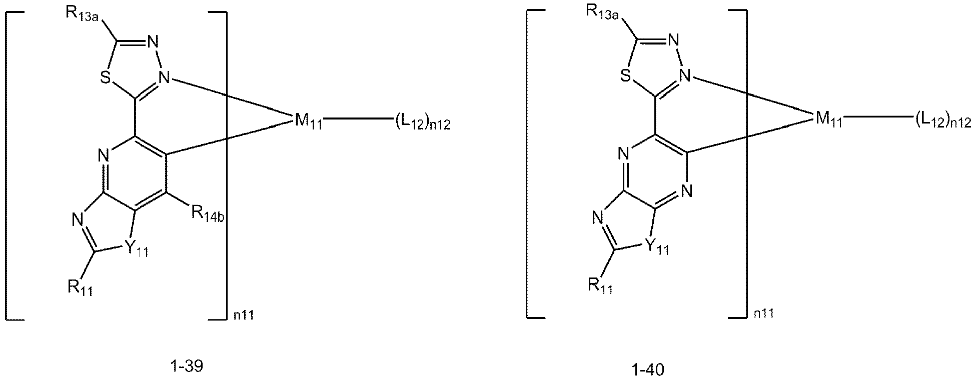 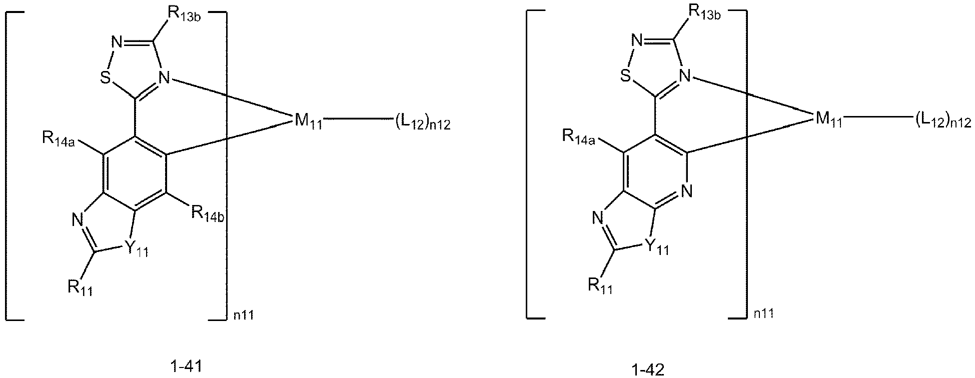 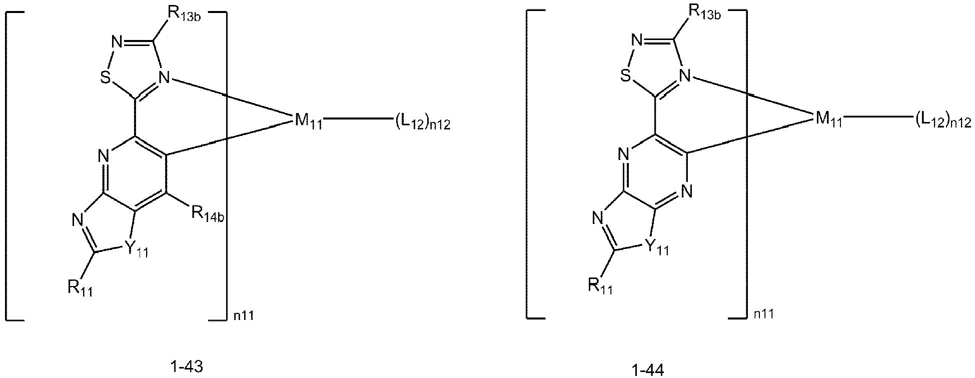 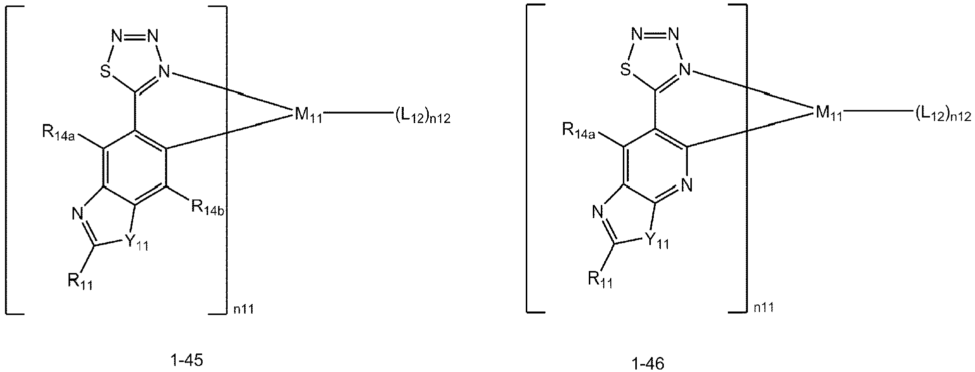 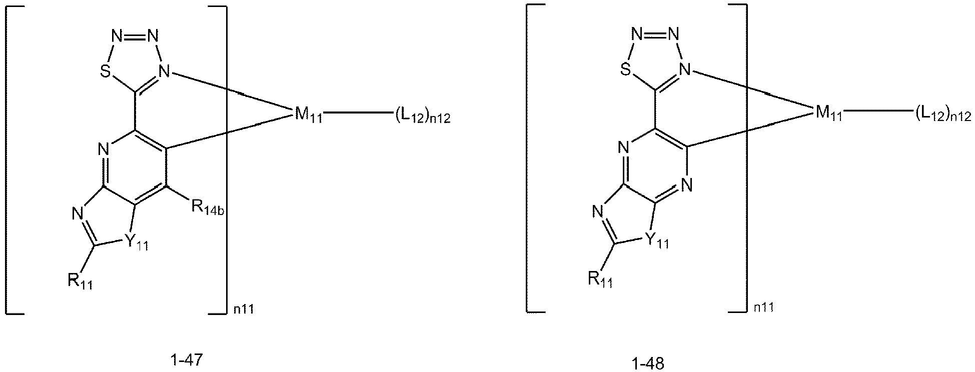 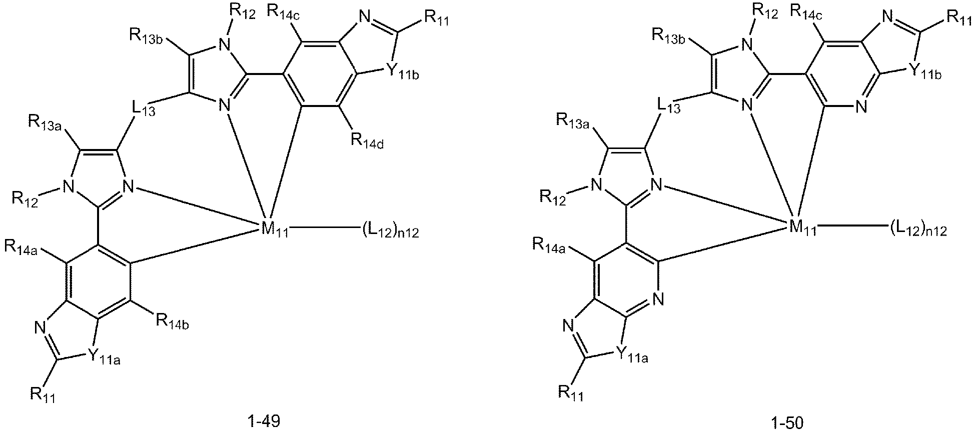 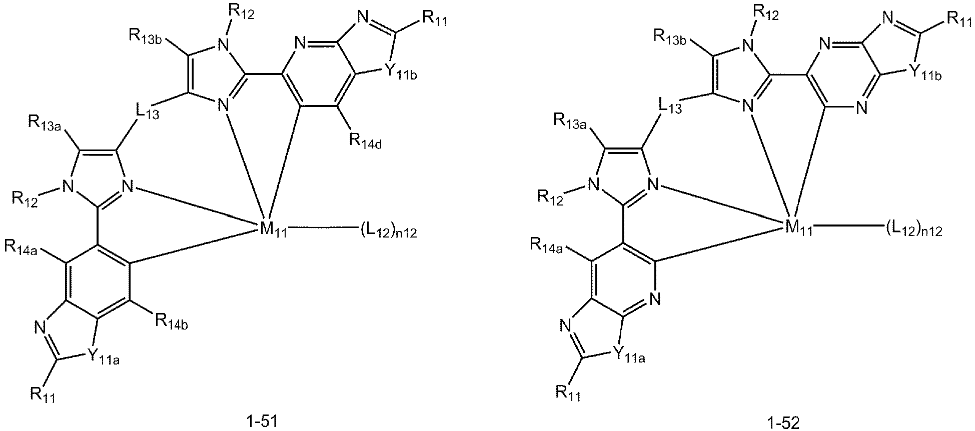 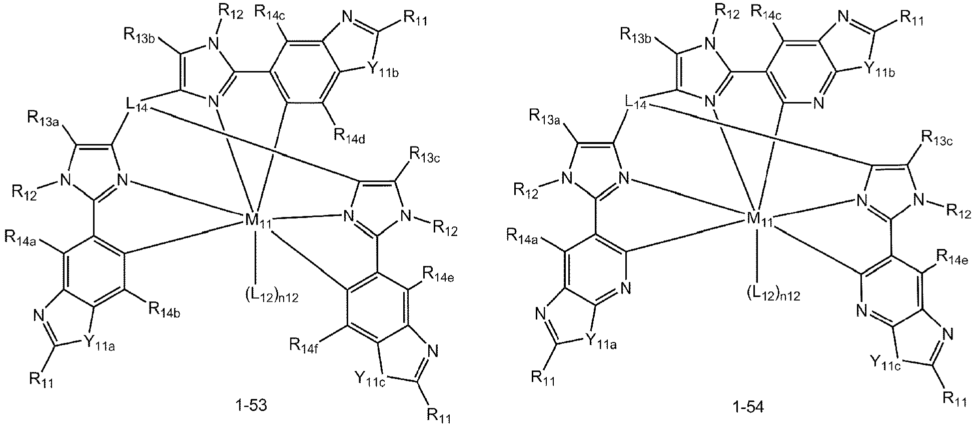 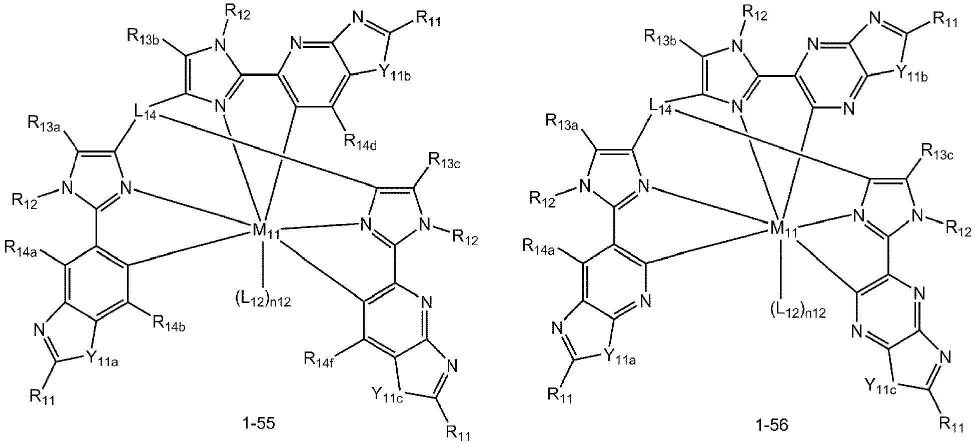 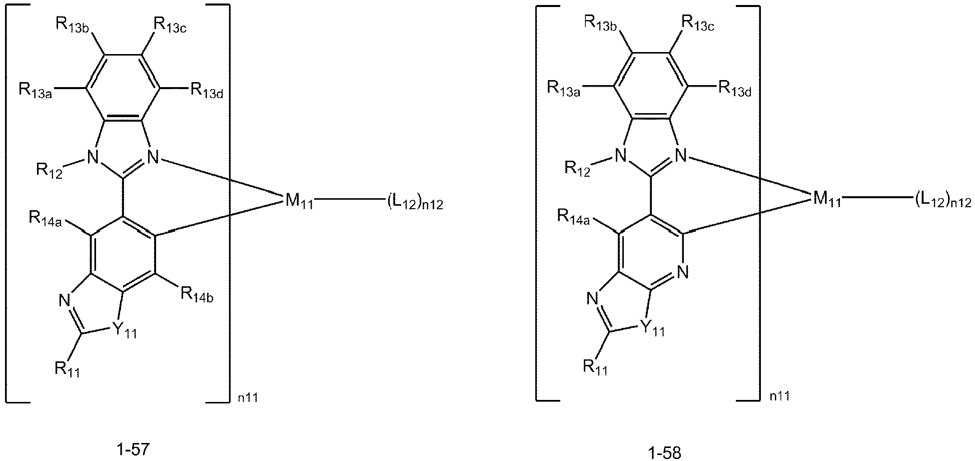 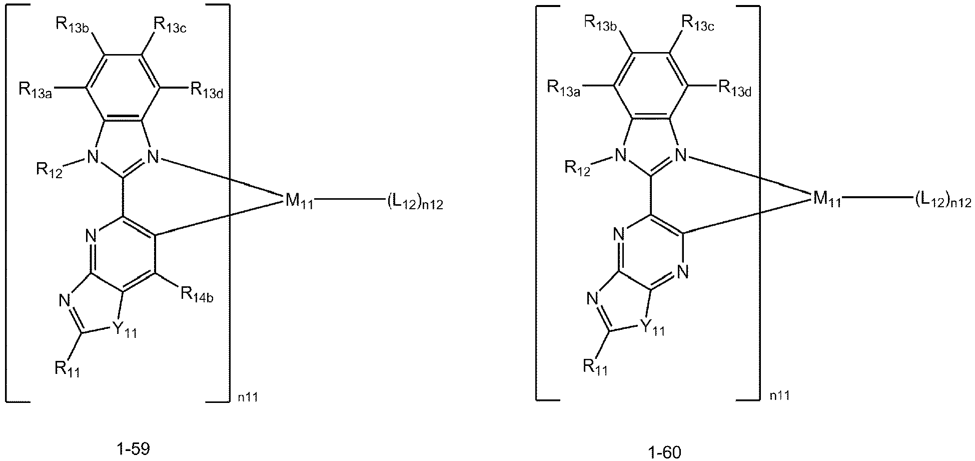 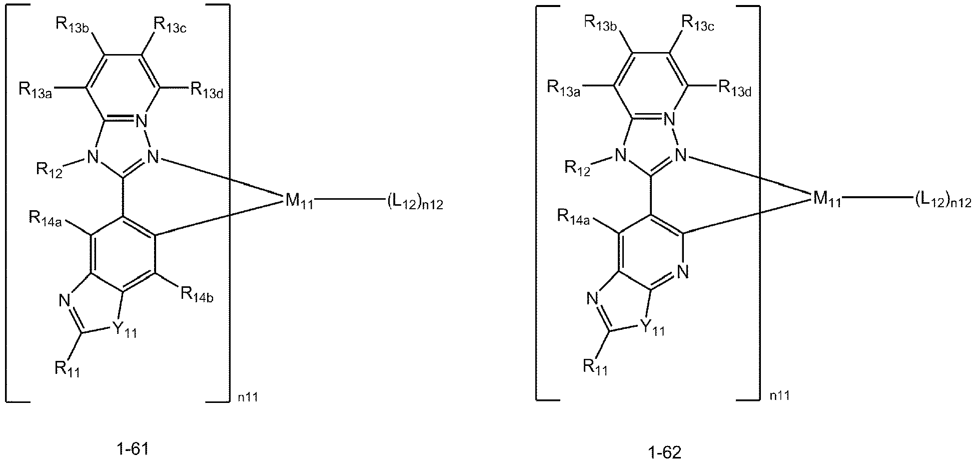 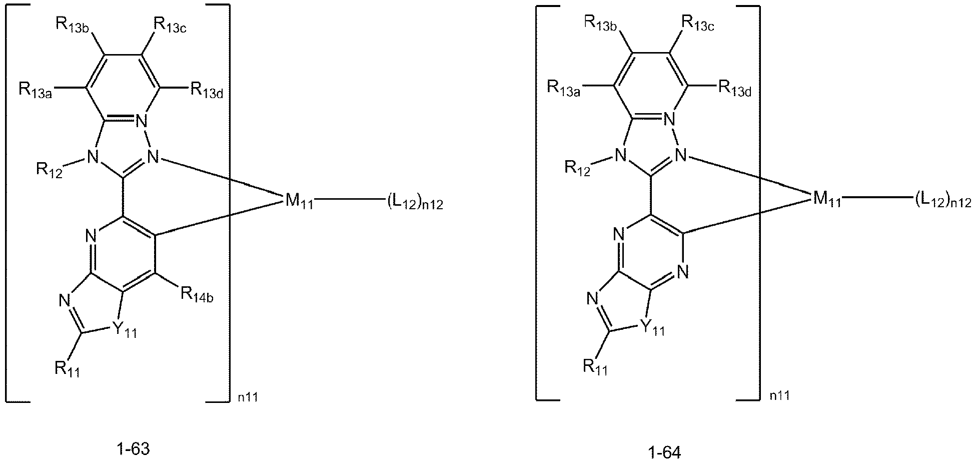 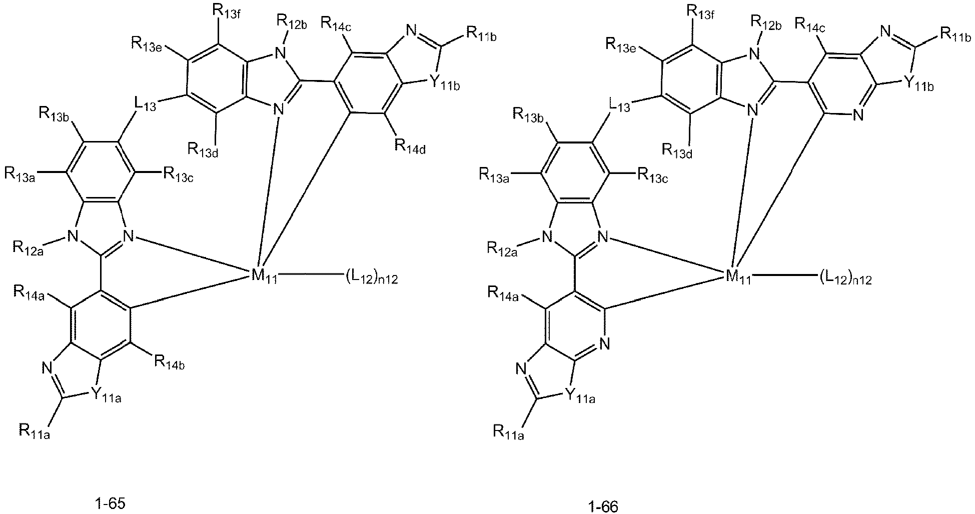 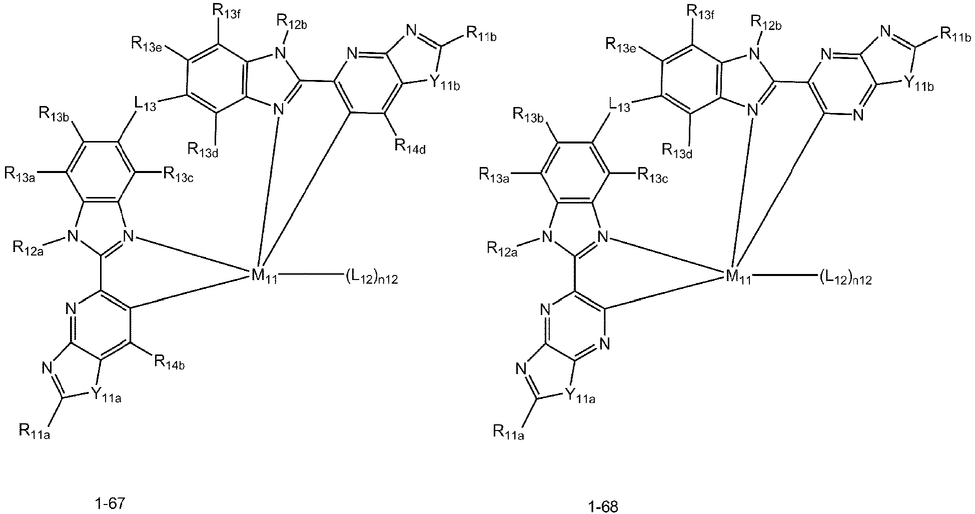 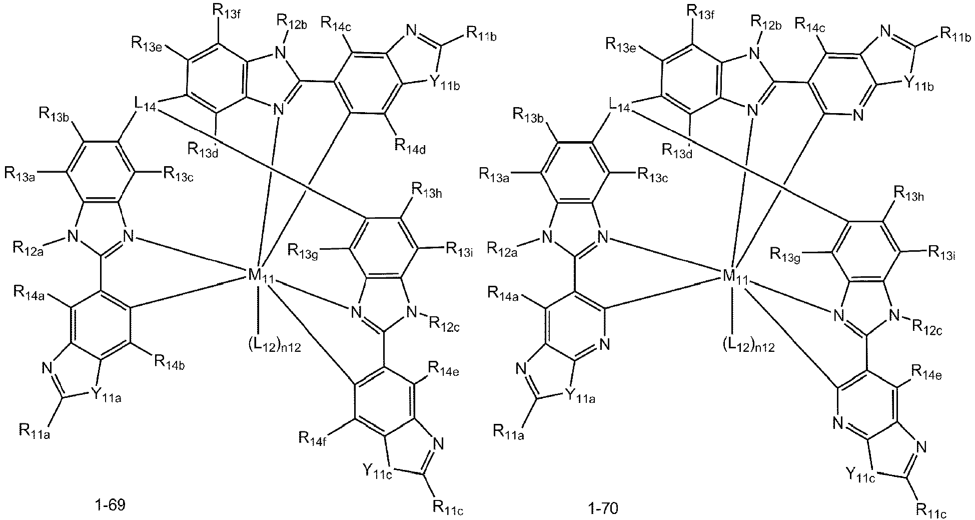 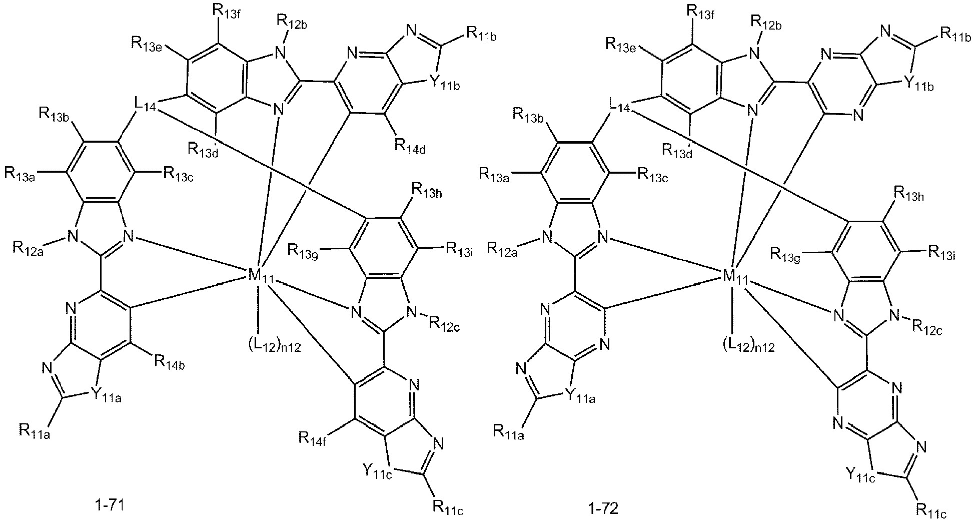 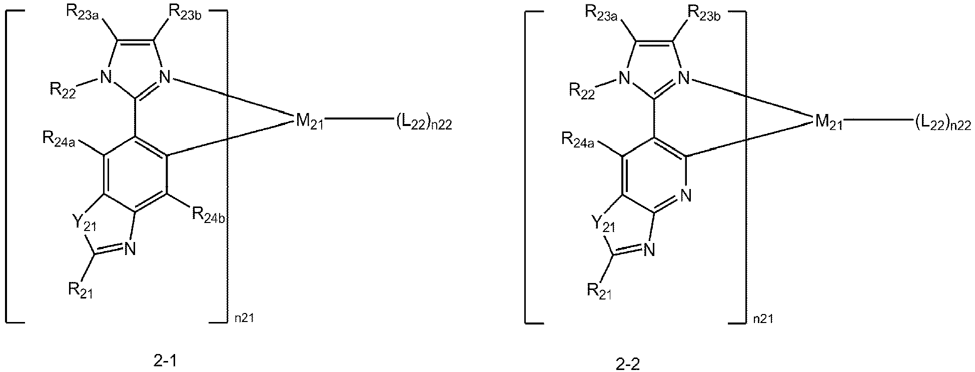 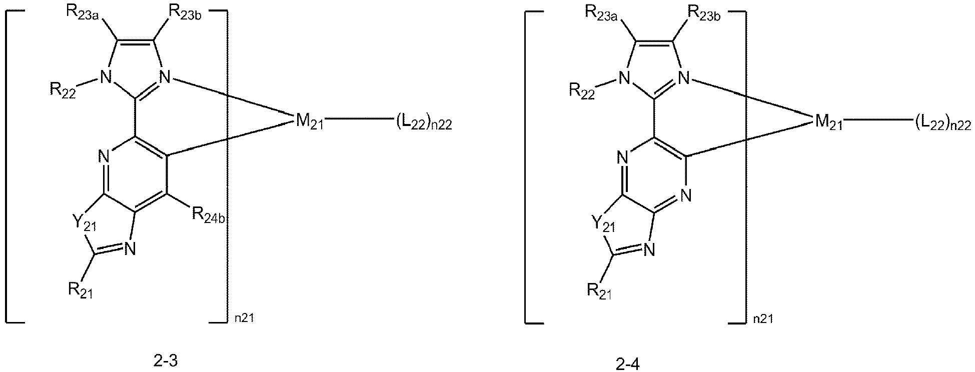 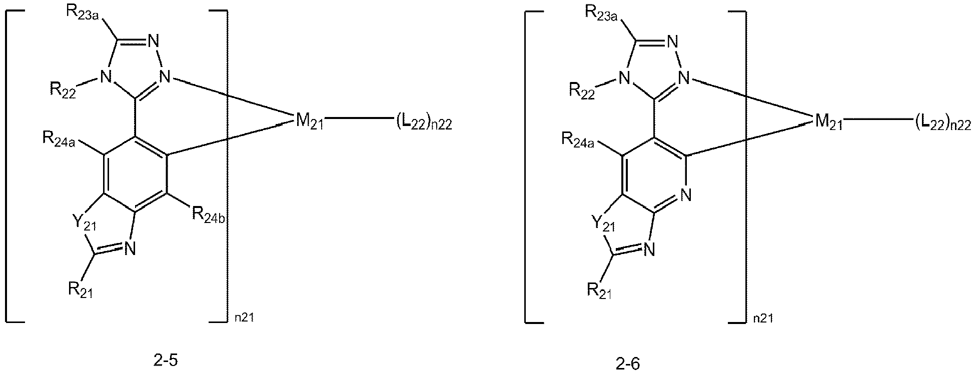 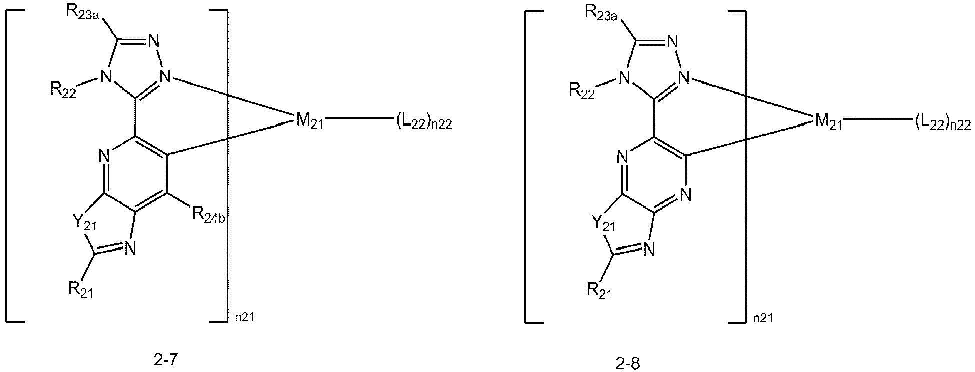 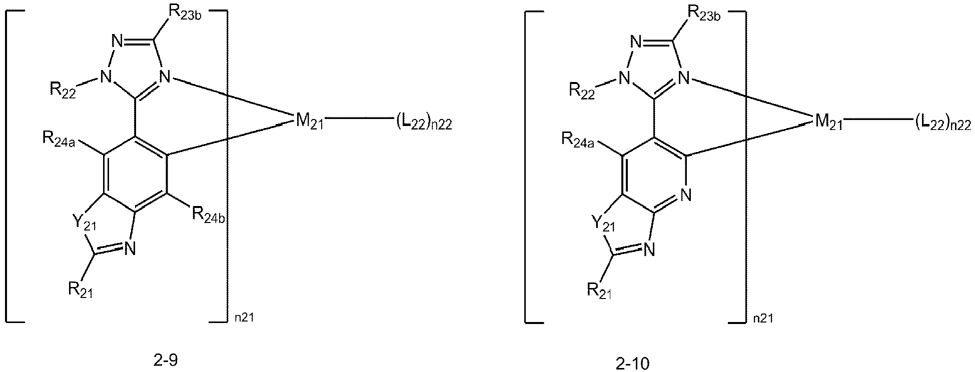 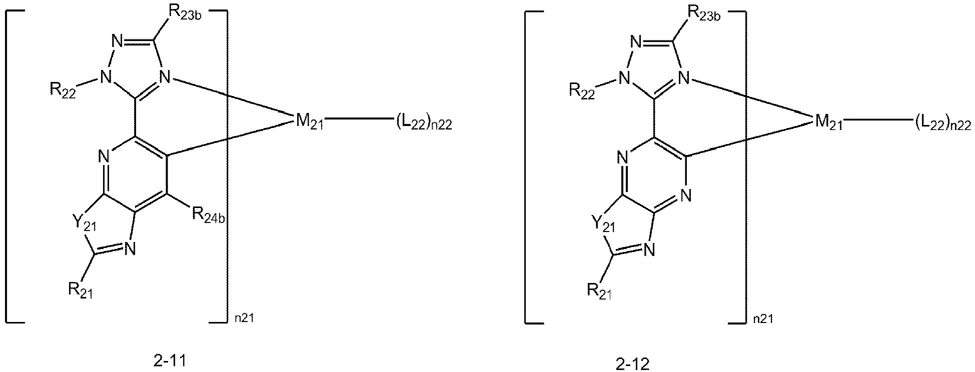 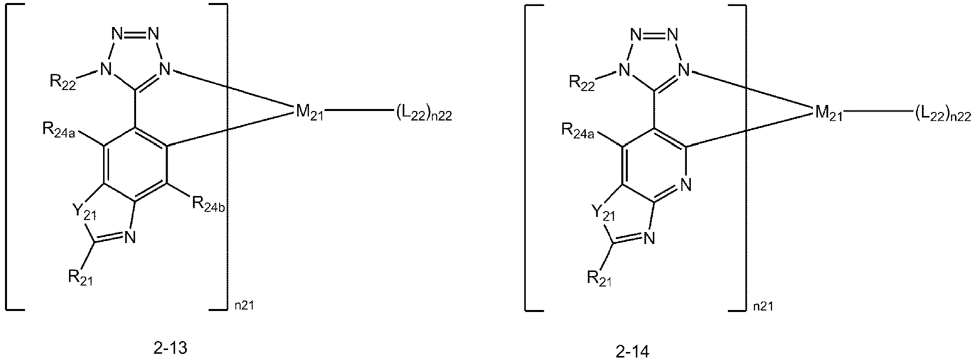 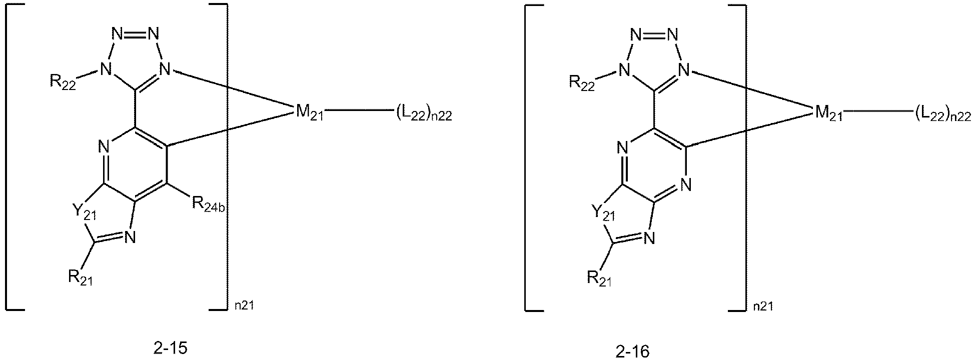 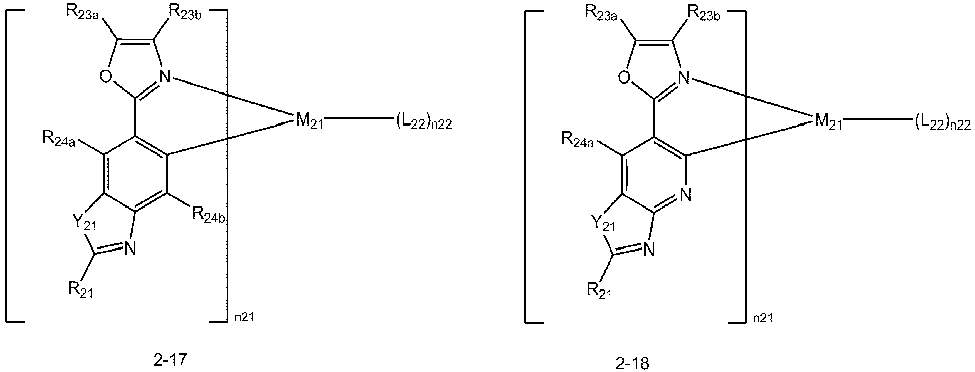 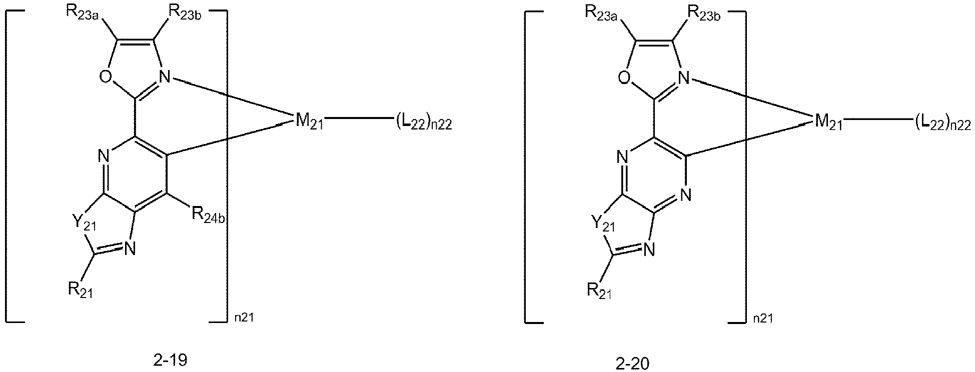 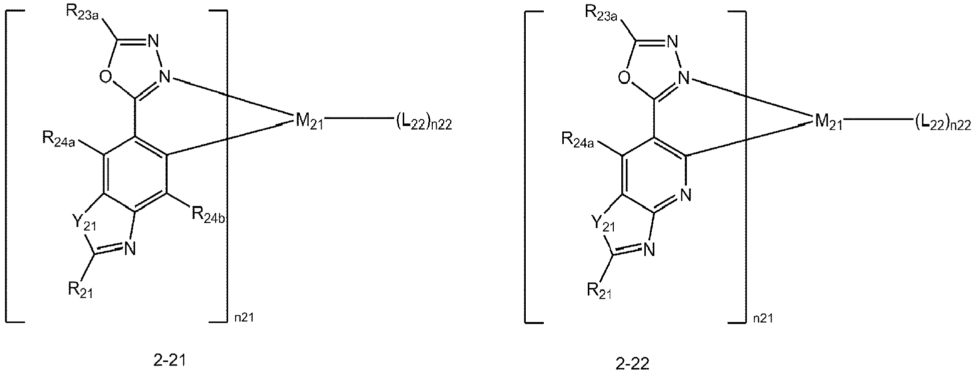 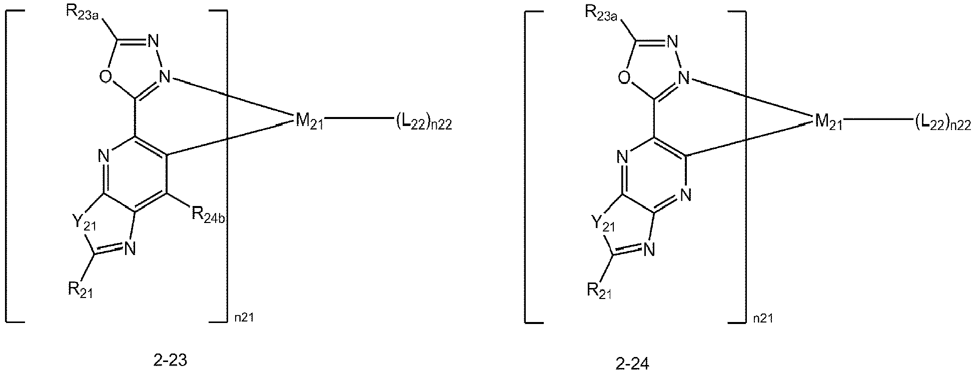 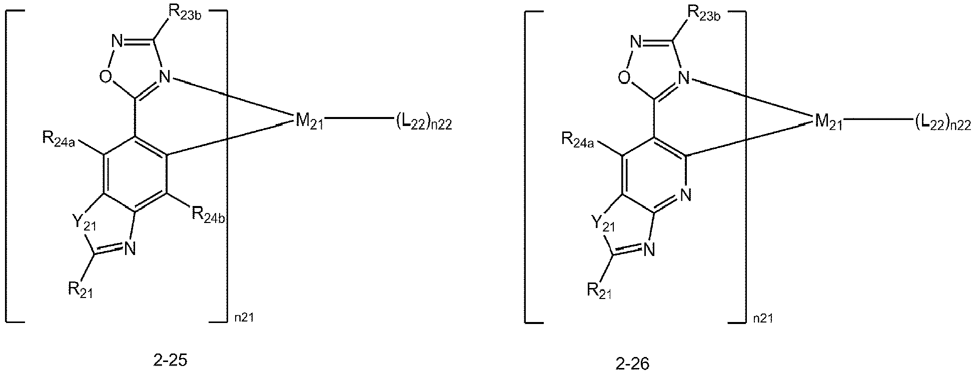 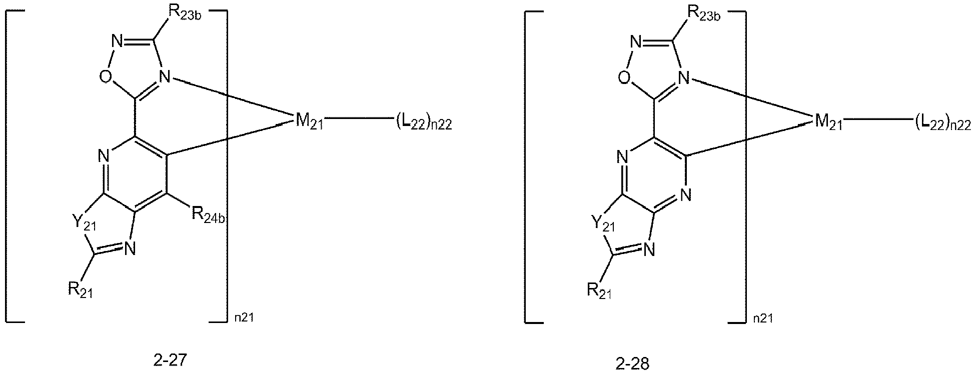 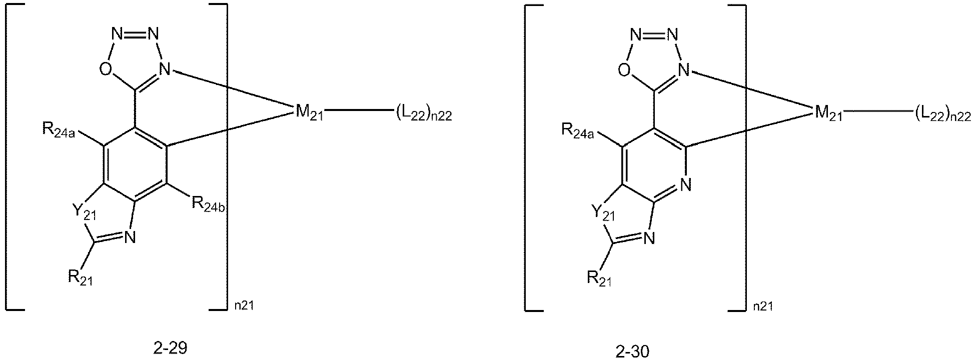 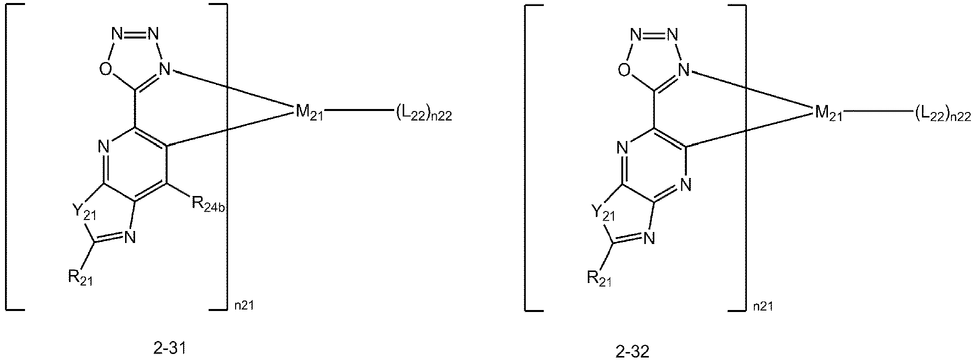 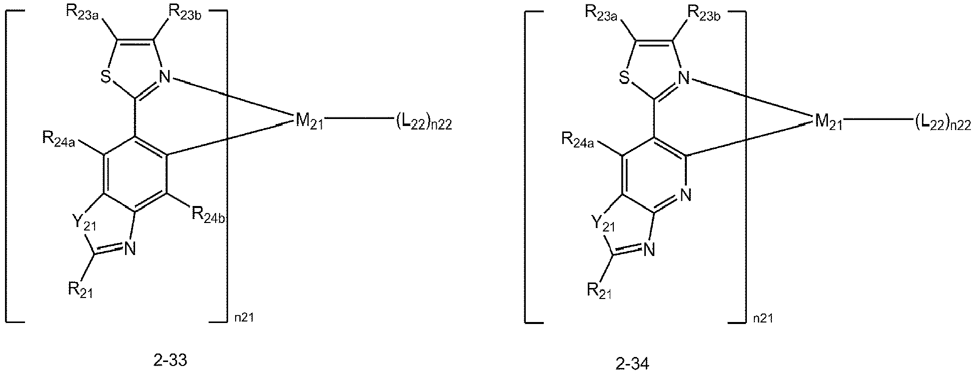 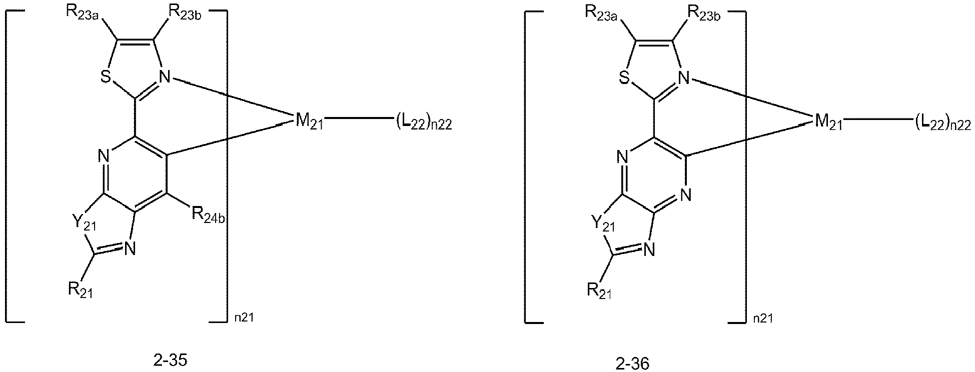 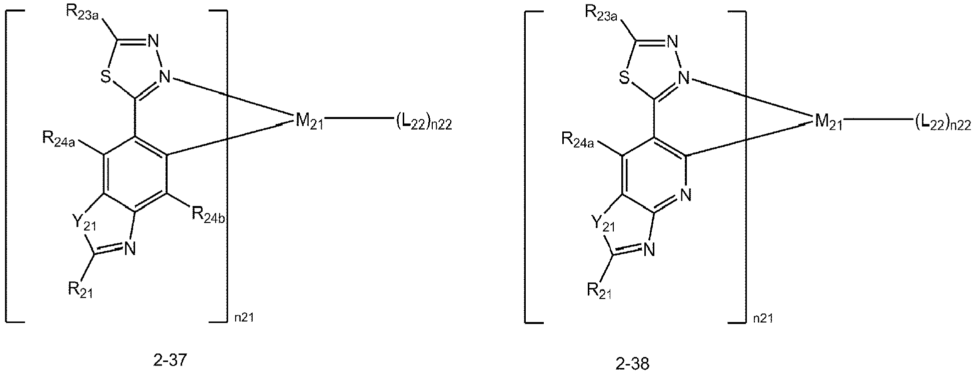 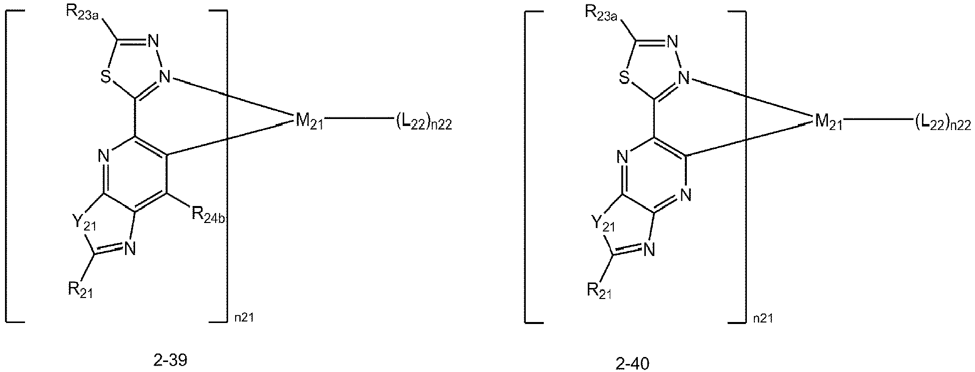 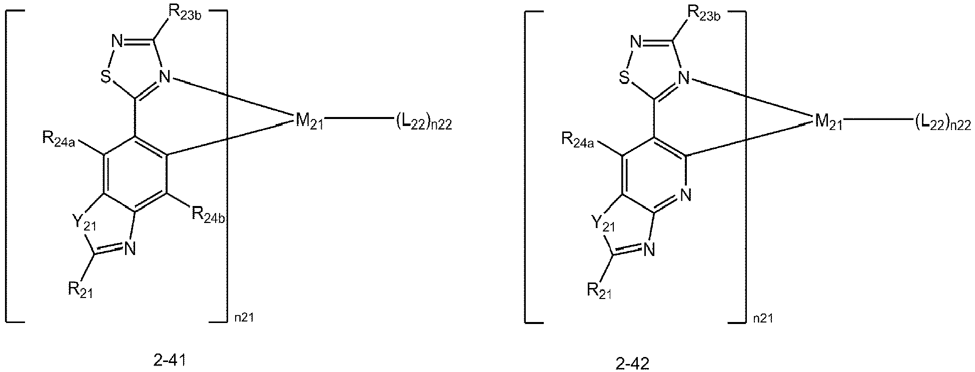 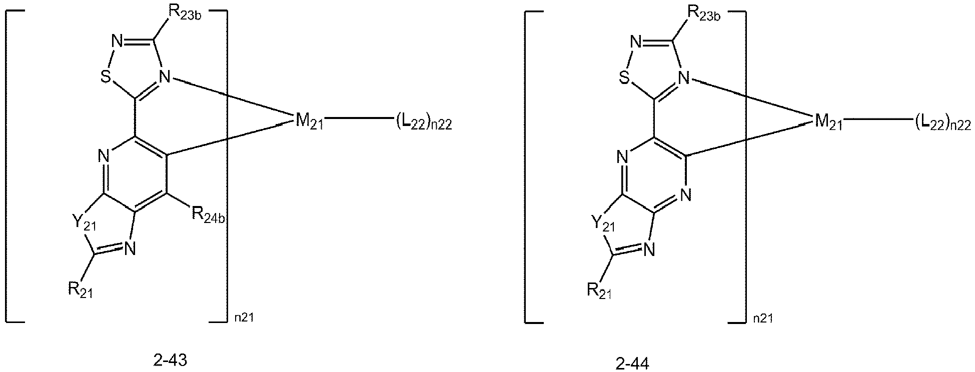 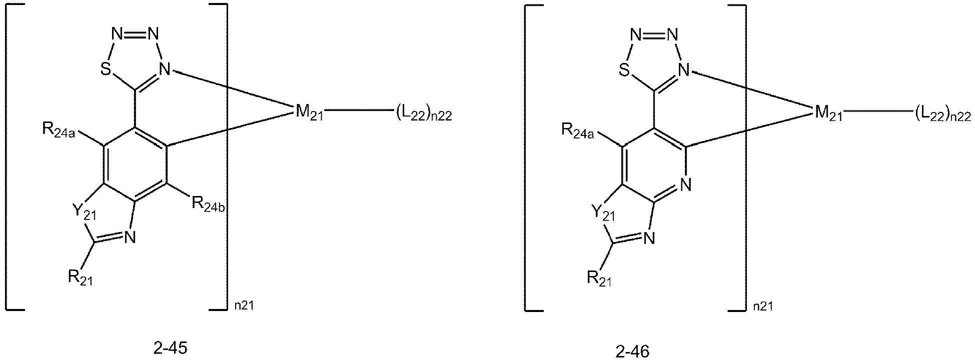 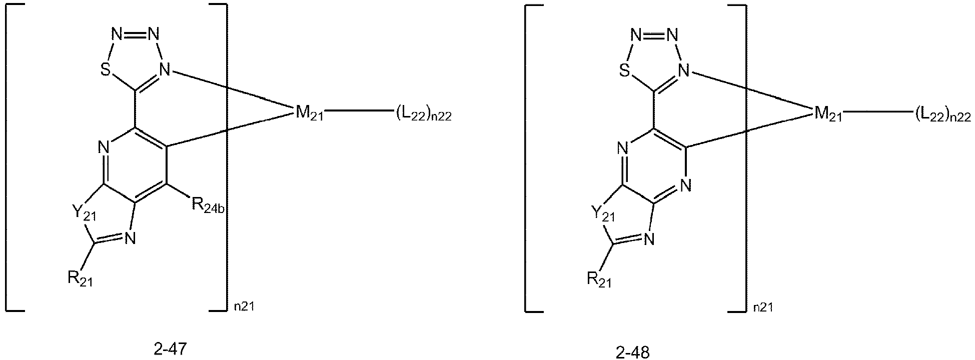 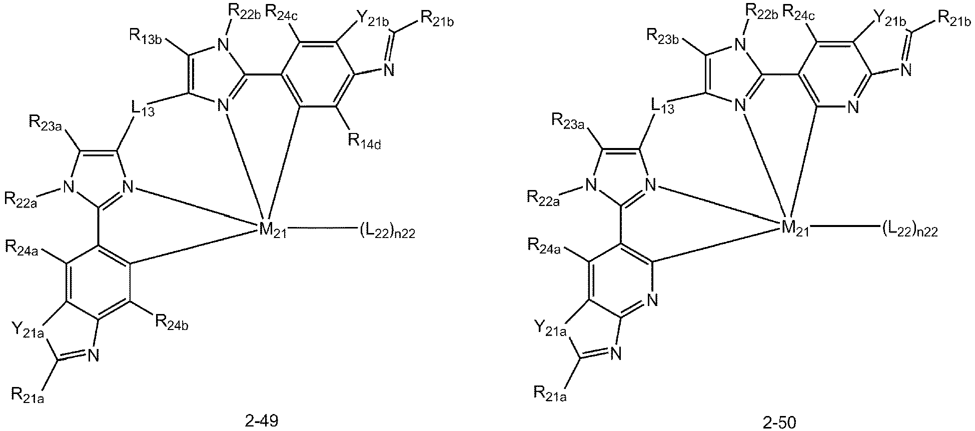 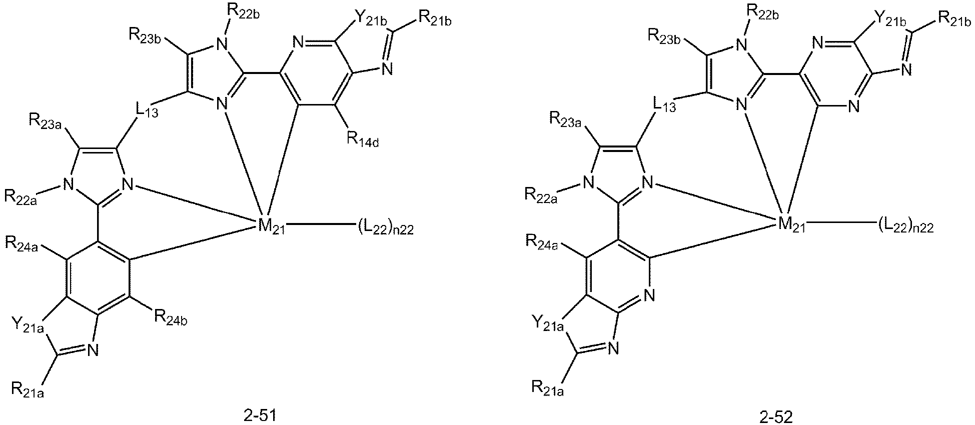 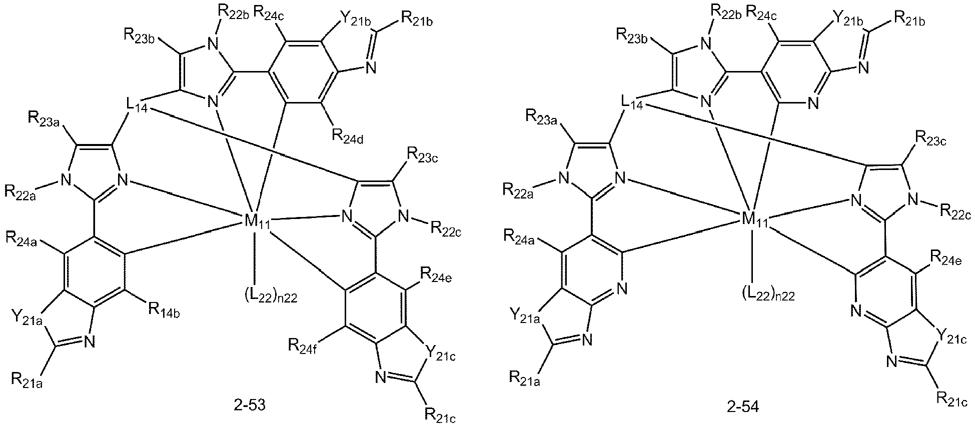 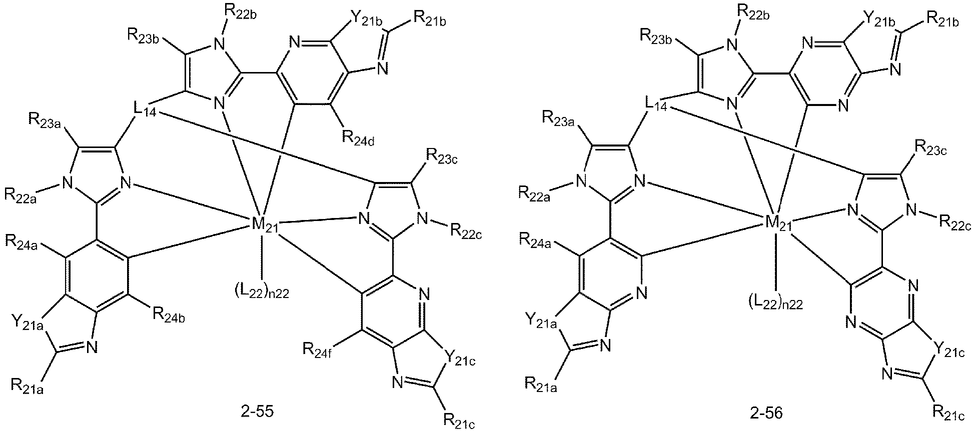 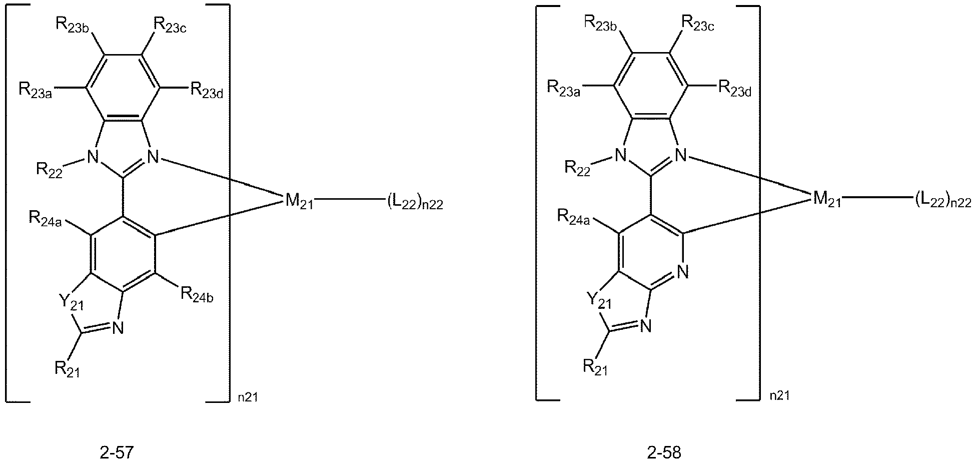 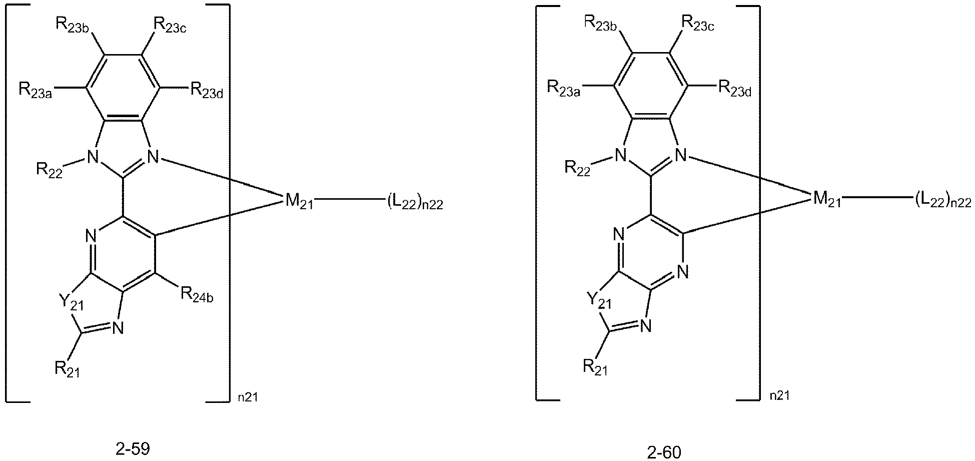 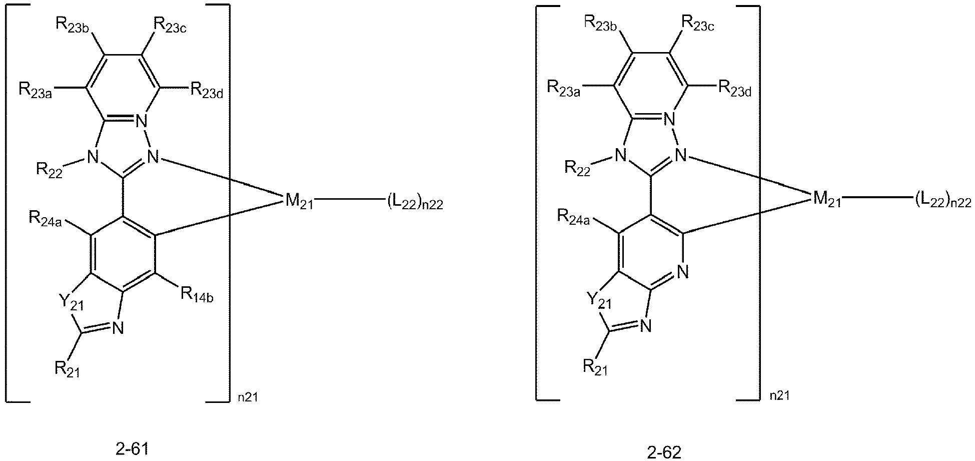 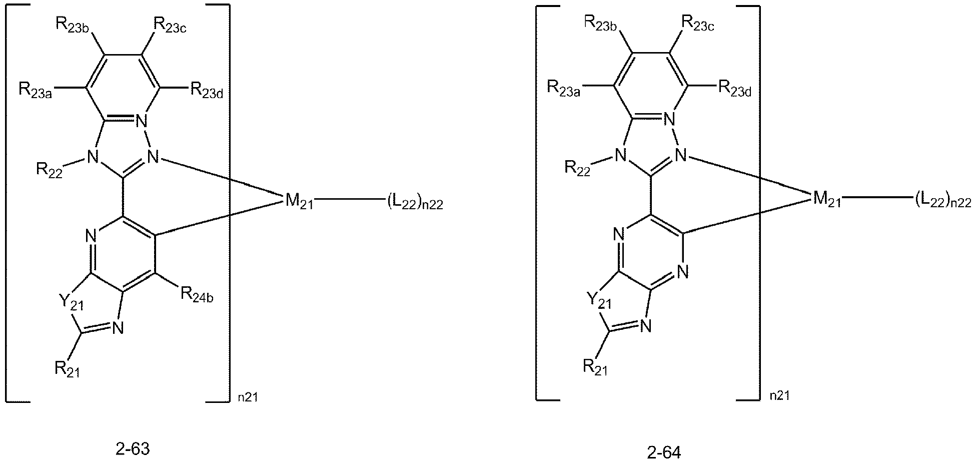 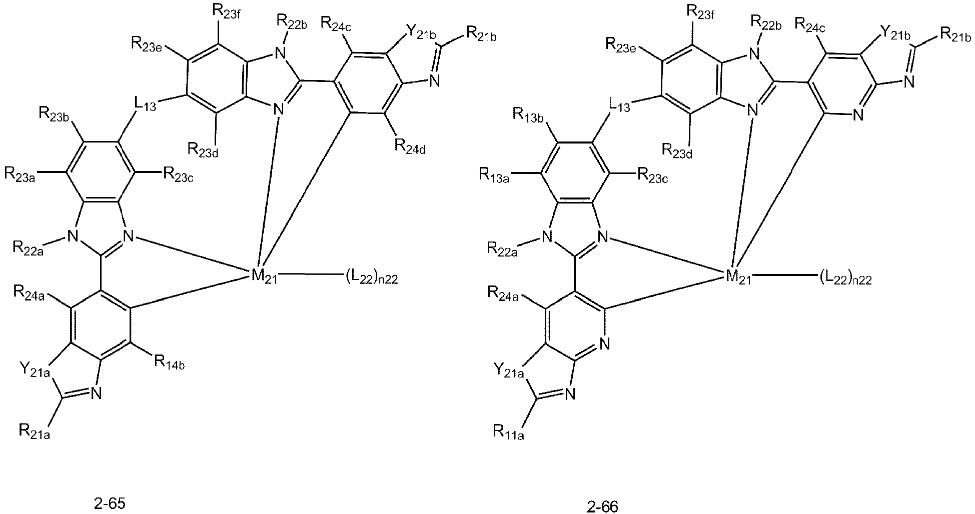 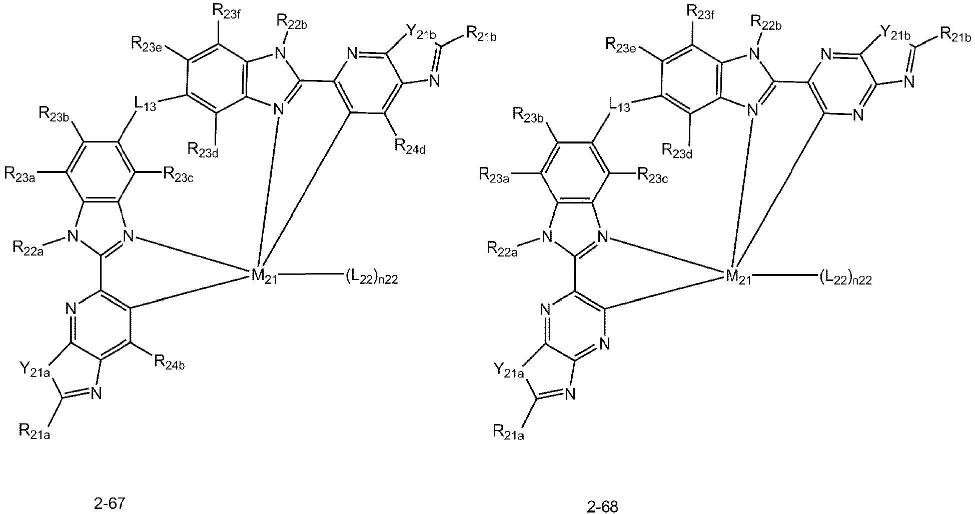 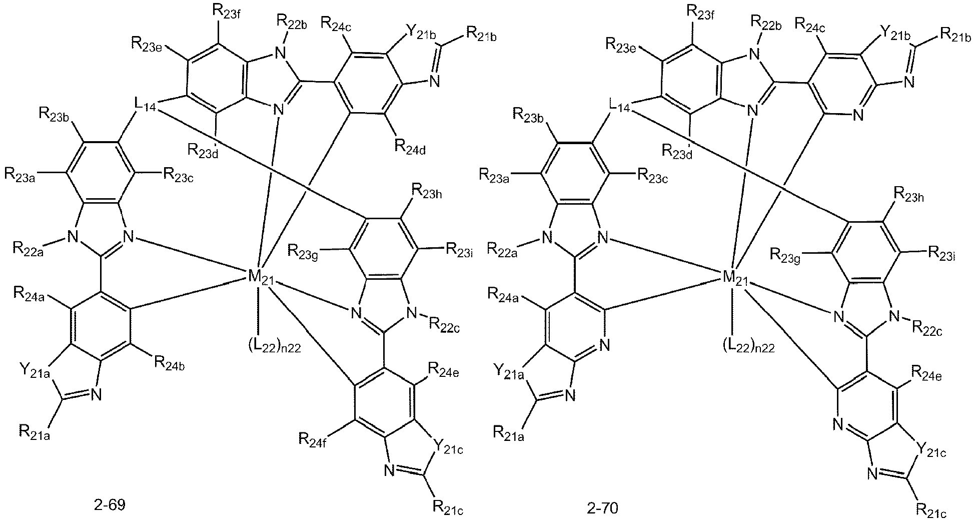 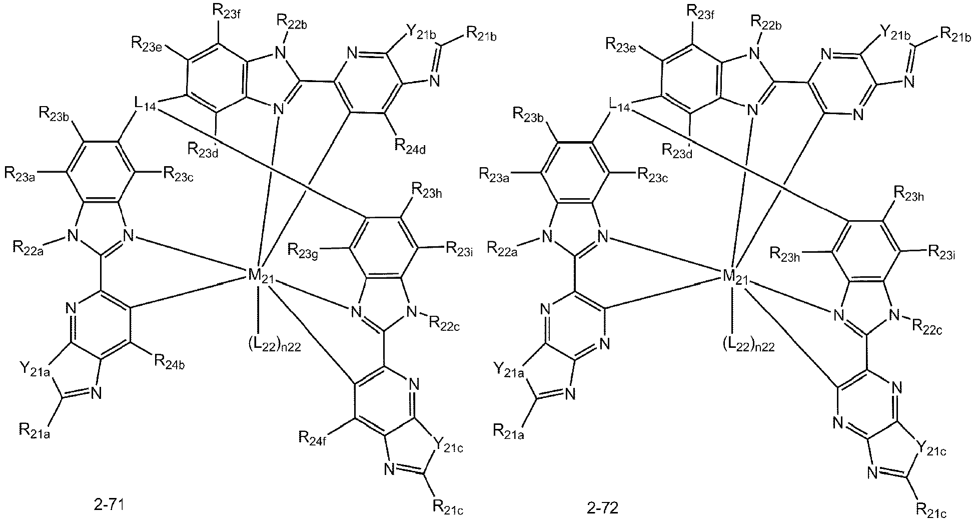 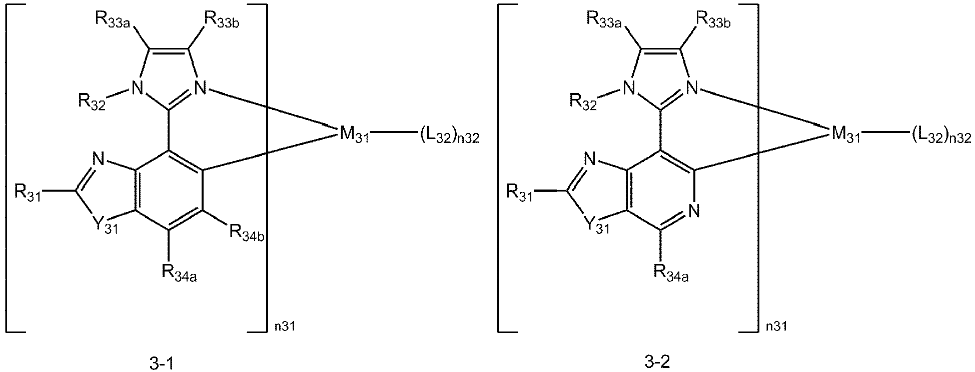 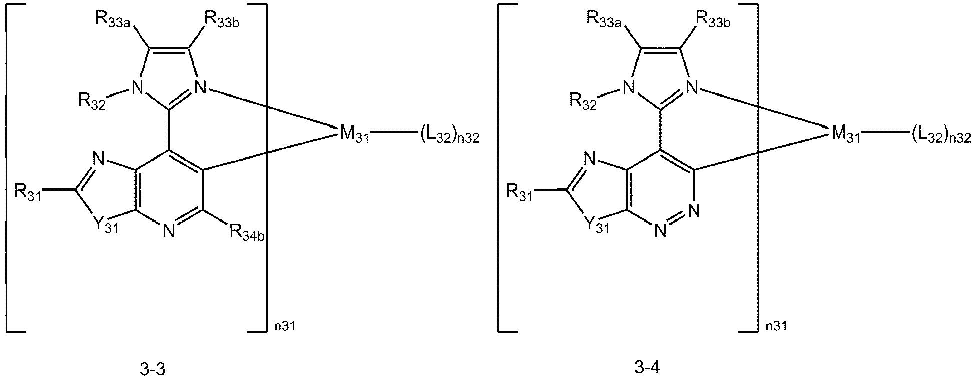 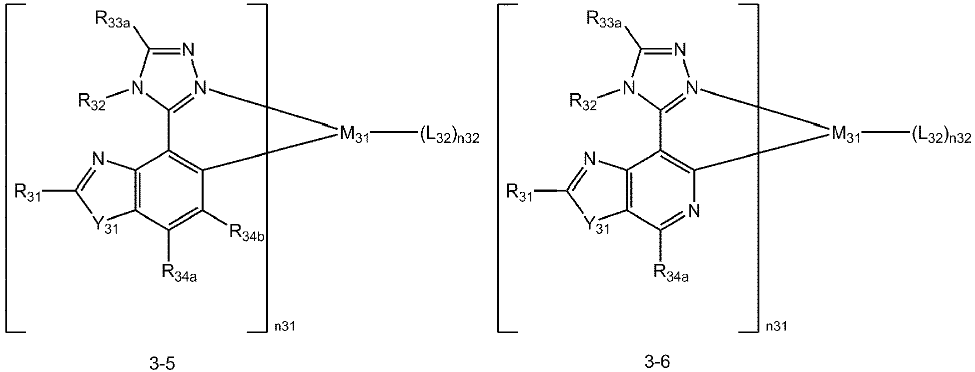 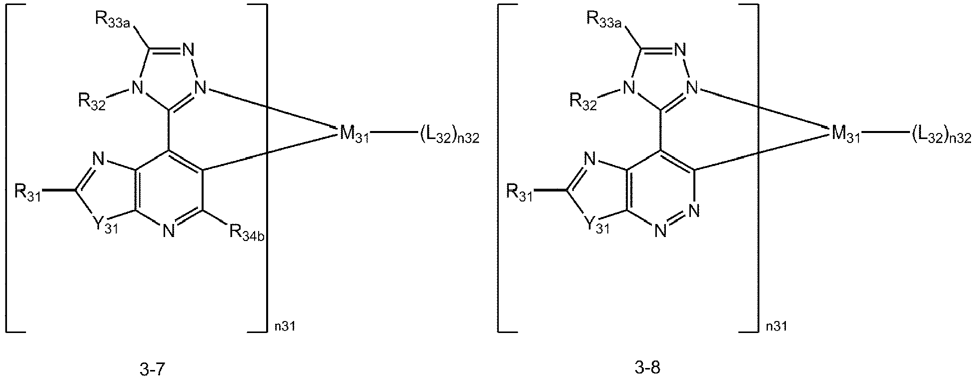 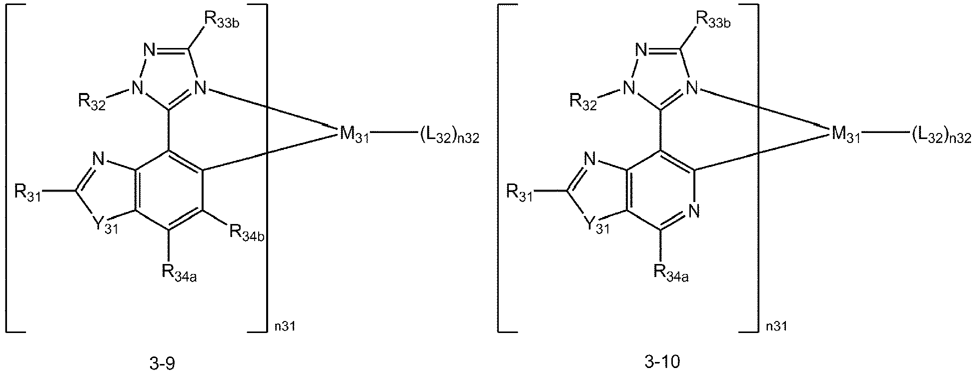 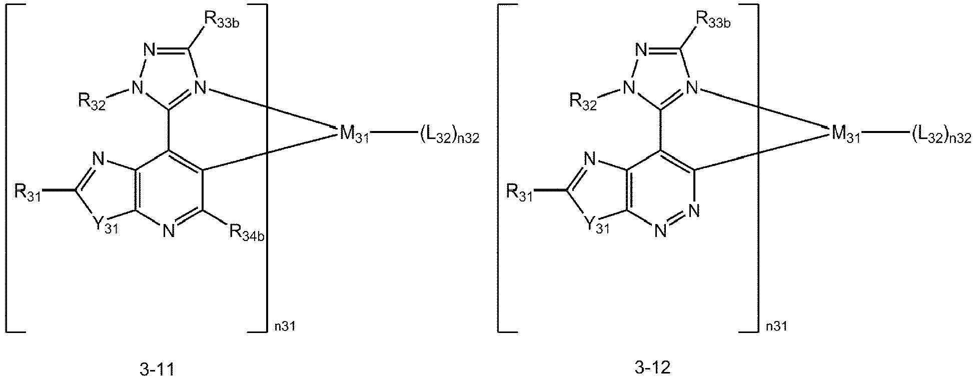 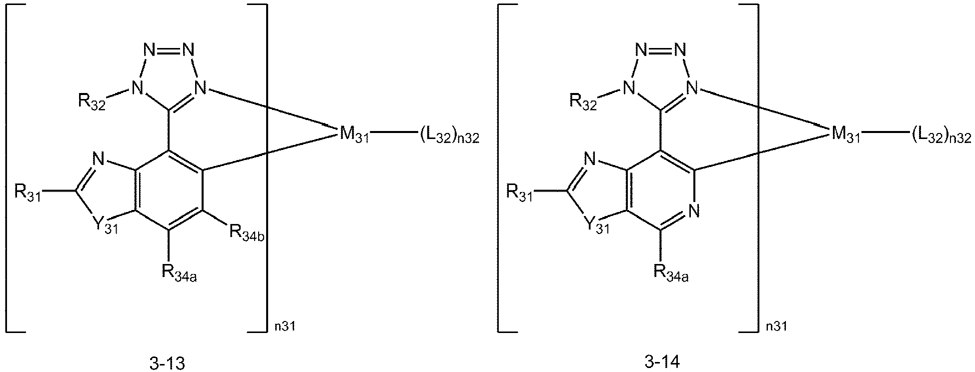 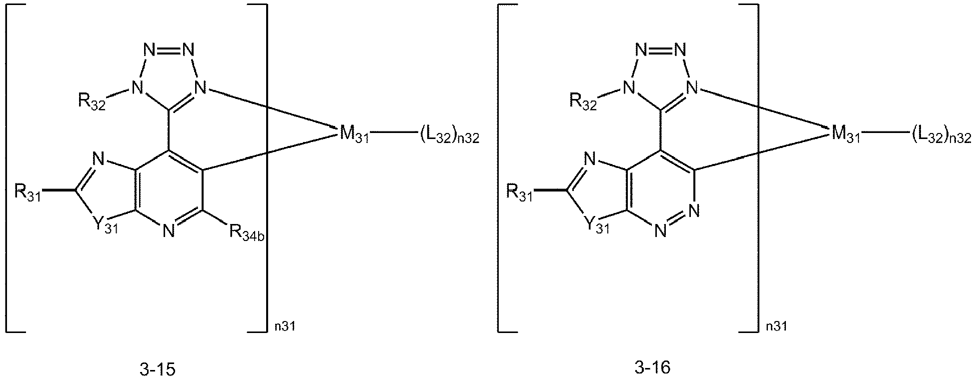 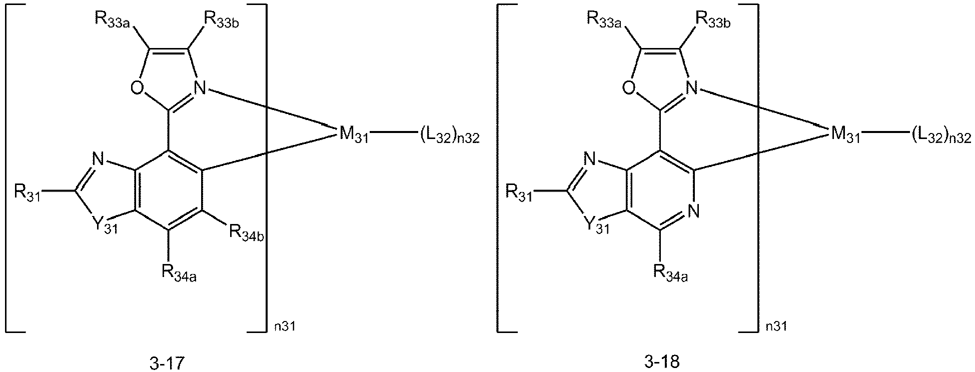 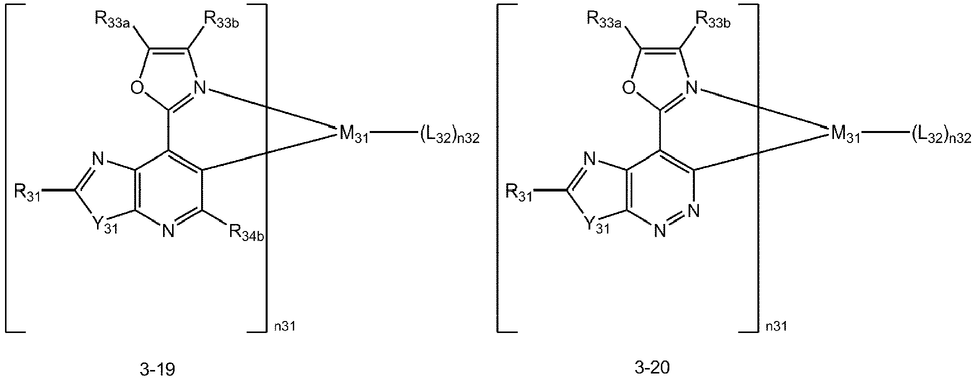 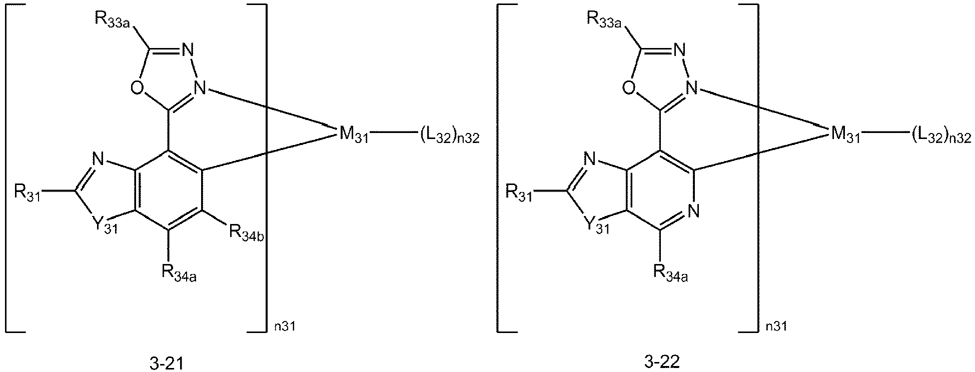 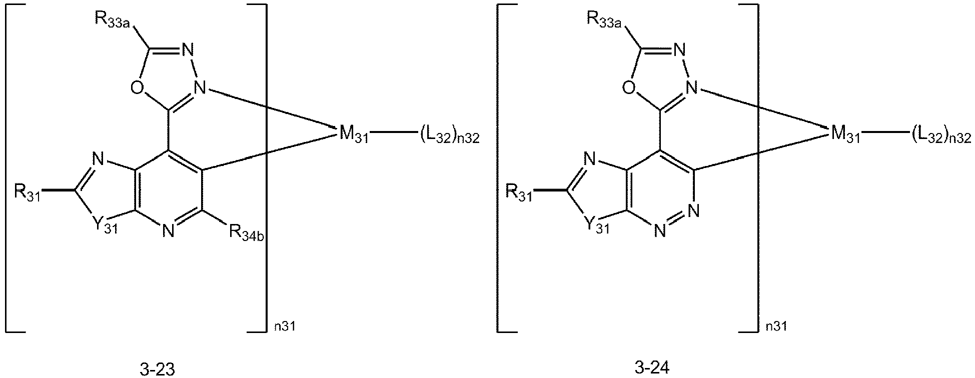 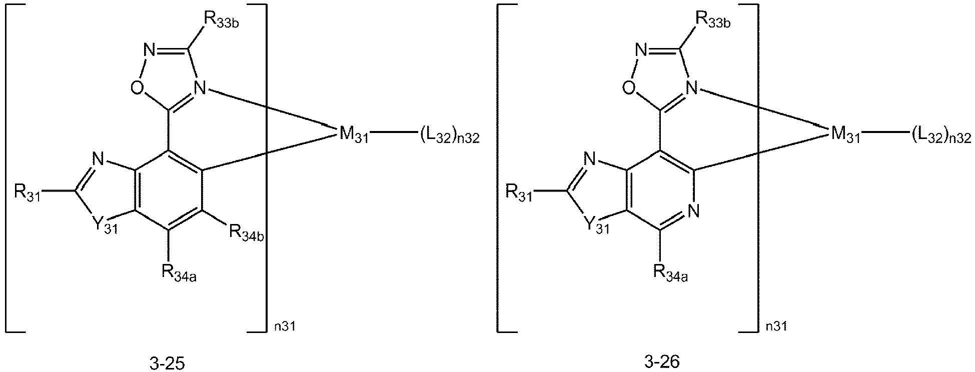 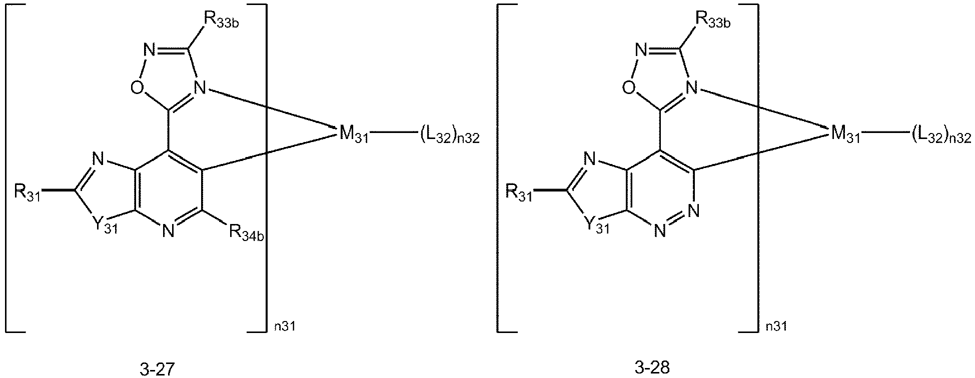 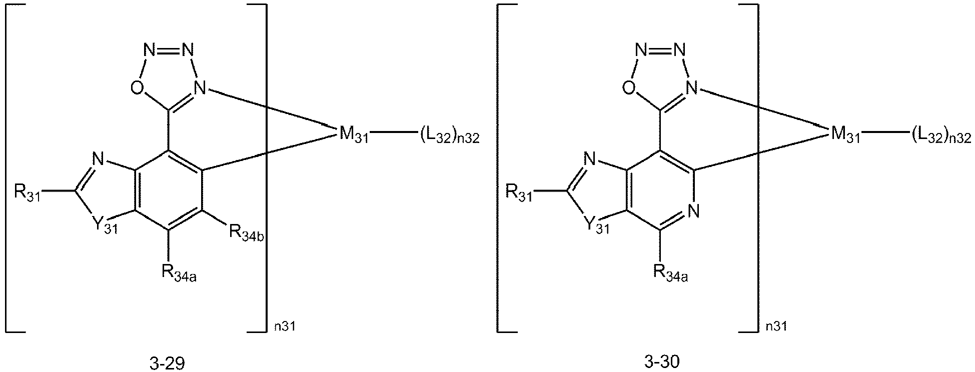 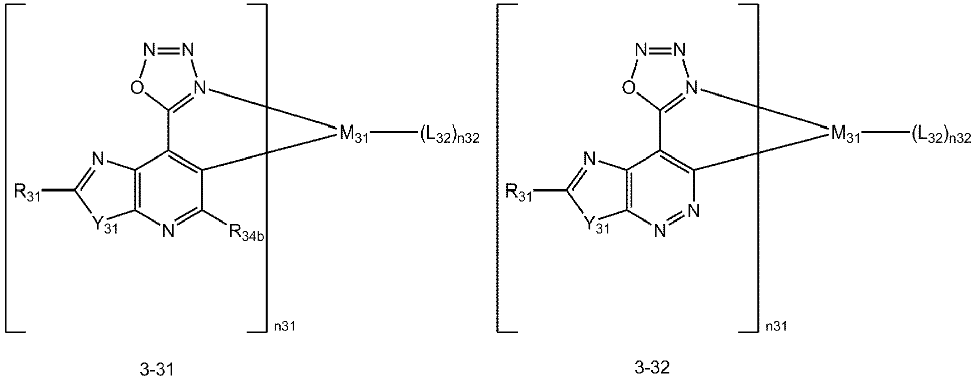 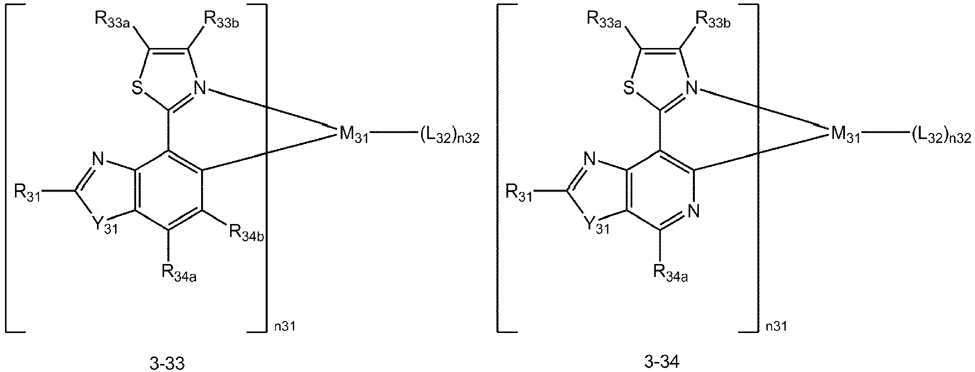 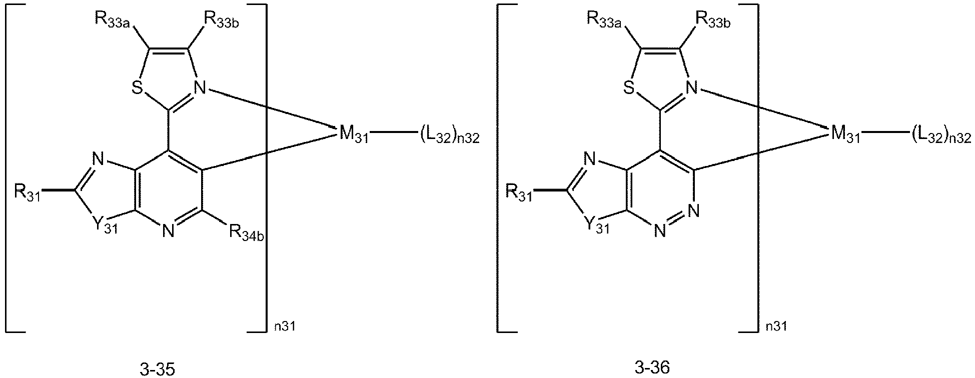 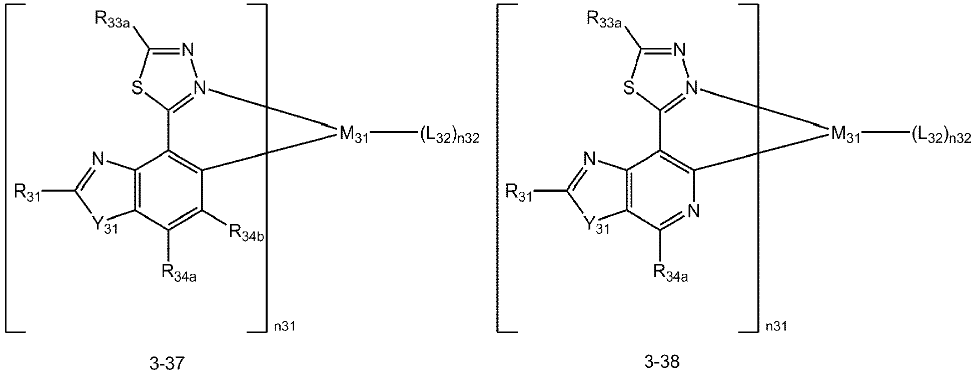 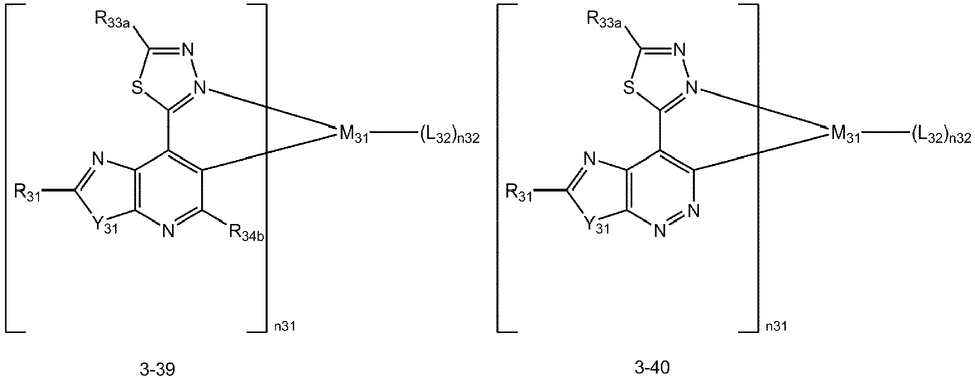 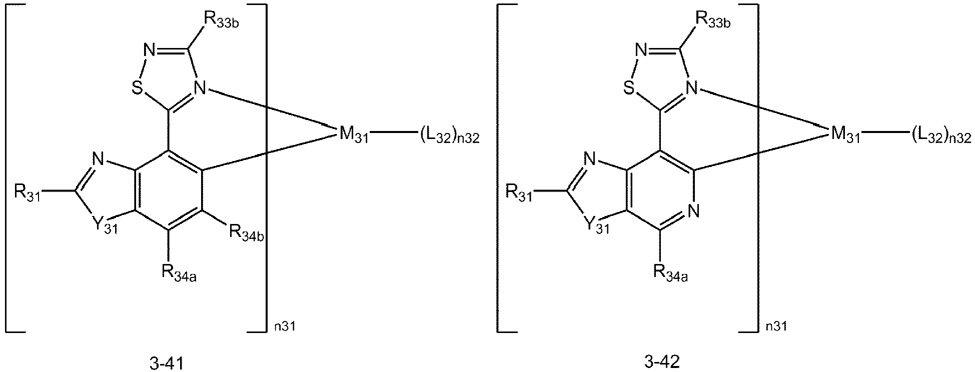 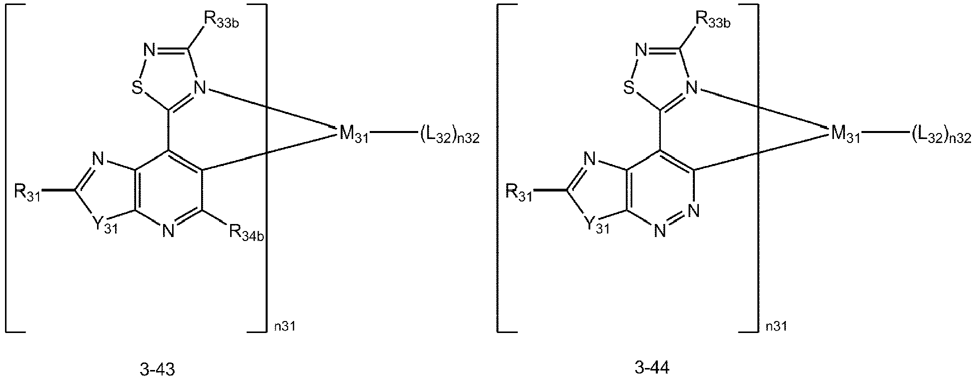 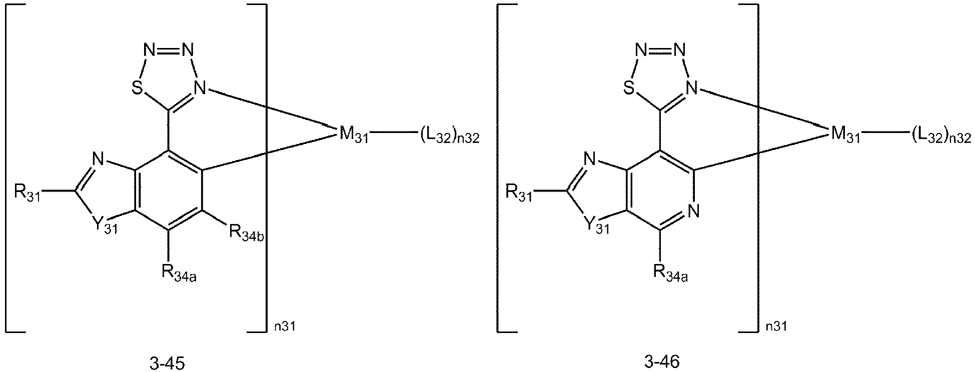 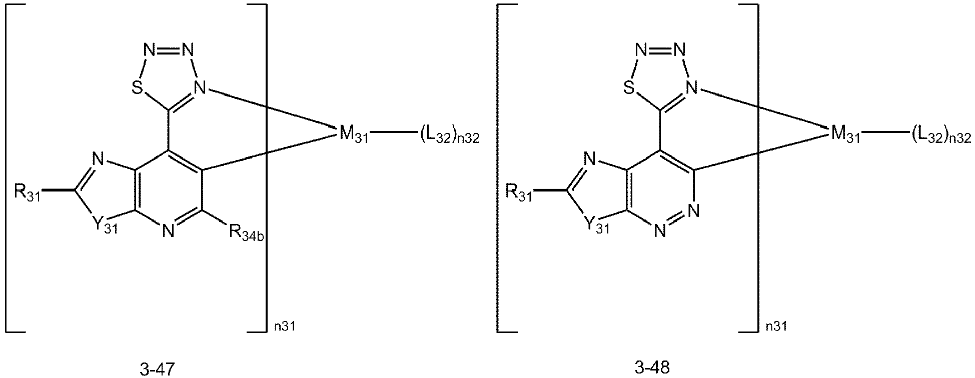 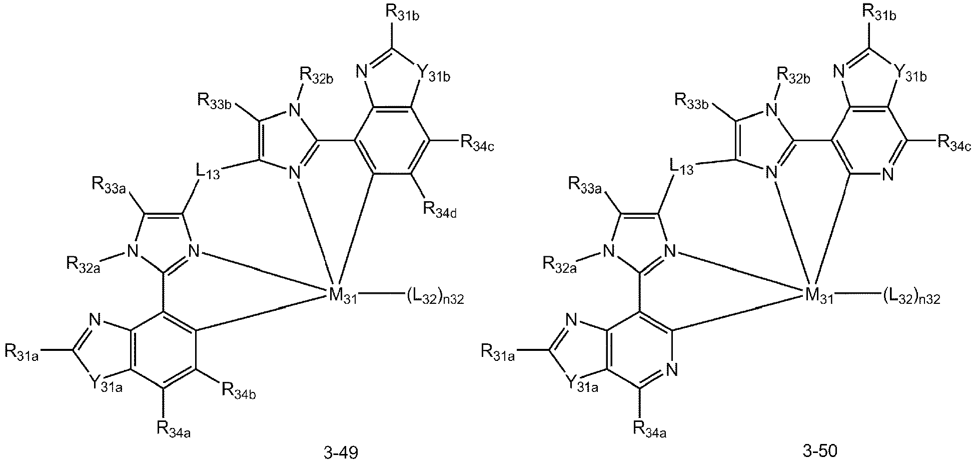 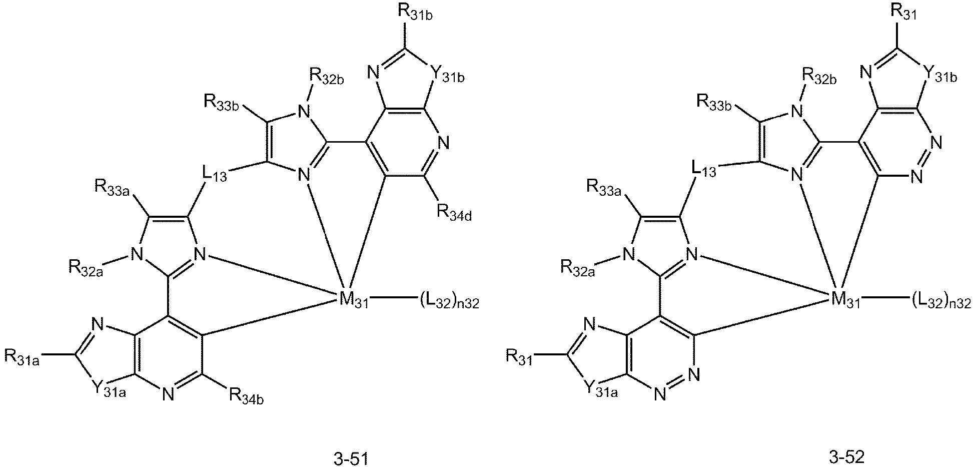 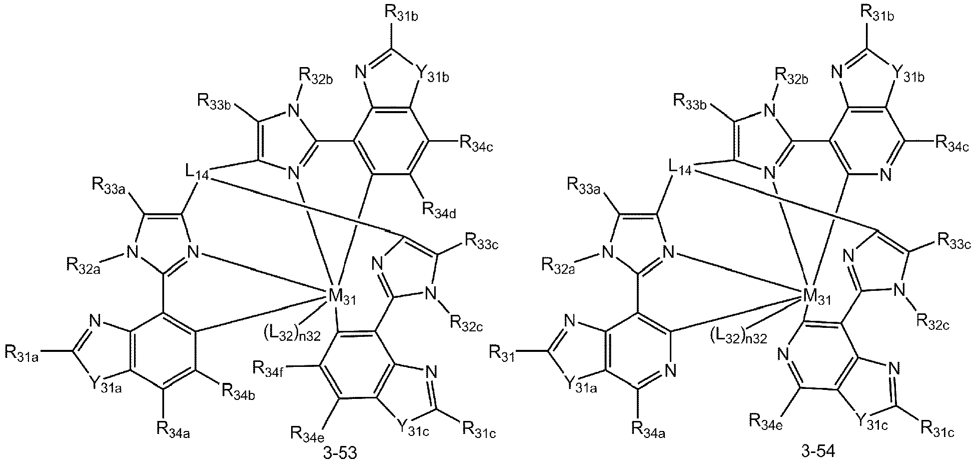 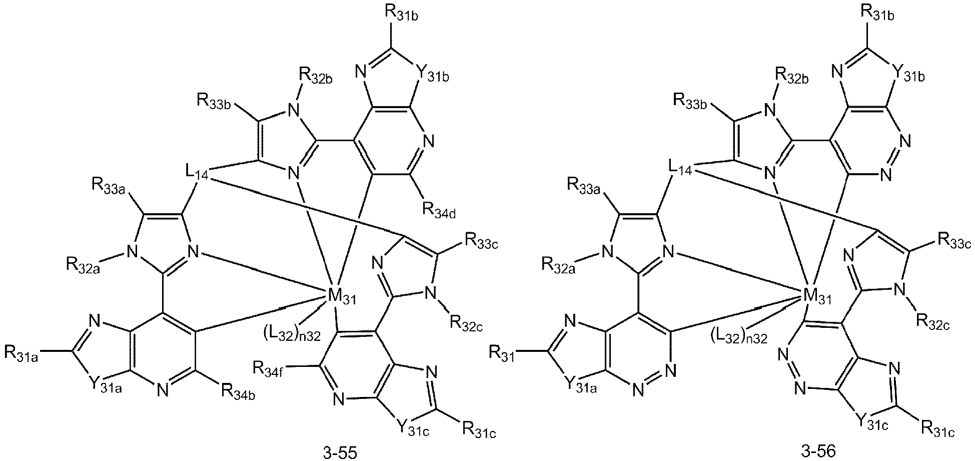 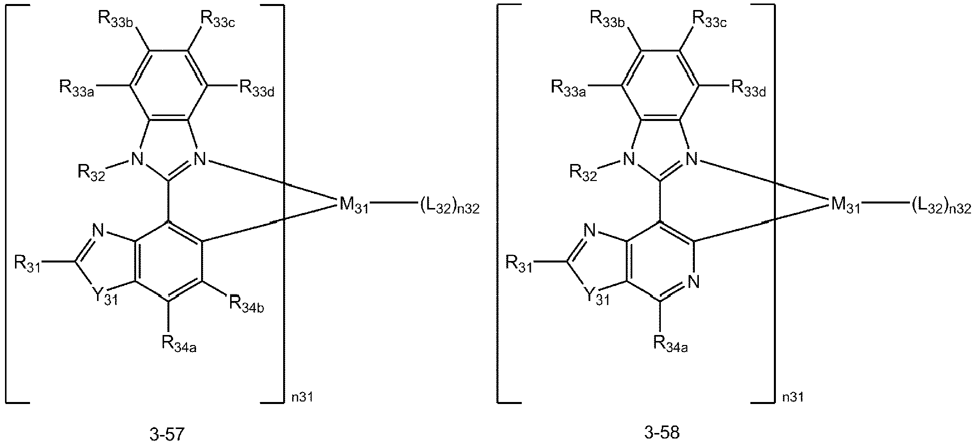 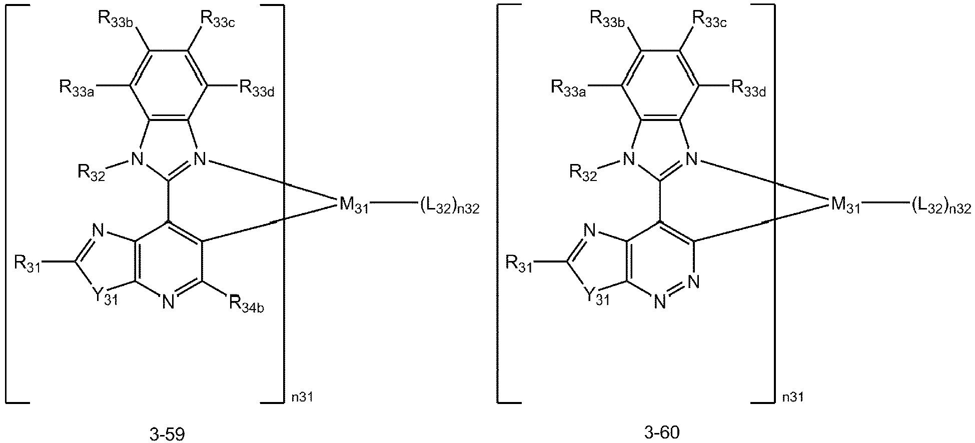 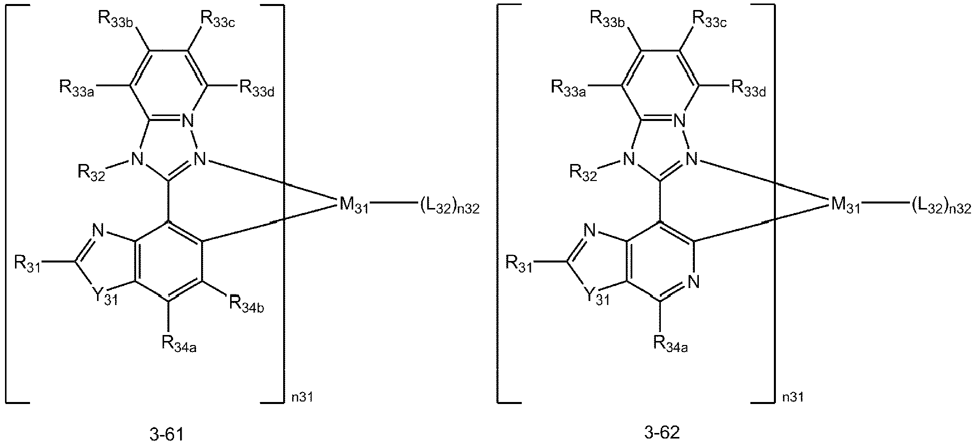 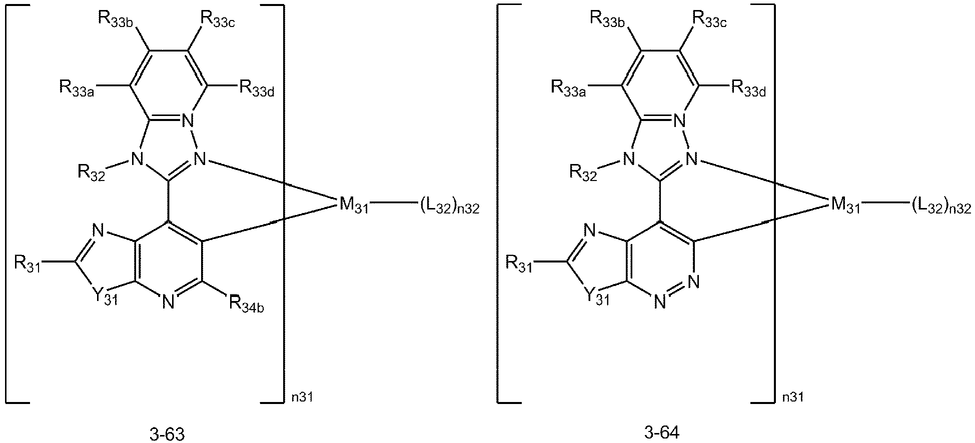 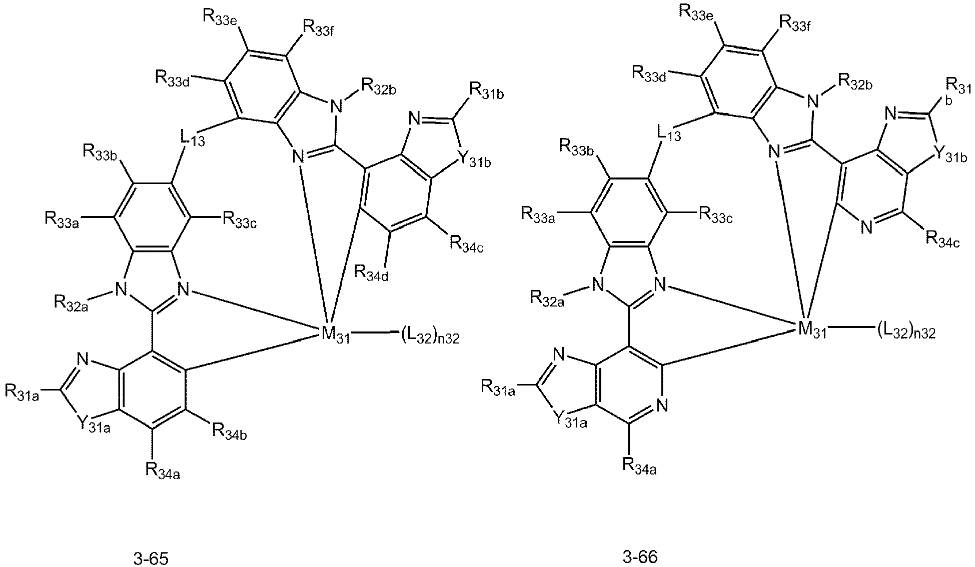 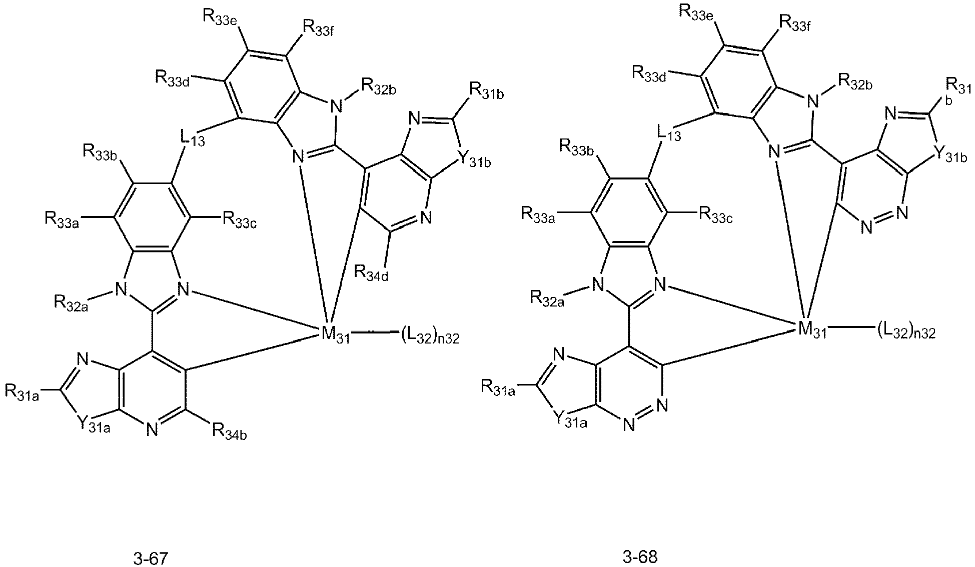 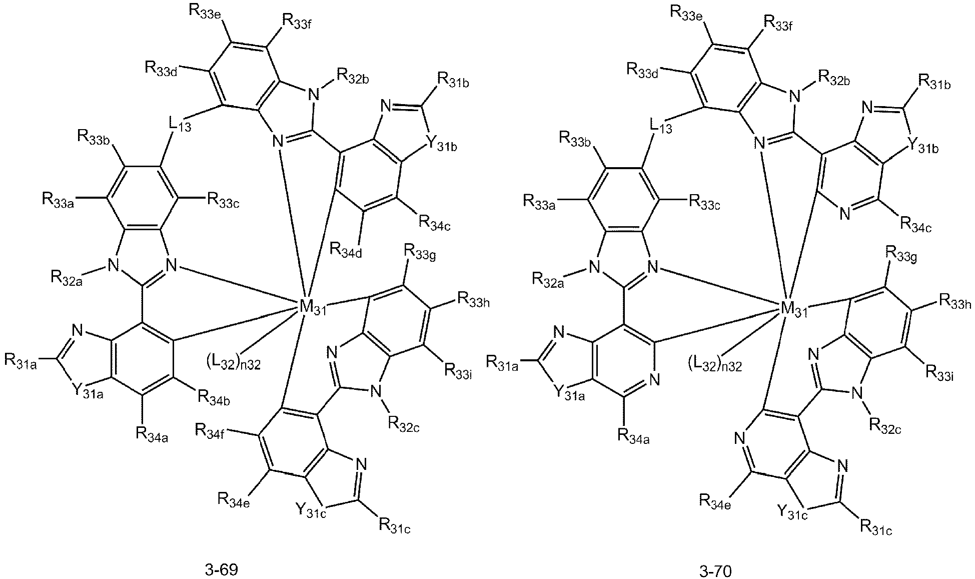 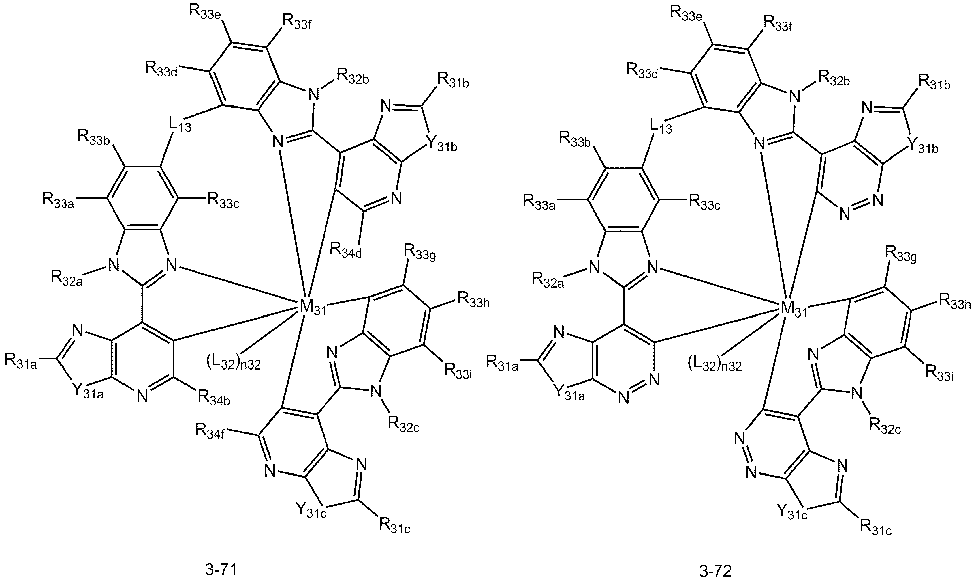 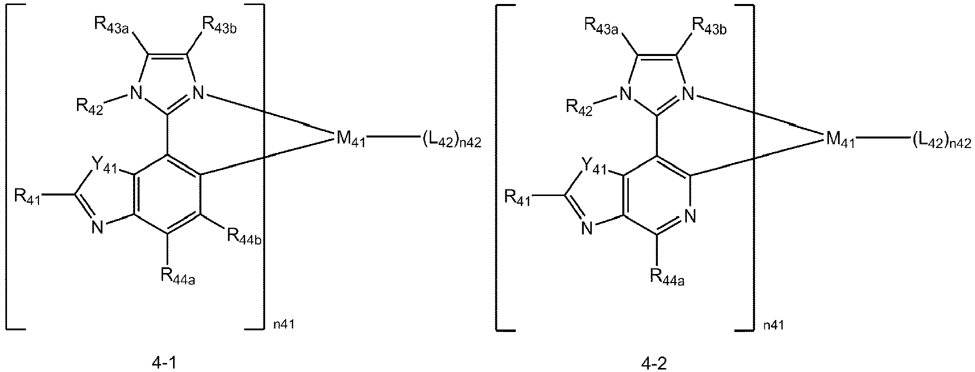 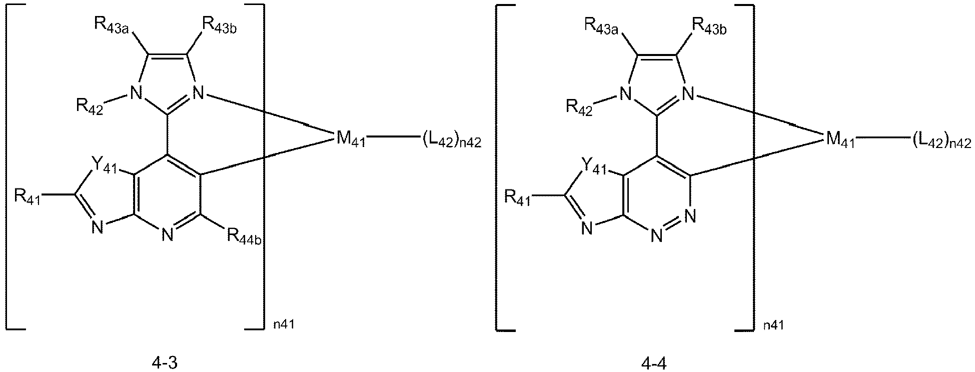 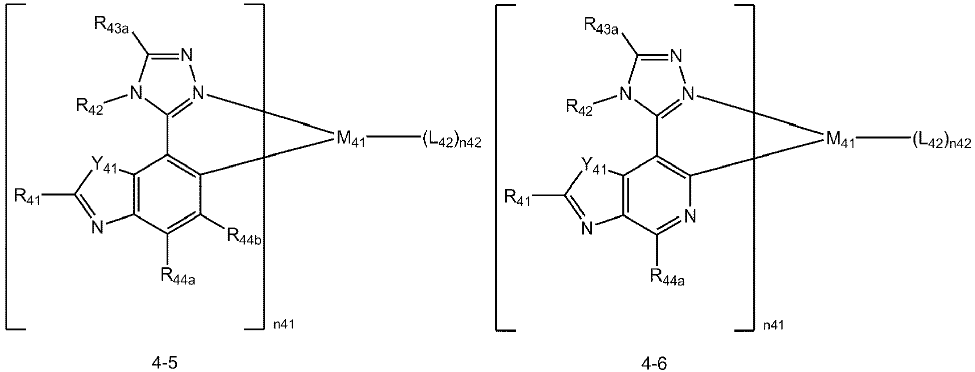 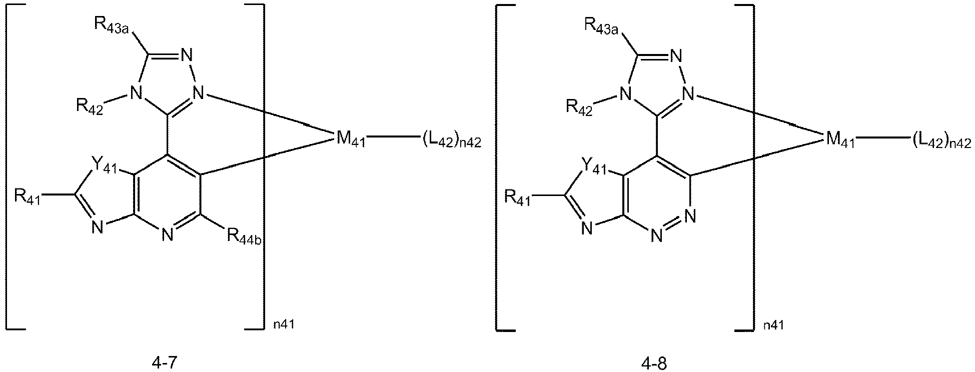 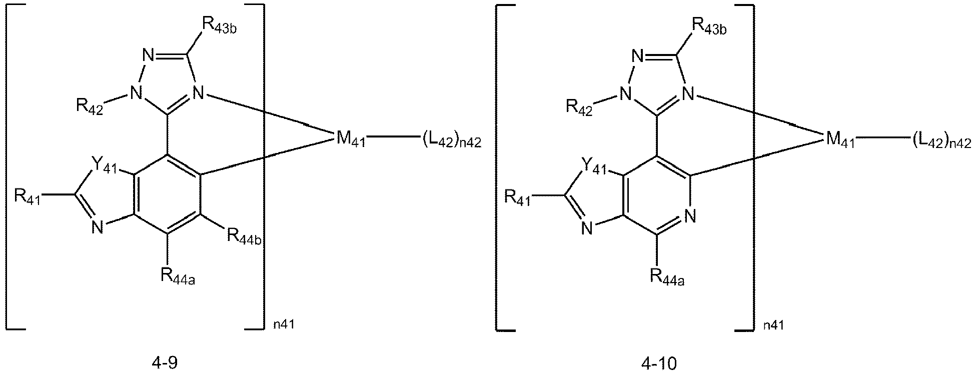 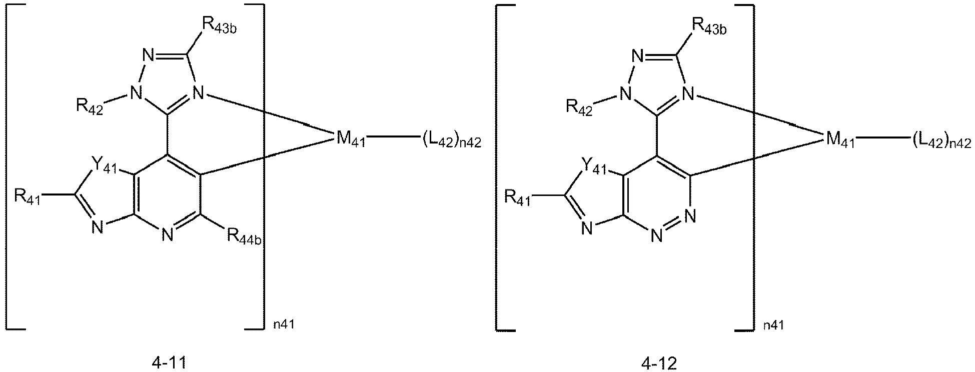 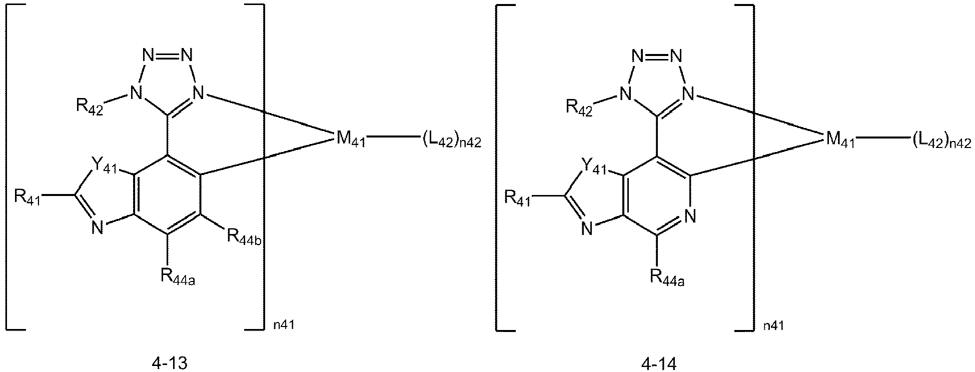 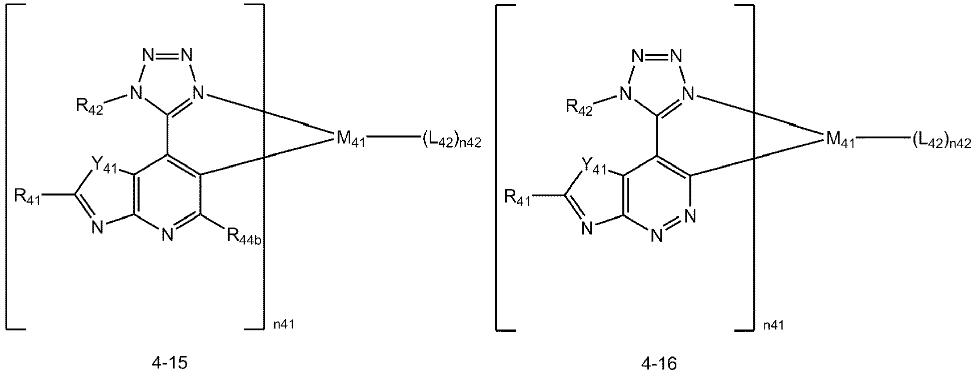 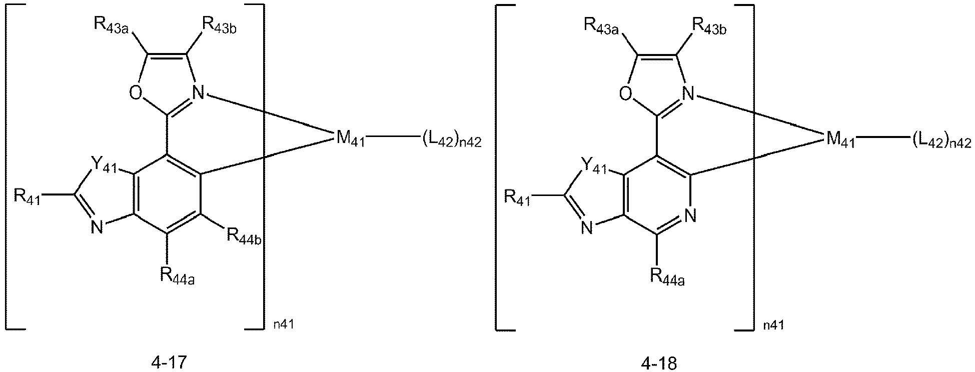 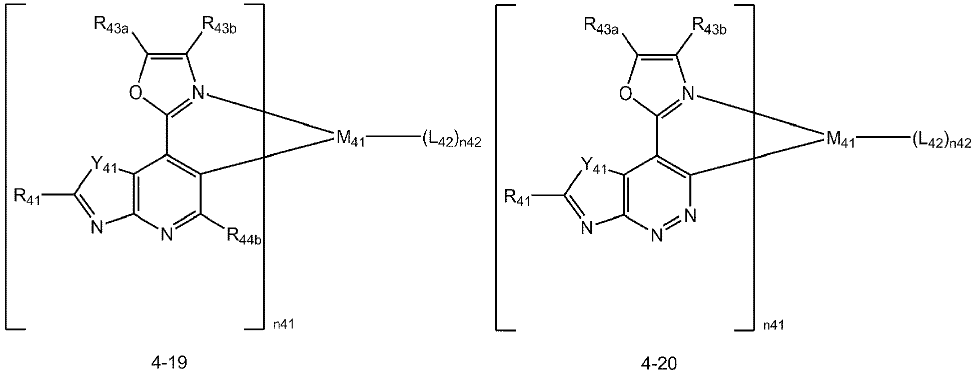 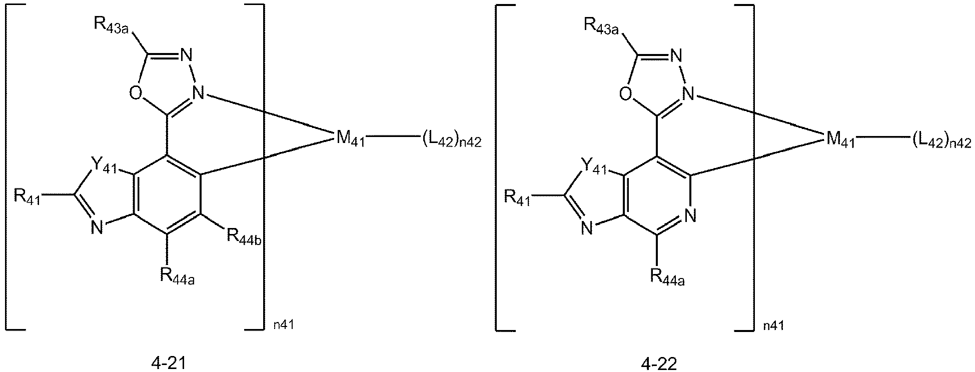 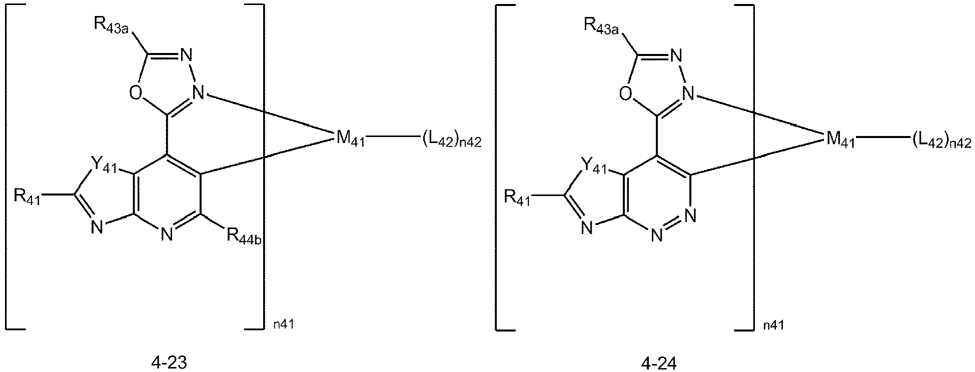 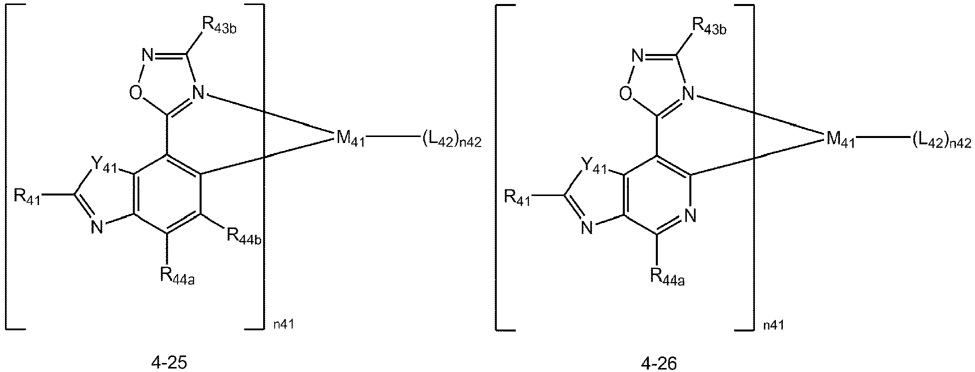 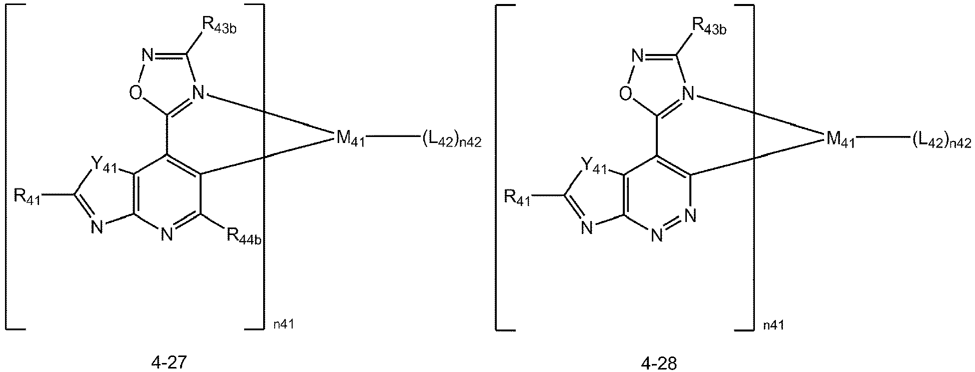 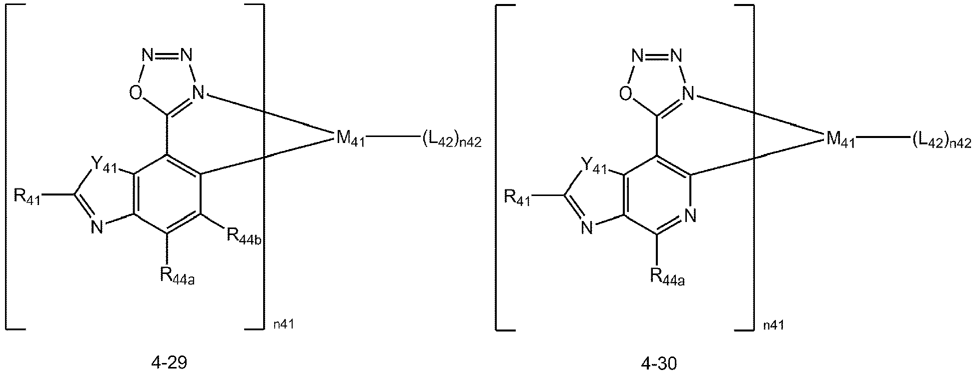 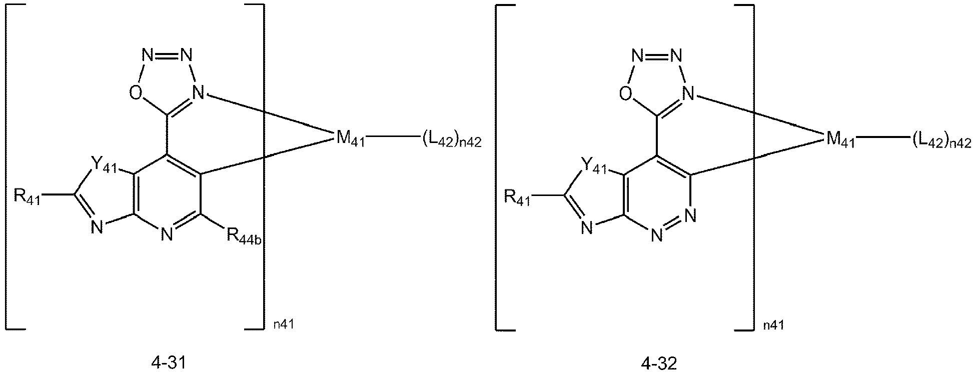 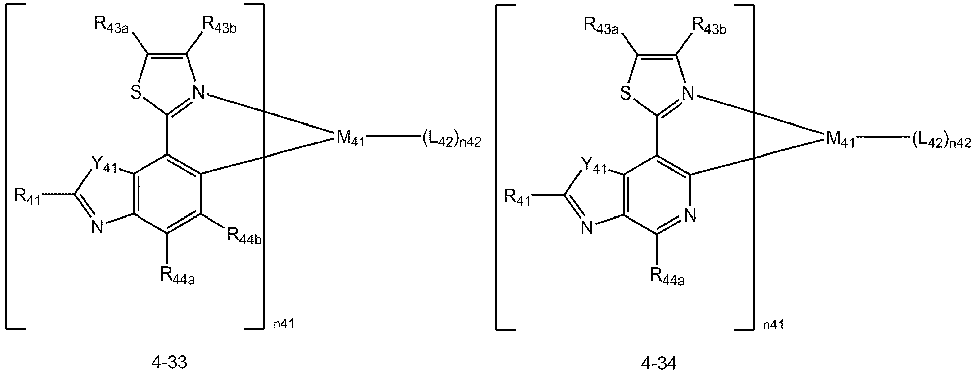 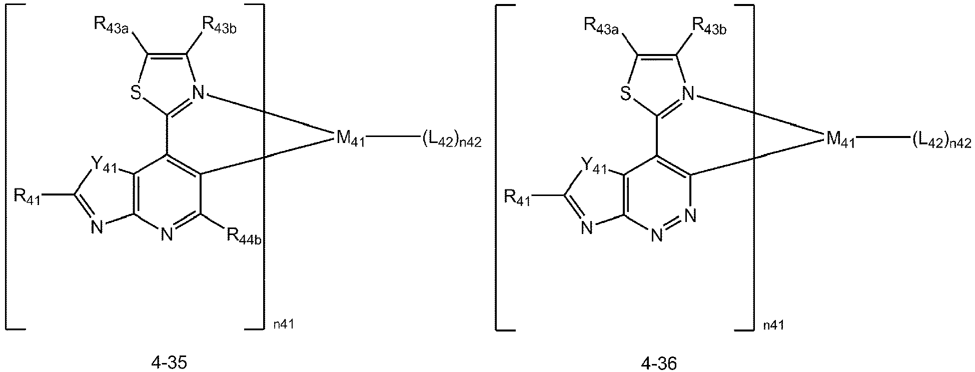 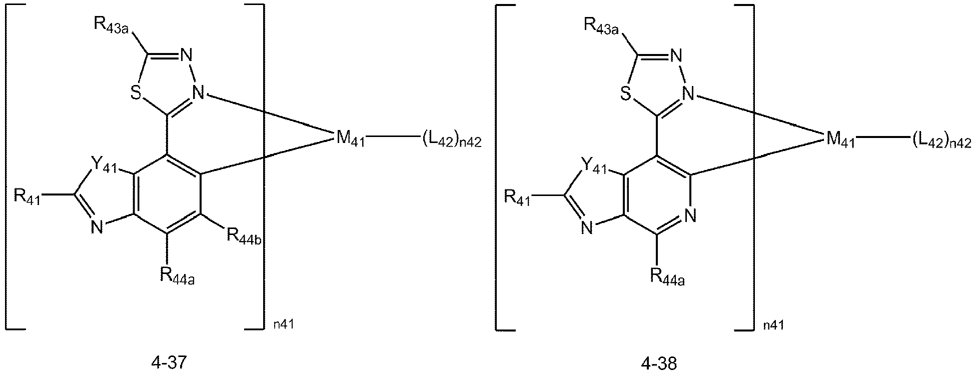 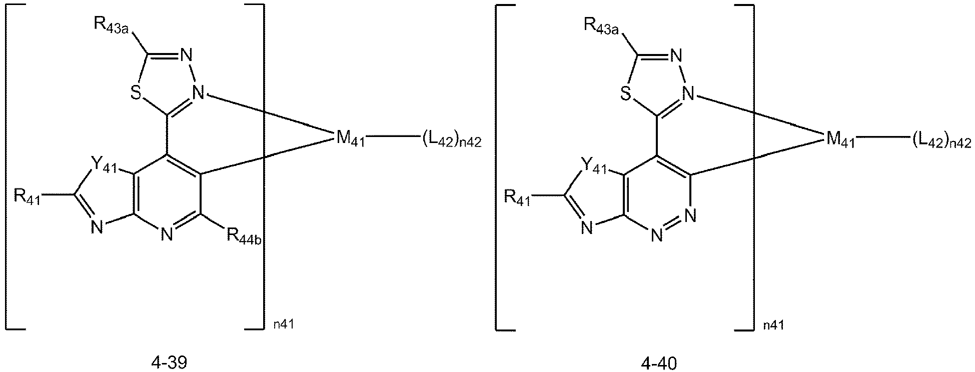 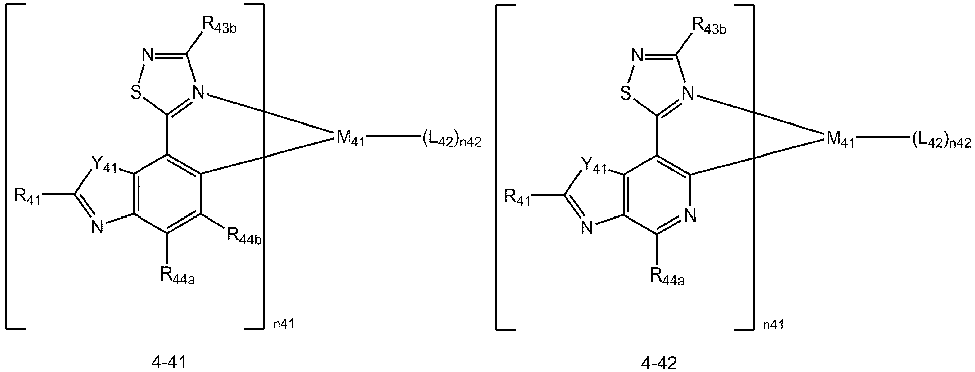 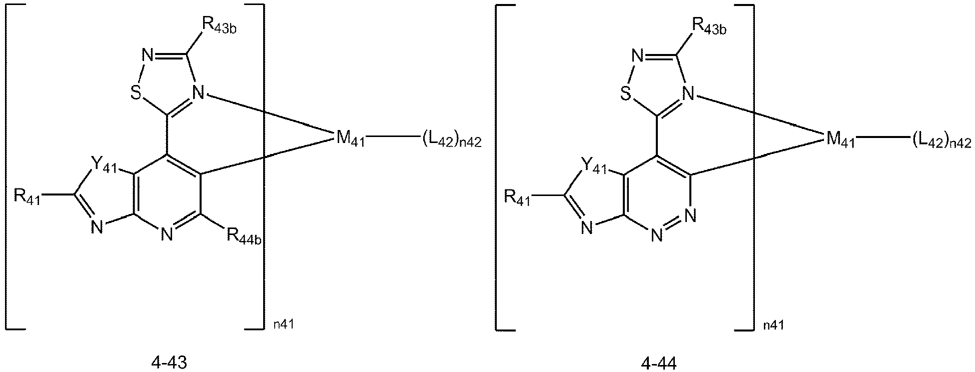 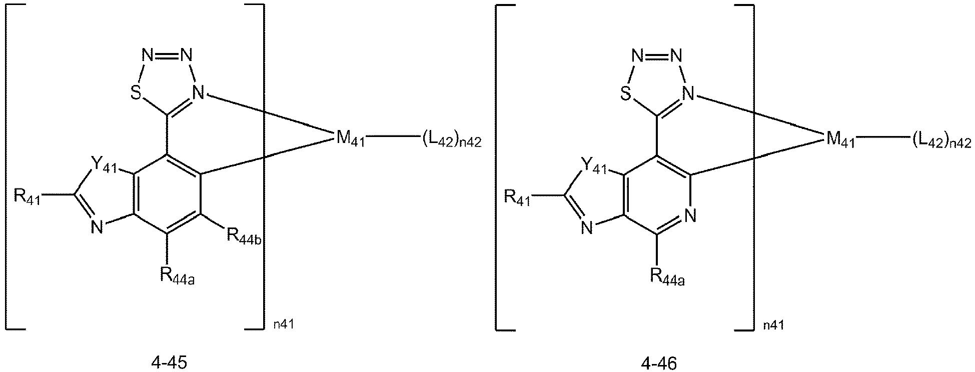 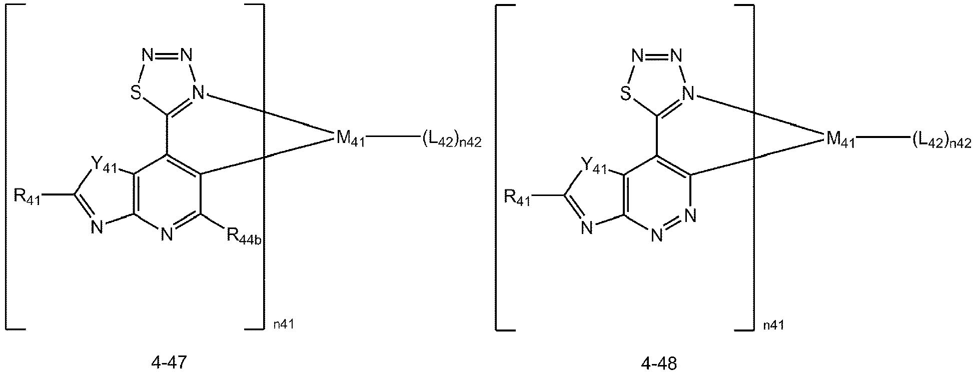 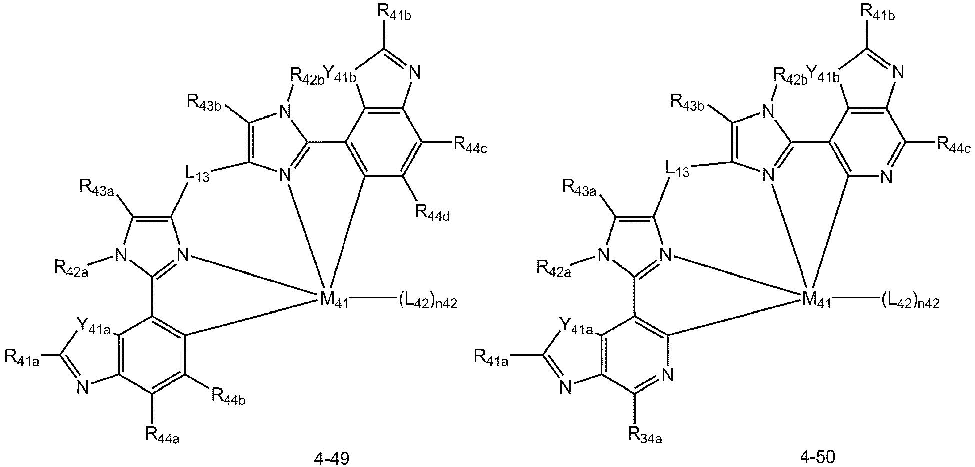 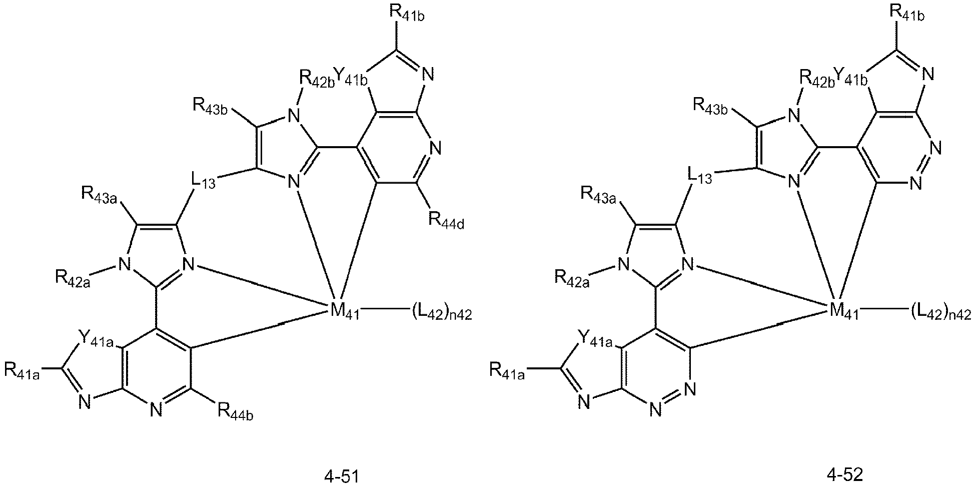 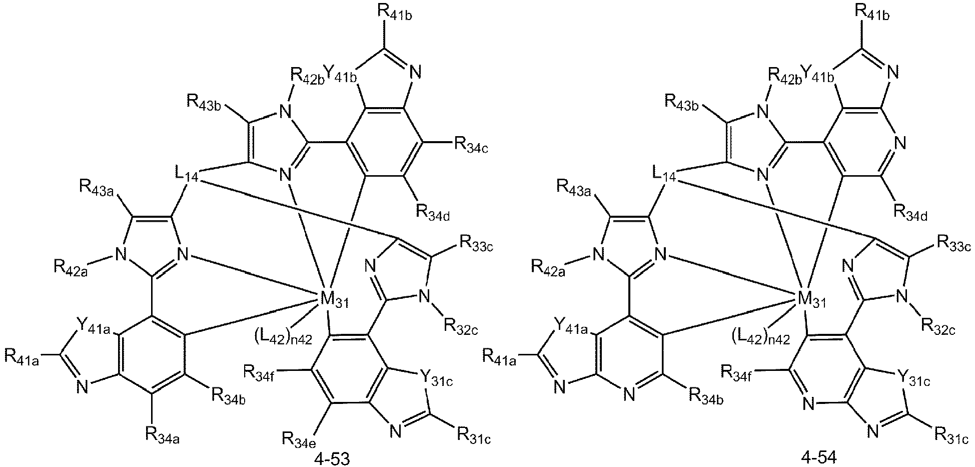 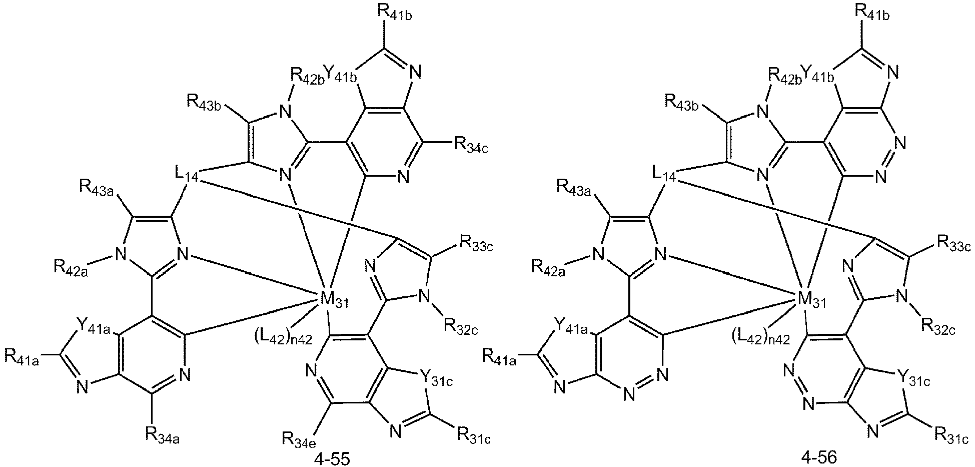 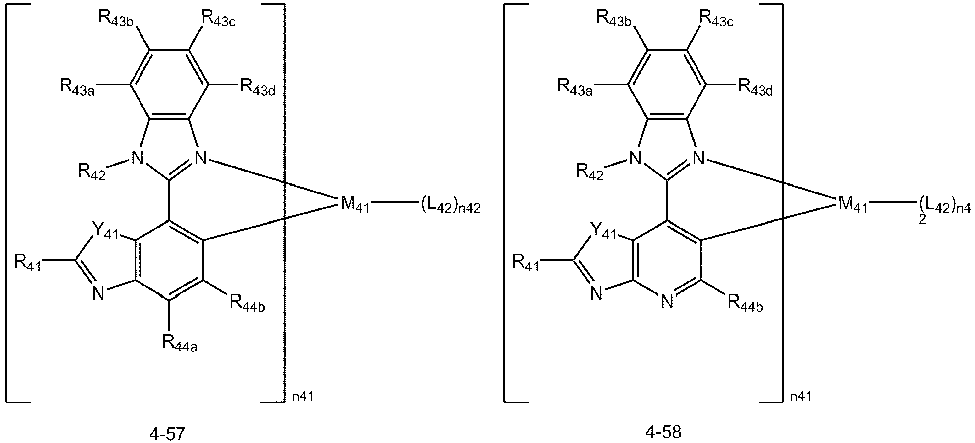 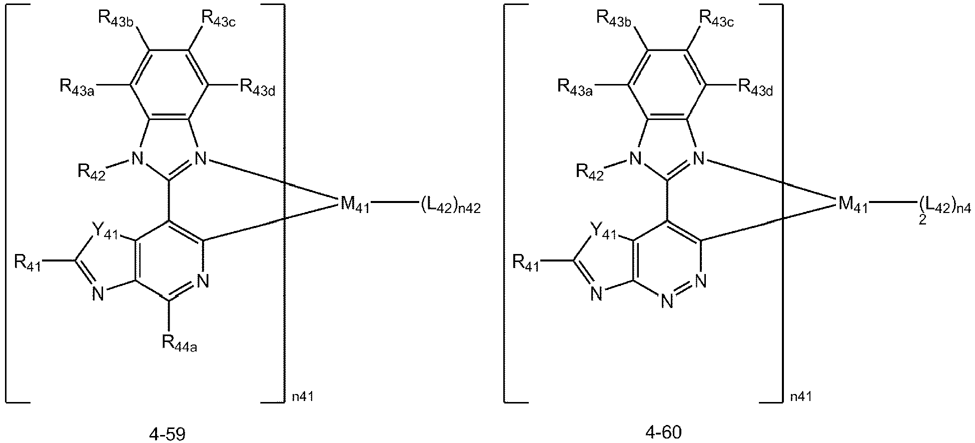 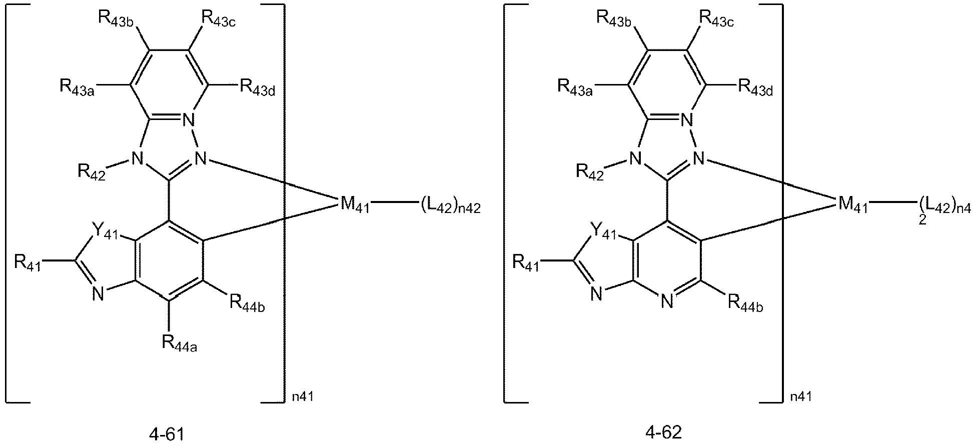 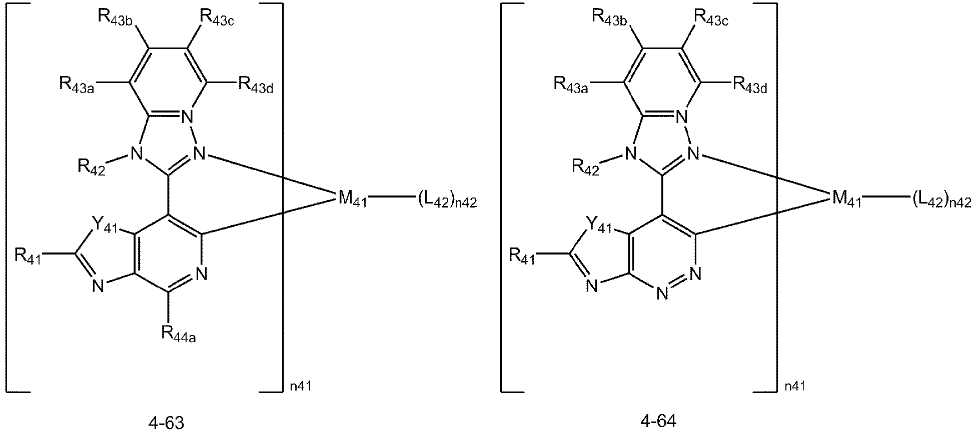 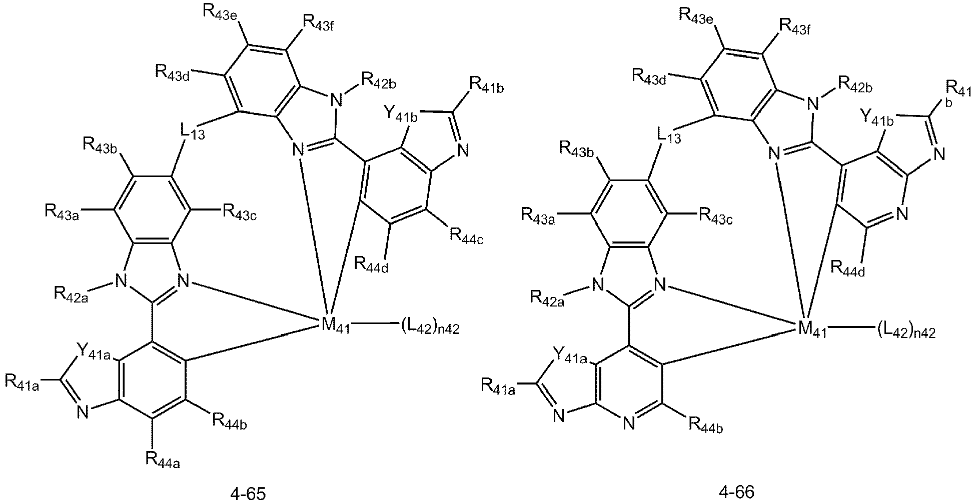 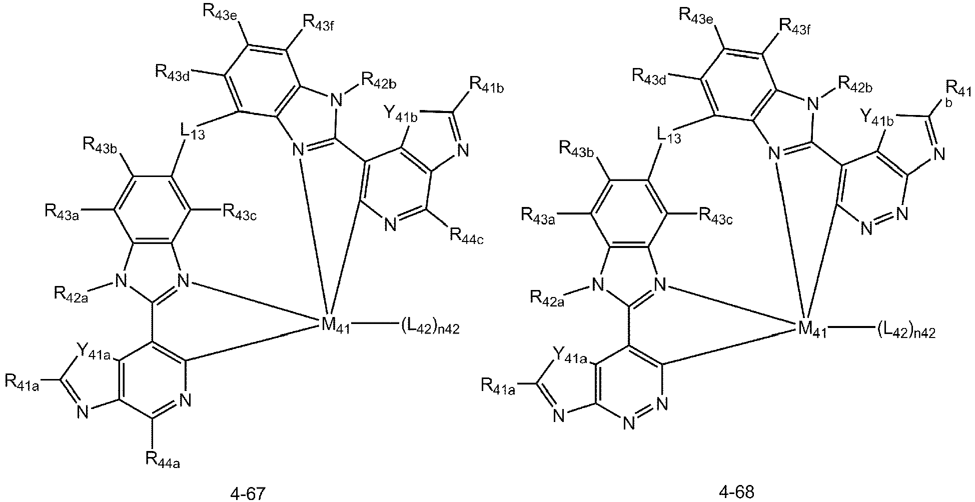 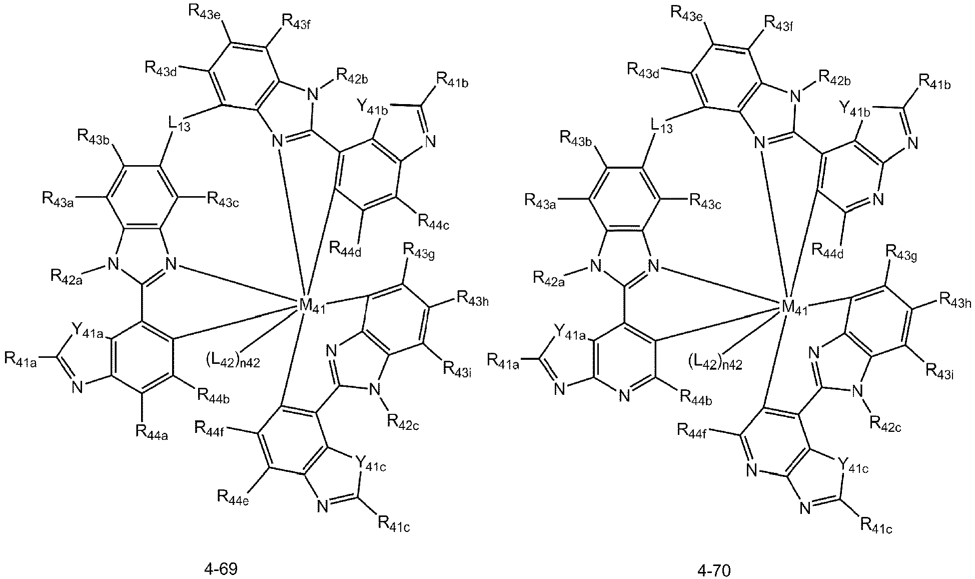 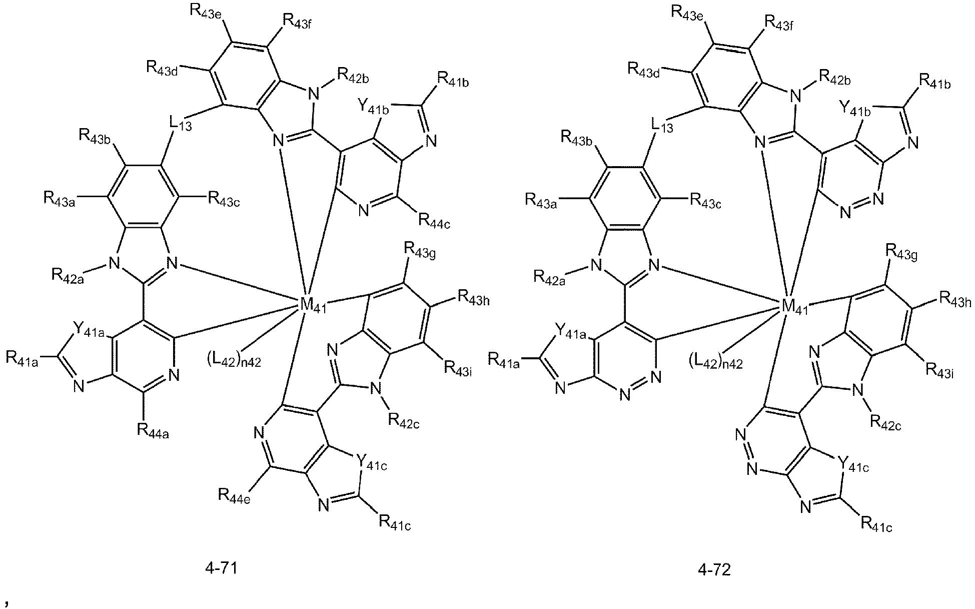
wherein, in Formulae 1-1 to 1-72, 2-1 to 2-72, 3-1 to 3-72, and 4-1 to 4-72,
R₁₃ₐ to R₁₃ᵢ are each independently the same as described in connection with R₁₃ in Formula 1,
R₁₄ₐ to R_{14f} are each independently the same as described in connection with R₁₄ in Formula 1,
Y₁₁ₐ and Y_{11c} are each independently the same as described in connection with Y₁₁ in Formula 1,
R₂₃ₐ to R₂₃ᵢ are each independently the same as described in connection with R₂₃ in Formula 2,
R₂₄ₐ to R_{24f} are each independently the same as described in connection with R₂₄ in Formula 2,
Y₂₁ₐ and Y_{21c} are each independently the same as described in connection with Y₂₁ in Formula 2,
R₃₃ₐ to R₃₃ᵢ are each independently the same as described in connection with R₃₃ in Formula 3,
R₃₄ₐ to R_{34f} are each independently the same as described in connection with R₃₄ in Formula 3,
Y₃₁ₐ and Y_{31c} are each independently the same as described in connection with Y₃₁ in Formula 3,
R₄₃ₐ to R₄₃ᵢ are each independently the same as described in connection with R₄₃ in Formula 4,
R₄₄ₐ to R_{44f} are each independently the same as described in connection with R₄₄ in Formula 4,
Y₄₁ₐ and Y_{41c} are each independently the same as described in connection with Y₄₁ in Formula 4,
L₁₃ is selected from "-O-"', *-S-*', *-[C(R₁₉)(R₂₀)]ₖ₁₁-*', *-[Si(R₁₉)(R₂₀)]ₖ₁₁-*', and a substituted or unsubstituted benzene group,
L₁₄ is selected from 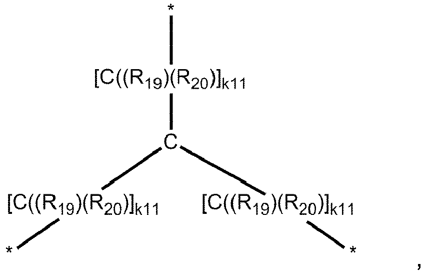 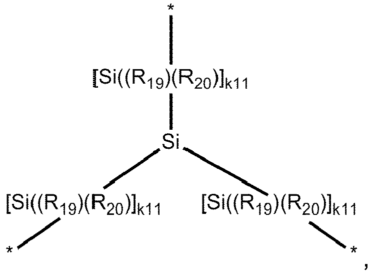 and a substituted or unsubstituted benzene group, R₁₉ and R₂₀ are each independently the same as described in connection with R₁₁, and k11 is selected from 1, 2, and 3.

12. The organometallic compound of any of claims 1-11, wherein
the organometallic compound represented by one of Formulae 1 to 4 is selected from Compounds 1 to 782:

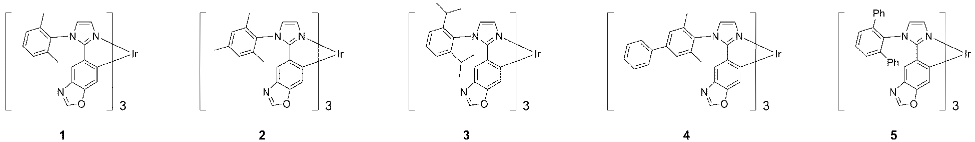

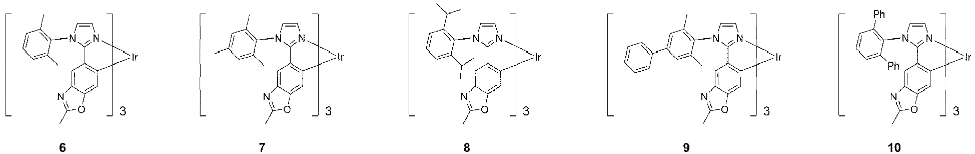

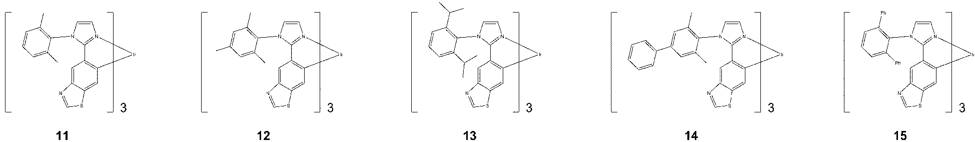

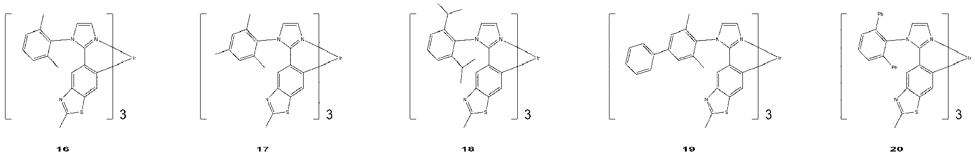

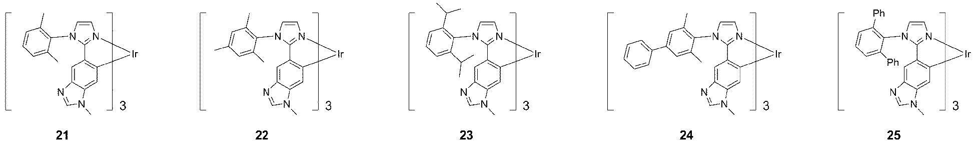

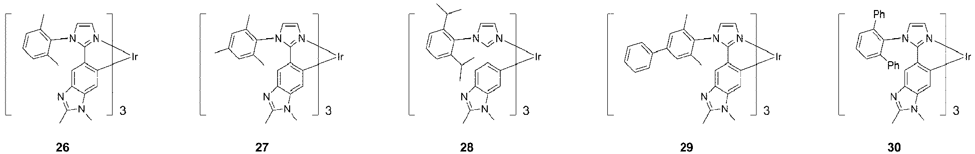

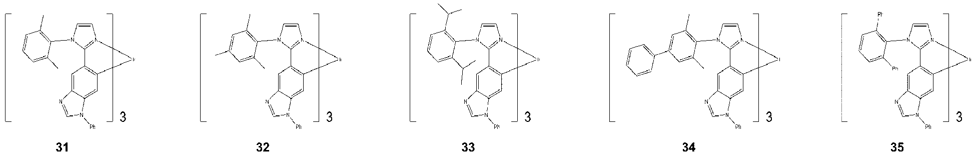

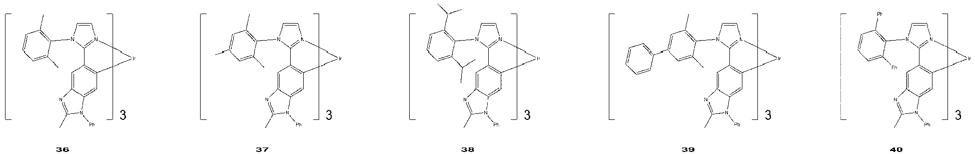

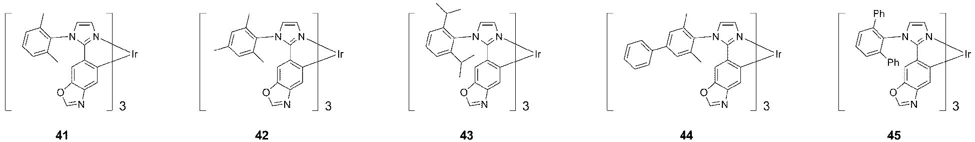

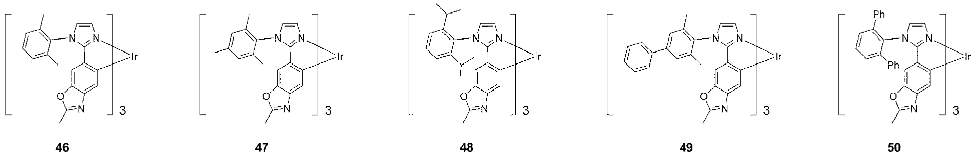

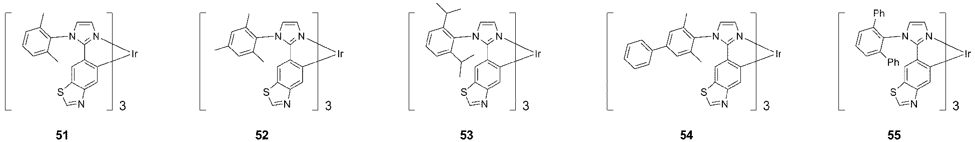

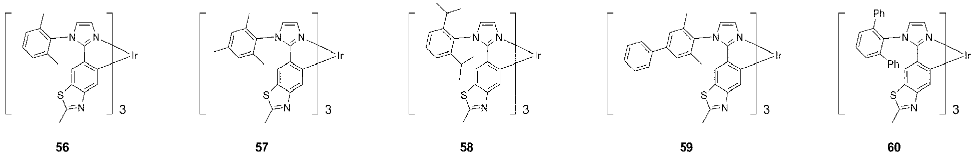

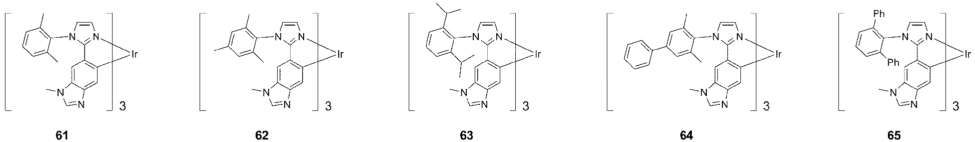

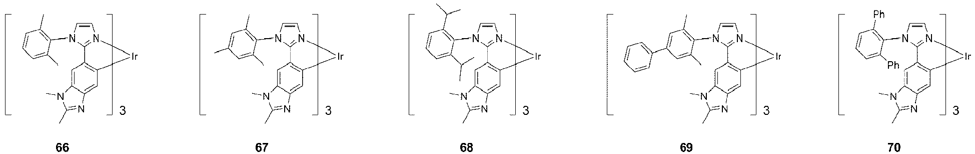

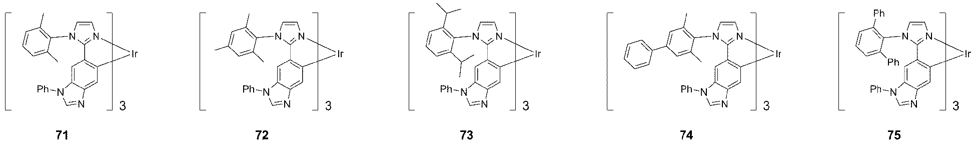

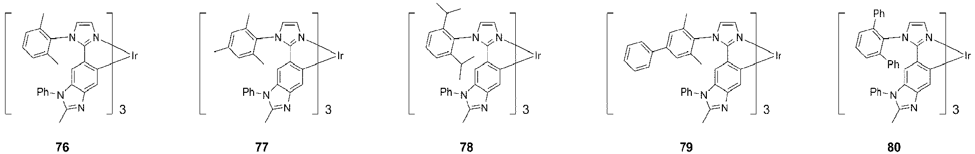

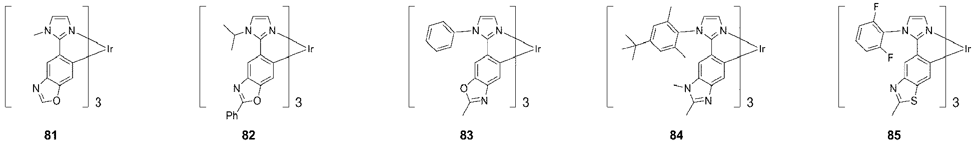

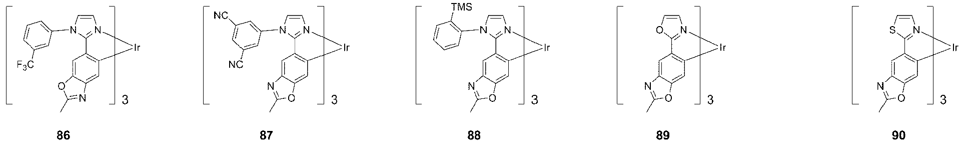

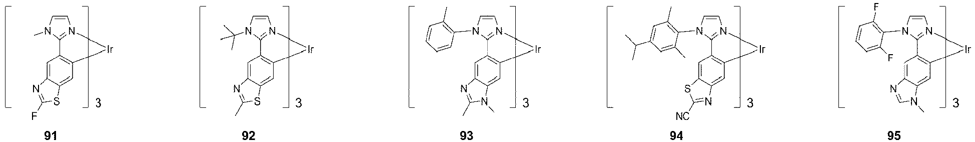

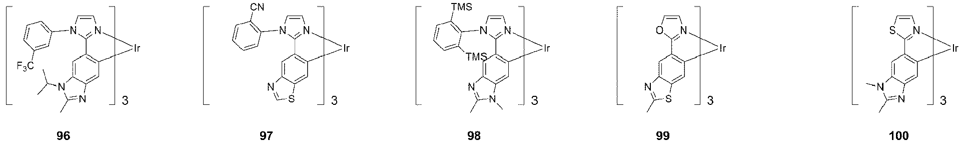

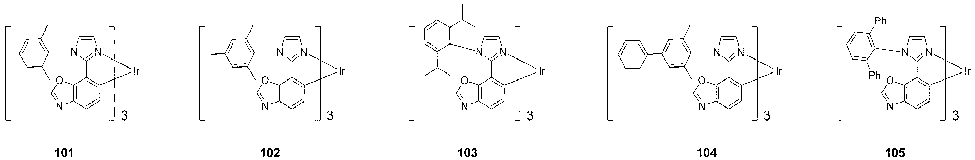

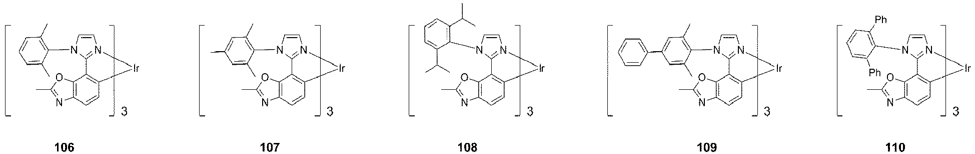

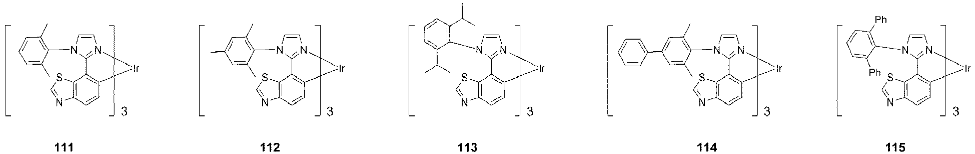

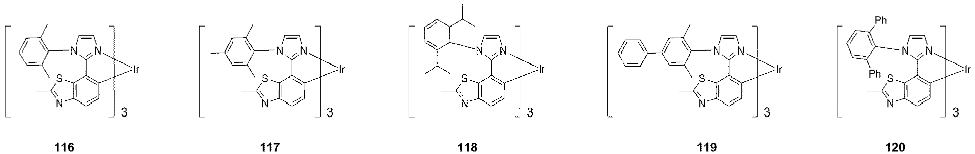

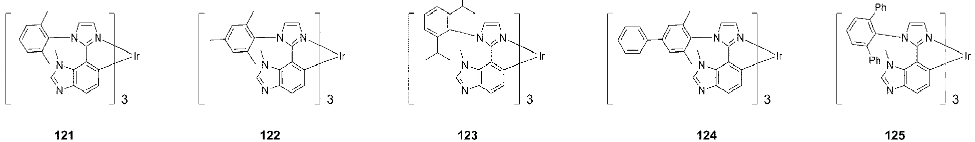

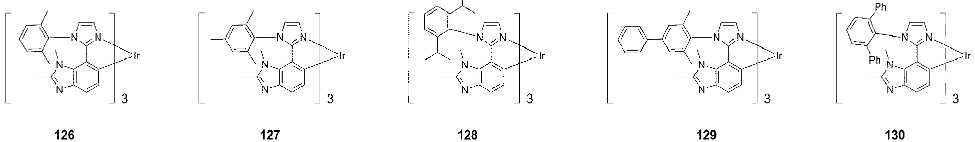

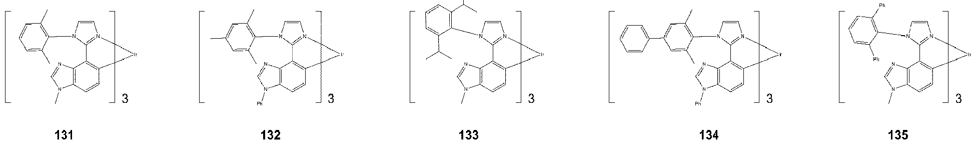

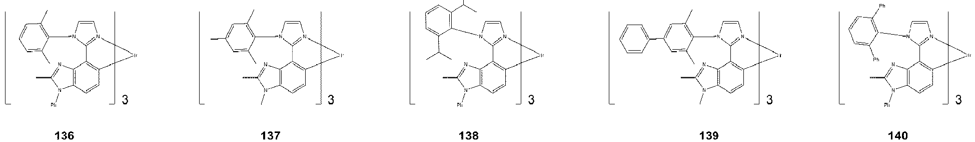

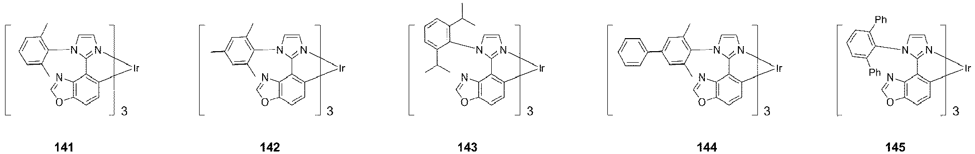

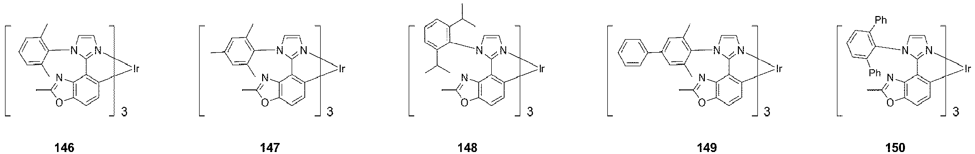

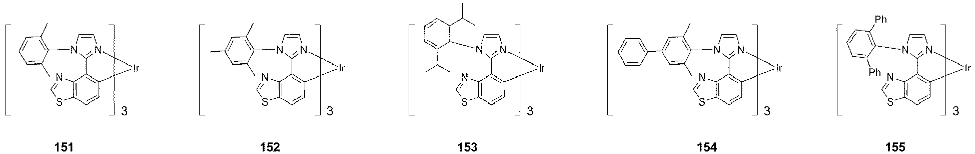

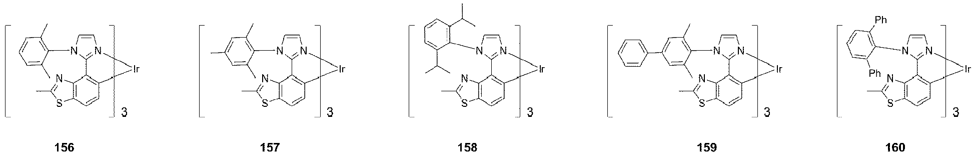

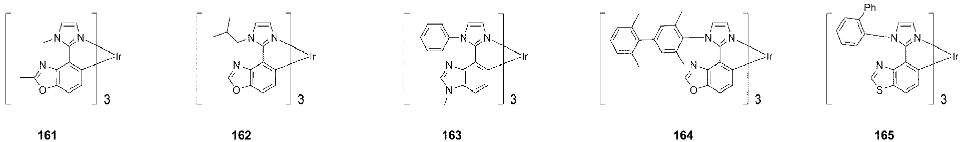

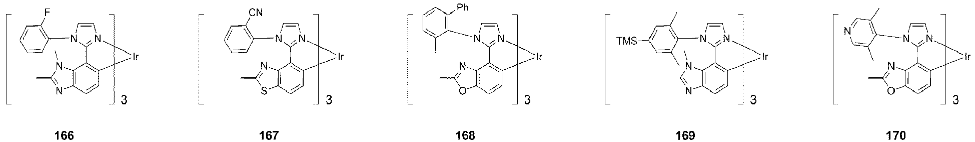

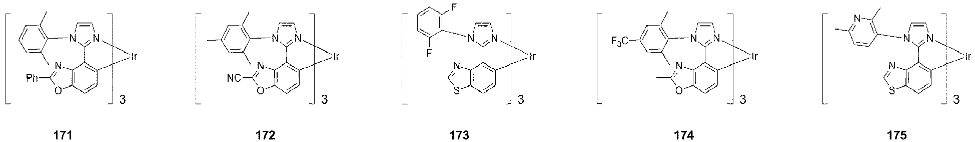

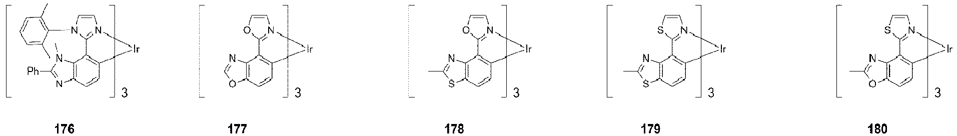

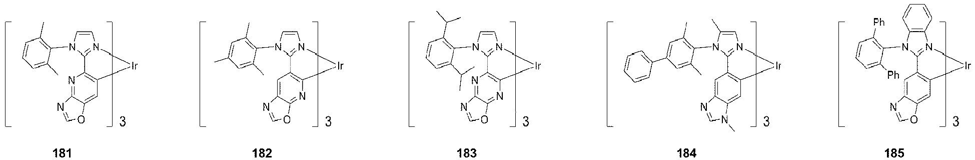

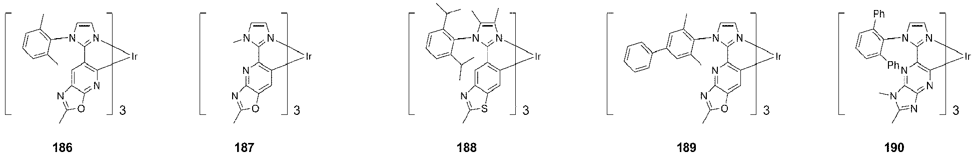

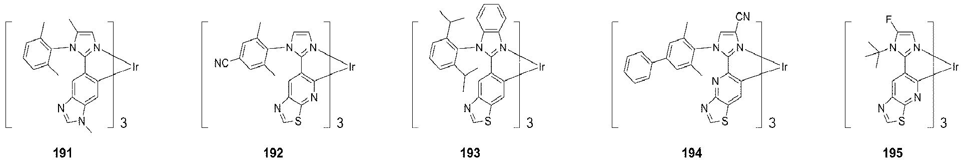

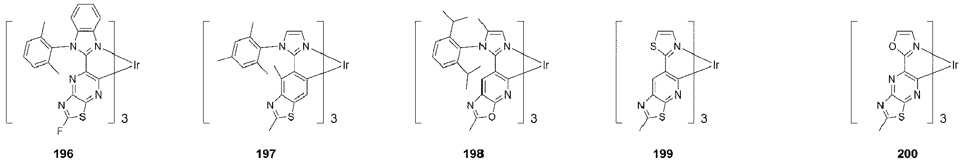

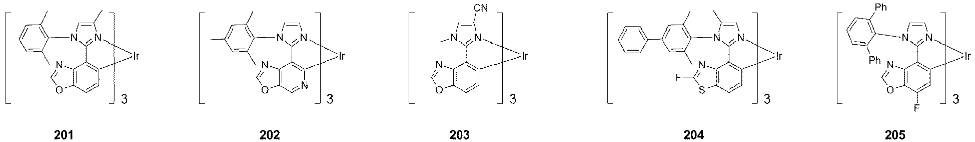

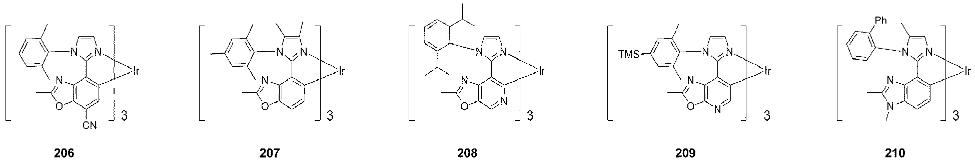

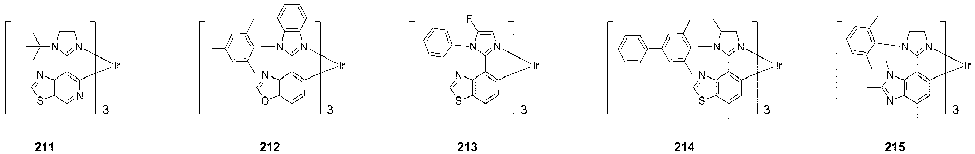

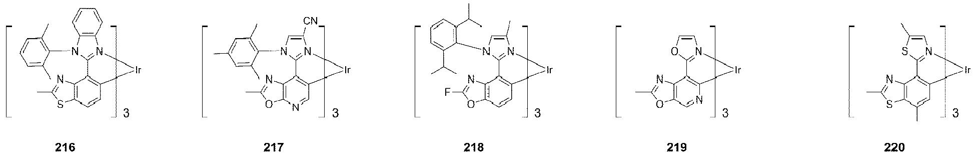

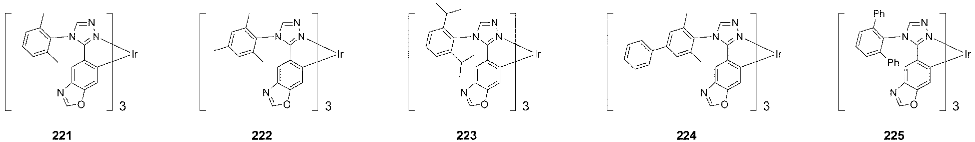

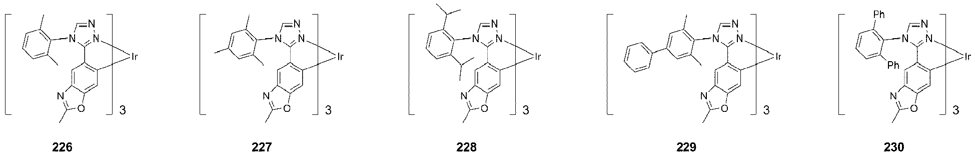

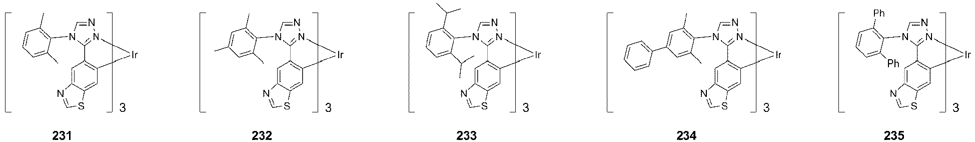

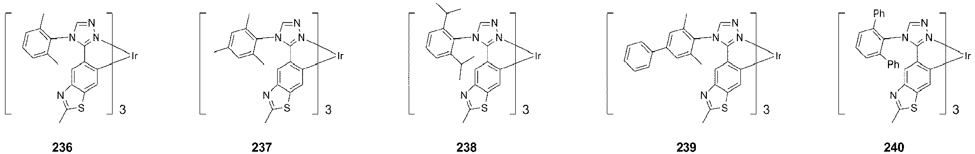

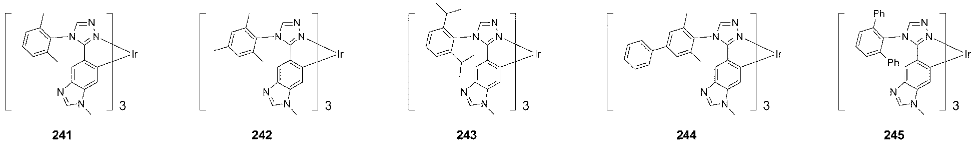

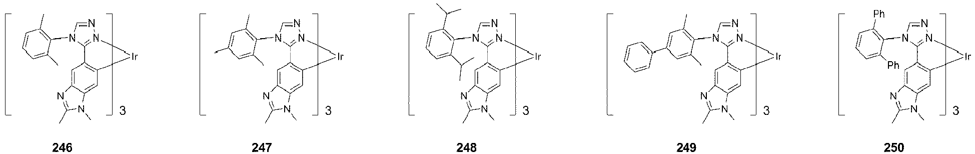

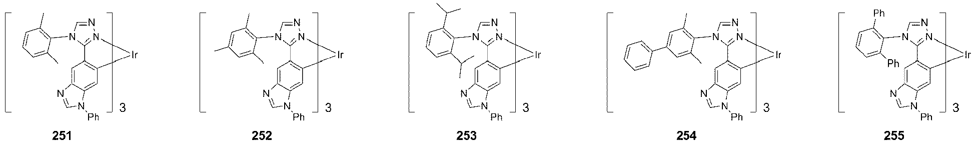

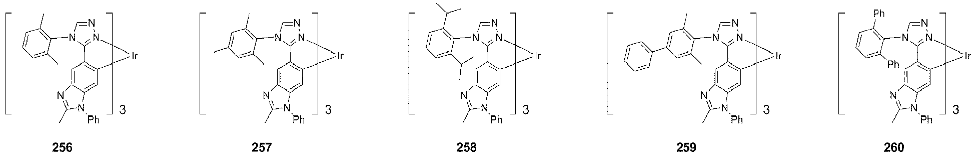

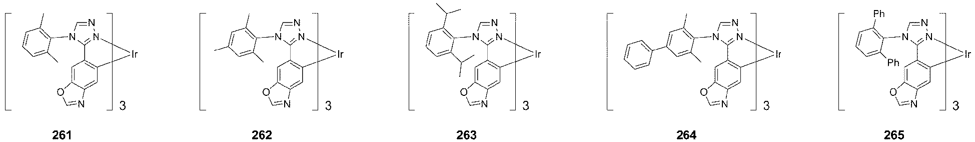

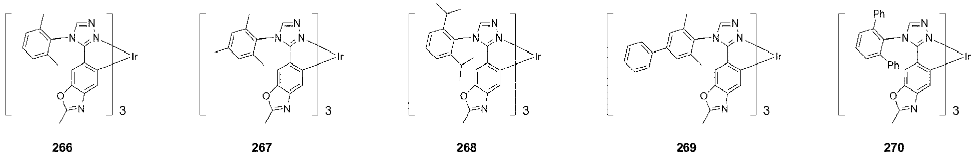

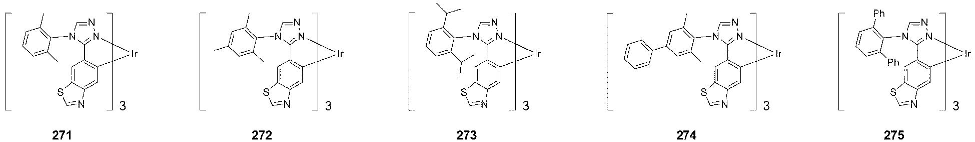

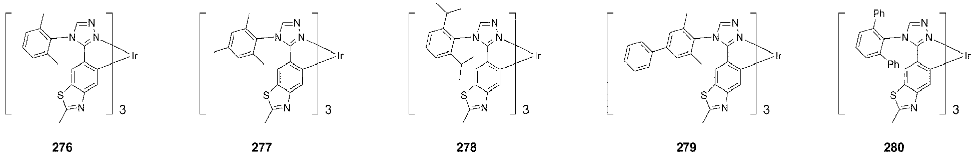

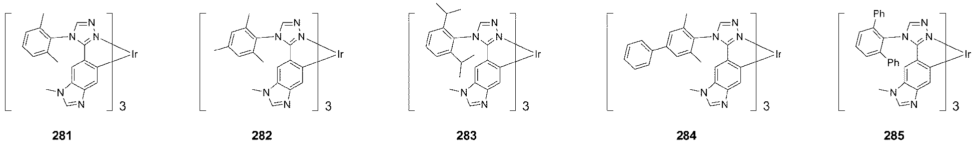

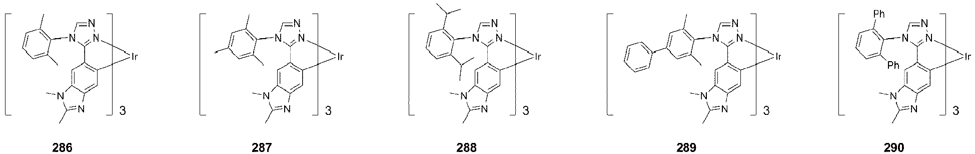

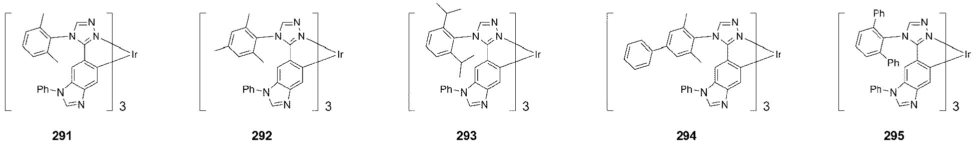

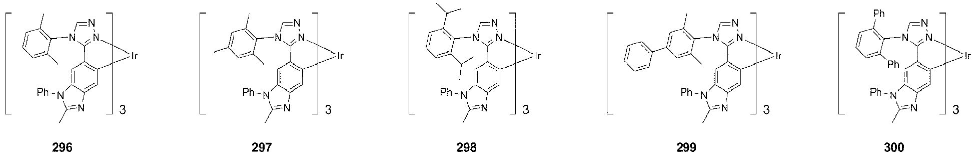

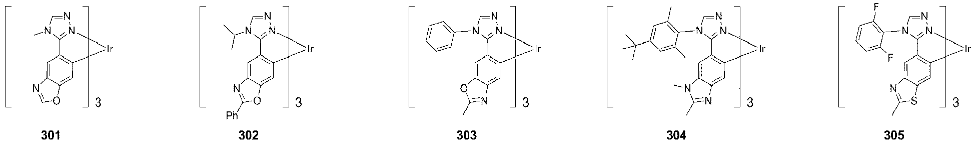

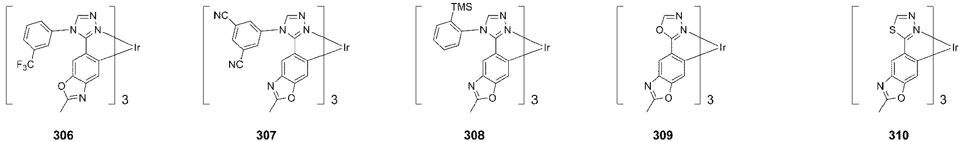

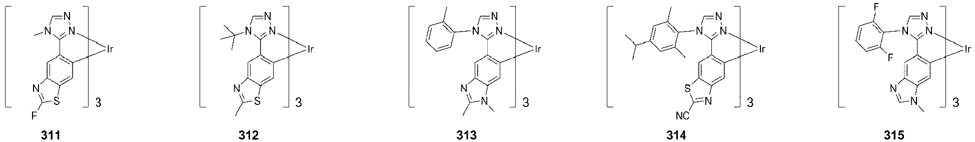

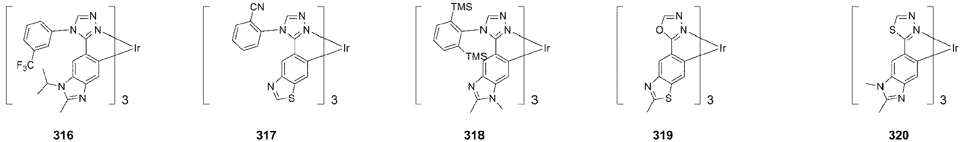

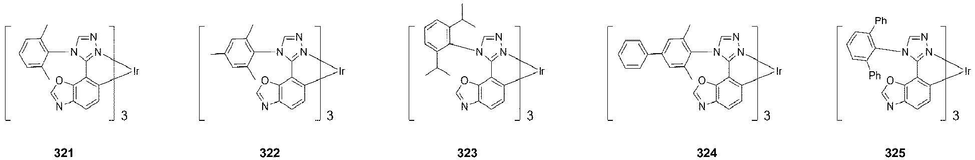

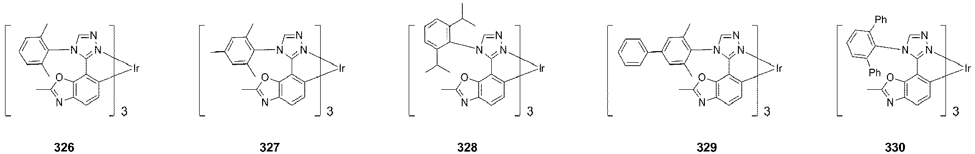

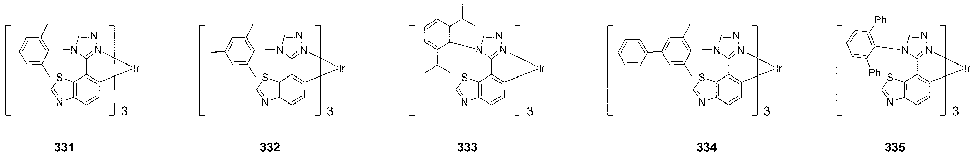

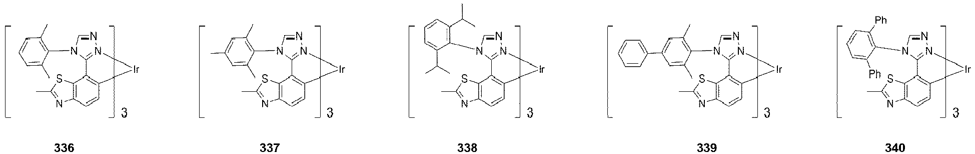

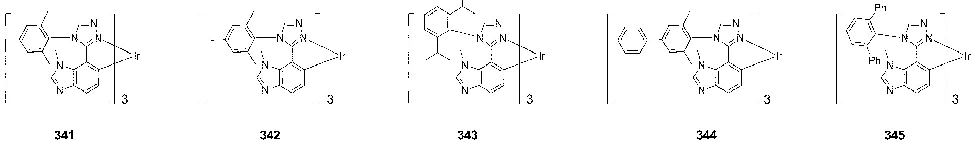

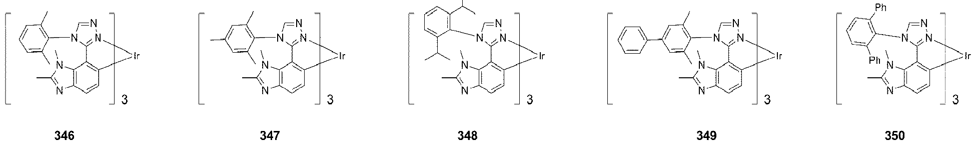

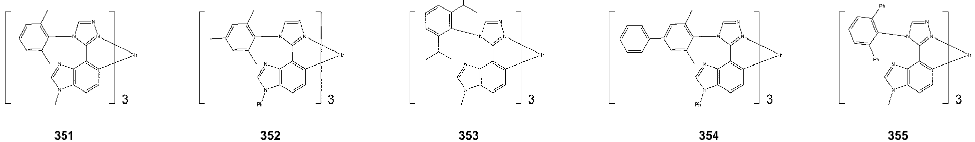

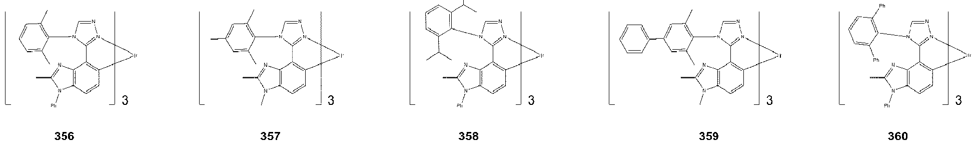

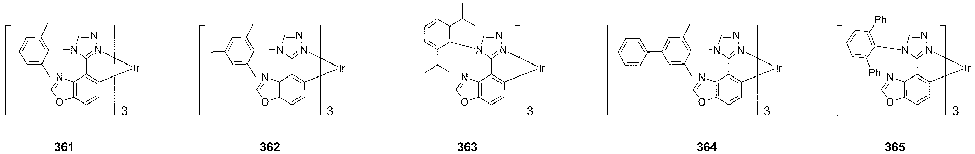

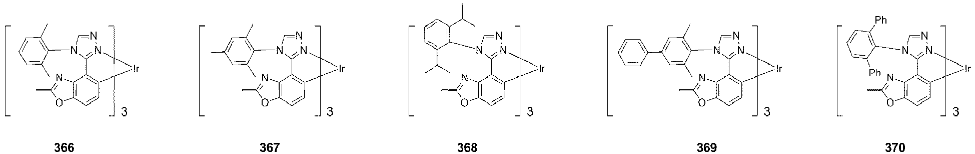

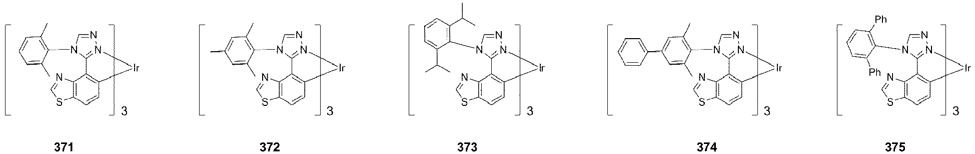

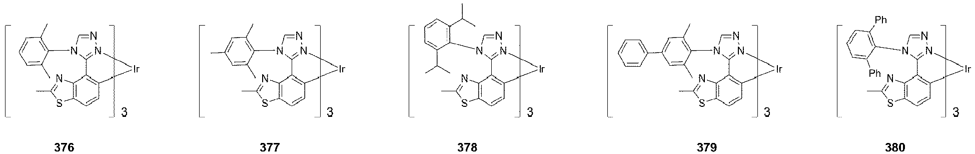

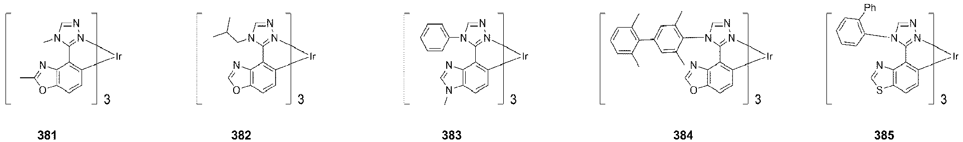

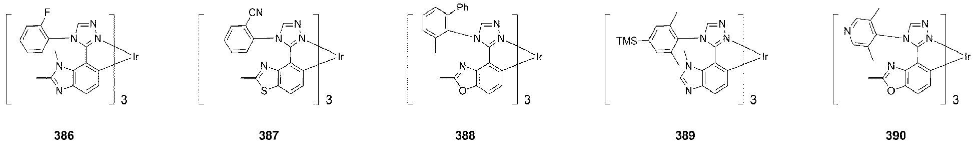

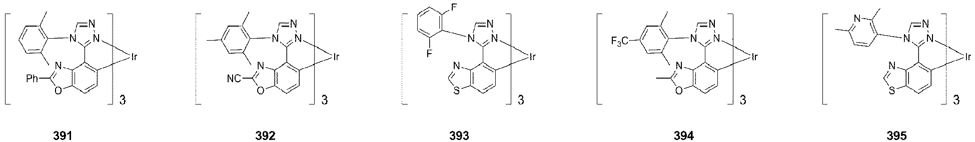

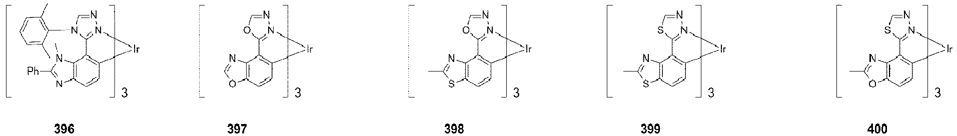

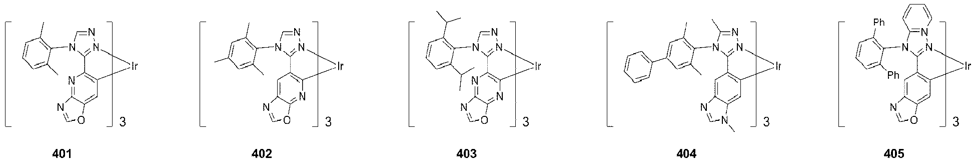

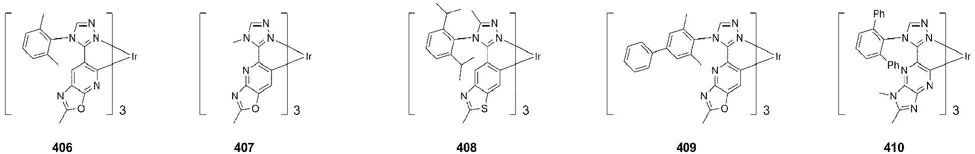

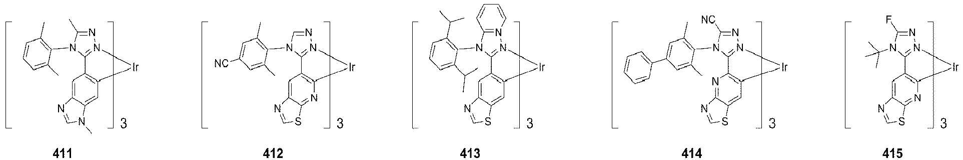

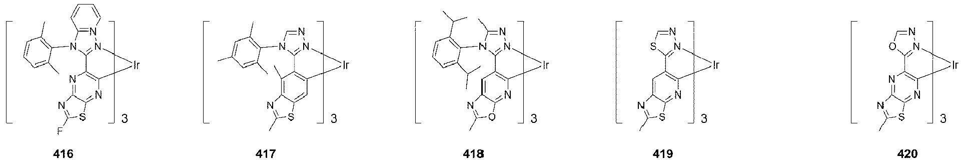

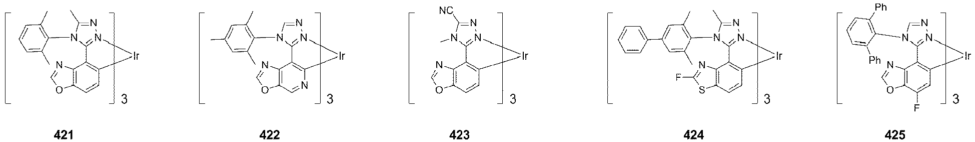

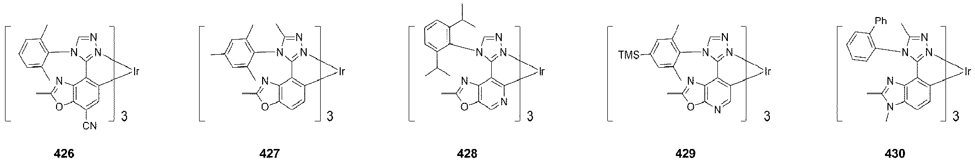

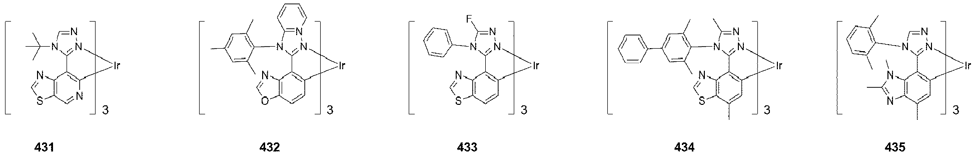

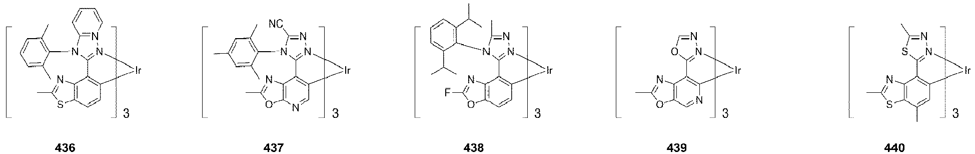

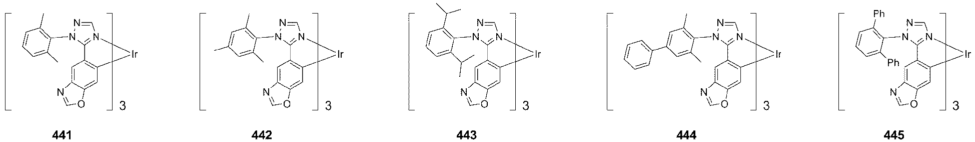

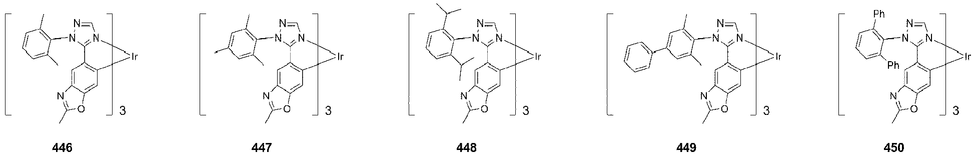

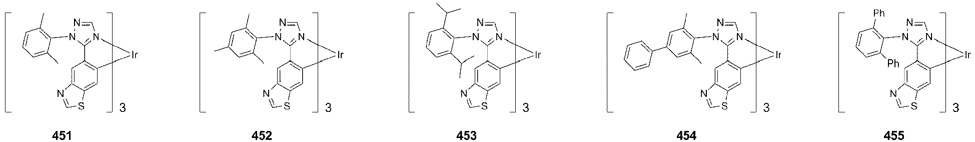

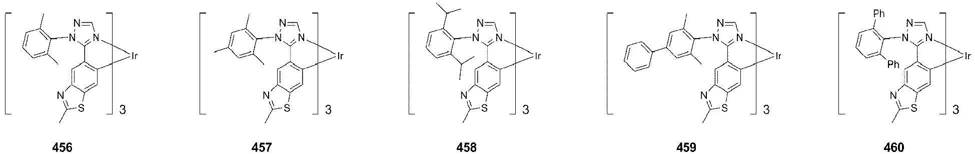

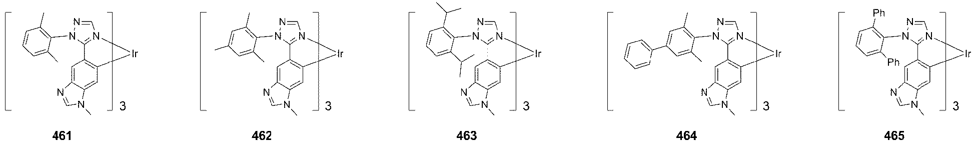

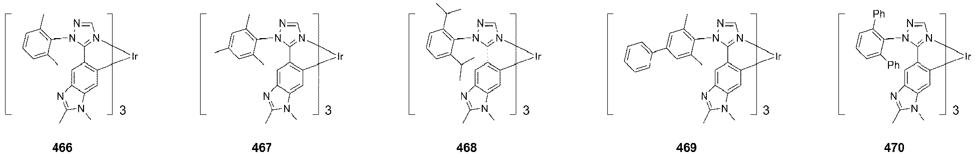

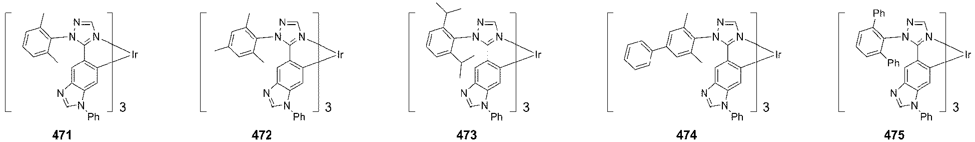

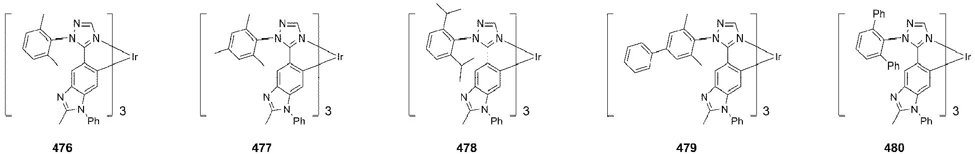

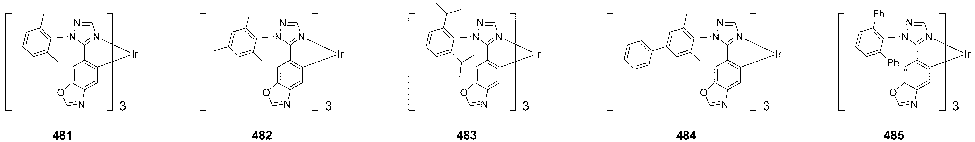

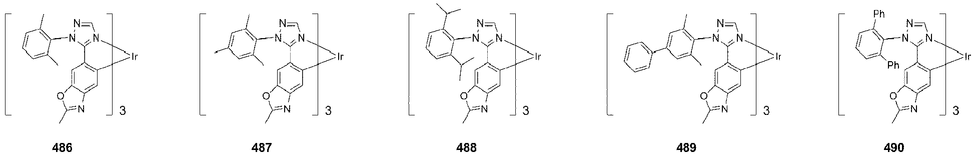

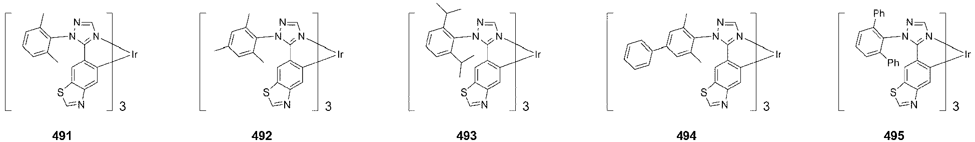

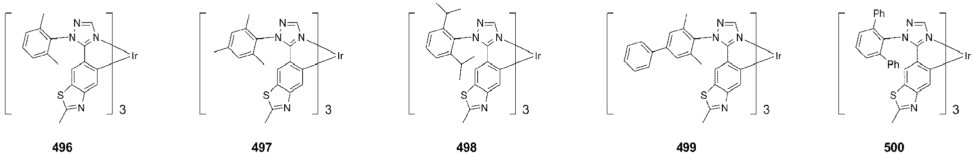

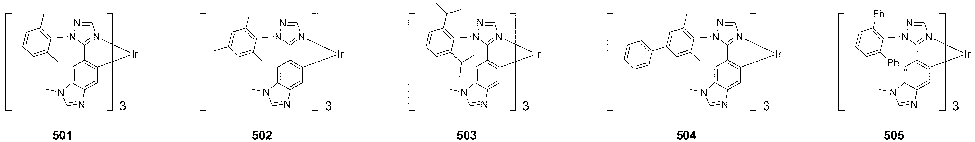

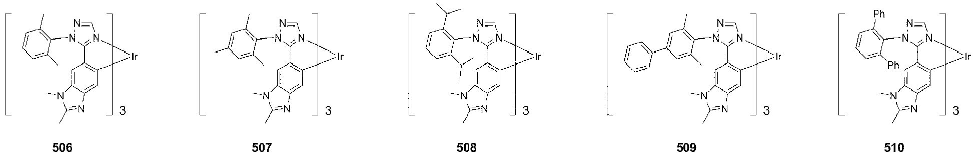

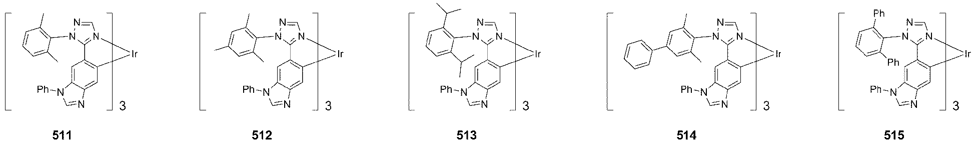

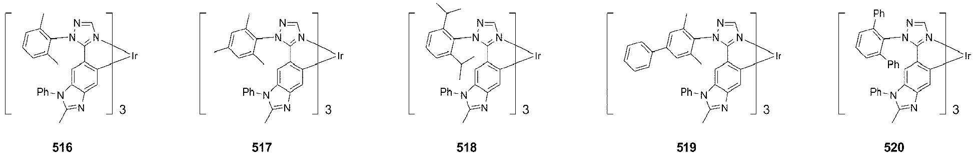

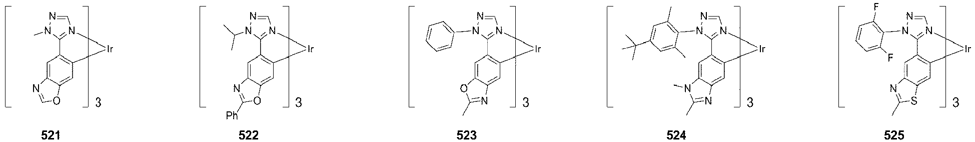

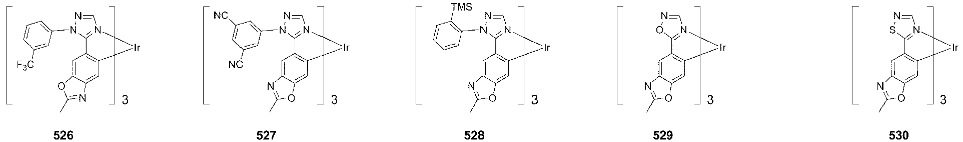

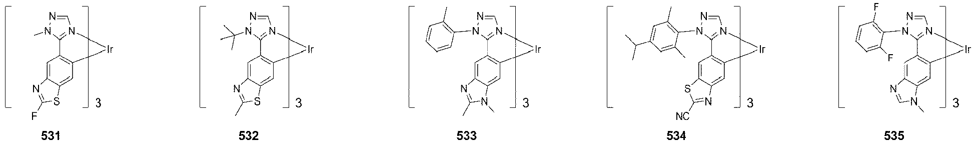

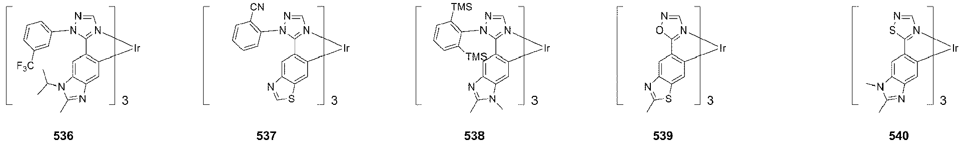

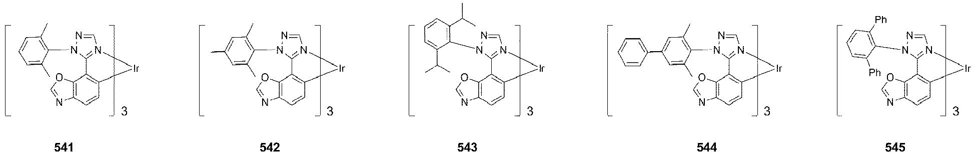

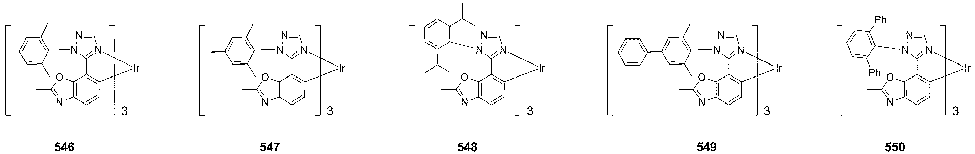

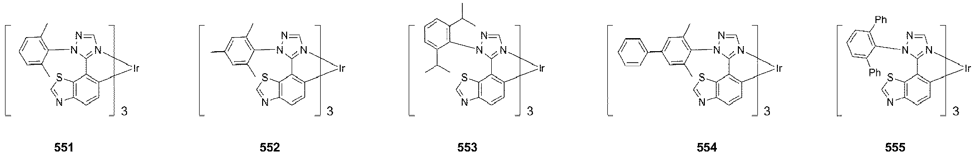

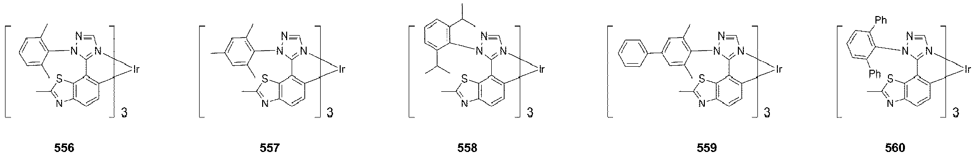

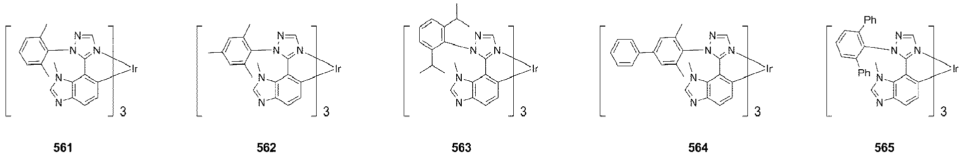

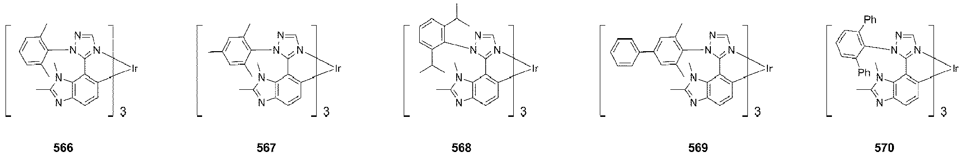

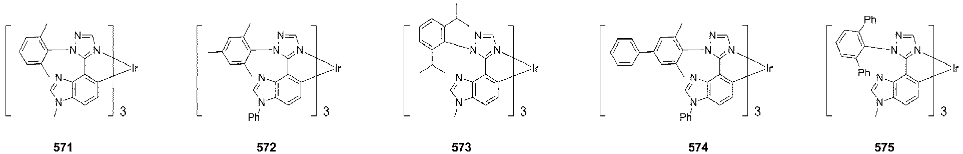

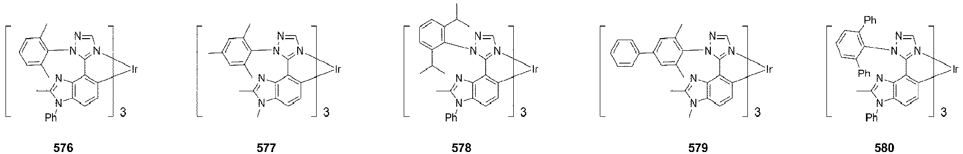

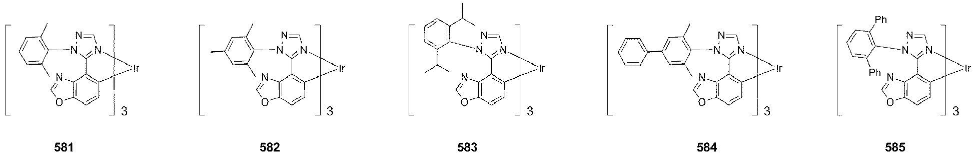

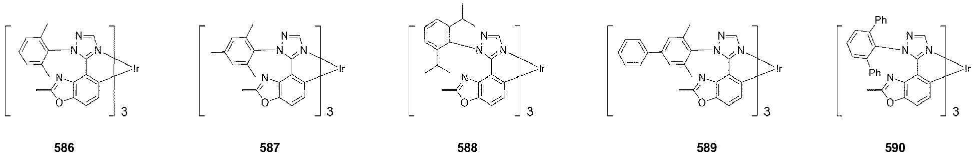

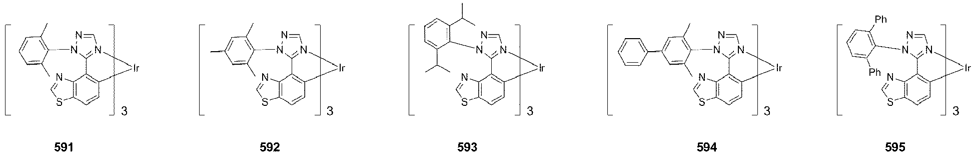

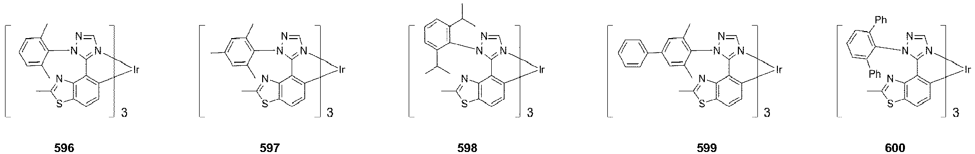

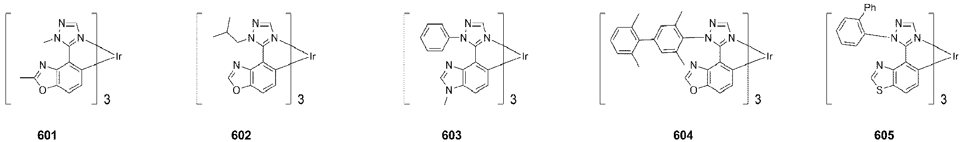

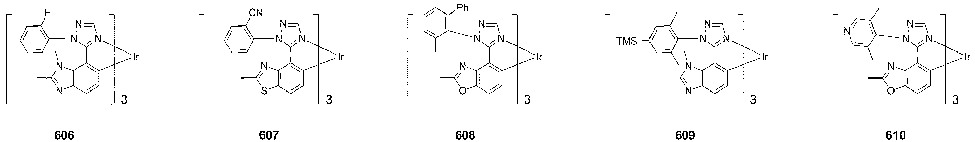

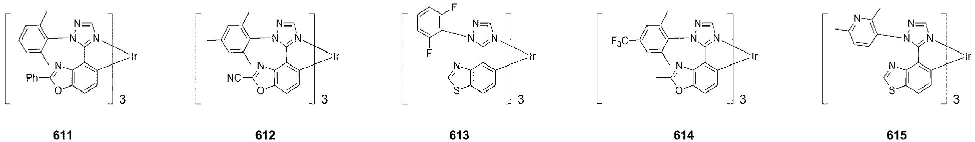

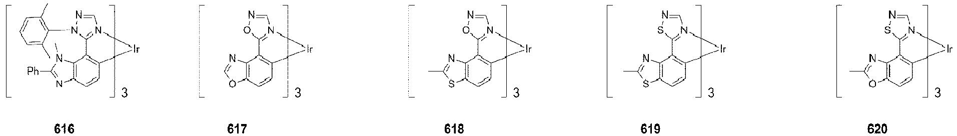

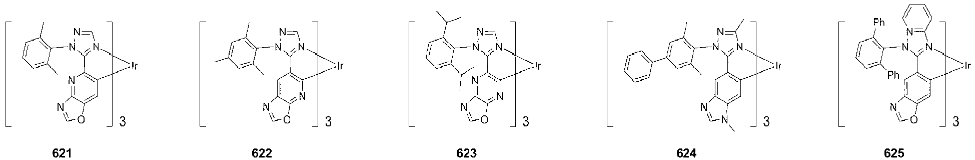

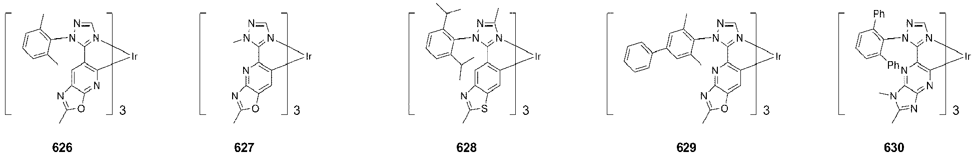

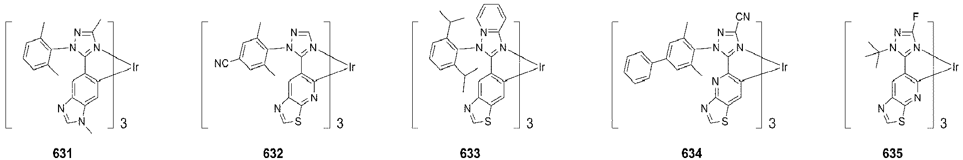

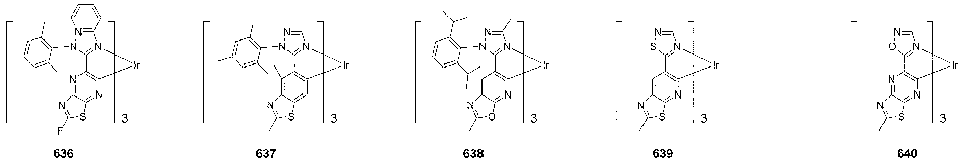

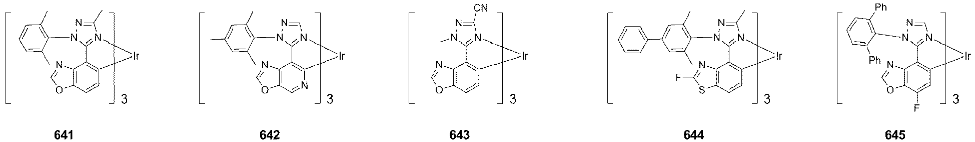

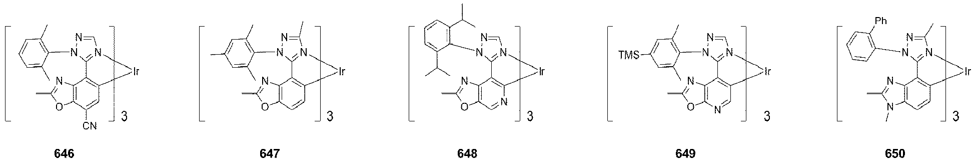

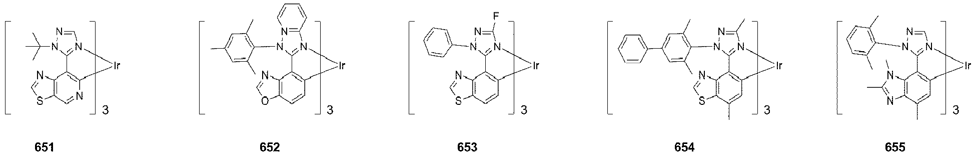

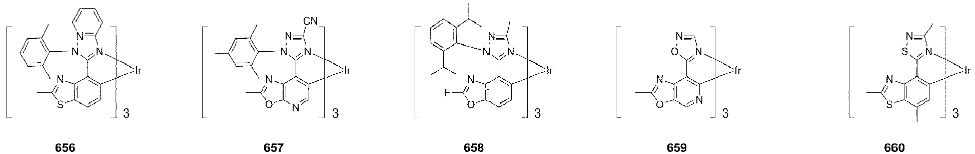

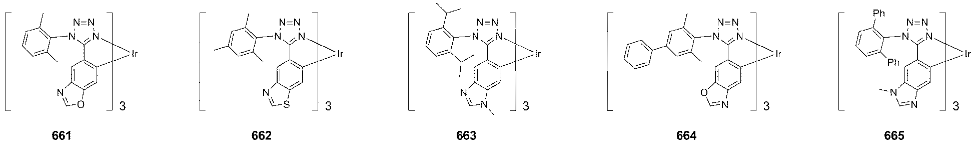

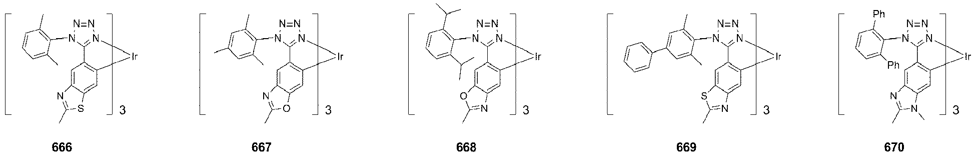

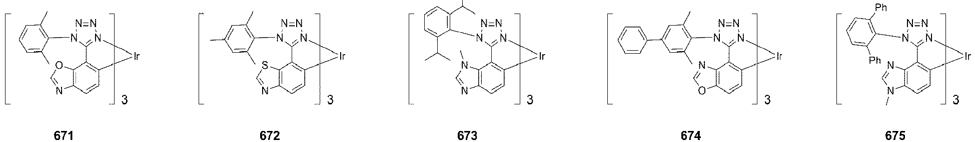

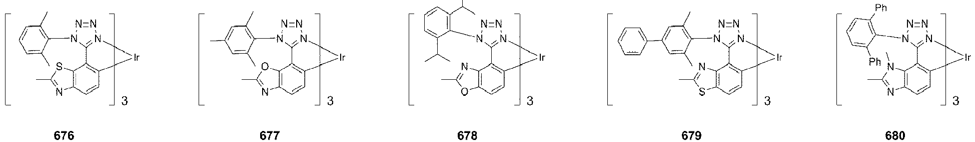

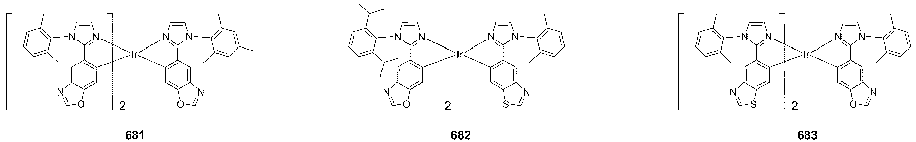

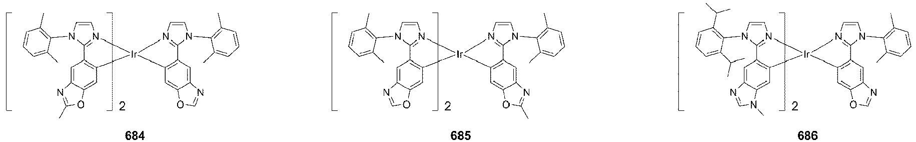

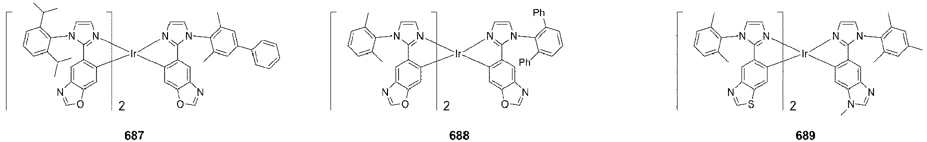

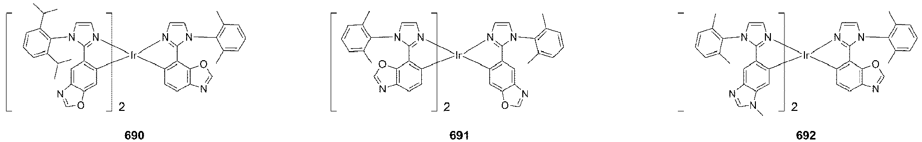

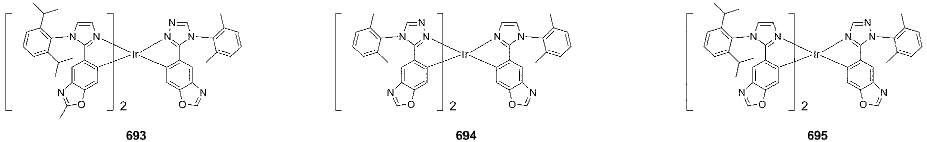

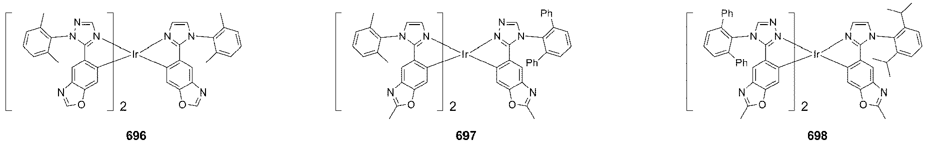

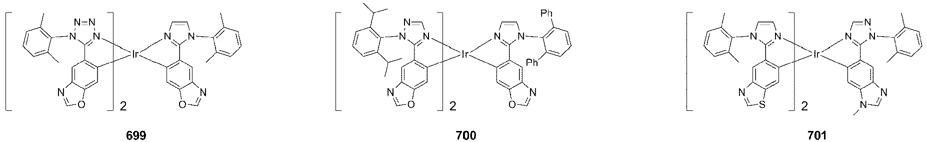

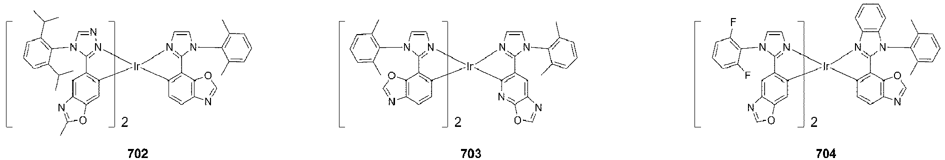

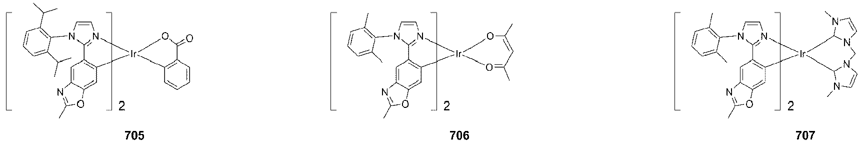

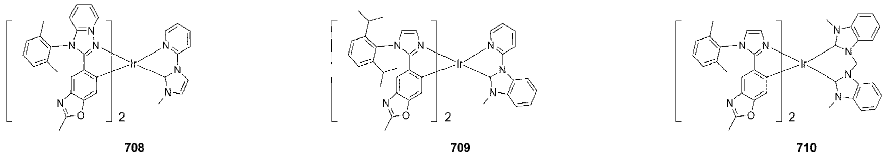

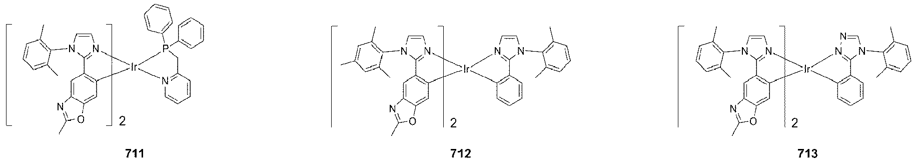

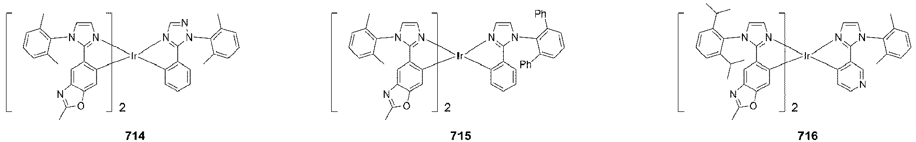

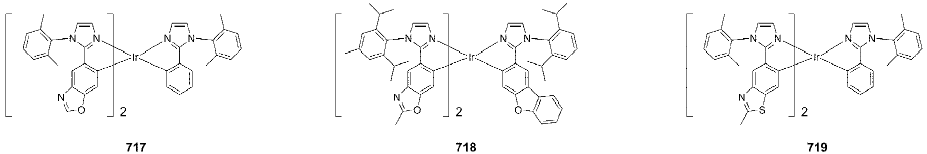

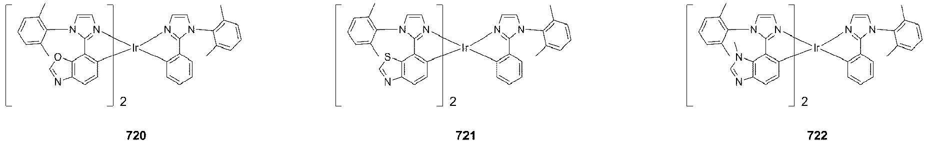

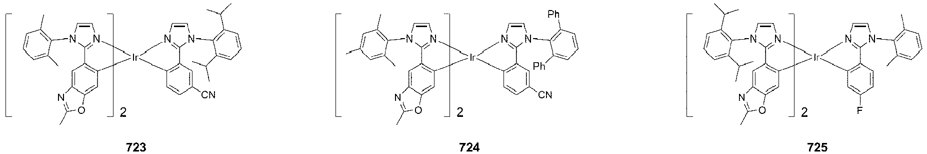

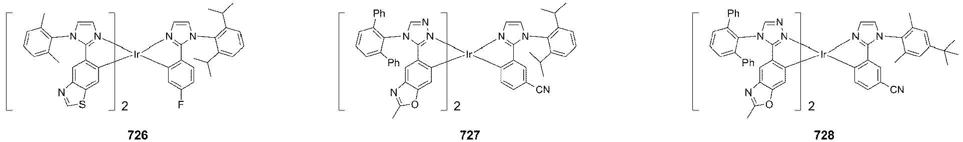

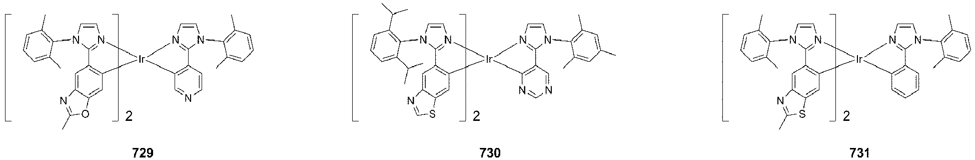

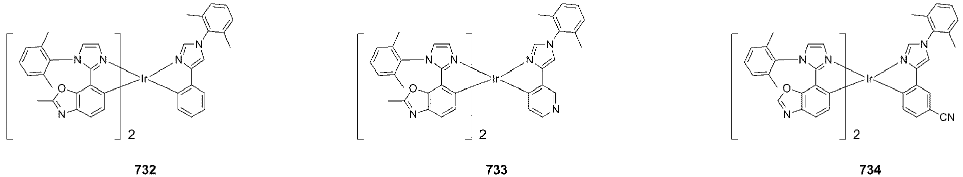

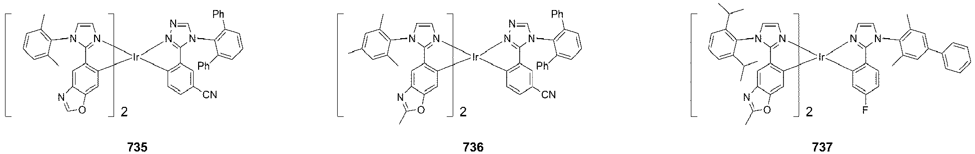

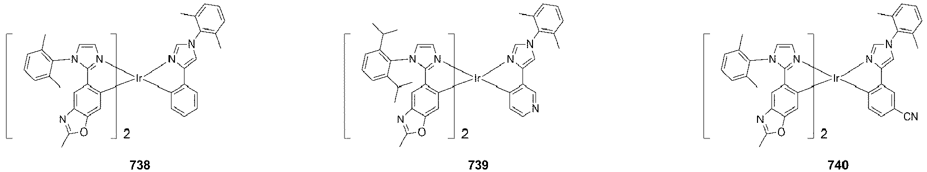

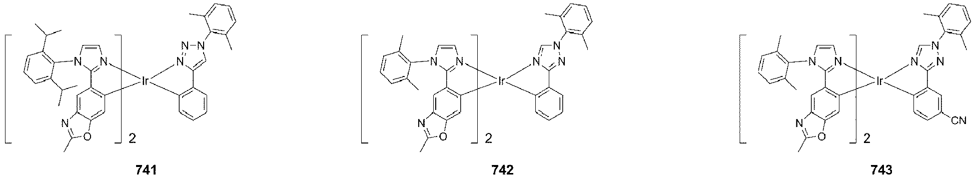

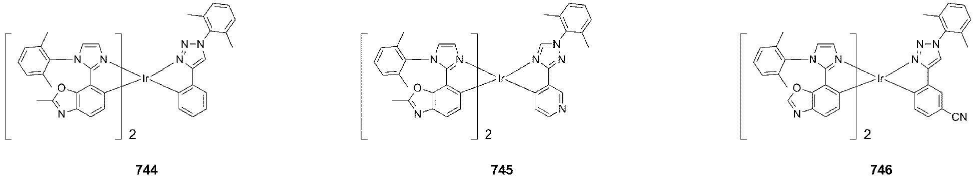

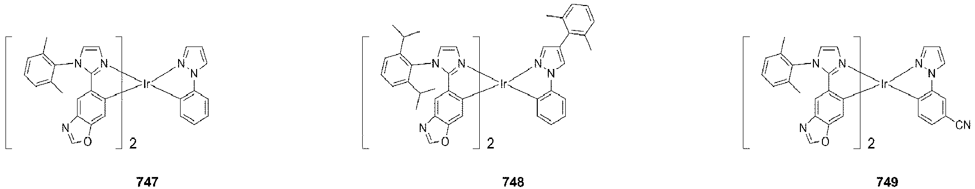

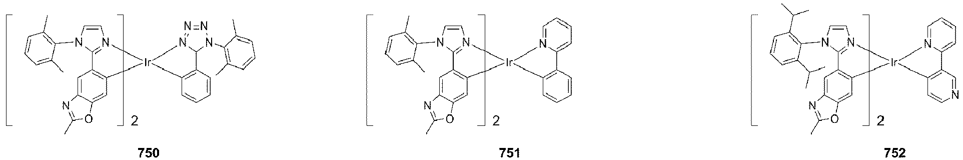

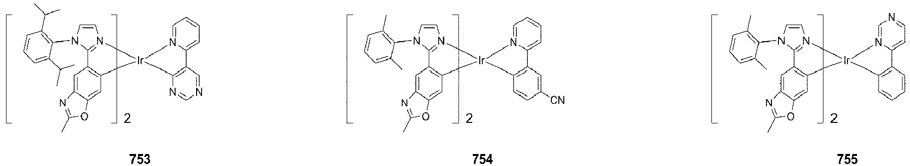

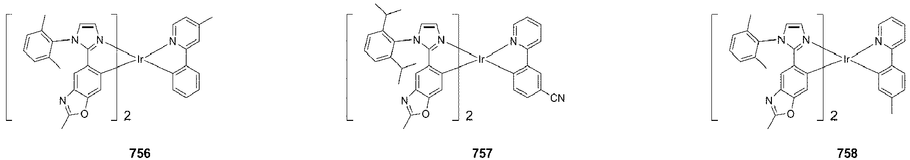

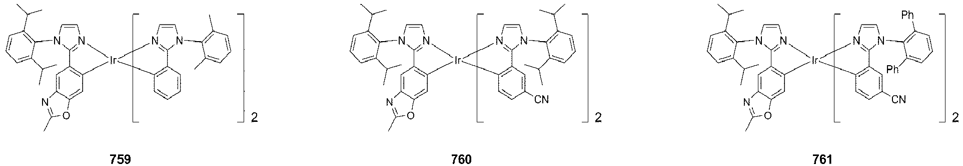

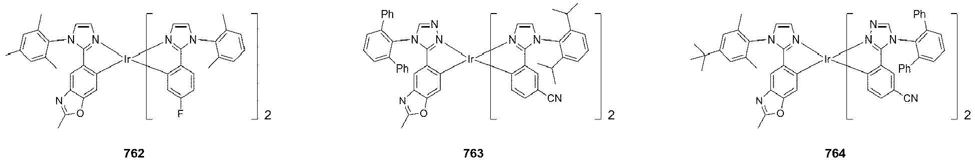

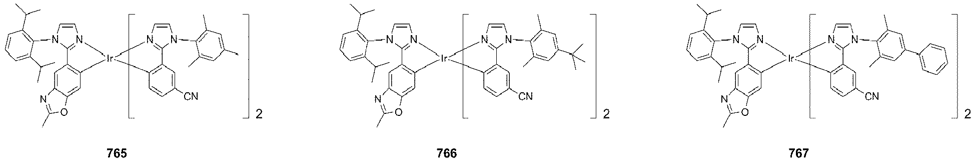

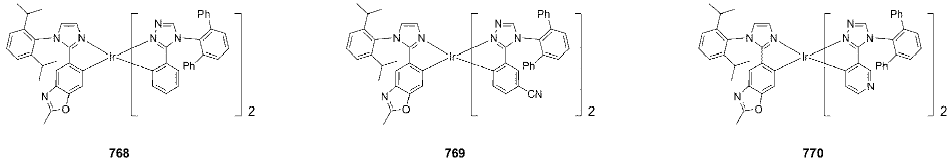

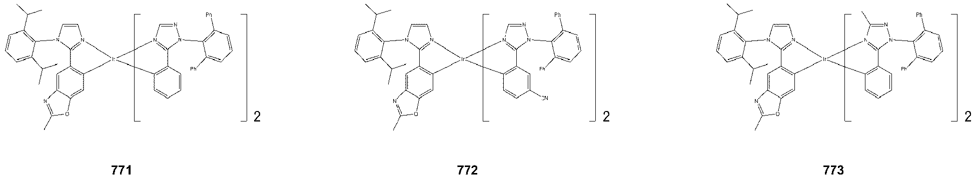

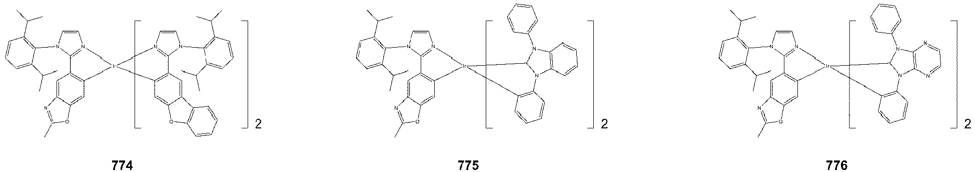

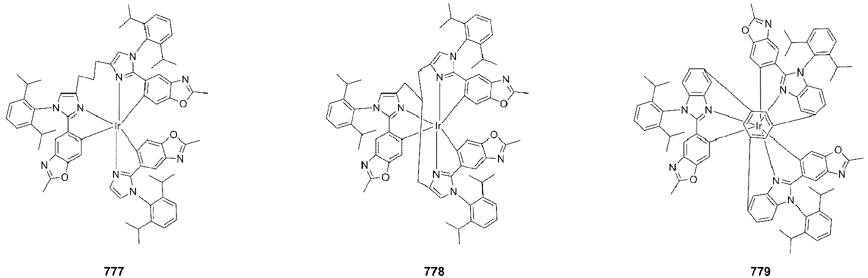

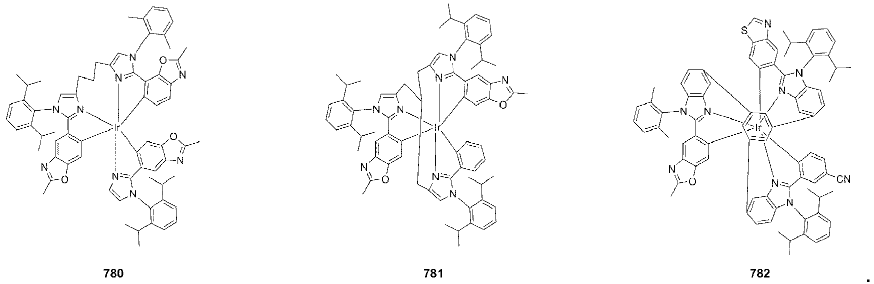

13. The organometallic compound of any of claims 1-12, wherein
the organometallic compound emits blue light having a maximum emission wavelength in a range of greater than or equal to 420 nanometers to less than 520 nanometers.

14. An organic light-emitting device comprising:
a first electrode;
a second electrode; and
an organic layer disposed between the first electrode and the second electrode,
wherein the organic layer comprises an emission layer and the organometallic compound of any of claims 1-13.

15. The organic light-emitting device of claim 14, wherein
the emission layer comprises the organometallic compound;
preferably wherein
the emission layer further comprises a host, and
an amount of the host is larger than an amount of the organometallic compound.
